# EUROPEAN PATENT APPLICATION

(11) **EP 3 540 776 A2**
(43) Date of publication of application: **18.09.2019**
(21) Application number: 19173175.1
(22) Date of filing: 12.12.2014
(51) Int. Cl.: H01L 27/146, H01L 21/768, H01L 23/48

(54) **SEMICONDUCTOR DEVICE, METHOD OF MANUFACTURING SEMICONDUCTOR DEVICE, AND ELECTRONIC APPARATUS**

(30) Priority: 19.12.2013 JP 2013262099; 14.05.2014 JP 2014100182
(62) Divisional of application: 14821306.9
(71) Applicant: Sony Corporation, Tokyo 108-0075 (JP)
(72) Inventor: KOMAI, Naoki, Tokyo, 108-0075 (JP); SASAKI, Naoto, Tokyo, 108-0075 (JP); OGAWA, Naoki, Tokyo, 108-0075 (JP); OINOUE, Takashi, Tokyo, 108-0075 (JP); IWAMOTO, Hayato, Tokyo, 108-0075 (JP); OOKA, Yutaka, Tokyo, 108-0075 (JP); NAGATA, Masaya, Tokyo, 108-0075 (JP)
(74) Representative: MFG Patentanwälte Meyer-Wildhagen Meggle-Freund Gerhard PartG mbB

(57) **Abstract**

A semiconductor device (1) includes a first semiconductor substrate (12) in which a pixel region (21) where pixel portions performing photoelectric conversion are two-dimensionally arranged is formed and a second semiconductor substrate (11) in which a logic circuit (23) processing a pixel signal output from the pixel portion is formed, the first and second semiconductor substrates being laminated. A protective substrate (18) protecting an on-chip lens (16) is disposed on the on-chip lens in the pixel region of the first semiconductor substrate with a sealing resin (17) interposed therebetween.

## Description

### Technical Field

The present disclosure relates to a semiconductor device, a method of manufacturing the semiconductor device, and an electronic device, and more particularly, to a semiconductor device configured to be further downsized, a method of manufacturing the semiconductor device, and an electronic device.

### <CROSS REFERENCE TO RELATED APPLICATIONS>

This application claims the benefit of Japanese Priority Patent Application JP 2013-262099 filed December 19, 2013, and Japanese Priority Patent Application JP 2014-100182 filed May 14, 2014, the entire contents of each of which are incorporated herein by reference.

### Background Art

In response to a request for downsizing a semiconductor device, there has been realized a wafer level CSP (Chip Size Package) for which a semiconductor device is downsized up to a chip size.

As a wafer level CSP of a solid-state imaging device, there has been suggested a structure in which a surface type solid-state imaging device in which a color filter or an on-chip lens is formed is pasted to a glass with a cavity structure, a through hole and a rewiring are formed from the side of a silicon substrate, and a solder ball is mounted (for example, see PTL 1).

### Citation List

### Patent Literature

PTL 1: Japanese Unexamined Patent Application Publication No. 2009-158862

### Summary of Invention

### Technical Problem

The surface type solid-state imaging device has a structure in which a pixel region where pixel portions performing photoelectric conversion are arranged and peripheral circuits performing control are disposed in a planar direction. In some cases, an image processing unit or the like performing a pixel signal is further disposed in the planar direction in addition to the peripheral circuits. Even when the surface type solid-state imaging device has a wafer level CSP structure, there has been a limit to area reduction due to the fact that the solid-state imaging device has a packet size of a plane area including at least the peripheral circuits.

The present disclosure is devised in light of such circumstances and it is desirable to further downsize a semiconductor device.

### Solution to Problem

According to a first embodiment of the present disclosure, there is provided a semiconductor device including a first semiconductor substrate in which a pixel region where pixel portions performing photoelectric conversion are two-dimensionally arranged is formed and a second semiconductor substrate in which a logic circuit processing a pixel signal output from the pixel portion is formed, the first and second semiconductor substrates being laminated. A protective substrate protecting an on-chip lens is disposed on the on-chip lens in the pixel region of the first semiconductor substrate with a sealing resin interposed therebetween.

According to a second embodiment of the present disclosure, there is provided a method of manufacturing a semiconductor device. The method includes: connecting a first semiconductor substrate in which a first wiring layer is formed and a second semiconductor substrate in which a second wiring layer is formed so that the wiring layers thereof face each other; forming a through electrode electrically connected to the first and second wiring layers; forming a color filter and an on-chip lens; and connecting a protective substrate protecting the on-chip lens onto the on-chip lens by a sealing resin.

In the second embodiment of the present disclosure, a first semiconductor substrate in which a first wiring layer is formed and a second semiconductor substrate in which a second wiring layer is formed are connected so that the wiring layers thereof face each other, a through electrode electrically connected to the first and second wiring layers is formed, a color filter and an on-chip lens are formed, and a protective substrate protecting the on-chip lens is connected onto the on-chip lens by a sealing resin.

According to a third embodiment of the present disclosure, there is provided a method of manufacturing a semiconductor device. The method includes: on a first semiconductor substrate in which a first wiring layer is formed, forming a color filter and an on-chip lens on an opposite surface to a side in which the first wiring layer of the first semiconductor substrate is formed; forming a through electrode penetrating through a second semiconductor substrate in which a second wiring layer is formed; and connecting the first semiconductor substrate in which the color filter and the on-chip lens are formed to the second semiconductor substrate in which the through electrode is formed so that the wiring layers thereof face each other.

In the third embodiment of the present disclosure, a color filter and an on-chip lens are formed, in a first semiconductor substrate in which a first wiring layer is formed, on an opposite surface to a side in which the first wiring layer of the first semiconductor substrate is formed; a through electrode penetrating through a second semiconductor substrate in the second substrate in which a second wiring layer is formed is formed; and the first semiconductor substrate in which the color filter and the on-chip lens are formed and the second semiconductor substrate in which the through electrode is formed are connected so that the wiring layers thereof face each other.

According to a fourth embodiment of the present disclosure, there is provided an electronic apparatus including a first semiconductor substrate in which a pixel region where pixel portions performing photoelectric conversion are two-dimensionally arranged is formed and a second semiconductor substrate in which a logic circuit processing a pixel signal output from the pixel portion is formed, the first and second semiconductor substrates being laminated. A protective substrate protecting an on-chip lens is disposed on the on-chip lens in the pixel region of the first semiconductor substrate with a sealing resin interposed therebetween.

In the first to fourth embodiments of the present disclosure, a first semiconductor substrate in which a pixel region where pixel portions performing photoelectric conversion are two-dimensionally arranged is formed and a second semiconductor substrate in which a logic circuit processing a pixel signal output from the pixel portion is formed are configured to be laminated. A protective substrate protecting an on-chip lens is disposed on the on-chip lens in the pixel region of the first semiconductor substrate with a sealing resin interposed therebetween.

The semiconductor device and the electronic device may be independent devices or may be modules embedded into other devices.

### Advantageous Effects of Invention

According to the first to fourth embodiments of the present disclosure, it is possible to further downsize the semiconductor device.

The advantageous effects described herein are not necessarily limited and any advantageous effect described in the present disclosure may be obtained.

### Brief Description of Drawings

Fig. 1 is a schematic diagram illustrating the outer appearance of a solid-state imaging device which is a semiconductor device according to an embodiment of the present disclosure.
Fig. 2 is an explanatory diagram illustrating a substrate of the solid-state imaging device.
Fig. 3 is a diagram illustrating an example of the circuit configuration of a laminated substrate.
Fig. 4 is a diagram illustrating an equivalent circuit of a pixel.
Fig. 5 is a diagram illustrating a detailed structure of the laminated substrate.
Fig. 6 is an explanatory diagram illustrating a detailed structure of the laminated substrate according to a first modification example.
Fig. 7 is an explanatory diagram illustrating a detailed structure of the laminated substrate according to a second modification example.
Fig. 8 is an explanatory diagram illustrating a detailed structure of the laminated substrate according to a third modification example.
Fig. 9 is an explanatory diagram illustrating a detailed structure of the laminated substrate according to a fourth modification example.
Fig. 10 is an explanatory diagram illustrating a detailed structure of the laminated substrate according to a fifth modification example.
Fig. 11 is an explanatory diagram illustrating a detailed structure of the laminated substrate according to a sixth modification example.
Fig. 12 is an explanatory diagram illustrating a detailed structure of the laminated substrate according to a seventh modification example.
Fig. 13 is an explanatory diagram illustrating a detailed structure of the laminated substrate according to an eighth modification example.
Fig. 14 is an explanatory diagram illustrating a detailed structure of the laminated substrate according to a ninth modification example.
Fig. 15 is a sectional view illustrating a face-to-back structure of a solid-state imaging device.
Fig. 16 is an explanatory diagram illustrating a first method of manufacturing the solid-state imaging device in Fig. 15.
Fig. 17 is an explanatory diagram illustrating the first method of manufacturing the solid-state imaging device in Fig. 15.
Fig. 18 is an explanatory diagram illustrating the first method of manufacturing the solid-state imaging device in Fig. 15.
Fig. 19 is an explanatory diagram illustrating the first method of manufacturing the solid-state imaging device in Fig. 15.
Fig. 20 is an explanatory diagram illustrating the first method of manufacturing the solid-state imaging device in Fig. 15.
Fig. 21 is an explanatory diagram illustrating the first method of manufacturing the solid-state imaging device in Fig. 15.
Fig. 22 is an explanatory diagram illustrating the first method of manufacturing the solid-state imaging device in Fig. 15.
Fig. 23 is an explanatory diagram illustrating the first method of manufacturing the solid-state imaging device in Fig. 15.
Fig. 24 is an explanatory diagram illustrating the first method of manufacturing the solid-state imaging device in Fig. 15.
Fig. 25 is an explanatory diagram illustrating the first method of manufacturing the solid-state imaging device in Fig. 15.
Fig. 26 is an explanatory diagram illustrating the first method of manufacturing the solid-state imaging device in Fig. 15.
Fig. 27 is an explanatory diagram illustrating the first method of manufacturing the solid-state imaging device in Fig. 15.
Fig. 28 is an explanatory diagram illustrating the first method of manufacturing the solid-state imaging device in Fig. 15.
Fig. 29 is an explanatory diagram illustrating the first method of manufacturing the solid-state imaging device in Fig. 15.
Fig. 30 is an explanatory diagram illustrating the first method of manufacturing the solid-state imaging device in Fig. 15.
Fig. 31 is an explanatory diagram illustrating a second method of manufacturing the solid-state imaging device in Fig. 15.
Fig. 32 is an explanatory diagram illustrating the second method of manufacturing the solid-state imaging device in Fig. 15.
Fig. 33 is an explanatory diagram illustrating the second method of manufacturing the solid-state imaging device in Fig. 15.
Fig. 34 is an explanatory diagram illustrating the second method of manufacturing the solid-state imaging device in Fig. 15.
Fig. 35 is an explanatory diagram illustrating the second method of manufacturing the solid-state imaging device in Fig. 15.
Fig. 36 is an explanatory diagram illustrating the second method of manufacturing the solid-state imaging device in Fig. 15.
Fig. 37 is an explanatory diagram illustrating the second method of manufacturing the solid-state imaging device in Fig. 15.
Fig. 38 is an explanatory diagram illustrating the second method of manufacturing the solid-state imaging device in Fig. 15.
Fig. 39 is an explanatory diagram illustrating the second method of manufacturing the solid-state imaging device in Fig. 15.
Fig. 40 is an explanatory diagram illustrating the second method of manufacturing the solid-state imaging device in Fig. 15.
Fig. 41 is an explanatory diagram illustrating the second method of manufacturing the solid-state imaging device in Fig. 15.
Fig. 42 is an explanatory diagram illustrating the second method of manufacturing the solid-state imaging device in Fig. 15.
Fig. 43 is an explanatory diagram illustrating a third method of manufacturing the solid-state imaging device in Fig. 15.
Fig. 44 is an explanatory diagram illustrating the third method of manufacturing the solid-state imaging device in Fig. 15.
Fig. 45 is an explanatory diagram illustrating the third method of manufacturing the solid-state imaging device in Fig. 15.
Fig. 46 is an explanatory diagram illustrating the third method of manufacturing the solid-state imaging device in Fig. 15.
Fig. 47 is an explanatory diagram illustrating the third method of manufacturing the solid-state imaging device in Fig. 15.
Fig. 48 is an explanatory diagram illustrating the third method of manufacturing the solid-state imaging device in Fig. 15.
Fig. 49 is an explanatory diagram illustrating the third method of manufacturing the solid-state imaging device in Fig. 15.
Fig. 50 is an explanatory diagram illustrating a rewiring according to a modification example.
Fig. 51A is an explanatory diagram illustrating the rewiring according to the modification example.
Fig. 51B is an explanatory diagram illustrating the rewiring according to the modification example.
Fig. 51C is an explanatory diagram illustrating the rewiring according to the modification example.
Fig. 52A is an explanatory diagram illustrating the rewiring according to the modification example.
Fig. 52B is an explanatory diagram illustrating the rewiring according to the modification example.
Fig. 52C is an explanatory diagram illustrating the rewiring according to the modification example.
Fig. 52D is an explanatory diagram illustrating the rewiring according to the modification example.
Fig. 53 is an explanatory diagram illustrating the rewiring according to the modification example.
Fig. 54A is an explanatory diagram illustrating the rewiring according to the modification example.
Fig. 54B is an explanatory diagram illustrating the rewiring according to the modification example.
Fig. 54C is an explanatory diagram illustrating the rewiring according to the modification example.
Fig. 54D is an explanatory diagram illustrating the rewiring according to the modification example.
Fig. 54E is an explanatory diagram illustrating the rewiring according to the modification example.
Fig. 55 is an explanatory diagram illustrating a method of manufacturing the solid-state imaging device in Fig. 5.
Fig. 56 is an explanatory diagram illustrating the method of manufacturing the solid-state imaging device in Fig. 5.
Fig. 57 is an explanatory diagram illustrating the method of manufacturing the solid-state imaging device in Fig. 5.
Fig. 58 is an explanatory diagram illustrating the method of manufacturing the solid-state imaging device in Fig. 5.
Fig. 59 is an explanatory diagram illustrating the method of manufacturing the solid-state imaging device in Fig. 5.
Fig. 60 is an explanatory diagram illustrating the method of manufacturing the solid-state imaging device in Fig. 5.
Fig. 61 is an explanatory diagram illustrating the method of manufacturing the solid-state imaging device in Fig. 5.
Fig. 62 is an explanatory diagram illustrating the method of manufacturing the solid-state imaging device in Fig. 5.
Fig. 63 is an explanatory diagram illustrating the method of manufacturing the solid-state imaging device in Fig. 5.
Fig. 64 is an explanatory diagram illustrating the method of manufacturing the solid-state imaging device in Fig. 5.
Fig. 65 is an explanatory diagram illustrating the method of manufacturing the solid-state imaging device in Fig. 5.
Fig. 66A is an explanatory diagram illustrating a first manufacturing method of the first modification example in Fig. 6.
Fig. 66B is an explanatory diagram illustrating the first manufacturing method of the first modification example in Fig. 6.
Fig. 66C is an explanatory diagram illustrating the first manufacturing method of the first modification example in Fig. 6.
Fig. 66D is an explanatory diagram illustrating the first manufacturing method of the first modification example in Fig. 6.
Fig. 67A is an explanatory diagram illustrating the first manufacturing method of the first modification example in Fig. 6.
Fig. 67B is an explanatory diagram illustrating the first manufacturing method of the first modification example in Fig. 6.
Fig. 67C is an explanatory diagram illustrating the first manufacturing method of the first modification example in Fig. 6.
Fig. 68A is an explanatory diagram illustrating a second manufacturing method of the first modification example in Fig. 6.
Fig. 68B is an explanatory diagram illustrating the second manufacturing method of the first modification example in Fig. 6.
Fig. 68C is an explanatory diagram illustrating the second manufacturing method of the first modification example in Fig. 6.
Fig. 68D is an explanatory diagram illustrating the second manufacturing method of the first modification example in Fig. 6.
Fig. 69A is an explanatory diagram illustrating the second manufacturing method of the first modification example in Fig. 6.
Fig. 69B is an explanatory diagram illustrating the second manufacturing method of the first modification example in Fig. 6.
Fig. 69C is an explanatory diagram illustrating the second manufacturing method of the first modification example in Fig. 6.
Fig. 70A is an explanatory diagram illustrating the second manufacturing method of the first modification example in Fig. 6.
Fig. 70B is an explanatory diagram illustrating the second manufacturing method of the first modification example in Fig. 6.
Fig. 70C is an explanatory diagram illustrating the second manufacturing method of the first modification example in Fig. 6.
Fig. 71A is an explanatory diagram illustrating a modification example of the second manufacturing method of the first modification example in Fig. 6.
Fig. 71B is an explanatory diagram illustrating the modification example of the second manufacturing method of the first modification example in Fig. 6.
Fig. 72A is an explanatory diagram illustrating a third manufacturing method of the first modification example in Fig. 6.
Fig. 72B is an explanatory diagram illustrating the third manufacturing method of the first modification example in Fig. 6.
Fig. 72C is an explanatory diagram illustrating the third manufacturing method of the first modification example in Fig. 6.
Fig. 72D is an explanatory diagram illustrating the third manufacturing method of the first modification example in Fig. 6.
Fig. 73A is an explanatory diagram illustrating the third manufacturing method of the first modification example in Fig. 6.
Fig. 73B is an explanatory diagram illustrating the third manufacturing method of the first modification example in Fig. 6.
Fig. 73C is an explanatory diagram illustrating the third manufacturing method of the first modification example in Fig. 6.
Fig. 73D is an explanatory diagram illustrating the third manufacturing method of the first modification example in Fig. 6.
Fig. 74A is an explanatory diagram illustrating a fourth manufacturing method of the first modification example in Fig. 6.
Fig. 74B is an explanatory diagram illustrating the fourth manufacturing method of the first modification example in Fig. 6.
Fig. 74C is an explanatory diagram illustrating the fourth manufacturing method of the first modification example in Fig. 6.
Fig. 74D is an explanatory diagram illustrating the fourth manufacturing method of the first modification example in Fig. 6.
Fig. 75A is an explanatory diagram illustrating the fourth manufacturing method of the first modification example in Fig. 6.
Fig. 75B is an explanatory diagram illustrating the fourth manufacturing method of the first modification example in Fig. 6.
Fig. 75C is an explanatory diagram illustrating the fourth manufacturing method of the first modification example in Fig. 6.
Fig. 75D is an explanatory diagram illustrating the fourth manufacturing method of the first modification example in Fig. 6.
Fig. 76A is an explanatory diagram illustrating a fifth manufacturing method of the first modification example in Fig. 6.
Fig. 76B is an explanatory diagram illustrating the fifth manufacturing method of the first modification example in Fig. 6.
Fig. 76C is an explanatory diagram illustrating the fifth manufacturing method of the first modification example in Fig. 6.
Fig. 76D is an explanatory diagram illustrating the fifth manufacturing method of the first modification example in Fig. 6.
Fig. 77A is an explanatory diagram illustrating the fifth manufacturing method of the first modification example in Fig. 6.
Fig. 77B is an explanatory diagram illustrating the fifth manufacturing method of the first modification example in Fig. 6.
Fig. 77C is an explanatory diagram illustrating the fifth manufacturing method of the first modification example in Fig. 6.
Fig. 78A is an explanatory diagram illustrating a sixth manufacturing method of the first modification example in Fig. 6.
Fig. 78B is an explanatory diagram illustrating the sixth manufacturing method of the first modification example in Fig. 6.
Fig. 78C is an explanatory diagram illustrating the sixth manufacturing method of the first modification example in Fig. 6.
Fig. 78D is an explanatory diagram illustrating the sixth manufacturing method of the first modification example in Fig. 6.
Fig. 79A is an explanatory diagram illustrating the sixth manufacturing method of the first modification example in Fig. 6.
Fig. 79B is an explanatory diagram illustrating the sixth manufacturing method of the first modification example in Fig. 6.
Fig. 79C is an explanatory diagram illustrating the sixth manufacturing method of the first modification example in Fig. 6.
Fig. 80A is an explanatory diagram illustrating the sixth manufacturing method of the first modification example in Fig. 6.
Fig. 80B is an explanatory diagram illustrating the sixth manufacturing method of the first modification example in Fig. 6.
Fig. 80C is an explanatory diagram illustrating the sixth manufacturing method of the first modification example in Fig. 6.
Fig. 81A is an explanatory diagram illustrating a first manufacturing method of the second modification example in Fig. 7.
Fig. 81B is an explanatory diagram illustrating the first manufacturing method of the second modification example in Fig. 7.
Fig. 81C is an explanatory diagram illustrating the first manufacturing method of the second modification example in Fig. 7.
Fig. 81D is an explanatory diagram illustrating the first manufacturing method of the second modification example in Fig. 7.
Fig. 82A is an explanatory diagram illustrating the first manufacturing method of the second modification example in Fig. 7.
Fig. 82B is an explanatory diagram illustrating the first manufacturing method of the second modification example in Fig. 7.
Fig. 82C is an explanatory diagram illustrating the first manufacturing method of the second modification example in Fig. 7.
Fig. 82D is an explanatory diagram illustrating the first manufacturing method of the second modification example in Fig. 7.
Fig. 83A is an explanatory diagram illustrating a second manufacturing method of the second modification example in Fig. 7.
Fig. 83B is an explanatory diagram illustrating the second manufacturing method of the second modification example in Fig. 7.
Fig. 83C is an explanatory diagram illustrating the second manufacturing method of the second modification example in Fig. 7.
Fig. 83D is an explanatory diagram illustrating the second manufacturing method of the second modification example in Fig. 7.
Fig. 84A is an explanatory diagram illustrating the second manufacturing method of the second modification example in Fig. 7.
Fig. 84B is an explanatory diagram illustrating the second manufacturing method of the second modification example in Fig. 7.
Fig. 84C is an explanatory diagram illustrating the second manufacturing method of the second modification example in Fig. 7.
Fig. 85A is an explanatory diagram illustrating the second manufacturing method of the second modification example in Fig. 7.
Fig. 85B is an explanatory diagram illustrating the second manufacturing method of the second modification example in Fig. 7.
Fig. 85C is an explanatory diagram illustrating the second manufacturing method of the second modification example in Fig. 7.
Fig. 86A is an explanatory diagram illustrating a manufacturing method of the third modification example in Fig. 8.
Fig. 86B is an explanatory diagram illustrating the manufacturing method of the third modification example in Fig. 8.
Fig. 86C is an explanatory diagram illustrating the manufacturing method of the third modification example in Fig. 8.
Fig. 86D is an explanatory diagram illustrating the manufacturing method of the third modification example in Fig. 8.
Fig. 87A is an explanatory diagram illustrating the manufacturing method of the third modification example in Fig. 8.
Fig. 87B is an explanatory diagram illustrating the manufacturing method of the third modification example in Fig. 8.
Fig. 87C is an explanatory diagram illustrating the manufacturing method of the third modification example in Fig. 8.
Fig. 87D is an explanatory diagram illustrating the manufacturing method of the third modification example in Fig. 8.
Fig. 88A is an explanatory diagram illustrating a manufacturing method of the fourth modification example in Fig. 9.
Fig. 88B is an explanatory diagram illustrating the manufacturing method of the fourth modification example in Fig. 9.
Fig. 88C is an explanatory diagram illustrating the manufacturing method of the fourth modification example in Fig. 9.
Fig. 88D is an explanatory diagram illustrating the manufacturing method of the fourth modification example in Fig. 9.
Fig. 89A is an explanatory diagram illustrating the manufacturing method of the fourth modification example in Fig. 9.
Fig. 89B is an explanatory diagram illustrating the manufacturing method of the fourth modification example in Fig. 9.
Fig. 89C is an explanatory diagram illustrating the manufacturing method of the fourth modification example in Fig. 9.
Fig. 89D is an explanatory diagram illustrating the manufacturing method of the fourth modification example in Fig. 9.
Fig. 90A is an explanatory diagram illustrating a manufacturing method of the fifth modification example in Fig. 10.
Fig. 90B is an explanatory diagram illustrating the manufacturing method of the fifth modification example in Fig. 10.
Fig. 90C is an explanatory diagram illustrating the manufacturing method of the fifth modification example in Fig. 10.
Fig. 90D is an explanatory diagram illustrating the manufacturing method of the fifth modification example in Fig. 10.
Fig. 91A is an explanatory diagram illustrating the manufacturing method of the fifth modification example in Fig. 10.
Fig. 91B is an explanatory diagram illustrating the manufacturing method of the fifth modification example in Fig. 10.
Fig. 91C is an explanatory diagram illustrating the manufacturing method of the fifth modification example in Fig. 10.
Fig. 91D is an explanatory diagram illustrating the manufacturing method of the fifth modification example in Fig. 10.
Fig. 92A is an explanatory diagram illustrating the manufacturing method of the fifth modification example in Fig. 10.
Fig. 92B is an explanatory diagram illustrating the manufacturing method of the fifth modification example in Fig. 10.
Fig. 92C is an explanatory diagram illustrating the manufacturing method of the fifth modification example in Fig. 10.
Fig. 92D is an explanatory diagram illustrating the manufacturing method of the fifth modification example in Fig. 10.
Fig. 93A is an explanatory diagram illustrating a manufacturing method of the sixth modification example in Fig. 11.
Fig. 93B is an explanatory diagram illustrating the manufacturing method of the sixth modification example in Fig. 11.
Fig. 93C is an explanatory diagram illustrating the manufacturing method of the sixth modification example in Fig. 11.
Fig. 94A is an explanatory diagram illustrating the manufacturing method of the sixth modification example in Fig. 11.
Fig. 94B is an explanatory diagram illustrating the manufacturing method of the sixth modification example in Fig. 11.
Fig. 94C is an explanatory diagram illustrating the manufacturing method of the sixth modification example in Fig. 11.
Fig. 95A is an explanatory diagram illustrating a manufacturing method of the seventh modification example in Fig. 12.
Fig. 95B is an explanatory diagram illustrating the manufacturing method of the seventh modification example in Fig. 12.
Fig. 95C is an explanatory diagram illustrating the manufacturing method of the seventh modification example in Fig. 12.
Fig. 96A is an explanatory diagram illustrating the manufacturing method of the seventh modification example in Fig. 12.
Fig. 96B is an explanatory diagram illustrating the manufacturing method of the seventh modification example in Fig. 12.
Fig. 96C is an explanatory diagram illustrating the manufacturing method of the seventh modification example in Fig. 12.
Fig. 97A is an explanatory diagram illustrating a manufacturing method of the eighth modification example in Fig. 13.
Fig. 97B is an explanatory diagram illustrating the manufacturing method of the eighth modification example in Fig. 13.
Fig. 97C is an explanatory diagram illustrating the manufacturing method of the eighth modification example in Fig. 13.
Fig. 98A is an explanatory diagram illustrating the manufacturing method of the eighth modification example in Fig. 13.
Fig. 98B is an explanatory diagram illustrating the manufacturing method of the eighth modification example in Fig. 13.
Fig. 98C is an explanatory diagram illustrating the manufacturing method of the eighth modification example in Fig. 13.
Fig. 99A is an explanatory diagram illustrating the manufacturing method of the eighth modification example in Fig. 13.
Fig. 99B is an explanatory diagram illustrating the manufacturing method of the eighth modification example in Fig. 13.
Fig. 99C is an explanatory diagram illustrating the manufacturing method of the eighth modification example in Fig. 13.
Fig. 100A is an explanatory diagram illustrating the manufacturing method of the eighth modification example in Fig. 13.
Fig. 100B is an explanatory diagram illustrating the manufacturing method of the eighth modification example in Fig. 13.
Fig. 100C is an explanatory diagram illustrating the manufacturing method of the eighth modification example in Fig. 13.
Fig. 101A is an explanatory diagram illustrating a manufacturing method of the ninth modification example in Fig. 14.
Fig. 101B is an explanatory diagram illustrating the manufacturing method of the ninth modification example in Fig. 14.
Fig. 101C is an explanatory diagram illustrating the manufacturing method of the ninth modification example in Fig. 14.
Fig. 102A is an explanatory diagram illustrating the manufacturing method of the ninth modification example in Fig. 14.
Fig. 102B is an explanatory diagram illustrating the manufacturing method of the ninth modification example in Fig. 14.
Fig. 102C is an explanatory diagram illustrating the manufacturing method of the ninth modification example in Fig. 14.
Fig. 102D is an explanatory diagram illustrating the manufacturing method of the ninth modification example in Fig. 14.
Fig. 103A is an explanatory diagram illustrating the manufacturing method of the ninth modification example in Fig. 14.
Fig. 103B is an explanatory diagram illustrating the manufacturing method of the ninth modification example in Fig. 14.
Fig. 103C is an explanatory diagram illustrating the manufacturing method of the ninth modification example in Fig. 14.
Fig. 104 is an explanatory diagram illustrating a detailed structure of the laminated substrate according to a tenth modification example.
Fig. 105A is an explanatory diagram illustrating a first manufacturing method of the tenth modification example in Fig. 15.
Fig. 105B is an explanatory diagram illustrating the first manufacturing method of the tenth modification example in Fig. 15.
Fig. 105C is an explanatory diagram illustrating the first manufacturing method of the tenth modification example in Fig. 15.
Fig. 105D is an explanatory diagram illustrating the first manufacturing method of the tenth modification example in Fig. 15.
Fig. 105E is an explanatory diagram illustrating the first manufacturing method of the tenth modification example in Fig. 15.
Fig. 106A is an explanatory diagram illustrating the first manufacturing method of the tenth modification example in Fig. 15.
Fig. 106B is an explanatory diagram illustrating the first manufacturing method of the tenth modification example in Fig. 15.
Fig. 106C is an explanatory diagram illustrating the first manufacturing method of the tenth modification example in Fig. 15.
Fig. 106D is an explanatory diagram illustrating the first manufacturing method of the tenth modification example in Fig. 15.
Fig. 106E is an explanatory diagram illustrating the first manufacturing method of the tenth modification example in Fig. 15.
Fig. 107A is an explanatory diagram illustrating the first manufacturing method of the tenth modification example in Fig. 15.
Fig. 107B is an explanatory diagram illustrating the first manufacturing method of the tenth modification example in Fig. 15.
Fig. 107C is an explanatory diagram illustrating the first manufacturing method of the tenth modification example in Fig. 15.
Fig. 107D is an explanatory diagram illustrating the first manufacturing method of the tenth modification example in Fig. 15.
Fig. 107E is an explanatory diagram illustrating the first manufacturing method of the tenth modification example in Fig. 15.
Fig. 108A is an explanatory diagram illustrating a second manufacturing method of the tenth modification example in Fig. 15.
Fig. 108B is an explanatory diagram illustrating the second manufacturing method of the tenth modification example in Fig. 15.
Fig. 108C is an explanatory diagram illustrating the second manufacturing method of the tenth modification example in Fig. 15.
Fig. 108D is an explanatory diagram illustrating the second manufacturing method of the tenth modification example in Fig. 15.
Fig. 108E is an explanatory diagram illustrating the second manufacturing method of the tenth modification example in Fig. 15.
Fig. 109A is an explanatory diagram illustrating the second manufacturing method of the tenth modification example in Fig. 15.
Fig. 109B is an explanatory diagram illustrating the second manufacturing method of the tenth modification example in Fig. 15.
Fig. 109C is an explanatory diagram illustrating the second manufacturing method of the tenth modification example in Fig. 15.
Fig. 109D is an explanatory diagram illustrating the second manufacturing method of the tenth modification example in Fig. 15.
Fig. 109E is an explanatory diagram illustrating the second manufacturing method of the tenth modification example in Fig. 15.
Fig. 110A is an explanatory diagram illustrating the second manufacturing method of the tenth modification example in Fig. 15.
Fig. 110B is an explanatory diagram illustrating the second manufacturing method of the tenth modification example in Fig. 15.
Fig. 110C is an explanatory diagram illustrating the second manufacturing method of the tenth modification example in Fig. 15.
Fig. 110D is an explanatory diagram illustrating the second manufacturing method of the tenth modification example in Fig. 15.
Fig. 110E is an explanatory diagram illustrating the second manufacturing method of the tenth modification example in Fig. 15.
Fig. 111A is an explanatory diagram illustrating a method of manufacturing a solid-state imaging device having a general backside irradiation type structure.
Fig. 111B is an explanatory diagram illustrating the method of manufacturing the solid-state imaging device having the general backside irradiation type structure.
Fig. 111C is an explanatory diagram illustrating the method of manufacturing the solid-state imaging device having the general backside irradiation type structure.
Fig. 111D is an explanatory diagram illustrating the method of manufacturing the solid-state imaging device having the general backside irradiation type structure.
Fig. 111E is an explanatory diagram illustrating the method of manufacturing the solid-state imaging device having the general backside irradiation type structure.
Fig. 112A is an explanatory diagram illustrating the method of manufacturing the solid-state imaging device having the general backside irradiation type structure.
Fig. 112B is an explanatory diagram illustrating the method of manufacturing the solid-state imaging device having the general backside irradiation type structure.
Fig. 112C is an explanatory diagram illustrating the method of manufacturing the solid-state imaging device having the general backside irradiation type structure.
Fig. 112D is an explanatory diagram illustrating the method of manufacturing the solid-state imaging device having the general backside irradiation type structure.
Fig. 112E is an explanatory diagram illustrating the method of manufacturing the solid-state imaging device having the general backside irradiation type structure.
Fig. 113A is an explanatory diagram illustrating the method of manufacturing the solid-state imaging device having the general backside irradiation type structure.
Fig. 113B is an explanatory diagram illustrating the method of manufacturing the solid-state imaging device having the general backside irradiation type structure.
Fig. 113C is an explanatory diagram illustrating the method of manufacturing the solid-state imaging device having the general backside irradiation type structure.
Fig. 113D is an explanatory diagram illustrating the method of manufacturing the solid-state imaging device having the general backside irradiation type structure.
Fig. 113E is an explanatory diagram illustrating the method of manufacturing the solid-state imaging device having the general backside irradiation type structure.
Fig. 114A is an diagram illustrating the overall configuration of a three-layer laminated substrate of a solid-state imaging device.
Fig. 114B is an diagram illustrating the overall configuration of the three-layer laminated substrate of the solid-state imaging device.
Fig. 115A is an explanatory diagram illustrating the configuration of the three-layer laminated substrate.
Fig. 115B is an explanatory diagram illustrating the configuration of the three-layer laminated substrate.
Fig. 115C is an explanatory diagram illustrating the configuration of the three-layer laminated substrate.
Fig. 116A is an explanatory diagram illustrating the configuration of the three-layer laminated substrate.
Fig. 116B is an explanatory diagram illustrating the configuration of the three-layer laminated substrate.
Fig. 116C is an explanatory diagram illustrating the configuration of the three-layer laminated substrate.
Fig. 117A is an explanatory diagram illustrating the configuration of the three-layer laminated substrate.
Fig. 117B is an explanatory diagram illustrating the configuration of the three-layer laminated substrate.
Fig. 117C is an explanatory diagram illustrating the configuration of the three-layer laminated substrate.
Fig. 118 is an explanatory diagram illustrating the configuration of the three-layer laminated substrate.
Fig. 119 is a block diagram illustrating a configuration example of an imaging apparatus which is an electronic apparatus according to an embodiment of the present disclosure.

### Description of Embodiments

Hereinafter, modes (hereinafter referred to as embodiments) for carrying out the present disclosure will be described. The description will be made in the following order.
1. Overall Configuration of Solid-state Imaging Device
2. First Basic Structure Example of Solid-state Imaging Device
3. First to Ninth Modification Structure Examples of Solid-state Imaging Device
4. Second Basic Structure Example of Solid-state Imaging Device
5. Manufacturing Method for Second Basic Structure
6. Manufacturing Method for First Basic Structure
7. Tenth Modification Example
8. Manufacturing Method of Tenth Modification Example
9. Configuration Example of Three-layer Laminated Substrate
10. Application Example to Electronic Apparatus

### <1. Overall Configuration of Solid-state Imaging Device>

### <Schematic Diagram of Outer Appearance>

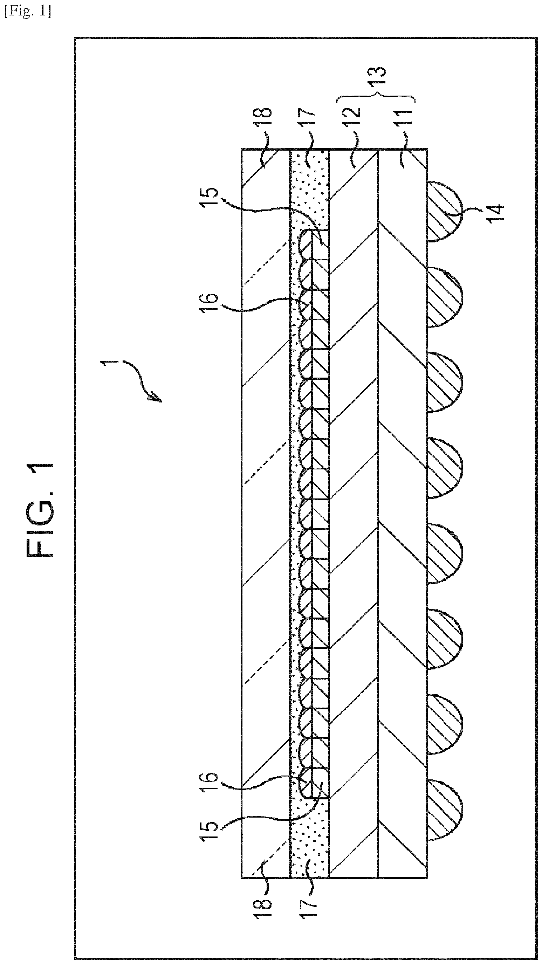

Fig. 1 is a schematic diagram illustrating the outer appearance of a solid-state imaging device which is a semiconductor device according to an embodiment of the present disclosure.

A solid-state imaging device 1 illustrated in Fig. 1 is a semiconductor package in which a laminated substrate 13 configured by laminating a lower substrate 11 and an upper substrate 12 is packaged.

In the lower substrate 11, a plurality of solder balls 14 which are backside electrodes electrically connected to an external substrate (not illustrated) are formed.

R (red), G (green), or B (blue) color filters 15 and on-chip lenses 16 are formed on the upper surface of the upper substrate 12. The upper substrate 12 is connected to a glass protective substrate 18 protecting the on-chip lenses 16 with a glass seal resin 17 interposed therebetween with a cavityless structure.

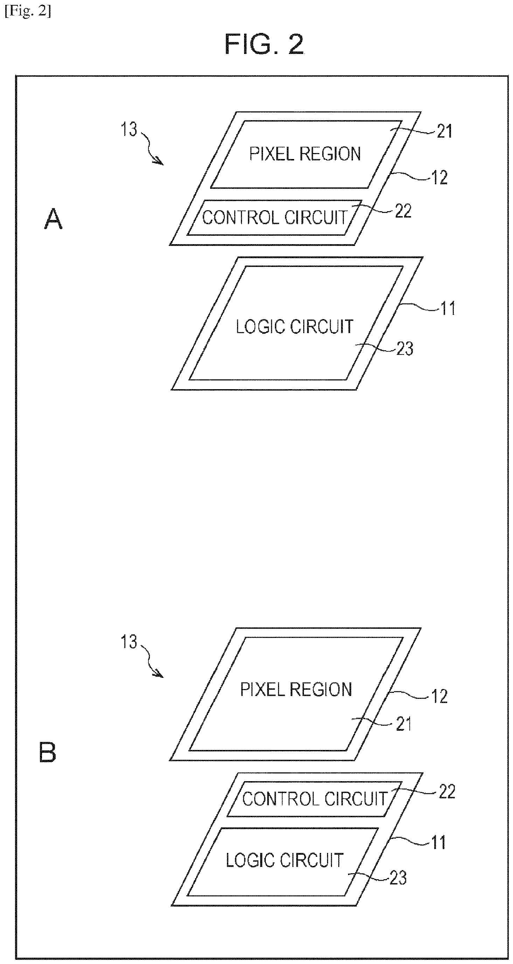

For example, as illustrated in Fig. 2A, a pixel region 21 where pixel portions performing photoelectric conversion are two-dimensionally arranged and a control circuit 22 controlling the pixel portions are formed in the upper substrate 12. A logic circuit 23 such as a signal processing circuit performing a pixel signal output from the pixel portion is formed in the lower substrate 11.

Alternatively, as illustrated in Fig. 2B, a configuration may be realized in which only the pixel region 21 is formed in the upper substrate 12 and the control circuit 22 and the logic circuit 23 are formed in the lower substrate 11.

As described above, by forming and laminating the logic circuit 23 or both of the control circuit 22 and the logic circuit 23 in the lower substrate 11 different from the upper substrate 12 of the pixel region 21, the size of the solid-state imaging device 1 can be downsized, compared to a case in which the pixel region 21, the control circuit 22, and the logic circuit 23 are disposed in a planar direction in one semiconductor substrate.

Hereinafter, the upper substrate 12 in which at least the pixel region 21 is formed is referred to as a pixel sensor substrate 12 and the lower substrate 11 in which at least the logic circuit 23 is formed is referred to as a logic substrate 11 in the description.

### <Configuration Example of Laminated Substrate>

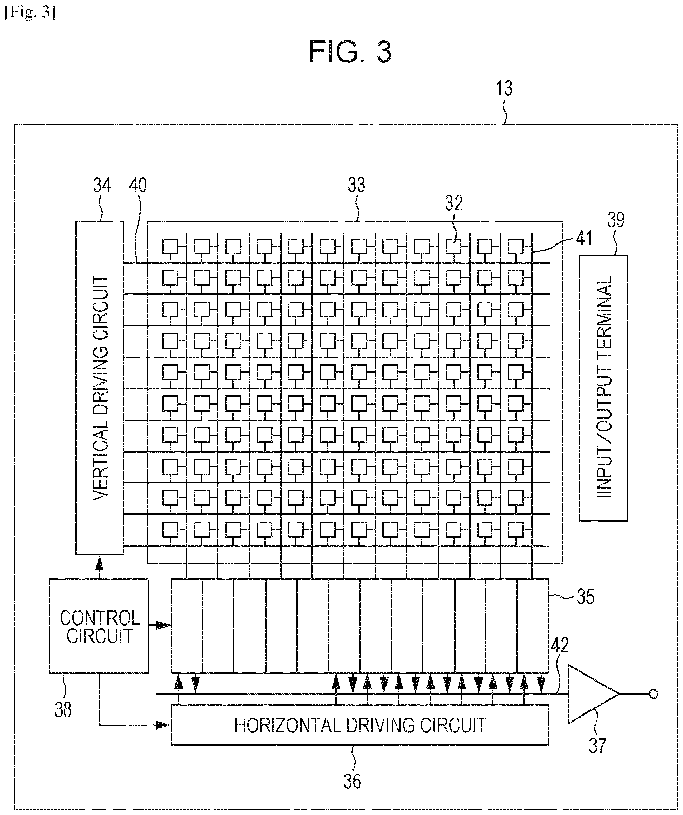

Fig. 3 is a diagram illustrating an example of the circuit configuration of a laminated substrate 13.

The laminated substrate 13 includes a pixel array unit 33 in which pixels 32 are arranged in a two-dimensional array form, a vertical driving circuit 34, column signal processing circuits 35, a horizontal driving circuit 36, an output circuit 37, a control circuit 38, and an input/output terminal 39.

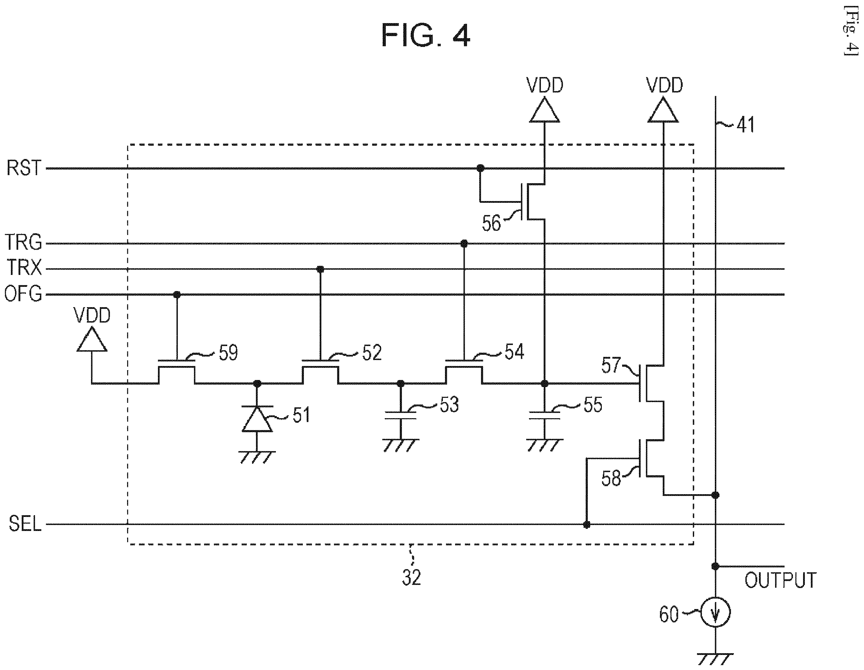

The pixel 32 includes a photodiode serving as a photoelectric conversion element and a plurality of pixel transistors. An example of the circuit configuration of the pixel 32 will be described below with reference to Fig. 4.

The pixels 32 can also have a pixel sharing structure. The pixel sharing structure is formed by a plurality of photodiodes, a plurality of transfer transistors, one shared floating diffusion (floating diffusion region), and each other shared pixel transistor. That is, the shared pixels are configured such that the photodiodes and the transfer transistors forming a plurality of unit pixels share each other pixel transistor.

The control circuit 38 receives an input clock and data instructing an operation mode or the like and outputs data of internal data or the like of the laminated substrate 13. That is, based on a vertical synchronization signal, a horizontal synchronization signal, and a master clock, the control circuit 38 generates a clock signal or a control signal serving as a reference of operations of the vertical driving circuit 34, the column signal processing circuit 35, the horizontal driving circuit 36, and the like. Then, the control circuit 38 outputs the generated clock signal or control signal to the vertical driving circuit 34, the column signal processing circuit 35, the horizontal driving circuit 36, and the like.

The vertical driving circuit 34 includes, for example, a shift register, selects a predetermined pixel driving wiring 40, supplies a pulse to drive the pixels 32 to the selected pixel driving wiring 40, and drives the pixels 32 in units of rows. That is, the vertical driving circuit 34 selectively scans the pixels 32 of the pixel array unit 33 sequentially in units of rows in the vertical direction and supplies a pixel signal based on a signal charge generated according to an amount of light received in the photoelectric conversion portion of each pixel 32 to the column signal processing circuit 35 via a vertical signal line 41.

The column signal processing circuit 35 is disposed at each column of the pixels 32 and performs signal processing such as noise removal on signals output from the pixels 32 corresponding to one row for each pixel column. For example, the column signal processing circuit 35 performs signal processing such as correlated double sampling (CDS) and AD conversion to remove fixed pattern noise unique to the pixel.

The horizontal driving circuit 36 includes, for example, a shift register, sequentially selects the column signal processing circuits 35 by sequentially outputting horizontal scanning pulses, and outputs a pixel signal from each of the column signal processing circuits 35 to a horizontal signal line 42.

The output circuit 37 performs signal processing on the signals sequentially supplied from the column signal processing circuits 35 via the horizontal signal line 42 and outputs the processed signals. For example, the output circuit 37 performs only buffering in some cases or performs black level adjustment, column variation correction, various kinds of digital signal processing, and the like in some cases. The input/output terminal 39 transmits and receives signals to and from the outside.

The laminated substrate 13 having the above-described configuration is a CMOS image sensor called a column AD type in which the column signal processing circuit 35 performing the CDS process and the AD conversion process is disposed at each pixel column.

### <Circuit Configuration Example of Pixel>

Fig. 4 illustrates an equivalent circuit of the pixel 32.

The pixel 32 illustrated in Fig. 4 has a configuration realizing an electronic global shutter function.

The pixel 32 includes a photodiode 51 which is a photoelectric conversion element, a first transfer transistor 52, a memory portion (MEM) 53, a second transfer transistor 54, an FD (floating diffusion region) 55, a reset transistor 56, an amplification transistor 57, a select transistor 58, and a discharge transistor 59.

The photodiode 51 is a photoelectric conversion portion that generates and accumulates a charge (signal charge) according to an amount of received light. The anode terminal of the photodiode 51 is grounded and the cathode terminal thereof is connected to the memory portion 53 via the first transfer transistor 52. The cathode terminal of the photodiode 51 is also connected to the discharge transistor 59 to discharge an unnecessary charge.

The first transfer transistor 52 reads the charge generated by the photodiode 51 and transfers the charge to the memory portion 53 when power is turned on by a transfer signal TRX. The memory portion 53 is a charge retention portion that temporarily retains the charge until the charge is transferred to the FD 55.

The second transfer transistor 54 reads the charge retained in the memory portion 53 and transfers the charge to the FD 55 when power is turned on by a transfer signal TRG.

The FD 55 is a charge retention portion that retains the charge read from the memory portion 53 to read the charge as a signal. The reset transistor 56 resets the potential of the FD 55 by discharging the charge stored in the FD 55 to a constant voltage source VDD when power is turned on by a reset signal RST.

The amplification transistor 57 outputs a pixel signal according to the potential of the FD 55. That is, the amplification transistor 57 forms a load MOS 60 serving as a constant current source and a source follower circuit. A pixel signal indicating a level according to the charge stored in the FD 55 is output from the amplification transistor 57 to the column signal processing circuit 35 (see Fig. 3) via the select transistor 58. For example, the load MOS 60 is disposed inside the column signal processing circuit 35.

When the pixel 32 is selected by a select signal SEL, the select transistor 58 is turned on and outputs the pixel signal of the pixel 32 to the column signal processing circuit 35 via the vertical signal line 41.

The discharge transistor 59 discharges unnecessary charge stored in the photodiode 51 to the constant voltage source VDD when power is turned on by a discharge signal OFG.

The transfer signals TRX and TRG, the reset signal RST, the discharge signal OFG, and the select signal SEL are supplied from the vertical driving circuit 34 via the pixel driving wiring 40.

An operation of the pixel 32 will be described in brief.

First, when the discharge signal OFG with a high level is supplied to the discharge transistors 59 before start of exposure, the discharge transistors 59 are turned on, the charges accumulated in the photodiodes 51 are discharged to the constant voltage source VDD, and the photodiodes 51 of all of the pixels are reset.

When the discharge transistors 59 are turned off by the discharge signal OFG with a low level after the reset of the photodiodes 51, exposure starts in all of the pixels of the pixel array unit 33.

When a predetermined exposure time decided in advance passes, the first transfer transistors 52 are turned on by the transfer signal TRX in all of the pixels of the pixel array unit 33, and the charges accumulated in the photodiodes 51 are transferred to the memory portions 53.

After the first transfer transistors 52 are turned off, the charges retained in the memory portions 53 of the pixels 32 are sequentially read to the column signal processing circuits 35 in units of rows. In the reading operation, the second transfer transistors 54 of the pixels 32 in the read rows are turned on by the transfer signal TRG and the charges retained in the memory portions 53 are transferred to the FDs 55. Then, when the select transistors 58 are turned on by the select signal SEL, signals indicating the level according to the charges accumulated in the FDs 55 are output from the amplification transistors 57 to the column signal processing circuits 35 via the select transistors 58.

As described above, the pixels 32 including the pixel circuit in Fig. 4 can perform an operation (imaging) according to a global shutter scheme of setting the same exposure time in all of the pixels of the pixel array unit 33, temporarily retaining the charges in the memory portions 53 after the end of the exposure, and sequentially reading the charges from the memory portions 53 in units of rows.

The circuit configuration of the pixel 32 is not limited to the configuration illustrated in Fig. 4. For example, a circuit configuration in which an operation is performed according to a so-called rolling shutter scheme without including the memory portion 53 can also be adopted.

### <2. First Basic Structure Example of Solid-state Imaging Device>

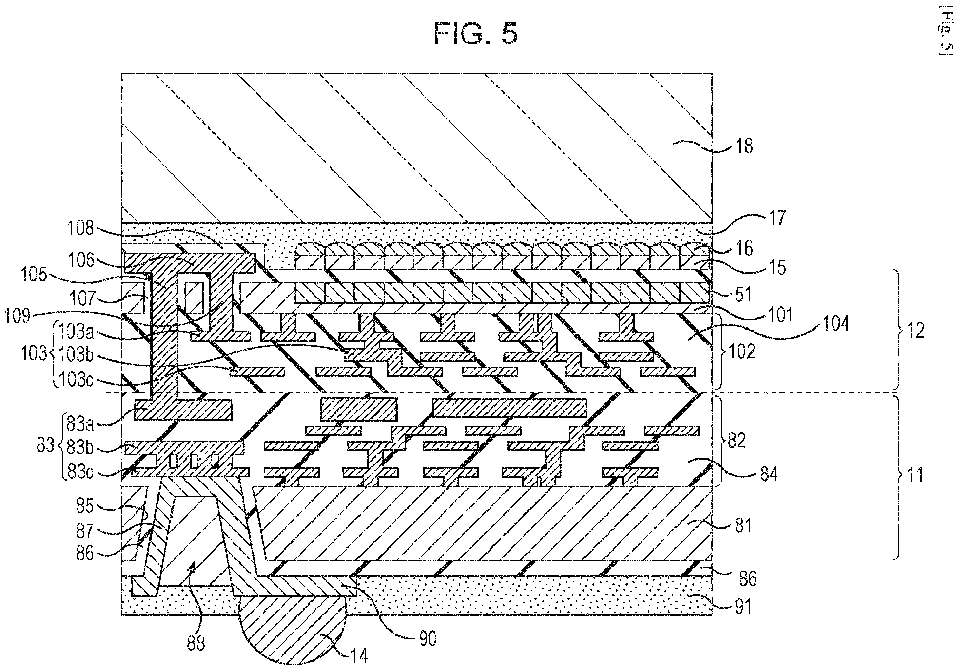

Next, the detailed configuration of the laminated substrate 13 will be described with reference to Fig. 5. Fig. 5 is a sectional view enlarging a part of the solid-state imaging device 1.

In the logic substrate 11, a multi-layer wiring layer 82 is formed on the upper side (the side of the pixel sensor substrate 12) of a semiconductor substrate 81 (hereinafter referred to as a silicon substrate 81) formed of, for example, silicon (Si). The control circuit 22 and the logic circuit 23 in Fig. 2 are formed by the multi-layer wiring layer 82.

The multi-layer wiring layer 82 includes a plurality of wiring layers 83 including an uppermost wiring layer 83a closest to the pixel sensor substrate 12, an intermediate wiring layer 83b, and a lowermost wiring layer 83c closest to the silicon substrate 81 and inter-layer insulation films 84 formed between the respective wiring layers 83.

The plurality of wiring layers 83 are formed of, for example, copper (Cu), aluminum (Al), or tungsten (W) and the inter-layer insulation films 84 are formed of, for example, a silicon oxide film or a silicon nitride film. In each of the plurality of wiring layers 83 and the inter-layer insulation films 84, the same material may be used in all of the layers or two or more material may be used in the layers.

At predetermined positions of the silicon substrate 81, a silicon through hole 85 penetrating through the silicon substrate 81 is formed and a silicon through electrode (TSV: Through Silicon Via) 88 is formed by embedding a connection conductor 87 on the inner wall of the silicon through hole 85 with an insulation film 86 interposed therebetween. The insulation film 86 can be formed of, for example, a SiO₂ film or a SiN film.

The insulation film 86 and the connection conductor 87 are formed along the inner wall surface of the silicon through electrode 88 illustrated in Fig. 5 so that the inside of the silicon through hole 85 is hollow. However, the entire inside of the silicon through hole 85 is embedded into the connection conductor 87 depending on the inner diameter. In other words, the inside of the through hole may be embedded with a conductor or a part thereof may be hollow. The same also applies to a chip through electrode (TCV: Through Chip Via) 105 or the like to be described below.

The connection conductor 87 of the silicon through electrode 88 is connected to a rewiring 90 formed on the lower surface side of the silicon substrate 81 and the rewiring 90 is connected to a solder ball 14. The connection conductor 87 and the rewiring 90 can be formed of, for example, copper (Cu), tungsten (W), titanium (Ti), tantalum (Ta), a titanium tungsten alloy (TiW), or a poly silicon.

On the lower surface side of the silicon substrate 81, a solder mask (solder resist) 91 is formed to cover the rewiring 90 and the insulation film 86 excluding a region in which the solder ball 14 is formed.

On the other hand, in the pixel sensor substrate 12, a multi-layer wiring layer 102 is formed on the lower side (the side of the logic substrate 11) of a semiconductor substrate 101 (hereinafter referred to as a silicon substrate 101) formed of a silicon (Si). The pixel circuit of the pixel region 21 in Fig. 2 is formed by the multi-layer wiring layer 102.

The multi-layer wiring layer 102 includes a plurality of wiring layers 103 including an uppermost-layer wiring layer 103a closest to the silicon substrate 101, an intermediate wiring layer 103b, and a lowermost wiring layer 103c closest to the logic substrate 11 and inter-layer insulation films 104 formed between the respective wiring layers 103.

The same kinds of materials of the wiring layers 83 and the inter-layer insulation films 84 described above can be adopted as materials used in the plurality of wiring layers 103 and the inter-layer insulation films 104. The fact that one material or two or more materials may be used to form the plurality of wiring layers 103 or the inter-layer insulation films 104 is the same in the wiring layers 83 and the inter-layer insulation films 84 described above.

In the example of Fig. 5, the multi-layer wiring layer 102 of the pixel sensor substrate 12 includes three layers of the wiring layers 103 and the multi-layer wiring layer 82 of the logic substrate 11 includes four layers of the wiring layers 83. However, the number of wiring layers is not limited thereto. Any number of layers can be formed.

In the silicon substrate 101, the photodiode 51 formed by a PN junction is formed in each pixel 32.

Although not illustrated, the plurality of pixel transistors such as the first transfer transistors 52 and the second transfer transistors 54, the memory portions (MEM) 53, or the like are formed in the multi-layer wiring layer 102 and the silicon substrate 101.

A silicon through electrode 109 connected to the wiring layer 103a of the pixel sensor substrate 12 and a chip through electrode 105 connected to the wiring layer 83a of the logic substrate 11 are formed at predetermined positions of the silicon substrate 101 in which the color filter 15 and the on-chip lens 16 are not formed.

The chip through electrode 105 and the silicon through electrode 109 are connected to a connection wiring 106 formed in the upper surface of the silicon substrate 101. An insulation film 107 is formed between the silicon substrate 101 and each of the silicon through electrode 109 and the chip through electrode 105. Further, the color filter 15 or the on-chip lens 16 is formed on the upper surface of the silicon substrate 101 with an insulation film (planarization film) 108 interposed therebetween.

As described above, the laminated substrate 13 of the solid-state imaging device 1 illustrated in Fig. 1 has a laminated structure in which the side of the multi-layer wiring layer 82 of the logic substrate 11 and the side of the multi-layer wiring layer 102 of the pixel sensor substrate 12 are bonded to each other. In Fig. 5, a pasted surface between the multi-layer wiring layer 82 of the logic substrate 11 and the multi-layer wiring layer 102 of the pixel sensor substrate 12 is indicated by a dashed line.

In the laminated substrate 13 of the solid-state imaging device 1, the wiring layer 103 of the pixel sensor substrate 12 and the wiring layer 83 of the logic substrate 11 are connected by two through electrodes, i.e., the silicon through electrode 109 and the chip through electrode 105, and the wiring layer 83 and the solder ball (backside electrode) 14 of the logic substrate 11 are connected by the silicon through electrode 88 and the rewiring 90. Thus, the plane area of the solid-state imaging device 1 can be reduced to the utmost minimum.

The laminated substrate 13 and the glass protective substrate 18 are pasted to each other by the glass seal resin 17 so that the cavityless structure is formed, and thus the solid-state imaging device can also be lowered in the height direction.

Accordingly, the solid-state imaging device 1 illustrated in Fig. 1, i.e., the further downsized semiconductor device (semiconductor package), can be realized.

### <3. First to Ninth Modification Structure Examples of Solid-state Imaging Device>

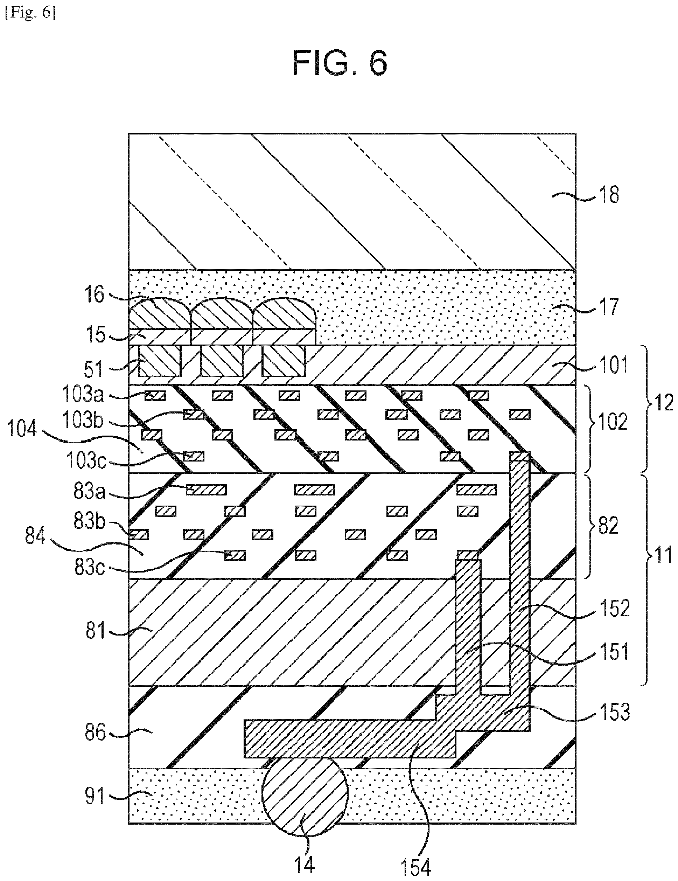

Next, other examples of the inner structure of the laminated substrate 13 of the solid-state imaging device 1 will be described with reference to Figs. 6 to 14.

In Figs. 6 to 14, the same reference numerals are given to portions corresponding to the portions in the structure illustrated in Fig. 5 and the description thereof will be appropriately omitted. Portions different from the portions of the structure illustrated in Fig. 5 will be described by comparing to the structure described above. Hereinafter, the structure illustrated in Fig. 5 is referred to as a basic structure. In Figs. 6 to 14, for example, parts of the structure illustrated in Fig. 5, such as the insulation film 86, the insulation film 107, and the insulation film 108, are not illustrated for simplicity in some cases.

### <First Modification Example>

Fig. 6 is a diagram illustrating the laminated substrate 13 of the solid-state imaging device 1 according to a first modification example.

In the basic structure of Fig. 5, the logic substrate 11 and the pixel sensor substrate 12 are connected on the side of the pixel sensor substrate 12 of the upper side using two through electrodes, i.e., the silicon through electrode 109 and the chip through electrode 105.

In contrast, in the first modification example of Fig. 6, the logic substrate 11 and the pixel sensor substrate 12 are connected on the side of the logic substrate 11 of the lower side using two through electrodes, i.e., a silicon through electrode 151 and a chip through electrode 152.

More specifically, the silicon through electrode 151 connected to the wiring layer 83c of the logic substrate 11 and the chip through electrode 152 connected to the wiring layer 103c of the pixel sensor substrate 12 are formed at predetermined positions of the silicon substrate 81 on the side of the logic substrate 11. The silicon through electrode 151 and the chip through electrode 152 are insulated from the silicon substrate 81 by insulation films (not illustrated).

The silicon through electrode 151 and the chip through electrode 152 are connected to a connection wiring 153 formed on the lower surface of the silicon substrate 81. The connection wiring 153 is also connected to a rewiring 154 connected to the solder ball 14.

In the first modification example described above, since the laminated structure of the logic substrate 11 and the pixel sensor substrate 12 is adopted, the package size of the solid-state imaging device 1 can be downsized.

In the first modification example, the connection wiring 153 electrically connecting the logic substrate 11 to the pixel sensor substrate 12 is formed not on the upper side of the silicon substrate 101 of the pixel sensor substrate 12 but on the lower side of the silicon substrate 81 of the logic substrate 11. Thus, since the space (thickness) between the glass protective substrate 18 and the laminated substrate 13 with the cavityless structure can be minimized, the low back of the solid-state imaging device 1 can be achieved.

### <Second Modification Example>

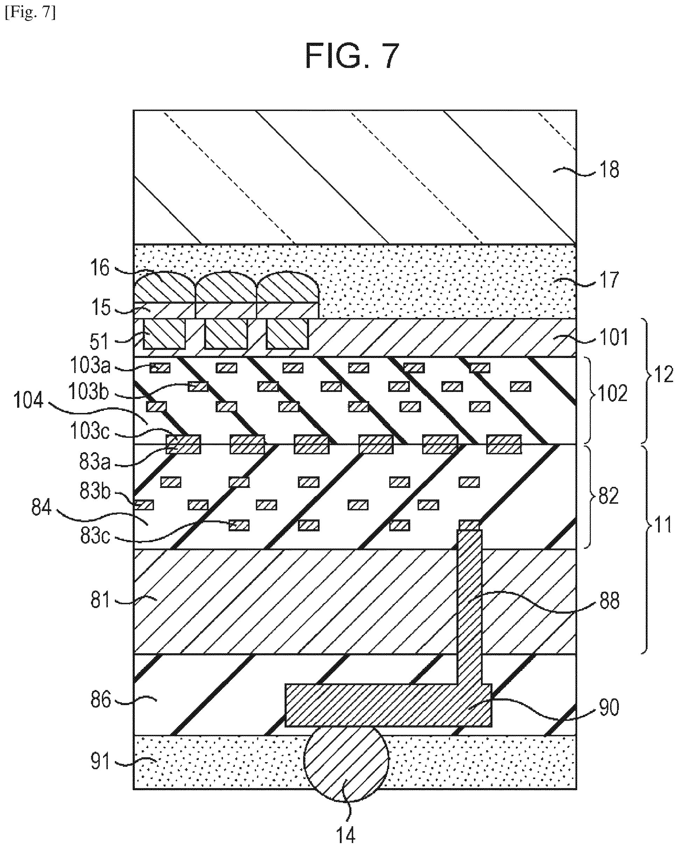

Fig. 7 is a diagram illustrating the laminated substrate 13 of the solid-state imaging device 1 according to a second modification example.

In the second modification example, the logic substrate 11 and the pixel sensor substrate 12 are connected by metal bond of wiring layers.

More specifically, the uppermost wiring layer 83a in the multi-layer wiring layer 82 of the logic substrate 11 and the lowermost wiring layer 103c in the multi-layer wiring layer 102 of the pixel sensor substrate 12 are connected by the metal bond. For example, copper (Cu) is suitable for the materials of the wiring layer 83a and the wiring layer 103c. In the example of Fig. 7, the wiring layer 83a and the wiring layer 103c are formed on only a part of the bonded surface of the logic substrate 11 and the pixel sensor substrate 12. However, a metal (copper) layer may be formed as a bonding wiring layer on the entire surface of the bonded surface.

In Fig. 7, the diagram is simply illustrated for comparison with Fig. 5. However, the wiring layer 83 and the solder ball 14 in the logic substrate 11 are connected by the silicon through electrode 88 and the rewiring 90 as in the basic structure of Fig. 5.

### <Third Modification Example>

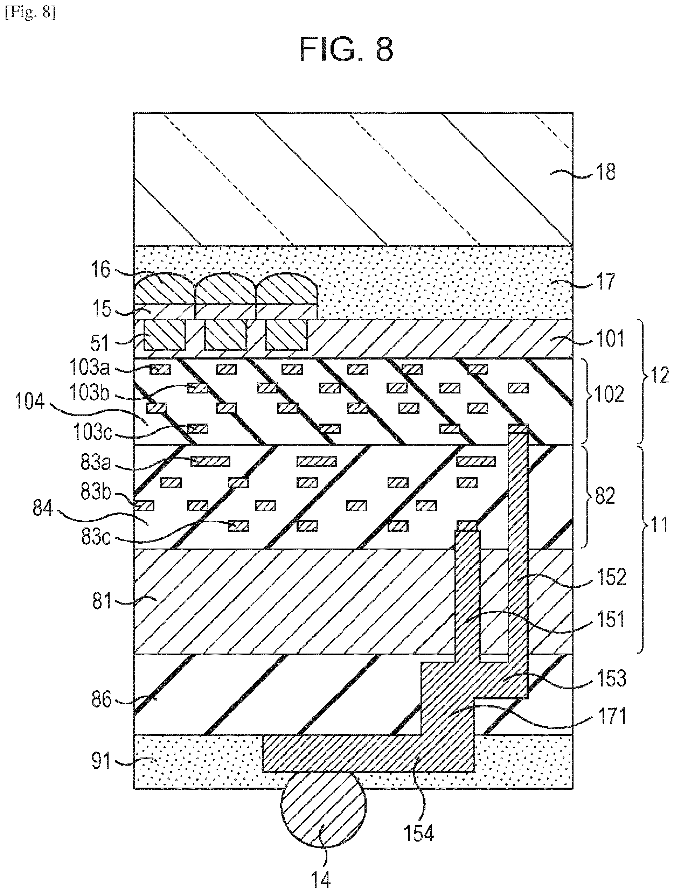

Fig. 8 is a diagram illustrating the laminated substrate 13 of the solid-state imaging device 1 according to a third modification example.

In the third modification example, a method of connecting the logic substrate 11 to the pixel sensor substrate 12 is the same as the method of the first modification example described in Fig. 6. That is, the logic substrate 11 and the pixel sensor substrate 12 are connected by the silicon through electrode 151, the chip through electrode 152, and the connection wiring 153.

The third modification example is different from the first modification example in that a connection conductor 171 is formed in a depth direction between the rewiring 154 connected to the solder ball 14 and the connection wiring 153 connecting the silicon through electrode 151 to the chip through electrode 152. The connection conductor 171 connects the connection wiring 153 to the rewiring 154.

### <Fourth Modification Example>

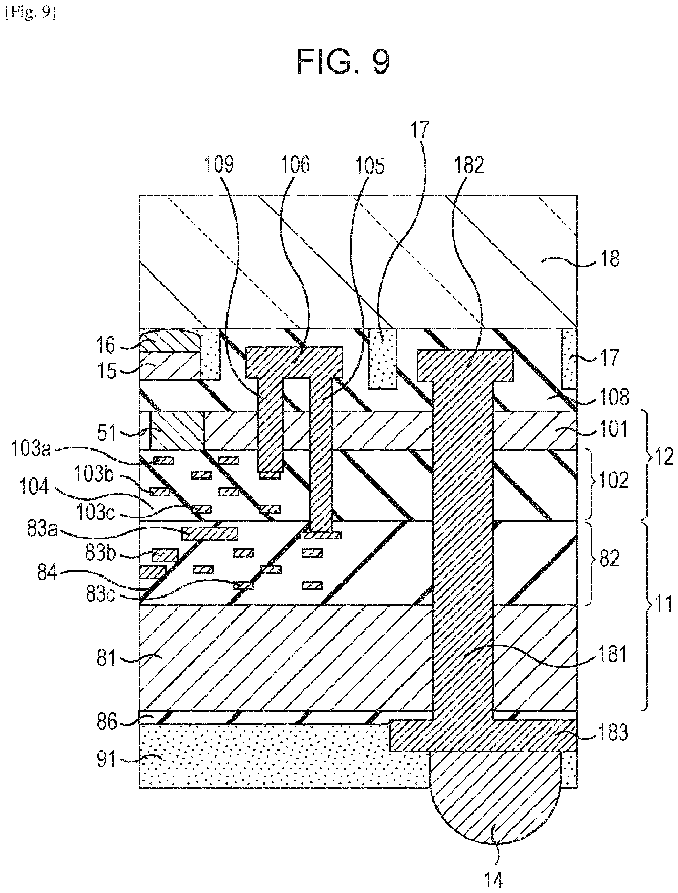

Fig. 9 is a diagram illustrating the laminated substrate 13 of the solid-state imaging device 1 according to a fourth modification example.

In the fourth modification example, a method of connecting the logic substrate 11 to the pixel sensor substrate 12 is the same as the method of the basic structure illustrated in Fig. 5. That is, the logic substrate 11 and the pixel sensor substrate 12 are connected to the upper side of the pixel sensor substrate 12 by using the connection wiring 106 and the two through electrodes, i.e., the silicon through electrode 109 and the chip through electrode 105.

The solder ball 14 of the lower side of the solid-state imaging device 1, and the plurality of wiring layers 83 of the logic substrate 11 and the plurality of wiring layers 103 of the pixel sensor substrate 12 are connected by a chip through electrode 181 penetrating through the logic substrate 11 and the pixel sensor substrate 12.

More specifically, the chip through electrode 181 penetrating through the logic substrate 11 and the pixel sensor substrate 12 is formed at a predetermined position of the laminated substrate 13. The chip through electrode 181 is connected to the wiring layer 103 of the pixel sensor substrate 12 via a connection wiring 182 formed in the upper surface of the silicon substrate 101 of the pixel sensor substrate 12. Further, the chip through electrode 181 is also connected to a rewiring 183 formed on the lower surface of the silicon substrate 81 of the logic substrate 11 of the lower side, and thus is connected to the solder ball 14 via the rewiring 183.

### <Fifth Modification Example>

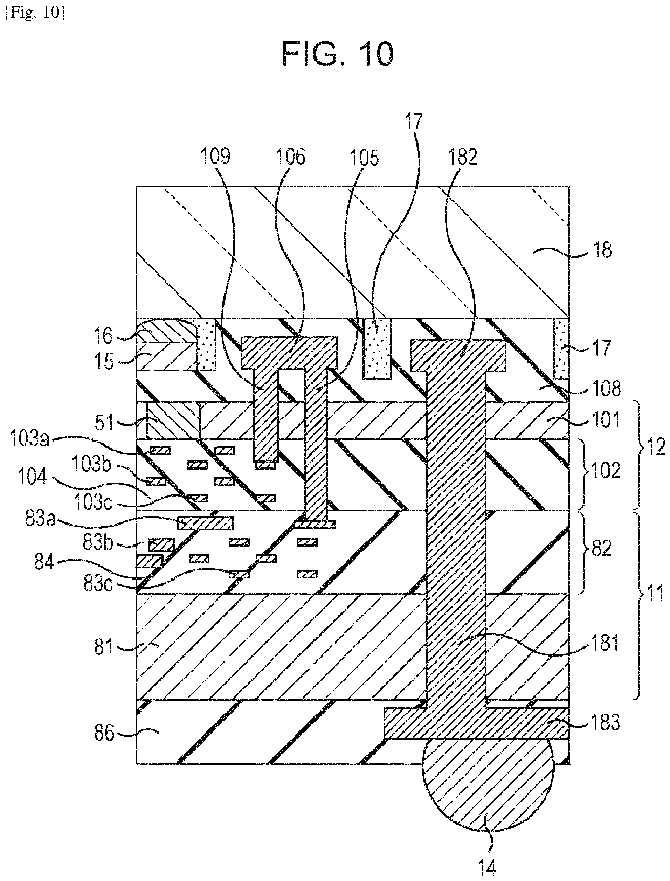

Fig. 10 is a diagram illustrating the laminated substrate 13 of the solid-state imaging device 1 according to a fifth modification example.

In the fifth modification example of Fig. 10, a method of connecting the logic substrate 11 to the pixel sensor substrate 12 and a method of connecting the lower side of the solid-state imaging device 1 to the solder ball 14 are the same as the methods of the fourth modification example described in Fig. 9.

In the fifth modification example, however, the structure of the lower side of the silicon substrate 81 of the logic substrate 11 is different from the structure of the fourth modification example of Fig. 9.

Specifically, in the fourth modification example described in Fig. 9, the lower surface of the silicon substrate 81 of the logic substrate 11 is covered with the insulation film 86, and then a solder mask (solder resist) 91 is formed.

In the fifth modification example of Fig. 10, however, the lower surface of the silicon substrate 81 of the logic substrate 11 is covered with only the thick insulation film 86. The insulation film 86 can include a SiO₂ film and a SiN film formed by, for example, a plasma chemical vapor deposition (CVD) method.

### <Sixth Modification Example>

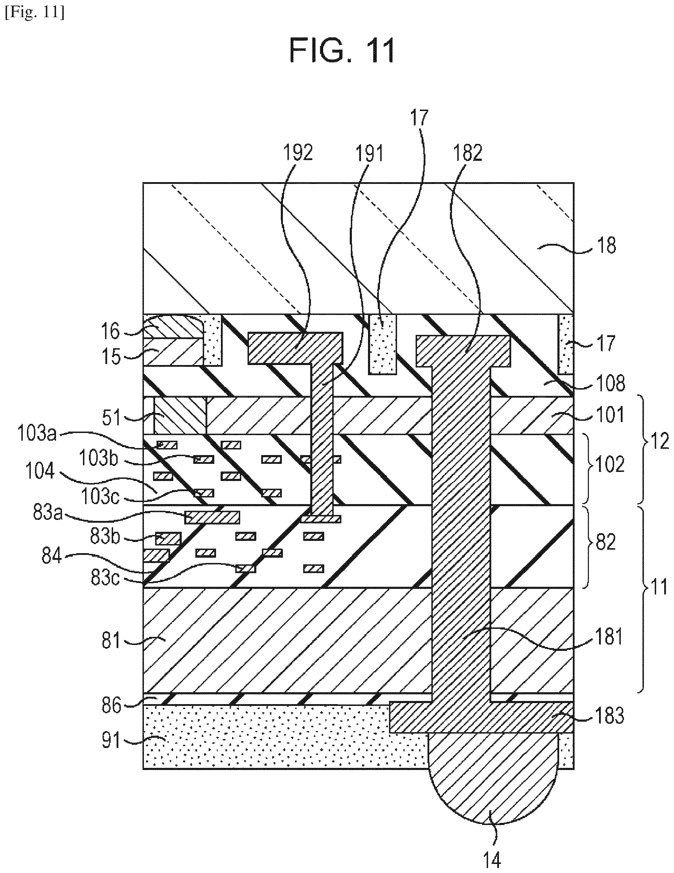

Fig. 11 is a diagram illustrating the laminated substrate 13 of the solid-state imaging device 1 according to a sixth modification example.

In the sixth modification example of Fig. 11, a connection method for the solder ball 14 is the same as the methods of the fourth modification example (Fig. 9) and the fifth modification example (Fig. 10) described above. That is, the solder ball 14 is connected to the wiring layer 83 of the logic substrate 11 and the wiring layer 103 of the pixel sensor substrate 12 by the chip through electrode 181 penetrating through the logic substrate 11 and the pixel sensor substrate 12.

In the sixth modification example, however, a method of connecting the logic substrate 11 to the pixel sensor substrate 12 is different from the methods of the fourth modification example (Fig. 9) and the fifth modification example (Fig. 10).

Specifically, in the sixth modification example, one chip through electrode 191 is formed from the connection wiring 192 formed on the upper side of the silicon substrate 101 of the pixel sensor substrate 12 to the wiring layer 83a of the logic substrate 11 to penetrate through the pixel sensor substrate 12. The chip through electrode 191 is also connected to the wiring layer 103b of the pixel sensor substrate 12.

Thus, in the sixth modification example, the one chip through electrode 191 is configured to share the connection with the wiring layer 83 of the logic substrate 11 and the connection with the wiring layer 103 of the pixel sensor substrate 12.

### <Seventh Modification Example>

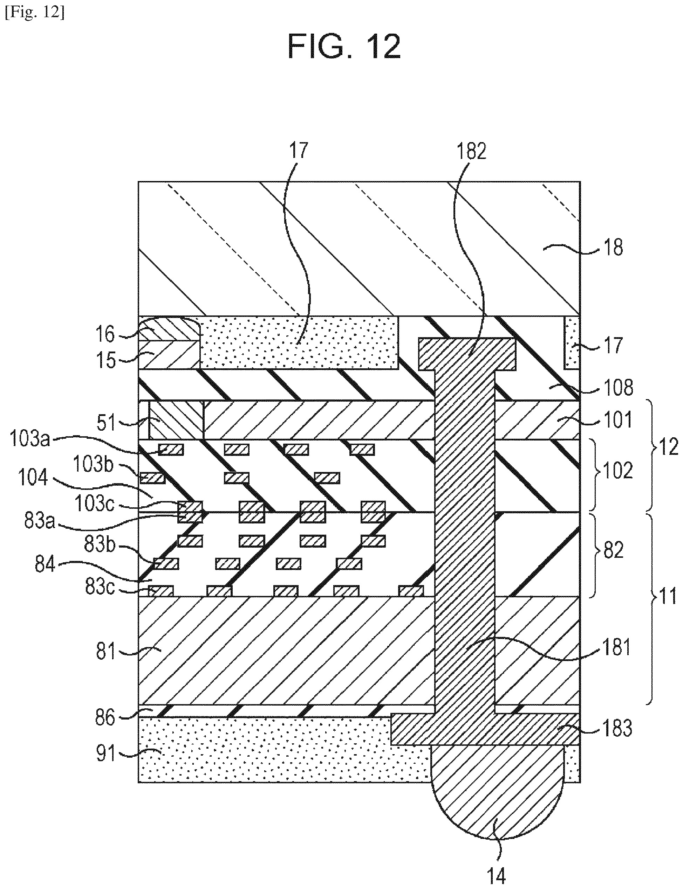

Fig. 12 is a diagram illustrating the laminated substrate 13 of the solid-state imaging device 1 according to a seventh modification example.

In the seventh modification example of Fig. 12, a connection method for the solder ball 14 on the lower side of the solid-state imaging device 1 is the same as the methods of the fourth to sixth modification examples (Figs. 9 to 11). That is, the solder ball 14 of the lower side of the solid-state imaging device 1, and the wiring layer 83 of the logic substrate 11 and the wiring layer 103 of the pixel sensor substrate 12 are connected by the chip through electrode 181 penetrating through the logic substrate 11 and the pixel sensor substrate 12.

In the seventh modification example, however, a method of connecting the logic substrate 11 to the pixel sensor substrate 12 is different from the methods of the fourth to sixth modification examples (Figs. 9 to 11).

More specifically, in the seventh modification example, the uppermost wiring layer 83a of the logic substrate 11 and the lowermost wiring layer 103c of the pixel sensor substrate 12 are connected by metal bond. For example, copper (Cu) is used as the materials of the wiring layer 83a and the wiring layer 103c. In the example of Fig. 12, the wiring layer 83a and the wiring layer 103c are formed on only a part of the bonded surface of the logic substrate 11 and the pixel sensor substrate 12. However, a metal (copper) layer may be formed as a bonding wiring layer on the entire surface of the bonded surface.

### <Eighth Modification Example>

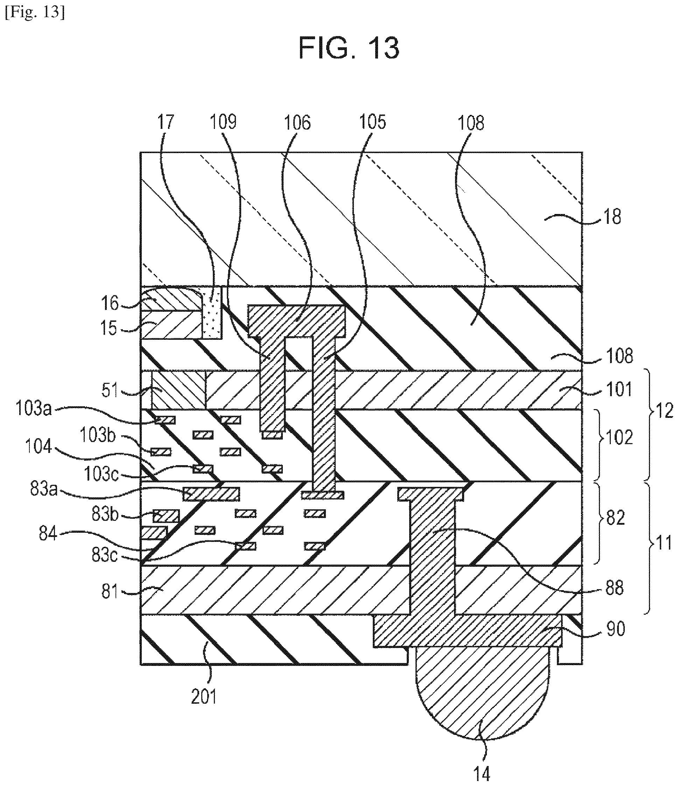

Fig. 13 is a diagram illustrating the laminated substrate 13 of the solid-state imaging device 1 according to an eighth modification example.

In the eighth modification example, an insulation film 201 formed on the lower surface of the silicon substrate 81 of the logic substrate 11 differs compared to the basic structure of Fig. 5.

In the eighth modification example, an inorganic film formed at a high temperature equal to or greater than 250 degrees and equal to or less than 400 degrees which does not affect the wiring layer 83 and the like is formed as the insulation film 201 on the lower surface of the silicon substrate 81 of the logic substrate 11. For example, a plasma TEOS film, a plasma SiN film, a plasma SiO₂ film, a CVD-SiN film, or a CVD-SiO₂ film can be formed as the insulation film 201.

For example, when an organic material is used to form the insulation film 201 and a low-temperature insulation film is used, there is a concern that deterioration of reliability through poor humidity resistance, erosion, or ion migration may occur. However, an inorganic film has good humidity resistance. Thus, in the structure of the eighth modification example, wiring reliability can be improved by adopting an inorganic film formed as the insulation film 201 at a temperature equal to or less than 400 degrees.

### <Ninth Modification Example>

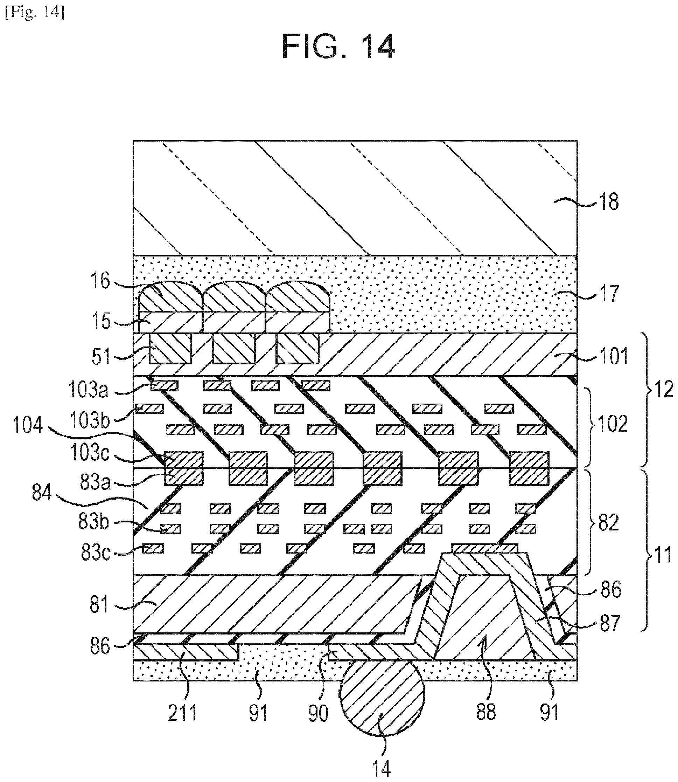

Fig. 14 is a diagram illustrating the laminated substrate 13 of the solid-state imaging device 1 according to a ninth modification example.

In the ninth modification example of Fig. 14, a method of connecting the logic substrate 11 to the pixel sensor substrate 12 is different from the method of the basic structure of Fig. 5.

That is, in the basic structure of Fig. 5, the logic substrate 11 and the pixel sensor substrate 12 are connected by the two through electrodes, i.e., the silicon through electrode 151 and the chip through electrode 152. In the ninth modification example, however, the uppermost wiring layer 83a in the multi-layer wiring layer 82 of the logic substrate 11 and the lowermost wiring layer 103c in the multi-layer wiring layer 102 of the pixel sensor substrate 12 are connected by metal bond (Cu-Cu bonding).

In the ninth modification example, a connection method for the solder ball 14 of the lower side of the solid-state imaging device 1 is the same as the method of the basic structure of Fig. 5. That is, by connecting the silicon through electrode 88 to the lowermost wiring layer 83c of the logic substrate 11, the solder ball 14 is connected to the wiring layer 83 and the wiring layer 103 in the laminated substrate 13.

However, a structure in the ninth modification example is different from the basic structure of Fig. 5 in that a dummy wiring 211 not electrically connected to any portion is formed of the same wiring material as the rewiring 90 in the same layer as the rewiring 90, to which the solder ball 14 is connected, on the side of the lower surface of the silicon substrate 81.

The dummy wiring 211 is formed to reduce the influence of unevenness when the uppermost wiring layer 83a on the side of the logic substrate 11 and the lowermost wiring layer 103c on the side of the pixel sensor substrate 12 are connected by the metal bond (Cu-Cu bonding). That is, when the rewiring 90 is formed only in a partial region of the lower surface of the silicon substrate 81 at the time of performing the Cu-Cu bonding, the unevenness is caused by a difference in the thickness due to presence or absence of the rewiring 90. Accordingly, by providing the dummy wiring 211, it is possible to reduce the influence of the unevenness.

### <4. Second Basic Structure Example of Solid-state Imaging Device>

In the basic structure of the solid-state imaging device 1 and the modification examples described above, the laminated substrate 13 has the laminated structure in which the side of the multi-layer wiring layer 82 of the logic substrate 11 and the side of the multi-layer wiring layer 102 of the pixel sensor substrate 12 are pasted to face each other. The structure in which the wiring layers of both of the substrates face each other is referred to as a face-to-face structure in the present specification.

Next, as another configuration example of the solid-state imaging device 1, a laminated structure in which an opposite surface to the side of the multi-layer wiring layer 82 of the logic substrate 11 is pasted to the side of the multi-layer wiring layer 102 of the pixel sensor substrate 12 to form the laminated substrate 13 will be described below. The structure in which the side of the wiring layer of one substrate is bonded to the opposite surface to the side of the wiring layer of the other substrate is referred to as a face-to-back structure in the present specification.

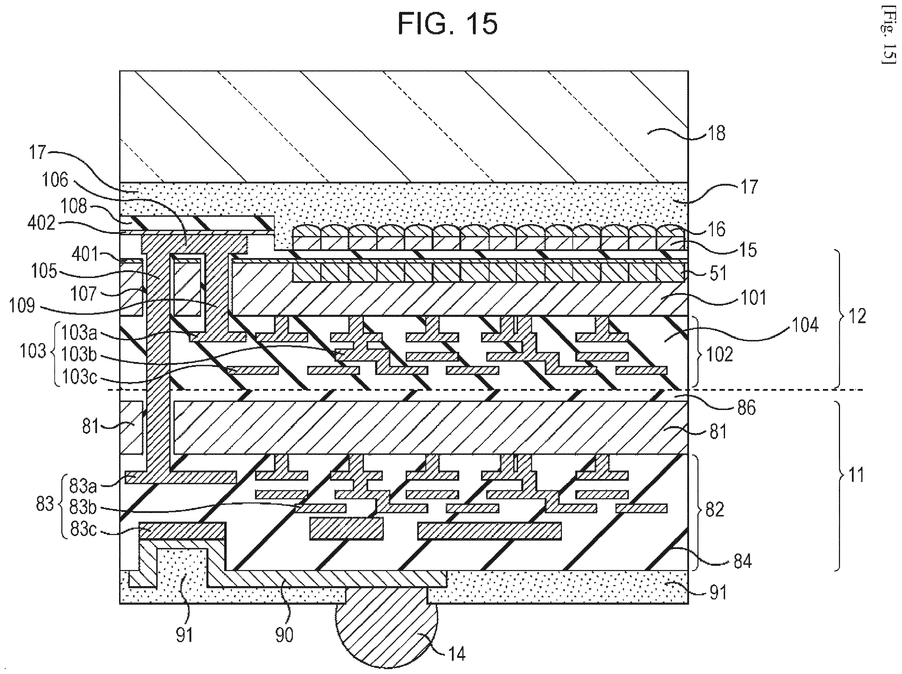

Fig. 15 is a sectional view enlarging a part of the solid-state imaging device 1 of Fig. 5 when the solid-state imaging device 1 is configured to have the face-to-back structure.

Basically, a difference between the face-to-back structure illustrated in Fig. 15 and the face-to-face structure illustrated in Fig. 5 is that the side of the multi-layer wiring layer 82 of the logic substrate 11 is bonded to the side of the multi-layer wiring layer 102 of the pixel sensor substrate 12 or is bonded not to the multi-layer wiring layer 82 but to the opposite side thereto.

Accordingly, in Fig. 15, the same reference numerals are given to portions corresponding to those of Fig. 5 and the detailed structure will not be described and will be described roughly.

In the solid-state imaging device 1 in Fig. 15, the inter-layer insulation film 104 of the multi-layer wiring layer 102 of the pixel sensor substrate 12 and the insulation film 86 of the logic substrate 11 are bonded to each other. In Fig. 15, a pasted surface between the insulation film 86 of the logic substrate 11 and the multi-layer wiring layer 102 of the pixel sensor substrate 12 is indicated by a dashed line.

In the logic substrate 11, the multi-layer wiring layer 82 is formed on the opposite side (lower side in the drawing) to the surface on which the insulation film 86 of the silicon substrate 81 is formed, and for example, the rewiring 90 formed of copper (Cu), the solder ball 14, and the solder mask (solder resist) 91 are formed.

On the other hand, in the pixel sensor substrate 12, the multi-layer wiring layer 102 is formed on the lower side (the side of the logic substrate 11) of the silicon substrate 101 in the drawing and the color filter 15, the on-chip lens 16, and the like are formed on the upper side of the silicon substrate 101 which is the opposite side to the surface on which the multi-layer wiring layer 102 is formed.

In the silicon substrate 101, the photodiode 51 is formed in each pixel.

The wiring layer 103 of the pixel sensor substrate 12 and the wiring layer 83 of the logic substrate 11 are connected by two through electrodes, i.e., the silicon through electrode 109 and the chip through electrode 105.

Fig. 15 is different from Fig. 5 in that a high dielectric film 401 suppressing a dark current is illustrated on the upper surface of the silicon substrate 101 and a cap film 402 formed of a nitride film (SiN) or the like is illustrated on the upper surface of the connection wiring 106 connecting the chip through electrode 105 to the silicon through electrode 109. The high dielectric film 401 and the cap film 402 can be formed in this way even in the face-to-face structure of Fig. 5. Alternatively, in the face-to-back structure of Fig. 15, the high dielectric film 401 and the cap film 402 may be omitted as in the face-to-face structure of Fig. 5.

In the laminated substrate 13 of the solid-state imaging device 1, the wiring layer 103 of the pixel sensor substrate 12 and the wiring layer 83 of the logic substrate 11 are connected by two through electrodes, i.e., the silicon through electrode 109 and the chip through electrode 105, and the connection wiring 106 connecting the two through electrodes to each other. Further, the wiring layer 83 of the logic substrate 11 and the solder ball (backside electrode) 14 are connected by the rewiring 90. Thus, the plane area of the solid-state imaging device 1 can be reduced to the utmost minimum.

The laminated substrate 13 and the glass protective substrate 18 are pasted to each other by the glass seal resin 17 so that the cavityless structure is formed, and thus the solid-state imaging device can also be lowered in the height direction.

Accordingly, the solid-state imaging device 1 having the face-to-back structure, i.e., the further downsized semiconductor device (semiconductor package), can be realized.

### <5. Manufacturing Method for Second Basic Structure>

### <First Method of Manufacturing Solid-state Imaging Device in Fig. 15>

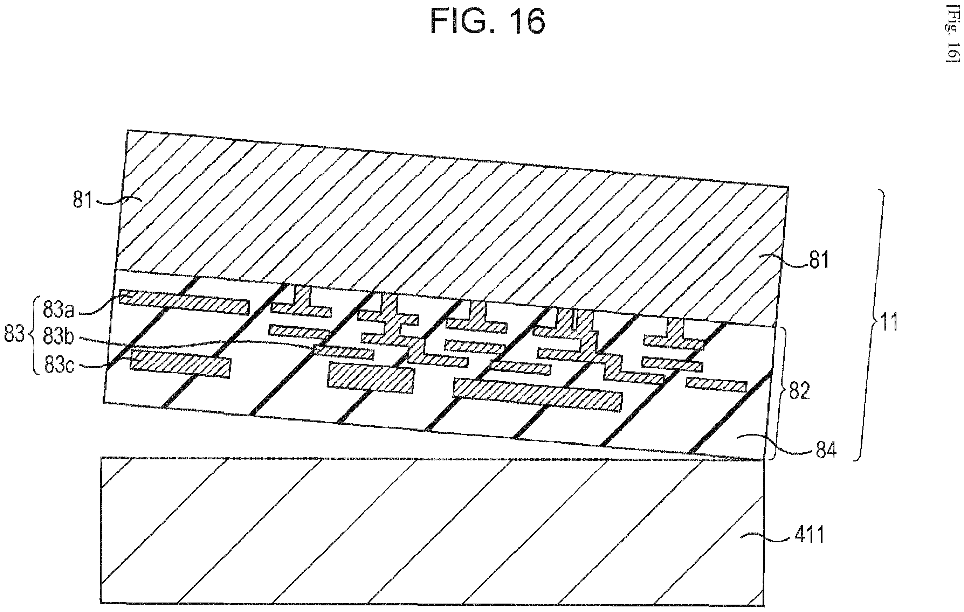

Next, a first method of manufacturing the solid-state imaging device 1 having the face-to-back structure illustrated in Fig. 15 will be described with reference to Figs. 16 to 30.

First, the half-finished logic substrate 11 and the half-finished pixel sensor substrate 12 are separately manufactured.

In the logic substrate 11, the multi-layer wiring layer 82 which becomes the control circuit 22 or the logic circuit 23 is formed in a region which becomes each chip portion of the silicon substrate (silicon wafer) 81. At this time, the silicon substrate 81 has not yet been thinned and has a thickness of, for example, about 600 micrometers.

On the other hand, in the pixel sensor substrate 12, the photodiode 51 and the source/ drain region of the pixel transistor of each pixel 32 are formed in a region which becomes each chip portion of the silicon substrate (silicon wafer) 101. The multi-layer wiring layer 102 forming a part of the control circuit 22 or the like is formed on the surface of the silicon substrate 101 on which the source/drain region of the pixel transistor is formed.

Subsequently, as illustrated in Fig. 16, a provisional bonded substrate (silicon substrate) 411 is pasted as a support substrate to the side of the multi-layer wiring layer 82 of the half-finished logic substrate 11.

Examples of the pasting include plasma bonding and bonding by an adhesive. In the embodiment, plasma bonding is assumed to be performed. In the case of plasma bonding, the logic substrate 11 and the provisional bonded substrate 411 are bonded by forming a plasma TEOS film, a plasma SiN film, a SiON film (block film), a SiC film, or the like on the bonded surface of the logic substrates 11 and the provisional bonded substrate 411, performing plasma processing on the bonded surfaces, superimposing both of the substrates, and then performing an annealing process.

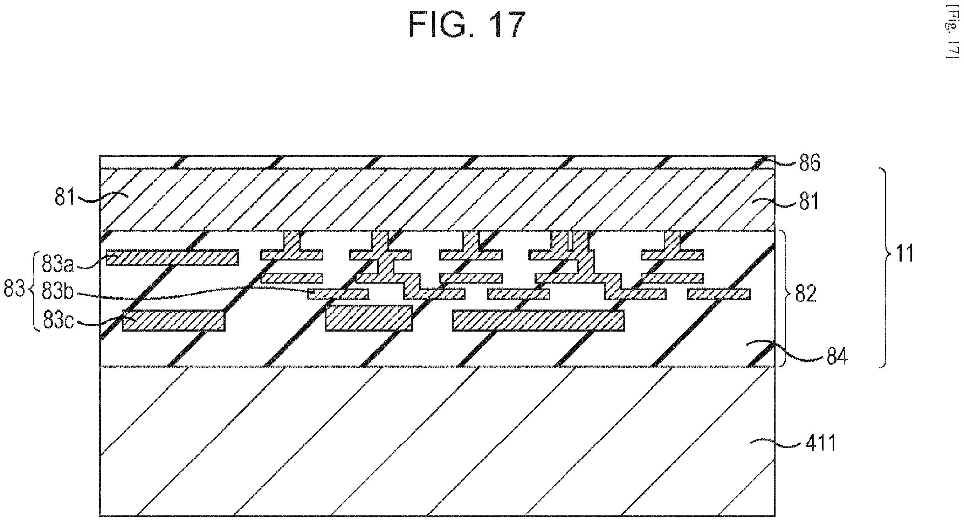

As illustrated in Fig. 17, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

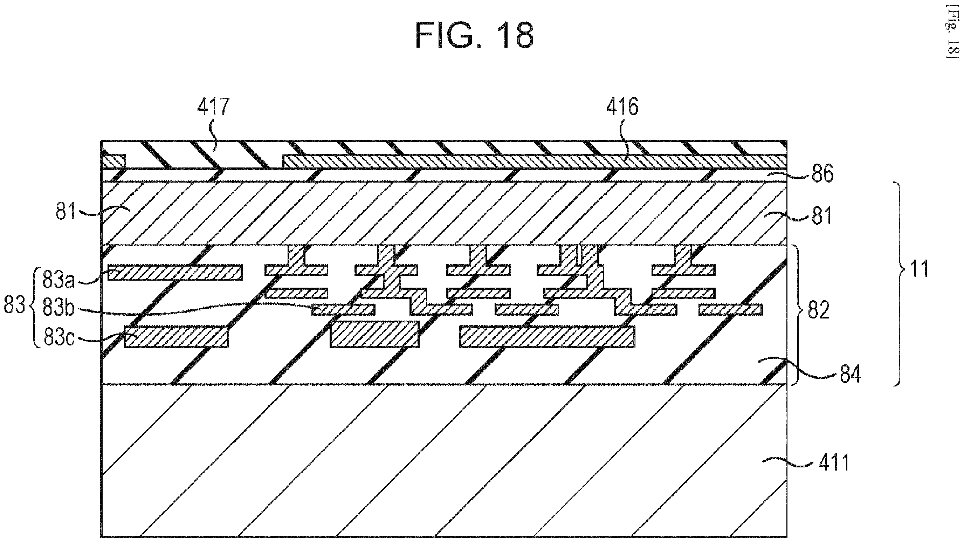

Here, as illustrated in Fig. 18, in order to avoid the influence of hot electrons caused by heating of the logic substrate 11, a light-shielding film 416 formed of metal such as tantalum (Ta), copper (Cu), or titanium (Ti) may be formed on the insulation film 86 and a protective film 417 formed of SiO₂ or the like may be formed on the light-shielding film 416. A region in which the light-shielding film 416 on the surface of the silicon substrate 81 is not formed is regions in which the silicon through electrode 109 and the chip through electrode 105 are formed. It is necessary to flatten the protective film 417 by a chemical mechanical polishing (CMP) method after being formed by a plasma CVD method or the like.

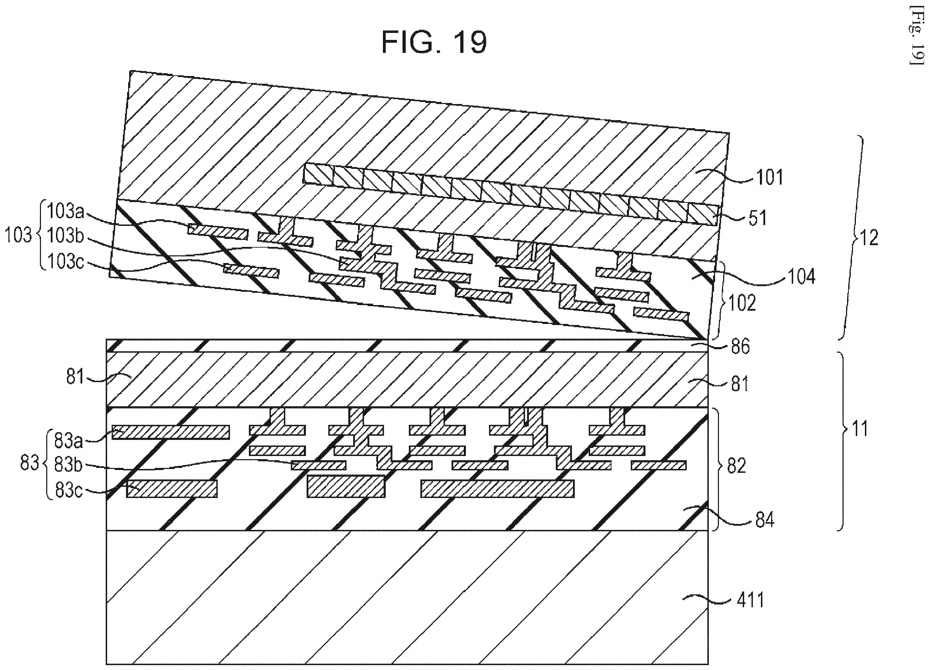

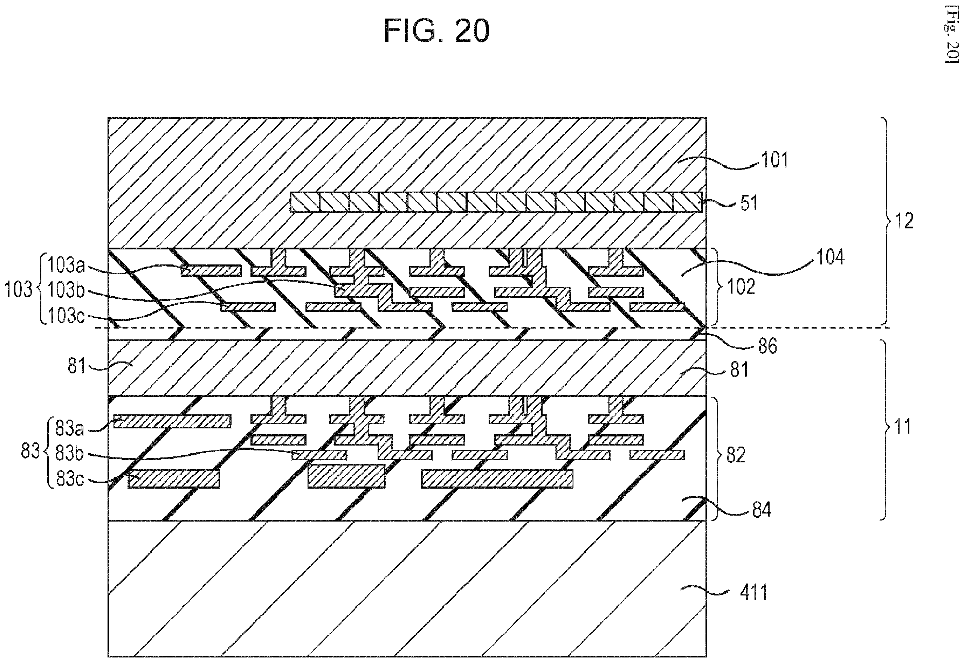

The description will be made below in a case in which the light-shielding film 416 and the protective film 417 are not formed. As illustrated in Fig. 19, the insulation film 86 of the logic substrate 11 and the multi-layer wiring layer 102 of the half-finished pixel sensor substrate 12 partially manufactured are pasted to face each other. Fig. 20 illustrates the pasted state, and a pasted surface is indicated by a dashed line. Examples of the pasting include plasma bonding and bonding by an adhesive. In the embodiment, plasma bonding is assumed to be performed. In the case of plasma bonding, the logic substrate 11 and the pixel sensor substrate 12 are bonded by forming a plasma TEOS film, a plasma SiN film, a SiON film (block film), a SiC film, or the like on the bonded surface of the logic substrates 11 and the pixel sensor substrate 12, performing plasma processing on the bonded surfaces, superimposing both of the substrates, and then performing an annealing process.

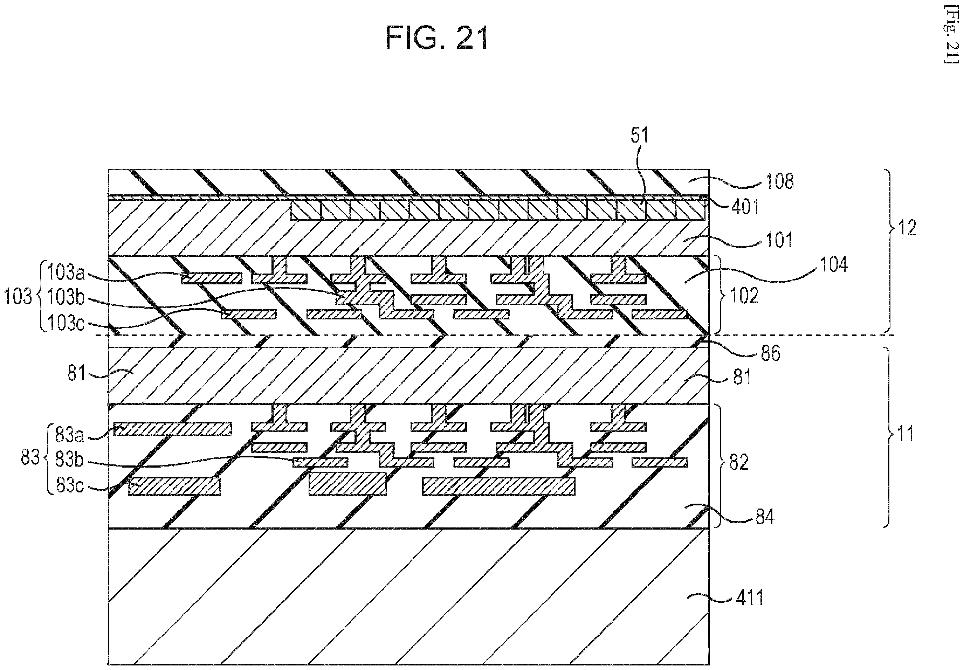

After the logic substrate 11 and the pixel sensor substrate 12 are pasted to each other, as illustrated in Fig. 21, the silicon substrate 101 of the pixel sensor substrate 12 is thinned to the extent of about 1 micrometer to about 10 micrometers. The high dielectric film 401 and the insulation film 108 serving as a sacrifice layer are formed. For example, a SiO₂ film or the like can be used as the insulation film 108.

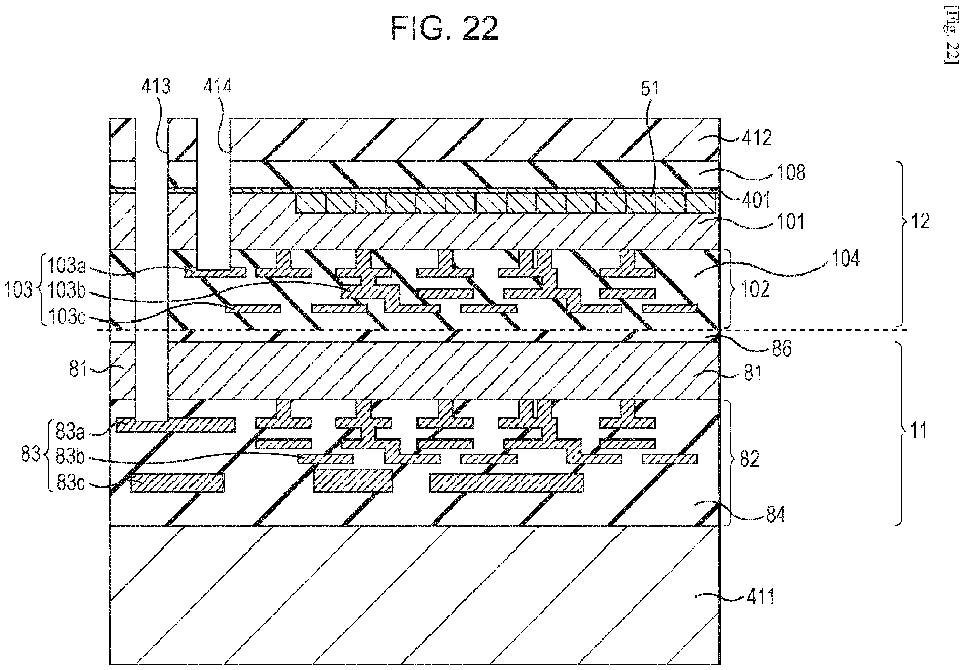

As illustrated in Fig. 22, a resist 412 is applied to the insulation film 108, the resist 412 is patterned in accordance with the regions in which the silicon through electrode 109 and the chip through electrode 105 are formed, and openings 413 and 414 corresponding to the chip through electrode 105 and the silicon through electrode 109 are formed. After the openings 413 and 414 are formed, the resist 412 is peeled off.

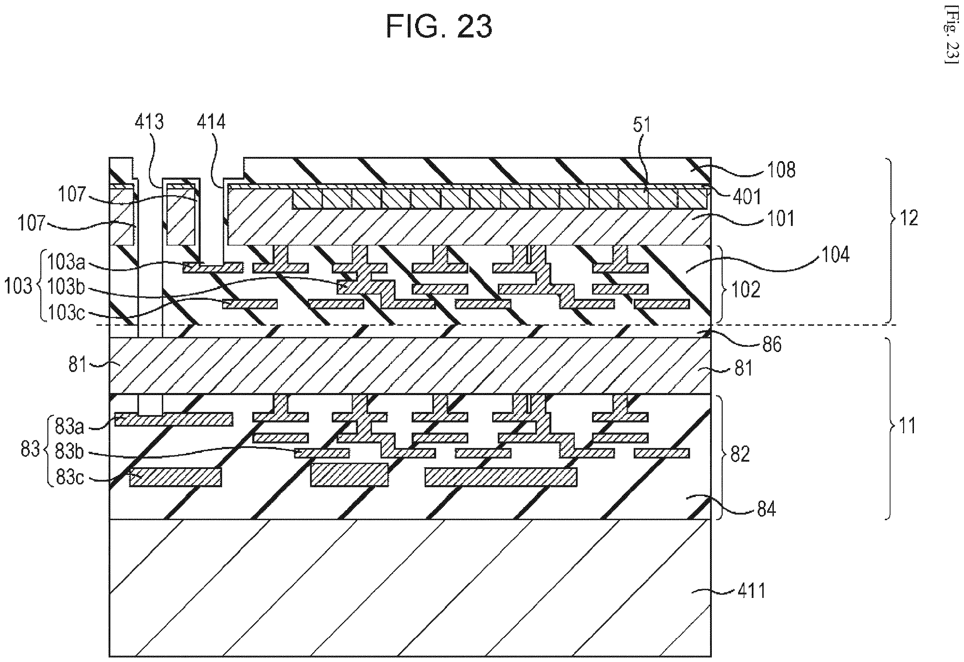

Subsequently, as illustrated in Fig. 23, after insulation films 107 are formed on the inner walls of the openings 413 and 414 by a plasma CVD method, the insulation films 107 of the bottom portions of the openings 413 and 414 are removed by an etch-back method. Thus, the wiring layer 83a of the logic substrate 11 is exposed in the opening 413 and the wiring layer 103a of the pixel sensor substrate 12 is exposed in the opening 414. A part of the insulation film 108 between the openings 413 and 414 is also removed in the etch-back process.

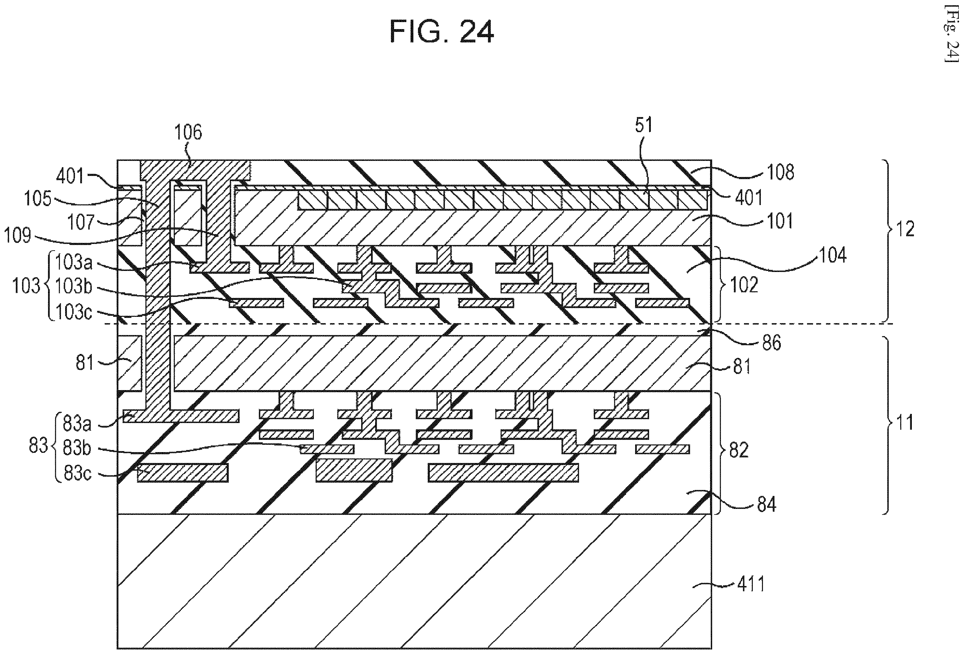

As illustrated in Fig. 24, by embedding copper (Cu) between the openings 413 and 414, the chip through electrode 105, the silicon through electrode 109, and the connection wiring 106 connecting the chip through electrode 105 to the silicon through electrode 109 are formed. As a method of embedding copper (Cu), for example, the following method can be adopted. First, a barrier metal film and a Cu seed layer for electric field plating are formed using a sputtering method and the Cu seed layer is reinforced by an electroless plating method or the like, as necessary. Thereafter, after the openings are filled with copper by an electrolytic plating method, the excess copper is removed by a CMP method, so that the chip through electrode 105, the silicon through electrode 109, and the connection wiring 106 are formed. As the material of the barrier metal film, for example, tantalum (Ta), titanium (Ti), tungsten (W), zirconium (Zr), a nitride film thereof, or a carbonized film thereof can be used. In the embodiment, a titanium film is used as the barrier metal film.

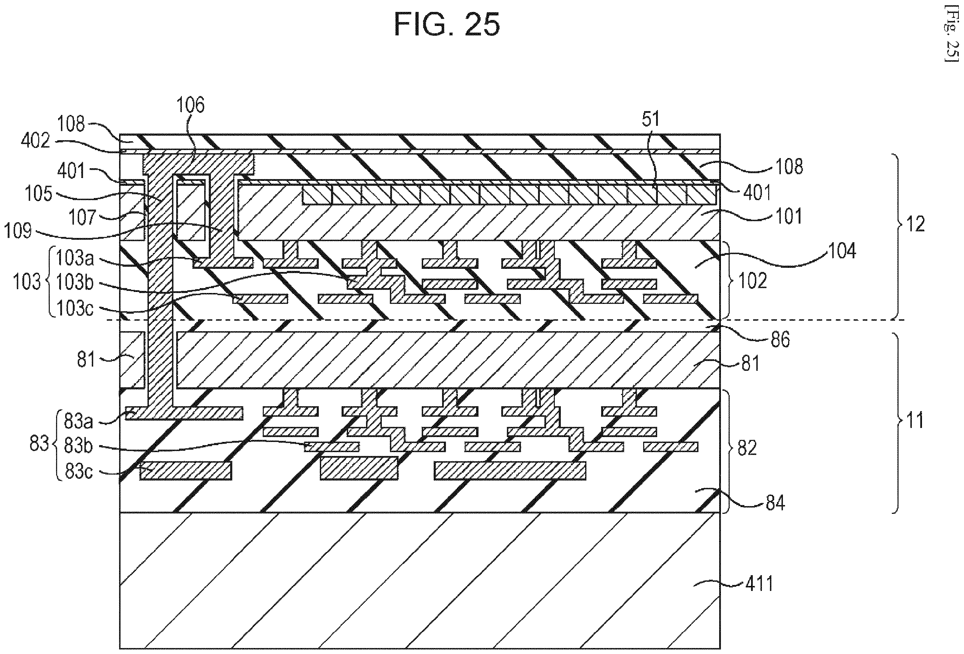

As illustrated in Fig. 25, after the cap film 402 formed of a nitride film (SiN) or the like is formed on the surfaces of the connection wiring 106 and the insulation film 108, the cap film 402 is further covered with the insulation film 108.

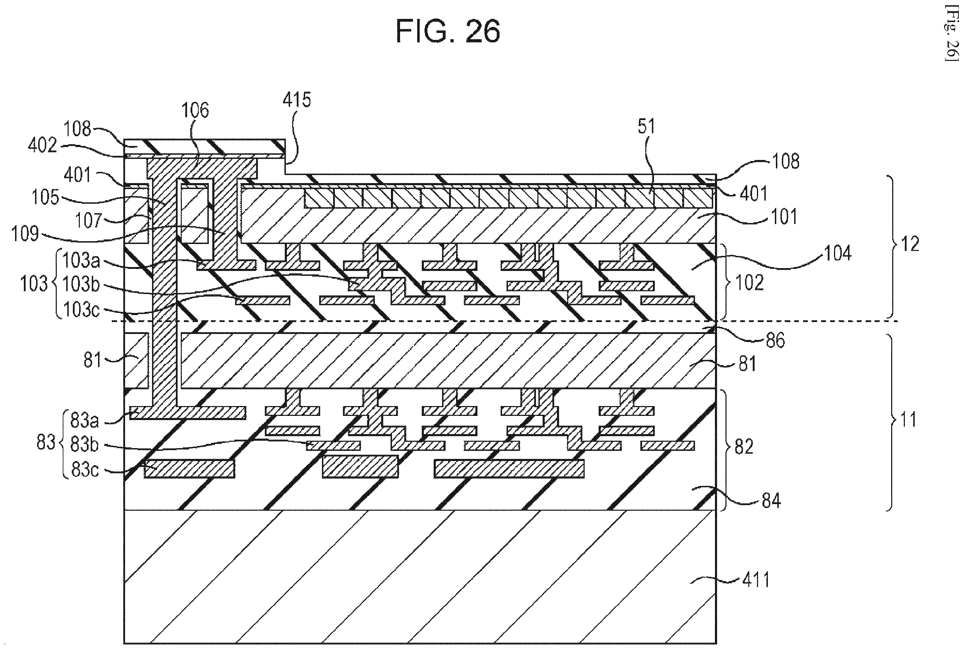

Subsequently, as illustrated in Fig. 26, a cavity 415 is formed by engraving the cap film 402 and the insulation film 108 of the pixel region 21 in which the photodiodes 51 are formed.

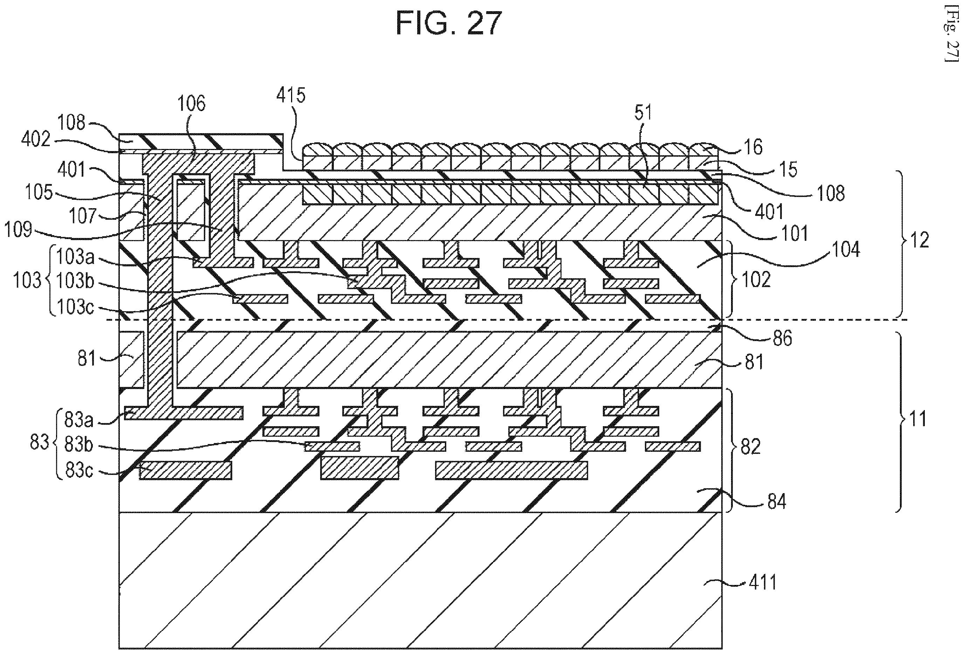

As illustrated in Fig. 27, the color filters 15 and the on-chip lenses 16 are formed in the formed cavity 415.

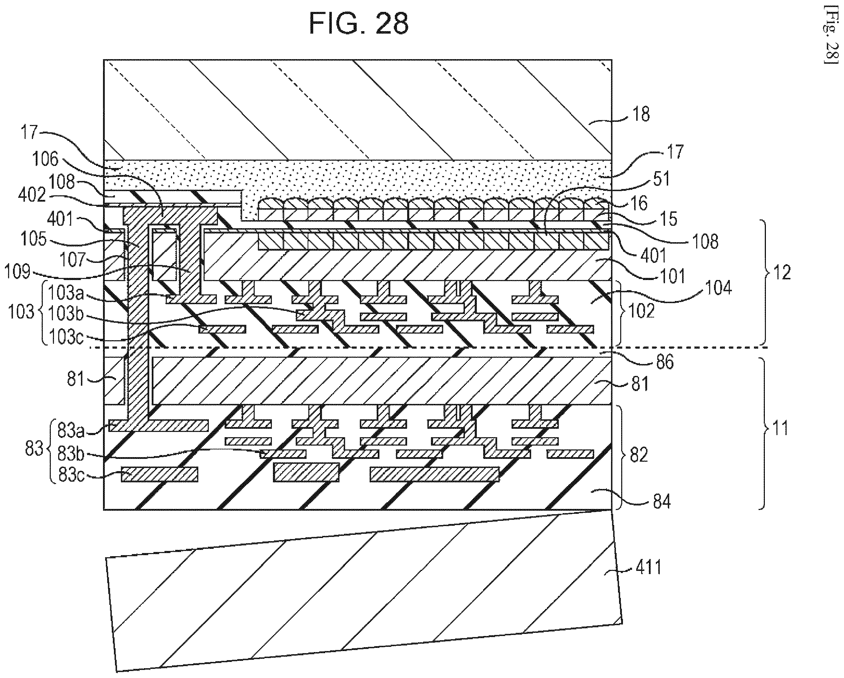

Next, as illustrated in Fig. 28, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 411 is de-bonded (peeled off).

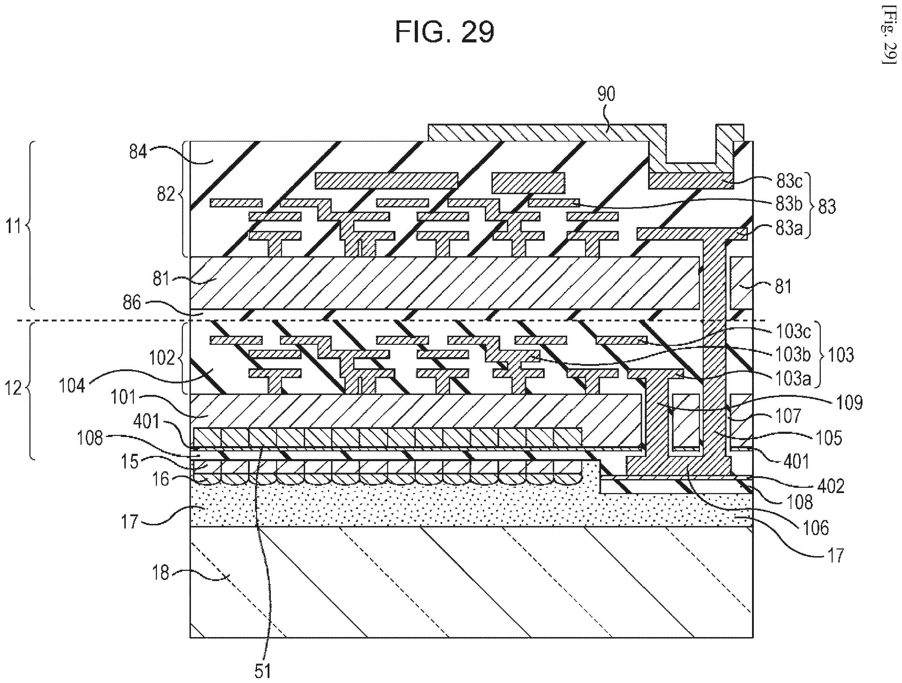

Next, as illustrated in Fig. 29, the logic substrate 11 and the pixel sensor substrate 12 are turned upside down, so that the glass protective substrate 18 serves as the support substrate, a part of the wiring layer 83c closest to the outside of the logic substrate 11 is opened and the rewiring 90 is formed by a semi-additive method.

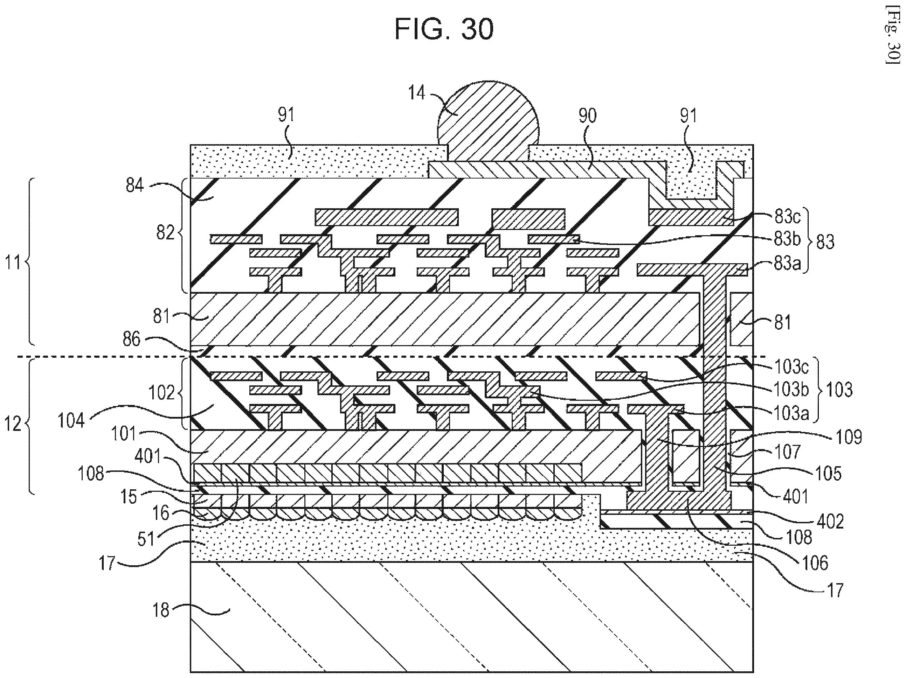

Subsequently, as illustrated in Fig. 30, after a solder mask 91 is formed to protect the rewiring 90, the solder mask 91 in only a region on which the solder ball 14 is mounted is removed, and then the solder ball 14 is formed by a solder ball mounting method or the like.

The solid-state imaging device 1 in Fig. 15 can be manufacturing by the above-described manufacturing method.

### <Second Method of Manufacturing Solid-state Imaging Device in Fig. 15>

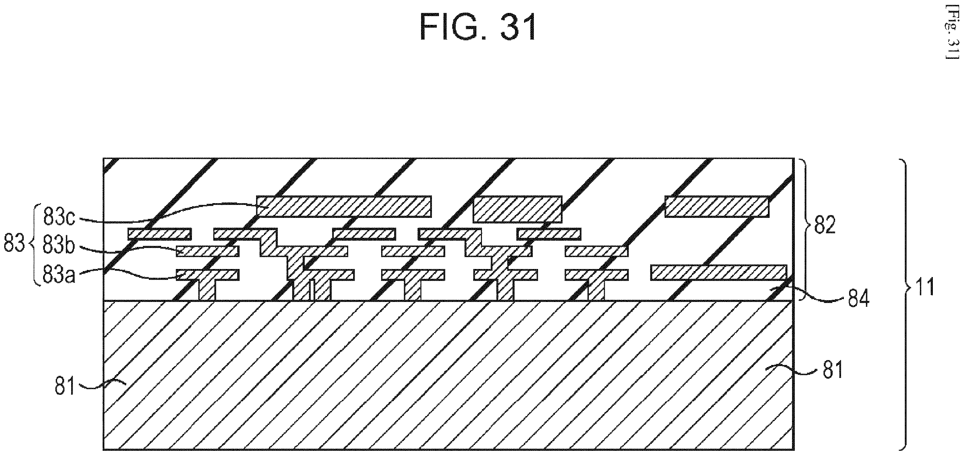

Next, a second method of manufacturing the solid-state imaging device 1 having the face-to-back structure illustrated in Fig. 15 will be described with reference to Figs. 31 to 43.

First, as illustrated in Fig. 31, the half-finished logic substrate 11 is manufactured in which the multi-layer wiring layer 82 which becomes the control circuit 22 or the logic circuit 23 is formed in a region which becomes each chip portion of the silicon substrate 81. At this time, the silicon substrate 81 has not yet been thinned and has a thickness of, for example, about 600 micrometers.

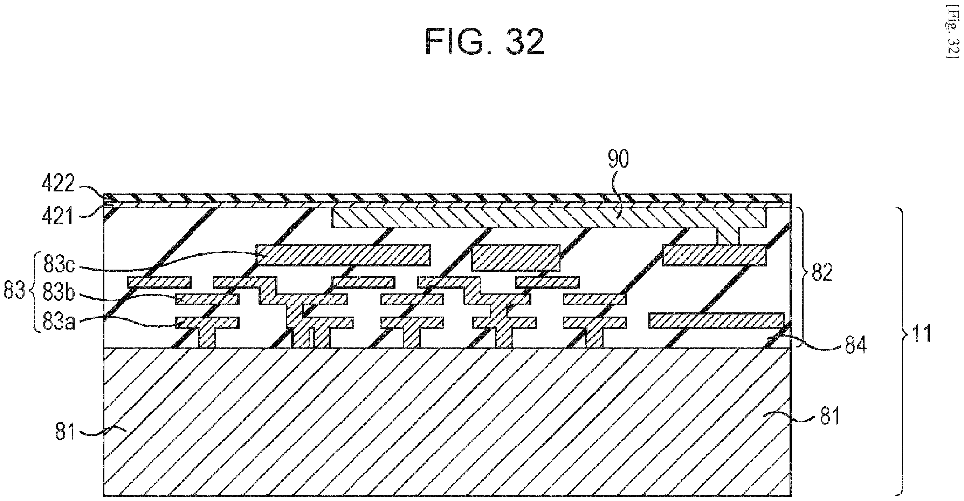

As illustrated in Fig. 32, the rewiring 90 connected to the uppermost wiring layer 83c of the multi-layer wiring layer 82 is formed using, for example, Cu as the wiring material by a damascene method. A cap film 421 using a nitride film (SiN) or the like is formed on the upper surfaces of the formed rewiring 90 and the inter-layer insulation film 84, and then is covered with the insulation film 422 such as SiO₂. In Fig. 15, the cap film 421 and the insulation film 422 are not illustrated. The cap film 421 and the insulation film 422 can be formed by, for example, a plasma CVD method.

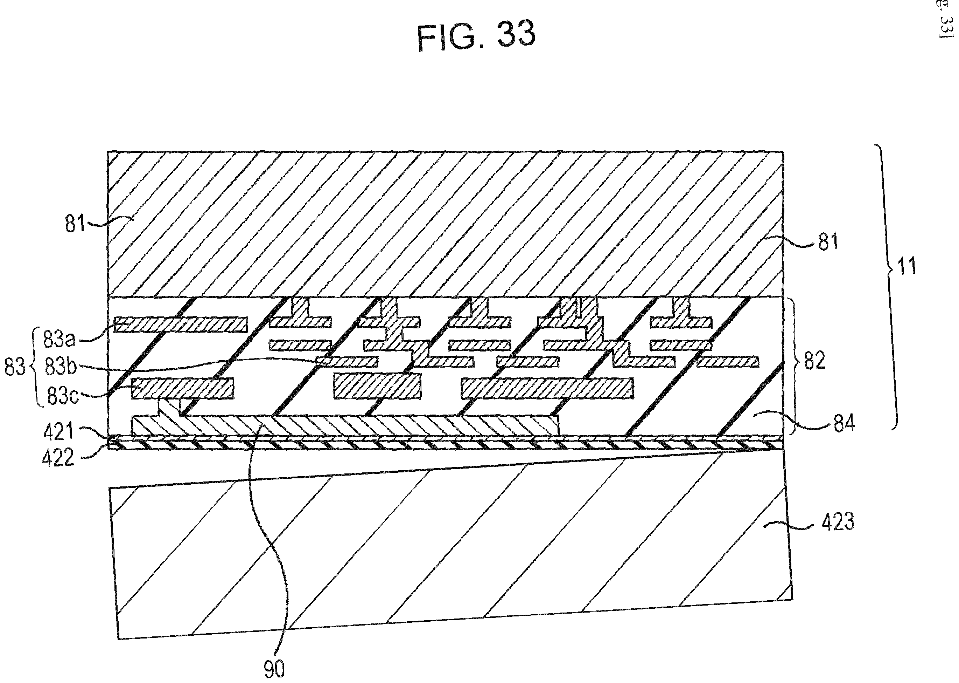

Subsequently, as illustrated in Fig. 33, a provisional bonded substrate (silicon substrate) 423 is pasted as a support substrate to the side of the multi-layer wiring layer 82 of the logic substrate 11 by plasma bonding or bonding with an adhesive.

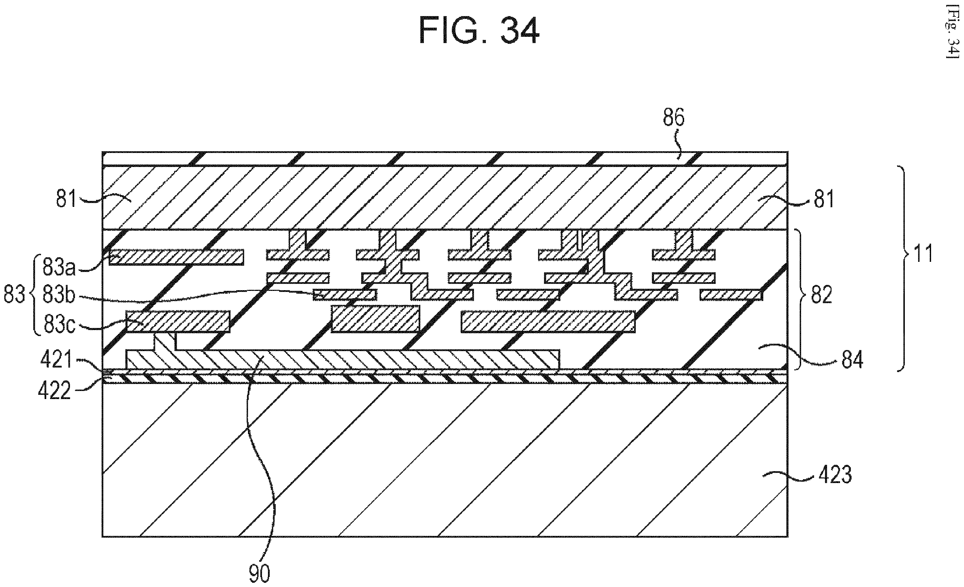

As illustrated in Fig. 34, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like. This manufacturing method is the same as the above-described first manufacturing method in that a light-shielding film 416 and a protective film 417 may be formed on the upper surface of the insulation film 86 to avoid the influence of hot electrons (refer to Fig. 18).

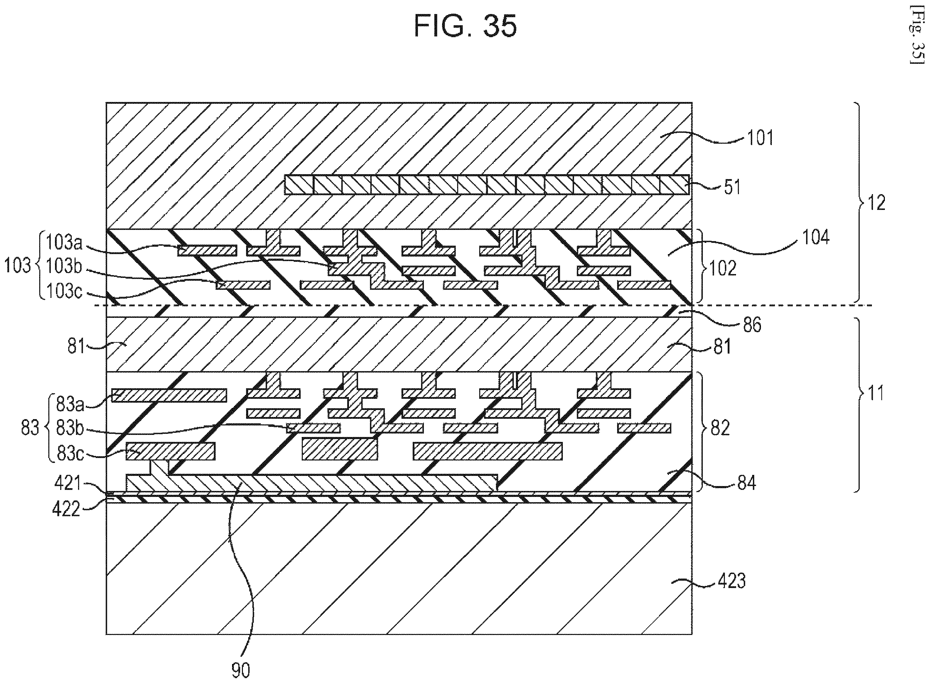

As illustrated in Fig. 35, the side of the multi-layer wiring layer 102 of the half-finished pixel sensor substrate 12 which is separately manufactured is pasted to the thinned logic substrate 11.

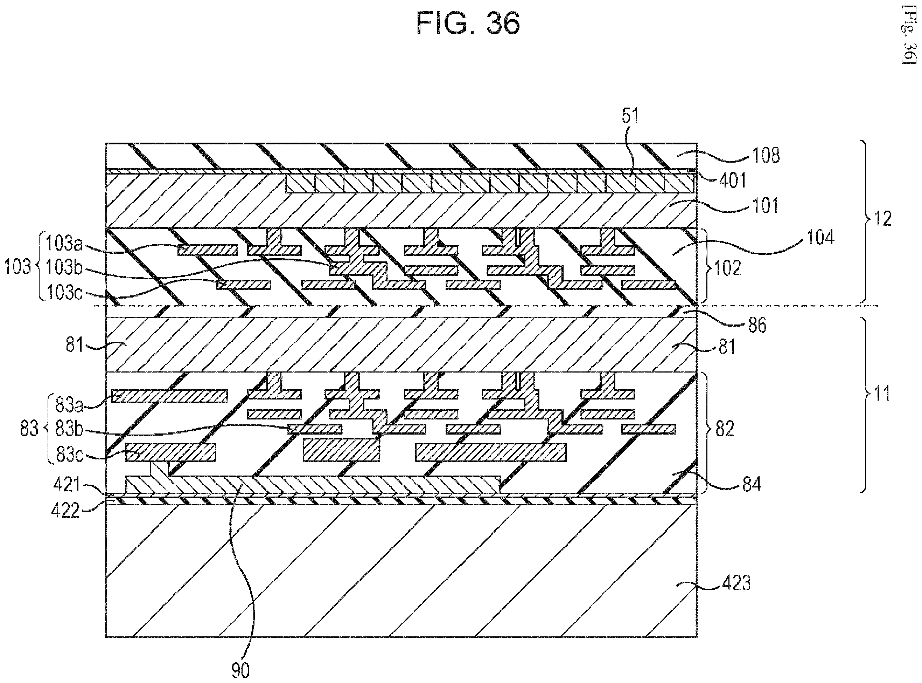

After the logic substrate 11 and the pixel sensor substrate 12 are pasted to each other, as illustrated in Fig. 36, the silicon substrate 101 of the pixel sensor substrate 12 is thinned to the extent of about 1 micrometer to about 10 micrometers. The high dielectric film 401 and the insulation film 108 serving as a sacrifice layer are formed. For example, a SiO₂ film or the like can be used as the insulation film 108.

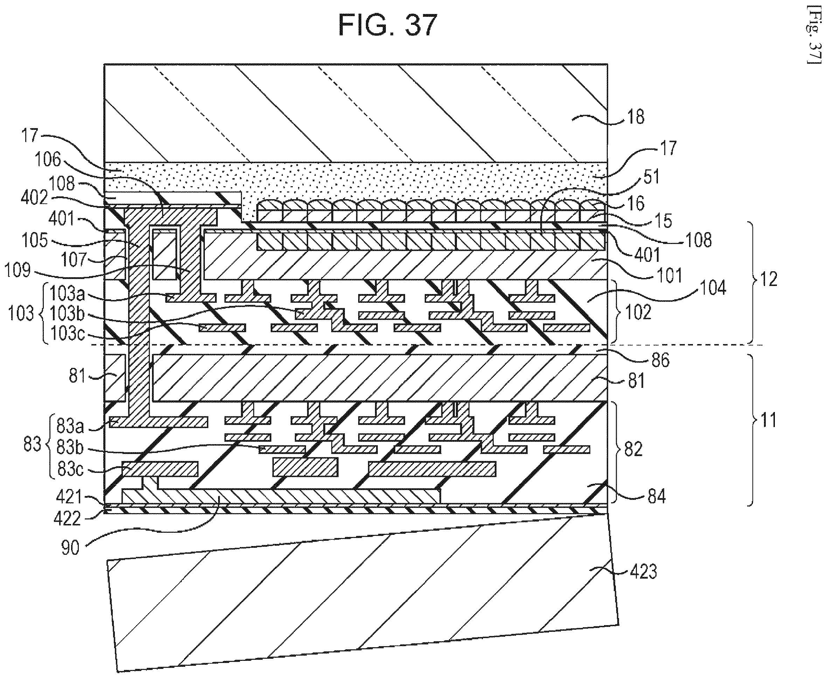

Thereafter, the chip through electrode 105, the silicon through electrode 109, and the connection wiring 106 connecting the chip through electrode 105 to the silicon through electrode 109 or the color filters 15 and the on-chip lenses 16 are formed by the method described with reference to Figs. 22 to 27 in the above-described first manufacturing method. Then, as illustrated in Fig. 37, the glass protective substrate 18 is connected via the glass seal resin 17, and then the provisional bonded substrate 423 is de-bonded.

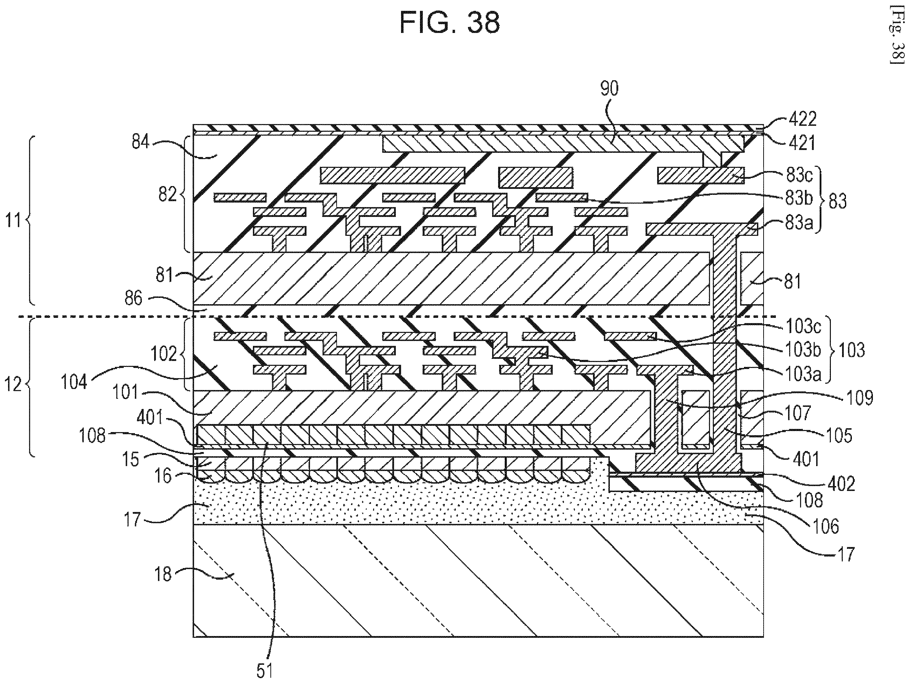

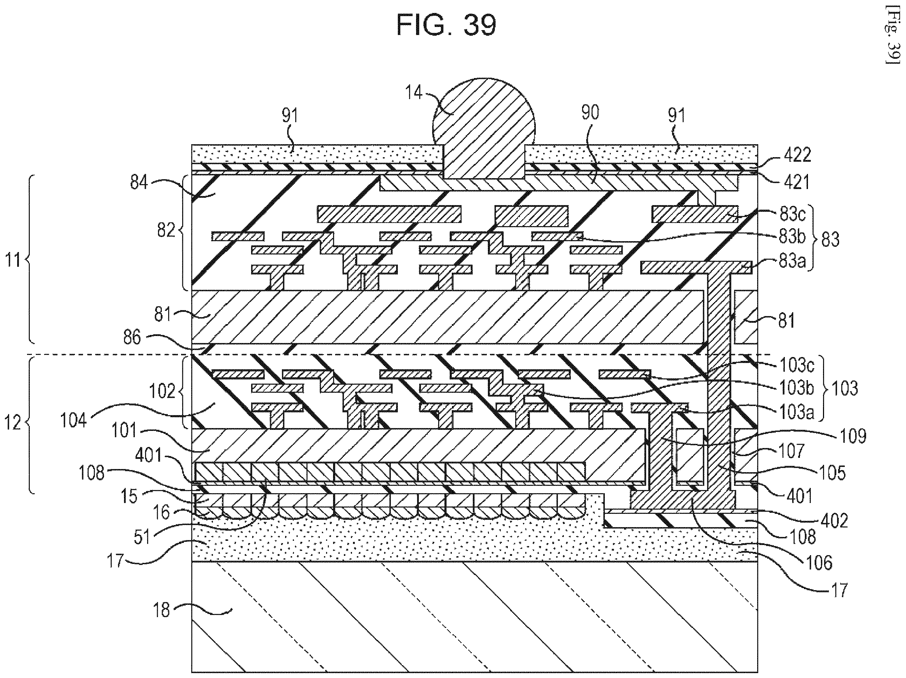

As illustrated in Fig. 38, the logic substrate 11 and the pixel sensor substrate 12 are turned upside down. As illustrated in Fig. 39, a part of the rewiring 90 is opened using the glass protective substrate 18 as the support substrate and the solder ball 14 is formed by a solder ball mounting method or the like. The upper surface of the insulation film 422 excluding the region on which the solder ball 14 is mounted is covered with the solder mask 91.

### <First Modification Example of Solder-Ball Mounted Portion>

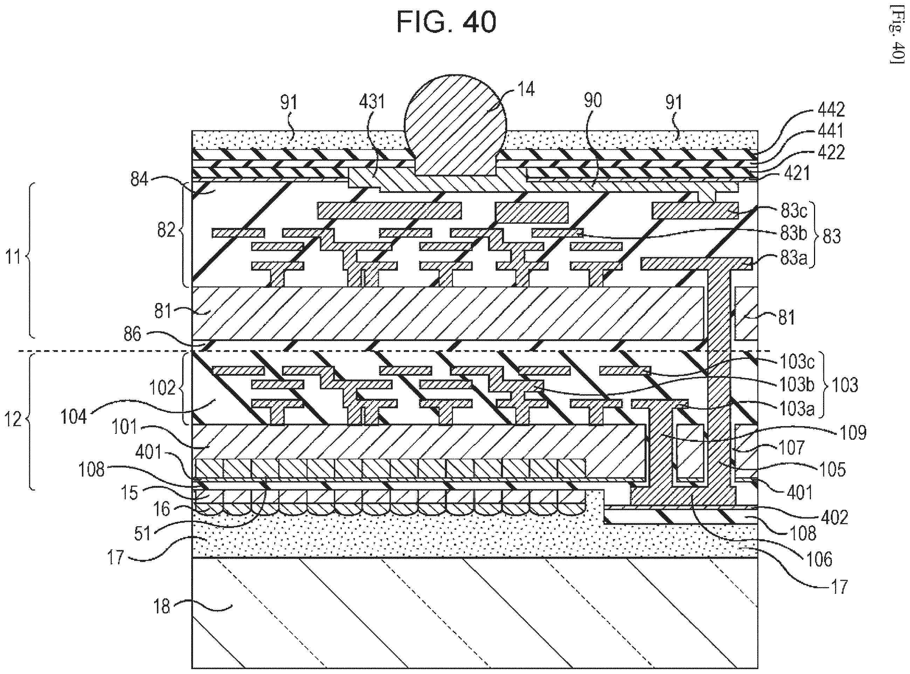

Fig. 40 illustrates a first modification example of a solder-ball mounted portion which is a region on which the solder ball 14 is mounted.

In the first modification example, as illustrated in Fig. 40, a solder land 431 is formed of the same material (for example, Cu) as the rewiring 90 on the rewiring 90. Then, the solder ball 14 is connected on the solder land 431.

The upper surface of the solder land 431 excluding the solder ball 14 is covered with a cap film 441 and an insulation film 442. Thus, a 4-layer structure of the cap film 421, the insulation film 422, the cap film 441, and the insulation film 442 is formed on the upper surface of the rewiring 90.

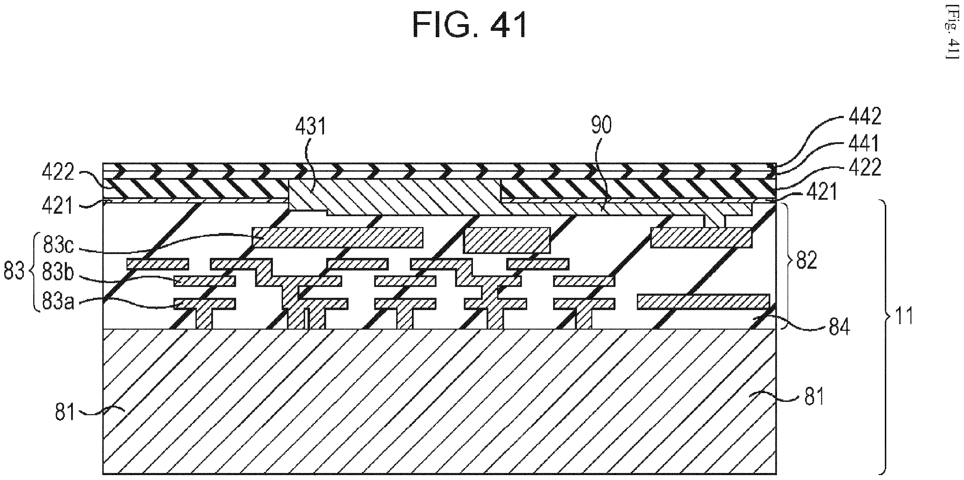

When the solder-ball mounted portion is formed with the structure illustrated in Fig. 40, the solder land 431, and the cap film 441 and the insulation film 442 may be further formed, as illustrated in Fig. 41, in addition to the processes of manufacturing the rewiring 90, and the cap film 421 and the insulation film 422, as described with reference to Fig. 32. The remaining manufacturing method is the same as the above-described second manufacturing method.

### <Second Modification Example of Solder-ball Mounted Portion>

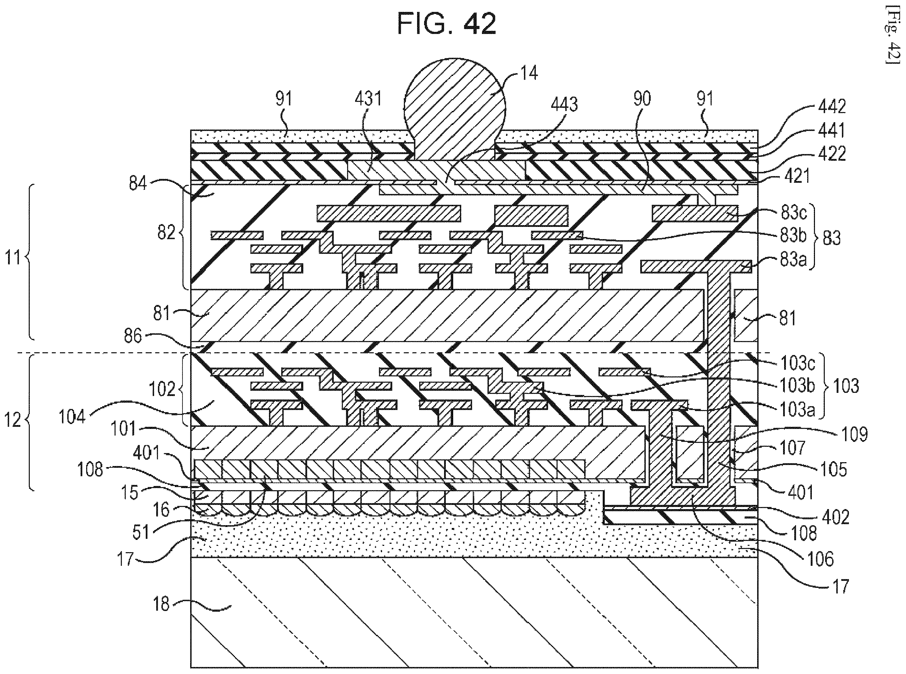

Fig. 42 illustrates a second modification example of the solder-ball mounted portion.

In the second modification example, as illustrated in Fig. 42, the rewiring 90 and the solder land 431 are not directly connected as in the first modification example, but are connected through a via (connection conductor) 443. The 4-layer structure of the cap film 421, the insulation film 422, the cap film 441, and the insulation film 442 is formed on the upper surface of the rewiring 90.

Thus, since it is easy to route a wiring by forming multiple layers using a via 443, an advantage can be obtained in terms of layout.

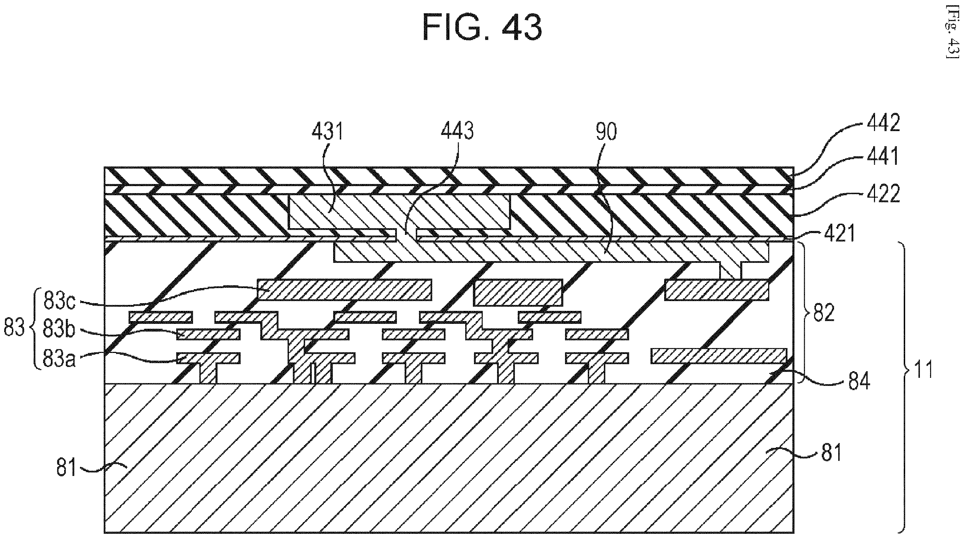

When the solder-ball mounted portion is formed with the structure illustrated in Fig. 42, as illustrated in Fig. 41, the solder land 431, the via 443, and the cap film 441 and the insulation film 442 may be further formed, as illustrated in Fig. 43, in addition to the processes of manufacturing the rewiring 90, and the cap film 421 and the insulation film 422, as described with reference to Fig. 32. The remaining manufacturing method is the same as the above-described second manufacturing method.

### <Third Method of Manufacturing Solid-state Imaging Device in Fig. 15>

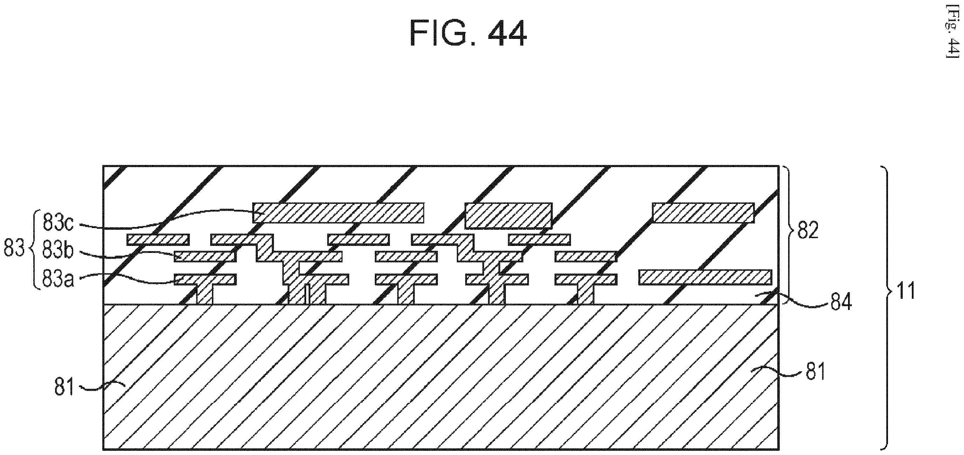

Next, a third method of manufacturing the solid-state imaging device 1 having the face-to-back structure illustrated in Fig. 15 will be described with reference to Figs. 44 to 49.

First, as illustrated in Fig. 44, the half-finished logic substrate 11 is manufactured in which the multi-layer wiring layer 82 which becomes the control circuit 22 or the logic circuit 23 is formed in a region which becomes each chip portion of the silicon substrate 81. At this time, the silicon substrate 81 has not yet been thinned and has a thickness of, for example, about 600 micrometers.

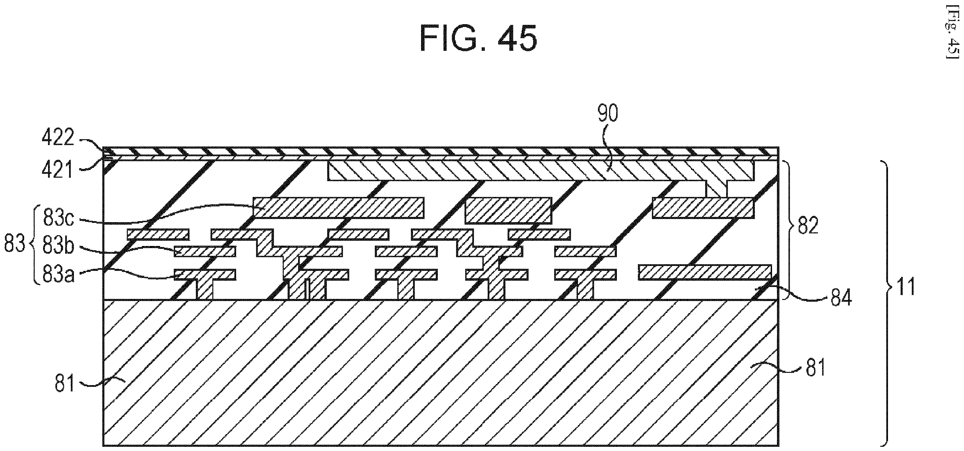

As illustrated in Fig. 45, the rewiring 90 connected to the uppermost wiring layer 83c of the multi-layer wiring layer 82 is formed using, for example, Cu as the wiring material by a damascene method. A cap film 421 using a nitride film (SiN) or the like is formed on the upper surfaces of the formed rewiring 90 and the inter-layer insulation film 84, and then is covered with the insulation film 422 such as a SiO₂.

The processes are the same as those of the above-described second manufacturing method.

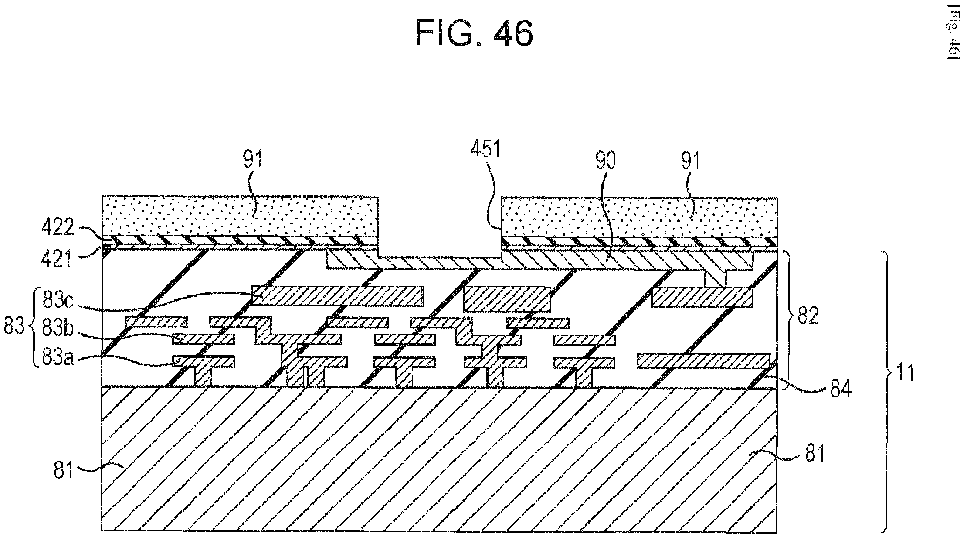

Next, as illustrated in Fig. 46, the solder mask 91 is formed and an opening 451 is formed by etching the solder mask 91, the cap film 421, and the insulation film 422 in the region on which the solder ball 14 is mounted. The opening 451 may be formed by applying a photoresist and performing dry-etching in the region on which the solder ball 14 is mounted.

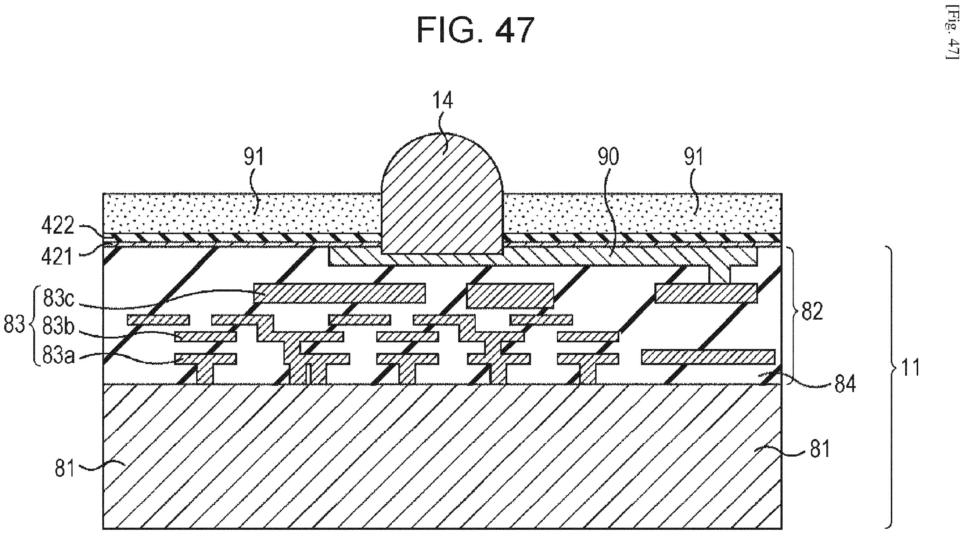

Then, as illustrated in Fig. 47, the solder ball 14 is formed in the opening 451 by, for example, a solder ball mounting method.

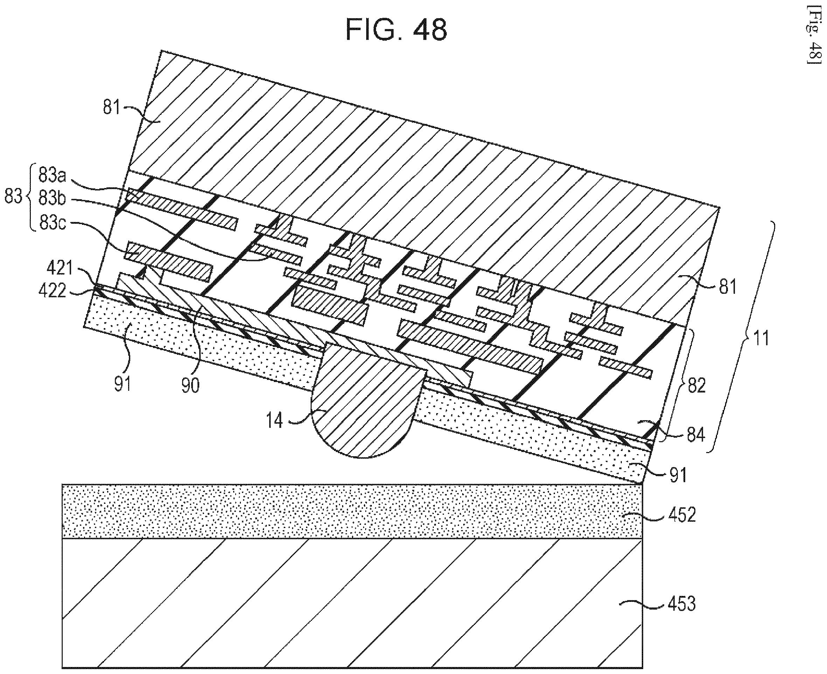

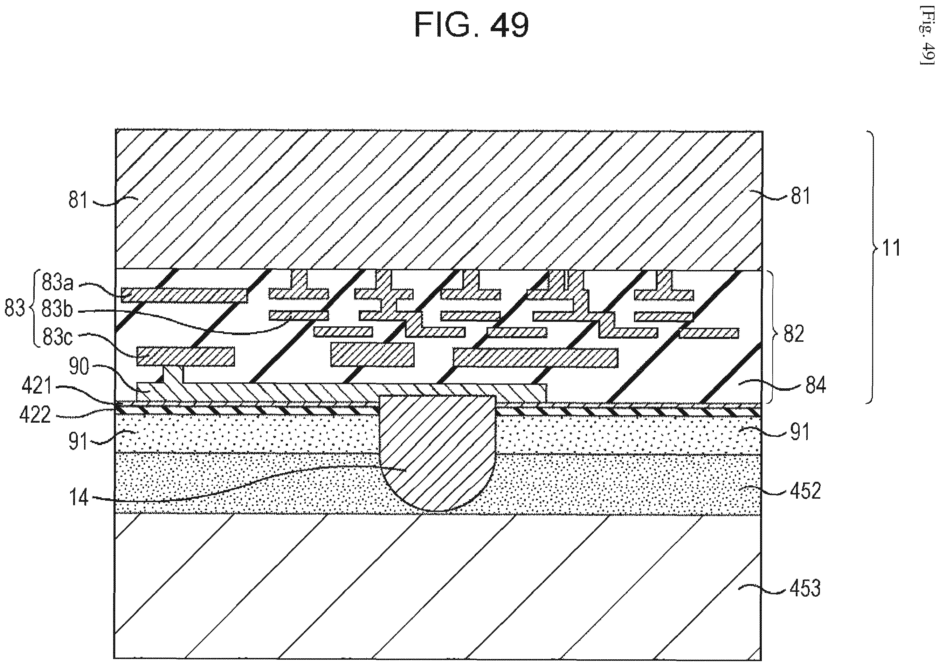

Next, as illustrated in Figs. 48 and 49, the side of the solder ball 14 of the logic substrate 11 and a provisional bonded substrate (silicon substrate) 453 are pasted together using an adhesive 452 with a thickness by which the solder ball 14 is concealed.

The manufacturing processes after the bonding of the logic substrate 11 and the provisional bonded substrate 453 using the adhesive 452 are the same manufacturing processes as the above-described second manufacturing method, and thus the description thereof will be omitted.

### <Modification Example of Rewiring>

In regard to the thickness of the rewiring 90 connected to the solder ball 14 or the wiring layer of the solder land 431, it is necessary to ensure that a thickness remaining does not react with the copper since the tin in the solder and copper in the metal wiring react to each other during the soldering and an inter-metallic compound (IMC) is formed.

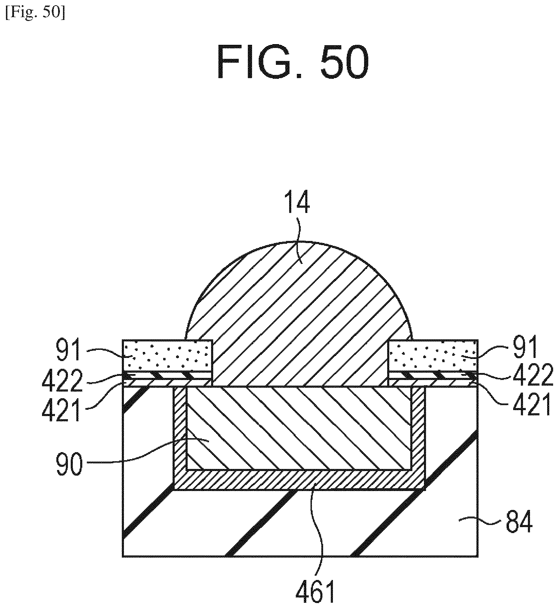

Alternatively, as illustrated in Fig. 50, a barrier metal 461 can be formed outside the rewiring 90. Thus, even when all the copper of the rewiring 90 is reacted, the reaction can be configured to be stopped by the barrier metal 461. As the material of the barrier metal 461, Ta, TaN, Ti, Co (cobalt), Cr (chromium), or the like can be used. When Ta or TaN is used as the material of the barrier metal 461, the thickness of the barrier metal 461 can be set to be about 30 nm. On the other hand, when Ti is used as the material of the barrier metal 461, the thickness of the barrier metal 461 can be considered to be about 200 nm. The barrier metal 461 may have a laminated structure of Ta (lower layer)/Ti (upper layer), TaN/Ta/Ti, or the like.

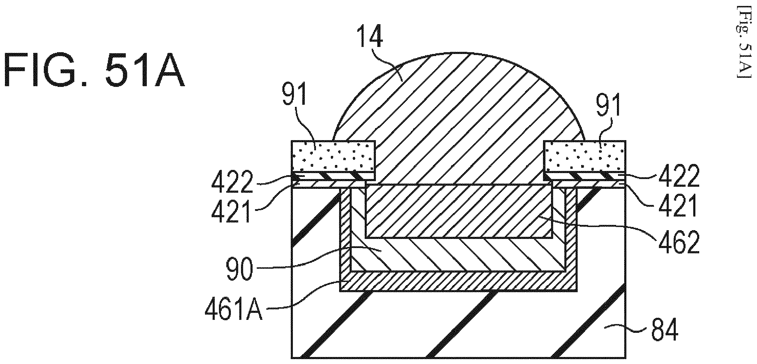

Figs. 51A to 51C illustrate post-reaction states in which an inter-metallic compound (IMC) is formed in the rewiring 90 when soldering is performed using Ta or TaN as the barrier metal 461. A barrier metal 461A in Figs. 51A to 51C indicates the barrier metal 461 formed using Ta or TaN.

Fig. 51A illustrates a state in which only an upper portion of the rewiring 90 close to the solder ball 14 turns into an IMC (CuSn) 462.

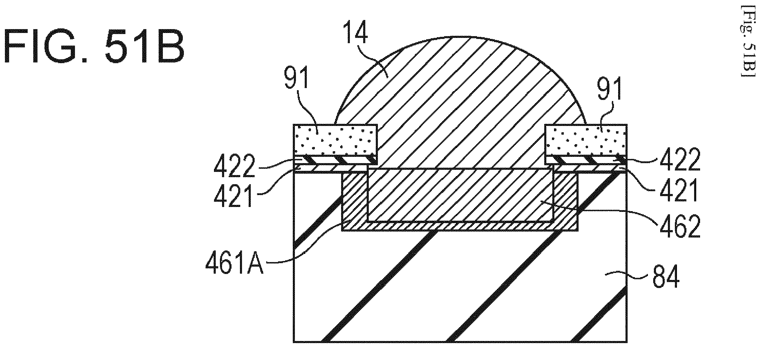

Fig. 51B illustrates a state in which the rewiring 90 is formed to be thinner than in Fig. 51A, all Cu of the rewiring 90 is changed into the IMC 462, and the reaction is stopped by the barrier metal 461A.

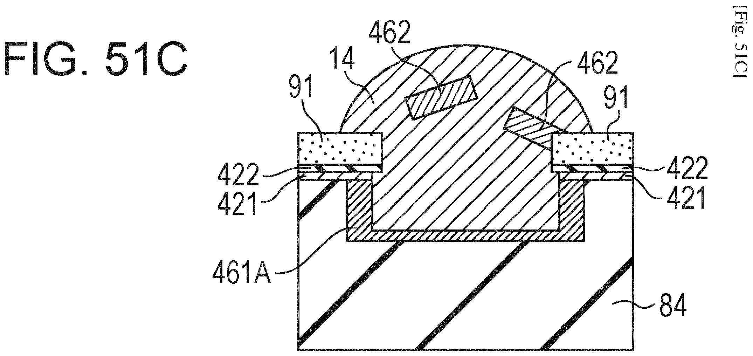

Fig. 51C illustrates a state in which the rewiring 90 is formed to be thinner than in Fig. 51A, all Cu of the rewiring 90 is changed into the IMC 462, and the reaction is stopped by the barrier metal 461A. In Fig. 51C, the IMC 462 diffuses to the inside of the solder ball 14.

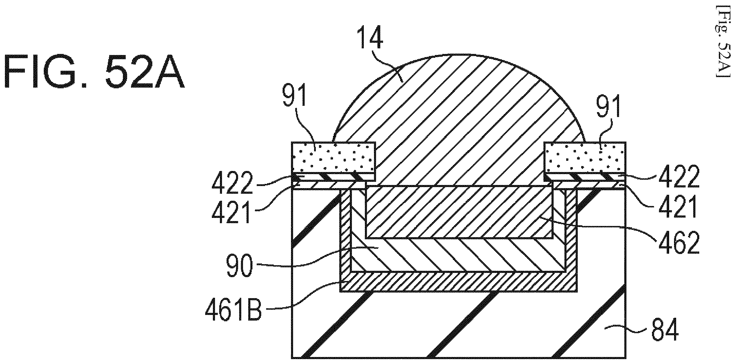

Figs. 52A to 52D illustrate post-reaction states in which an inter-metallic compound (IMC) is formed in the rewiring 90 when soldering is performed using Ti as the barrier metal 461. A barrier metal 461B in Figs. 52A to 52D indicates the barrier metal 461 formed using Ti.

As in Fig. 51A, Fig. 52A illustrates a state in which only an upper portion of the rewiring 90 close to the solder ball 14 turns into an IMC (CuSn) 462.

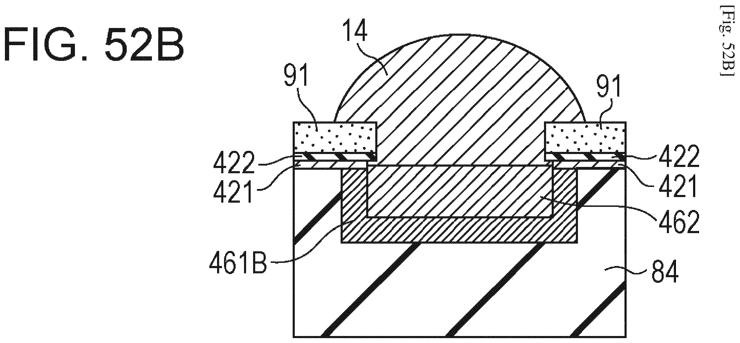

As in Fig. 51B, Fig. 52B illustrates a state in which the rewiring 90 is formed to be thinner than in Fig. 52A, all Cu of the rewiring 90 is changed into the IMC 462, and the reaction is stopped by the barrier metal 461B.

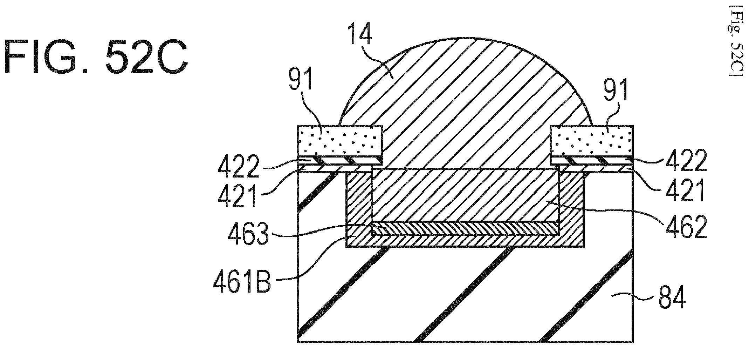

Fig. 52C illustrates a state in which the rewiring 90 is formed to be thinner than in Fig. 52A, all Cu of the rewiring 90 is reacted and changed into the IMC 462 of CuSn, a part of the barrier metal 461B is also reacted, and thus an IMC 463 of TiSn is formed.

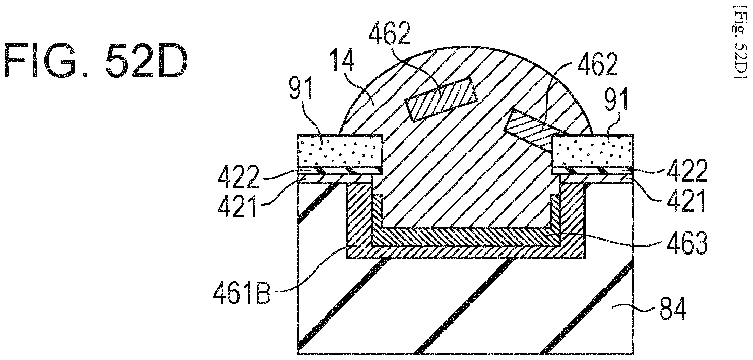

Fig. 52D illustrates a state in which the rewiring 90 is formed to be thinner than in Fig. 52A, all Cu of the rewiring 90 is reacted, the IMC 462 of CuSn diffuses to the inside of the solder ball 14, a part of the barrier metal 461B is reacted, and thus the IMC 463 of TiSn is formed.

Thus, by forming the barrier metal 461 in the lower layer of the rewiring 90, a soldering defective can be suppressed. When Ti is used as the material of the barrier metal 461, growth of a Kirkendall void occurring due to a difference in a mutual diffusion speed between Cu and Sn can also be expected to be suppressed in a reliability test after the soldering.

### <Example of Case in Which Solder Land Is Present>

Even when the solder land 431 is formed above the rewiring 90, as illustrated in Fig. 40 or 42, the barrier metal 461 can be formed in this way.

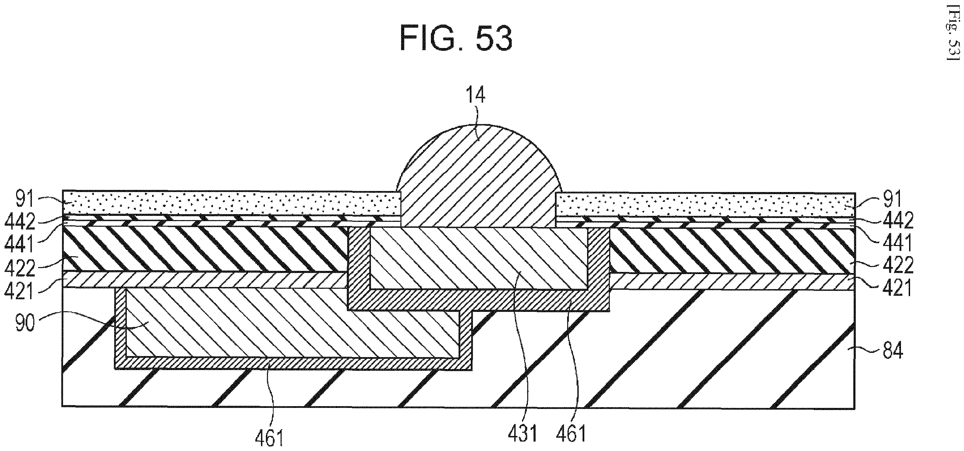

Fig. 53 illustrates a structure example in which the barrier metal 461 is formed in a lower layer of each of the rewiring 90 and the solder land 431. Thus, a structure in which the barrier metal 461 is disposed under the solder ball 14 is referred to as an Under Bump Metal (UBM) structure.

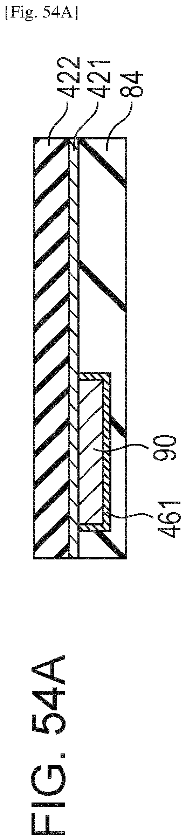

A process of forming the barrier metal 461 when the solder land 431 is present, as illustrated in Fig. 53, will be described with reference to Figs. 54A to 54E.

First, as illustrated in Fig. 54A, after the barrier metal 461 is formed by a sputtering method, the rewiring 90 is formed by a damascene method. After the rewiring 90 is formed, the cap film 421 and the insulation film 422 are laminated.

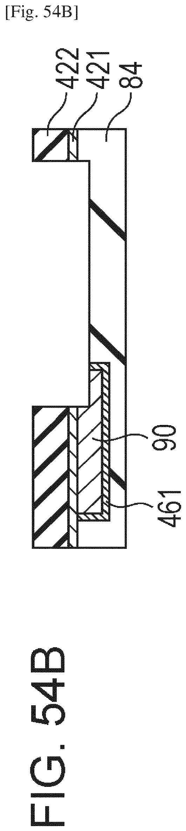

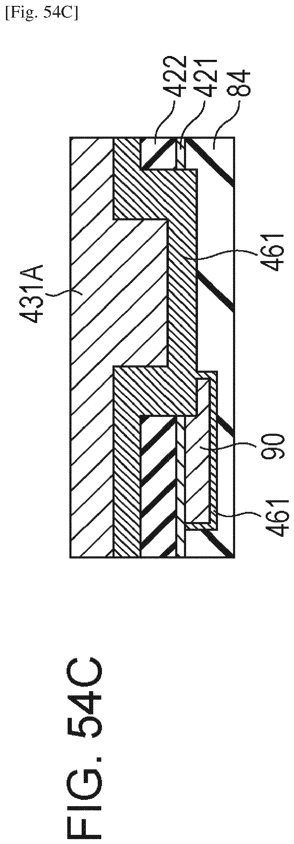

Next, after the region in which the solder land 431 is formed is opened, as illustrated in Fig. 54B, as illustrated in Fig. 54C, the barrier metal 461 and a wiring material 431A for the solder land 431 are formed. Here, by setting the thickness of the barrier metal 461 to be thick to the extent of, for example, about 500 nm, it is possible to improve connection reliability of the solder ball 14.

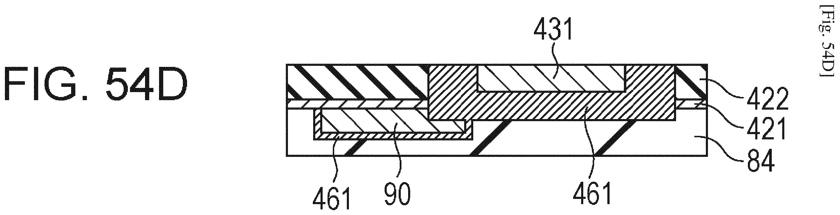

Then, by flattening the surface by a CMP method to remove the excess wiring material 431A and the excess barrier metal 461, as illustrated in Fig. 54D, the solder land 431 is formed.

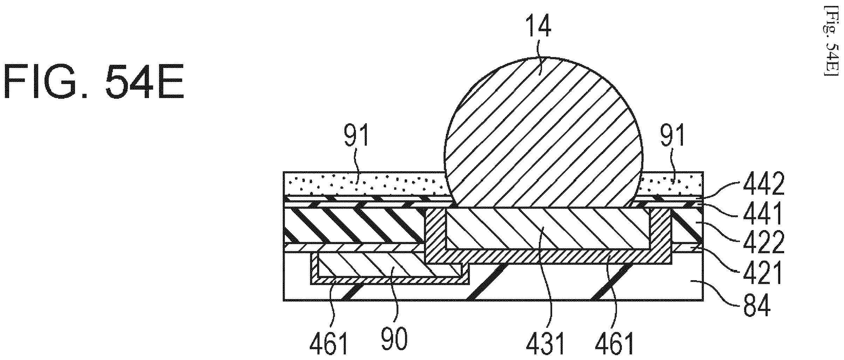

Finally, as illustrated in Fig. 54E, the cap film 441 and the insulation film 442 are formed on the uppermost surface, the solder ball 14 is formed above the solder land 431, and the solder mask 91 is formed in the other portion.

As described above, by forming the rewiring 90 and the solder land 431 by the damascene method, the barrier metal 461 can be formed on the wiring side wall, and thus the risk of inter-wiring leak or the like can be reduced. Since the UBM structure of the solder-ball mounted portion is formed by the damascene method, it is possible to remove undercut of the barrier metal 461, and thus it is easy to thicken the barrier metal 461 or form a laminated film.

According to the first to third methods of manufacturing the solid-state imaging device 1 with the face-to-back structure described above, the two through electrodes, i.e., the chip through electrode 105 and the silicon through electrode 109, are formed before the color filters 15 or the on-chip lenses 16 are formed. Therefore, the insulation film 107 or the insulation film 108 serving as an isolation film can also be formed before the color filters 15 or the on-chip lenses 16 are formed. Thus, the insulation film 107 or the insulation film 108 with good film quality can be formed, and thus characteristics of pressure resistance, adhesion, or the like can be improved. That is, it is possible to improve the reliability of the insulation film 107 or the insulation film 108 ensuring high reliability.

### <6. Manufacturing Method for First Basic Structure>

Next, a method of manufacturing the solid-state imaging device 1 having the face-to-face structure in which the wiring layers of the logic substrate 11 and the pixel sensor substrate 12 face each other, as illustrated in Figs. 5 to 14, will be described.

### <Method of Manufacturing Basic Structure in Fig. 5>

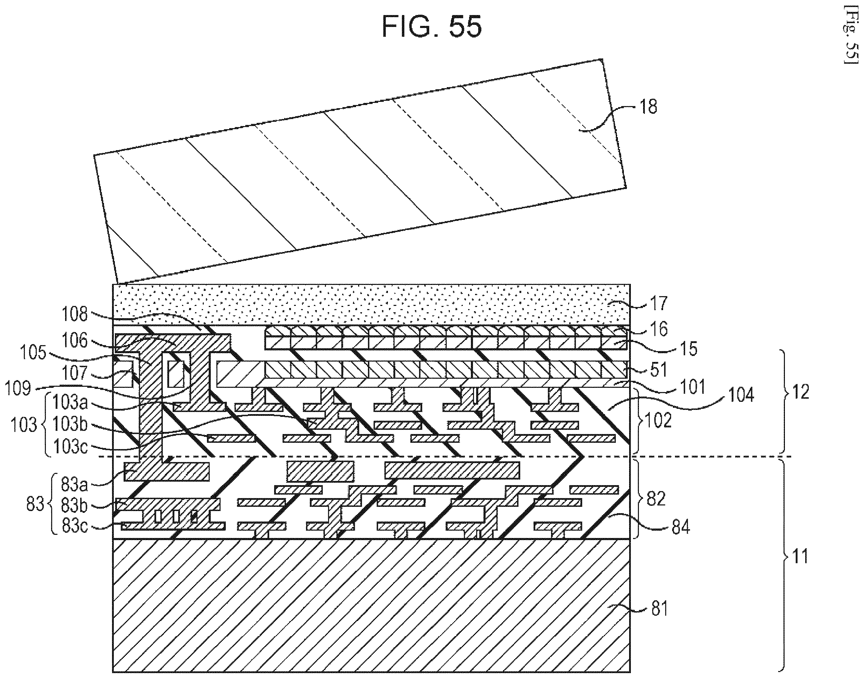

A method of manufacturing the solid-state imaging device 1 having the basic structure illustrated in Fig. 5 will be first described with reference to Figs. 55 to 65.

First, the half-finished logic substrate 11 and the half-finished pixel sensor substrate 12 are separately manufactured.

In the logic substrate 11, the multi-layer wiring layer 82 which becomes the control circuit 22 or the logic circuit 23 is formed in a region which becomes each chip portion of the silicon substrate (silicon wafer) 81. At this time, the silicon substrate 81 has not yet been thinned and has a thickness of, for example, about 600 micrometers.

On the other hand, in the pixel sensor substrate 12, the photodiode 51 and the source/ drain region of the pixel transistor of each pixel 32 are formed in a region which becomes each chip portion of the silicon substrate (silicon wafer) 101. The multi-layer wiring layer 102 forming a part of the control circuit 22 or the like is formed on one surface of the silicon substrate 101 and the color filters 15 and the on-chip lenses 16 are formed on the other surface of the silicon substrate 101.

As illustrated in Fig. 55, the side of the multi-layer wiring layer 82 of the manufactured logic substrate 11 and the side of the multi-layer wiring layer 102 of the pixel sensor substrate 12 are pasted to face each other. Examples of the pasting include plasma bonding and bonding by an adhesive. In the embodiment, plasma bonding is assumed to be performed. In the case of plasma bonding, the logic substrate 11 and the pixel sensor substrate 12 are bonded by forming a plasma TEOS film, a plasma SiN film, a SiON film (block film), a SiC film, or the like on the bonded surface of the logic substrates 11 and the pixel sensor substrate 12, performing plasma processing on the bonded surfaces, superimposing both of the substrates, and then performing an annealing process.

After the logic substrate 11 and the pixel sensor substrate 12 are pasted together, the silicon through electrode 109, the chip through electrode 105, and the connection wiring 106 connecting the chip through electrode 105 to the silicon through electrode 109 are formed by a damascene method or the like.

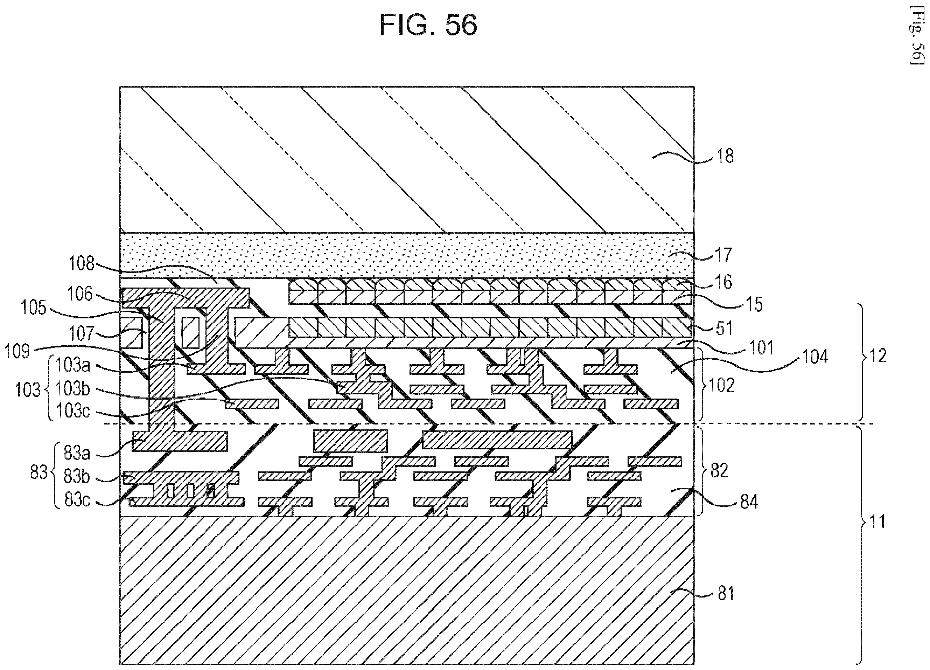

As illustrated in Fig. 55, the glass seal resin 17 is applied to the entire surface on which the on-chip lenses 16 of the pixel sensor substrate 12 pasted to the logic substrate 11 are formed. As illustrated in Fig. 56, the glass protective substrate 18 is connected with the cavityless structure.

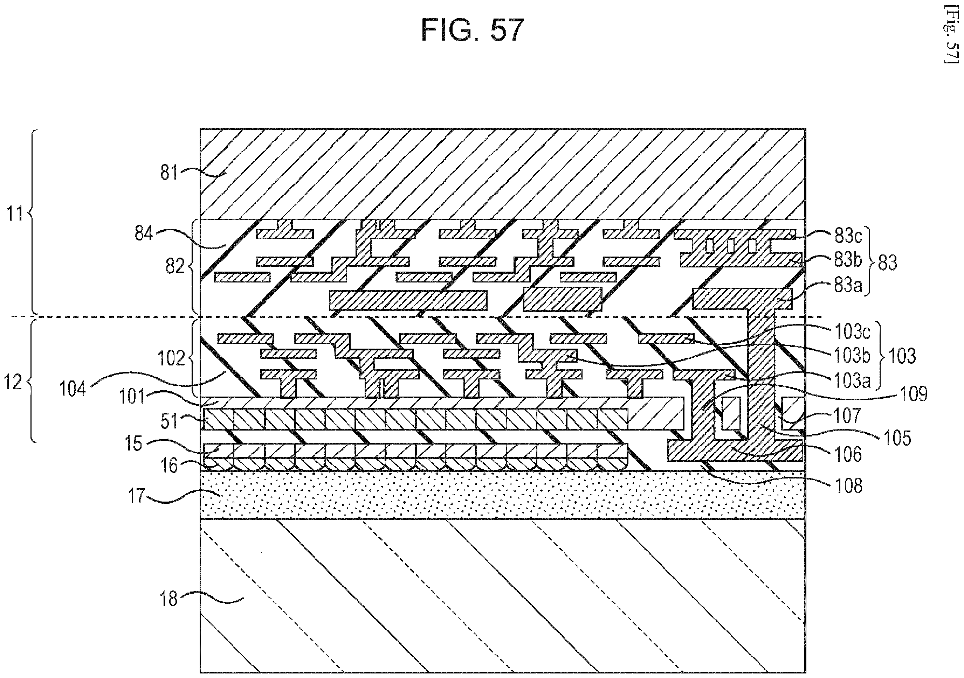

Next, as illustrated in Fig. 57, after the laminated substrate 13 in which the logic substrate 11 and the pixel sensor substrate 12 are pasted together is turned upside down, the silicon substrate 81 of the logic substrate 11 is thinned to the extent of having a thickness which does not affect device characteristics, e.g., to the extent of about 30 micrometers to about 100 micrometers.

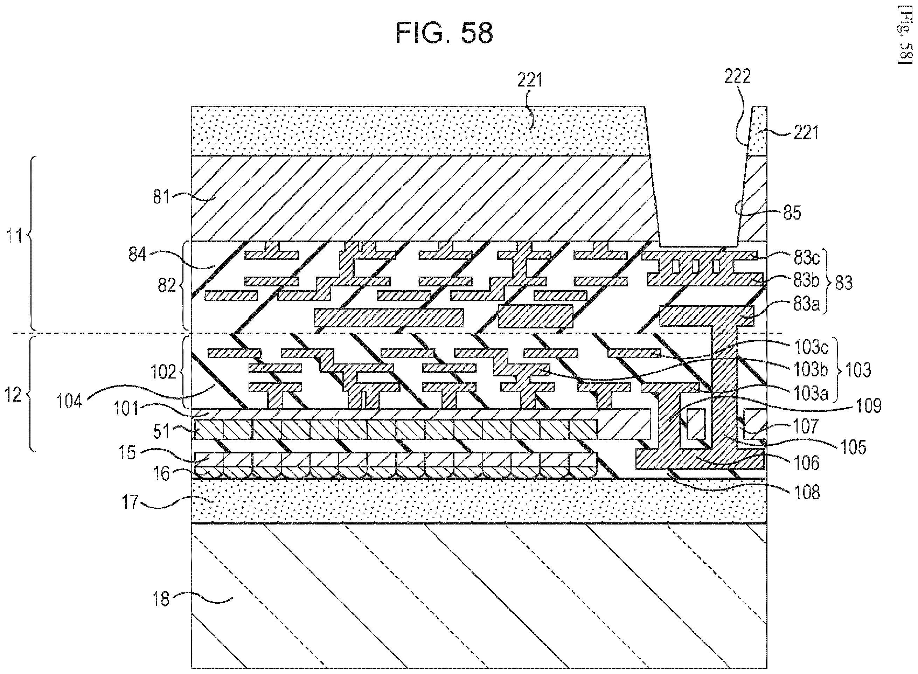

Next, as illustrated in Fig. 58, after a photoresist 221 is patterned so that a position on the thinned silicon substrate 81 at which the silicon through electrode 88 (not illustrated) is disposed is opened, the silicon substrate 81 and a part of an inter-layer insulation film 84 below the silicon substrate 81 are removed by dry etching to form an opening 222.

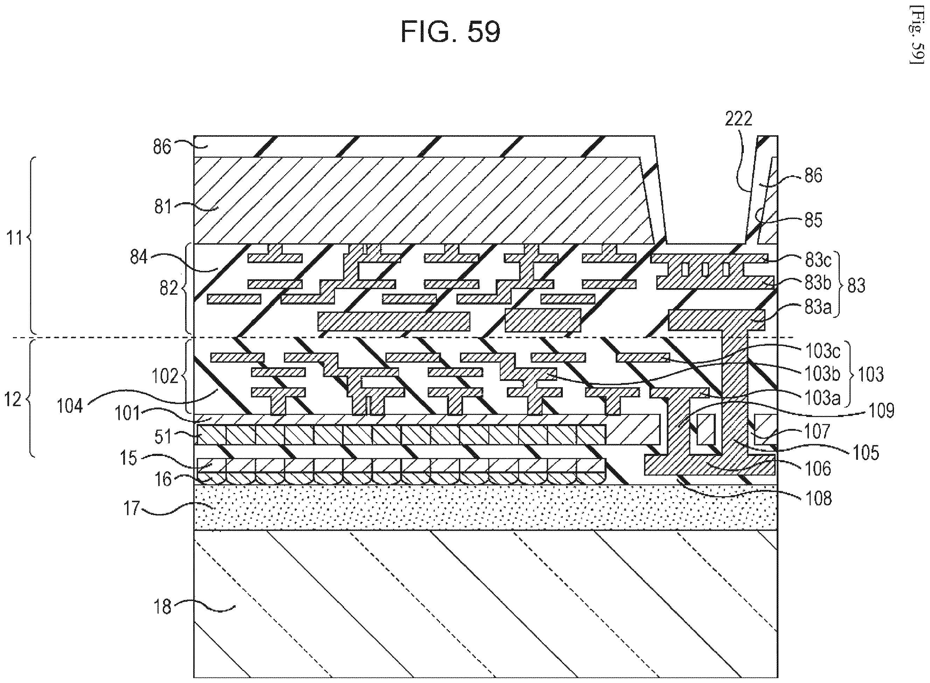

Next, as illustrated in Fig. 59, an insulation film (isolation film) 86 is formed on the entire upper surface of the silicon substrate 81 including the opening 222 by, for example, a plasma CVD method. As described above, for example, a SiO₂ film or a SiN film can be formed as the insulation film 86.

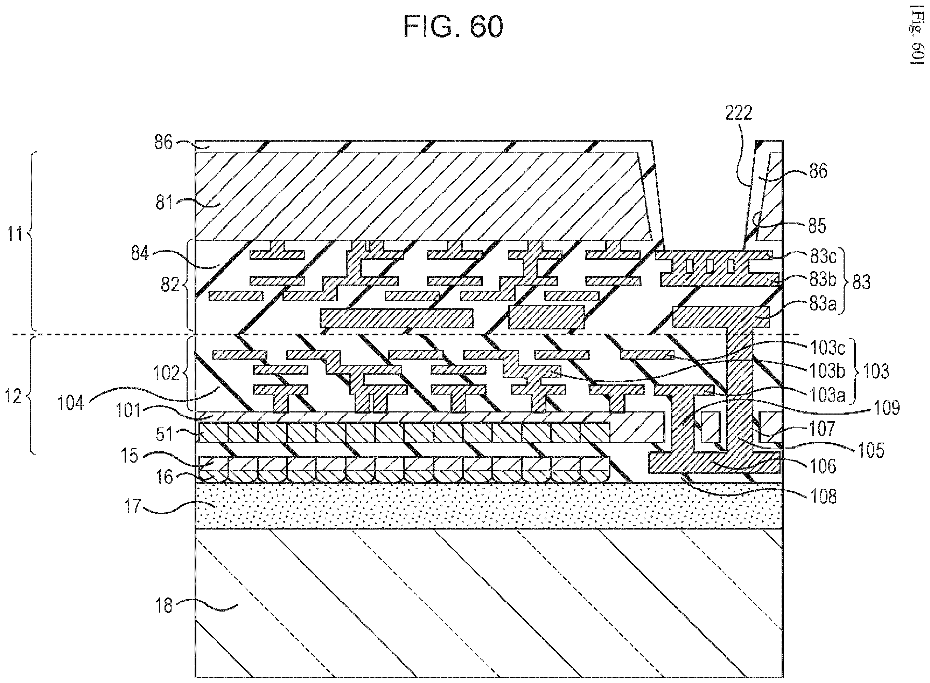

Next, as illustrated in Fig. 60, the insulation film 86 of the bottom surface of the opening 222 is removed by an etch-back method, so that the wiring layer 83c closest to the silicon substrate 81 is exposed.

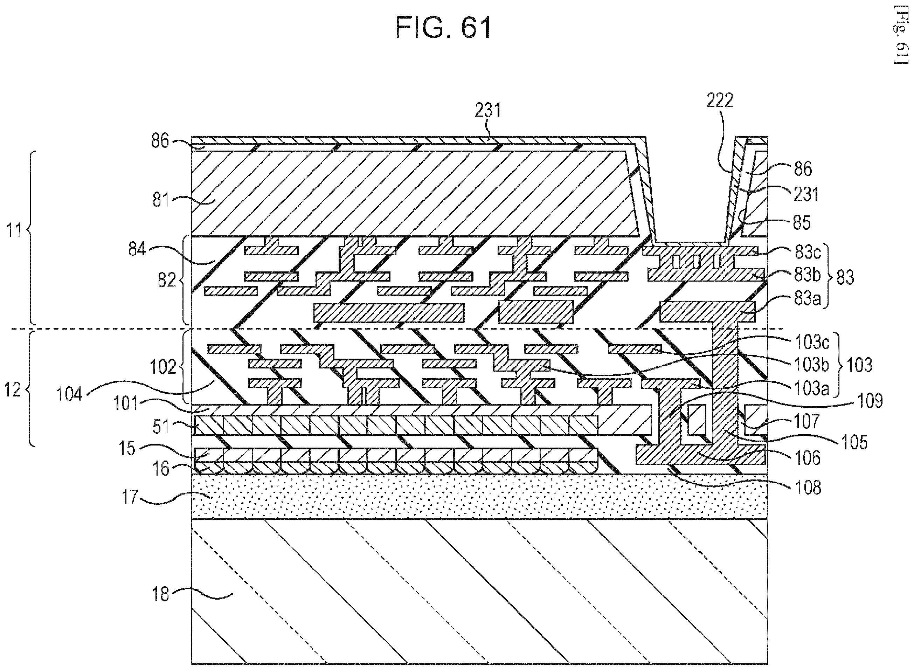

Next, as illustrated in Fig. 61, a barrier metal film (not illustrated) and a Cu seed layer 231 are formed by a sputtering method. The barrier metal film is a film preventing the connection conductor 87 (Cu) from diffusing and the Cu seed layer 231 becomes an electrode when the connection conductor 87 is embedded by an electrolytic plating method. As the material of the barrier metal film, for example, tantalum (Ta), titanium (Ti), tungsten (W), zirconium (Zr), a nitride film thereof, or a carbonized film thereof can be used. In the embodiment, a titanium film is used as the barrier metal film.

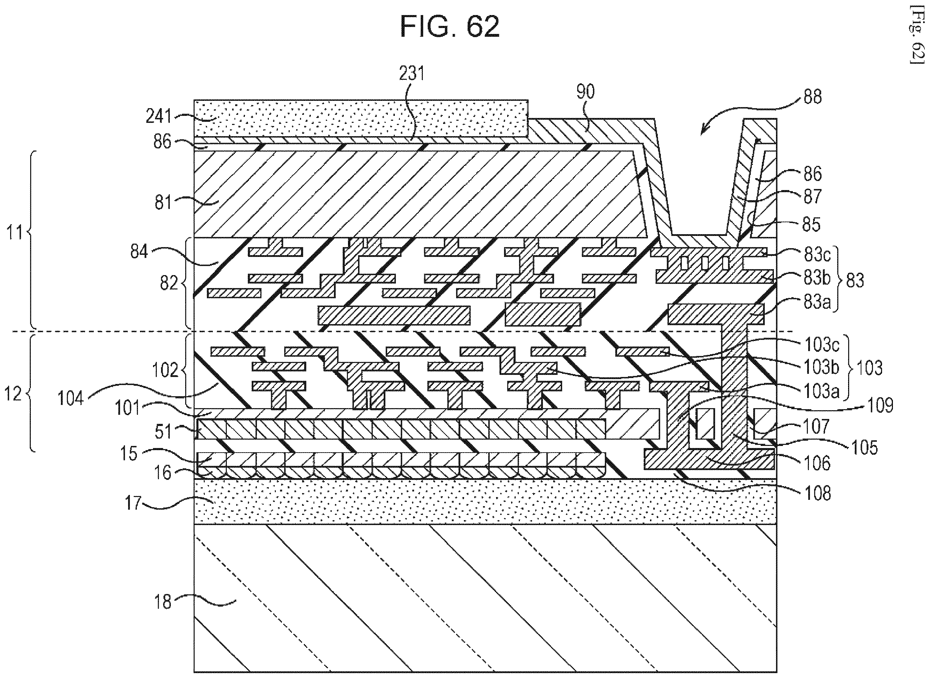

Next, as illustrated in Fig. 62, after a resist pattern 241 is formed in a necessary region on the Cu seed layer 231, copper (Cu) serving as the connection conductor 87 is plated by an electrolytic plating method. Thus, the silicon through electrode 88 is formed and the rewiring 90 is also formed on the upper side of the silicon substrate 81.

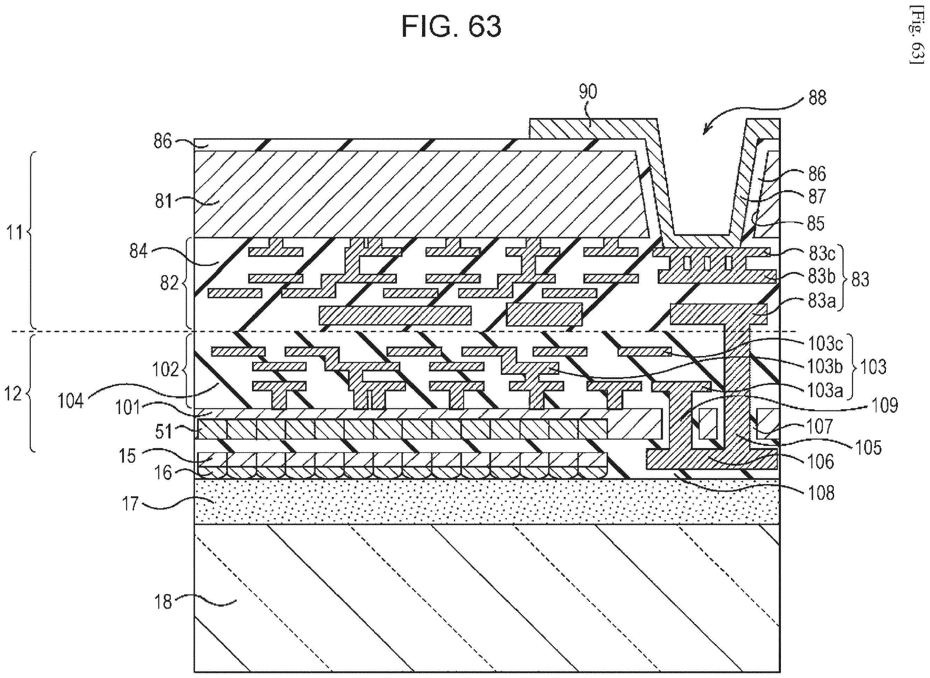

Next, as illustrated in Fig. 63, after the resist pattern 241 is removed, the barrier metal film (not illustrated) below the resist pattern 241 and the Cu seed layer 231 are removed by wet etching.

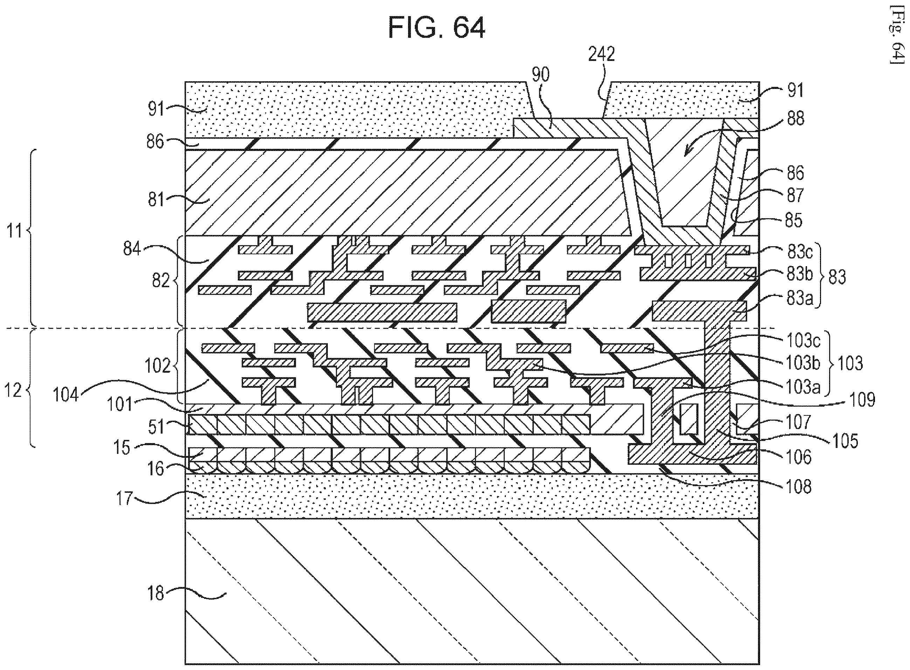

Next, as illustrated in Fig. 64, after the solder mask 91 is formed to protect the rewiring 90, a solder mask opening 242 is formed by removing the solder mask 91 only in a region on which the solder ball 14 is mounted.

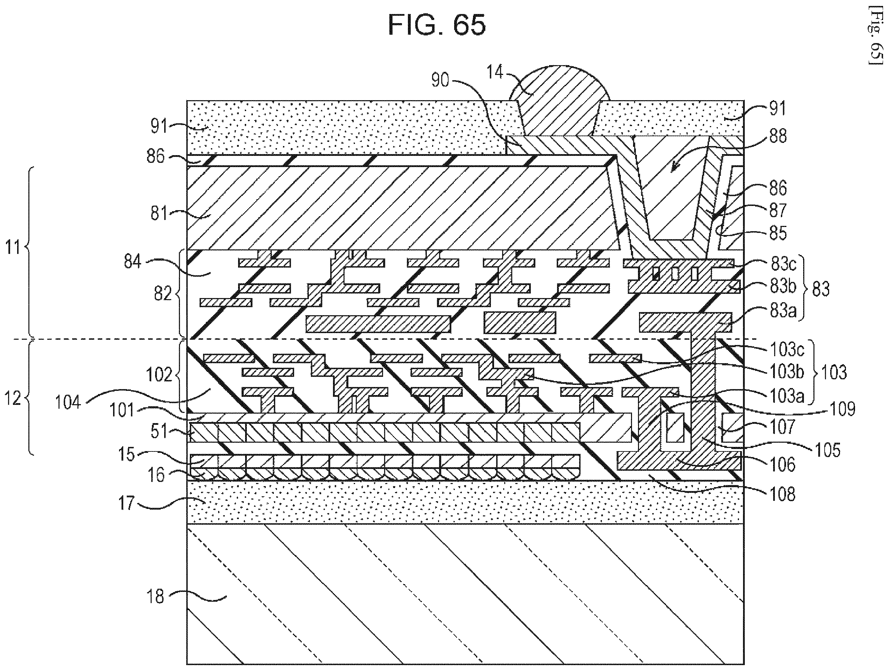

Then, as illustrated in Fig. 65, the solder ball 14 is formed in the solder mask opening 242 by a solder-ball mounting method or the like.

The solid-state imaging device 1 having the basic structure illustrated in Fig. 5 can be manufacturing by the above-described manufacturing method.

According to the foregoing manufacturing method, the silicon through electrode 88 is formed after the color filters 15 are formed. In this case, during the process of forming the silicon through electrode 88, it is particularly necessary to form the insulation film 86 insulating the silicon substrate 81 from the connection conductor 87 by a low-temperature plasma CVD method at about 200 degrees to about 220 degrees in order to prevent the color filters 15, the on-chip lenses 16, and the like from being damaged.

However, when the insulation film 86 is formed at a low temperature, interatomic bond may be insufficient and film quality may deteriorate in some cases. Further, when the film quality deteriorates, peeling or cracking may occur, and thus silicon pressure-resistance failure, a metal wiring leak, or the like may occur in some cases.

Accordingly, a manufacturing method of ensuring reliability of the insulation film 86 while preventing the color filter 15, the on-chip lens 16, or the like from being damaged will be described below.

### <First Manufacturing Method of First Modification Example>

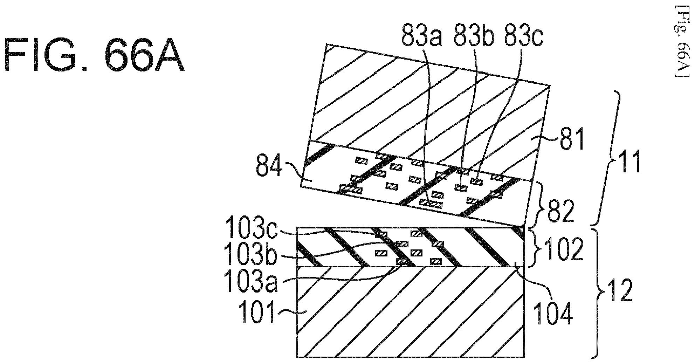

A first method of manufacturing the solid-state imaging device 1 having the structure according to the first modification example illustrated in Fig. 6 will be described with reference to Figs. 66A to 67C.

First, the half-finished logic substrate 11 and the half-finished pixel sensor substrate 12 are separately manufactured.

In the logic substrate 11, the multi-layer wiring layer 82 which becomes the control circuit 22 or the logic circuit 23 is formed in a region which becomes each chip portion of the silicon substrate (silicon wafer) 81. At this time, the silicon substrate 81 has not yet been thinned and has a thickness of, for example, about 600 micrometers.

On the other hand, in the pixel sensor substrate 12, the photodiode 51 and the source/ drain region of the pixel transistor of each pixel 32 are formed in a region which becomes each chip portion of the silicon substrate (silicon wafer) 101. The multi-layer wiring layer 102 forming a part of the control circuit 22 or the like is formed on the surface of the silicon substrate 101 on which the source/drain region of the pixel transistor is formed. Some of the drawings after Figs. 66A to 66D do not illustrate the photodiodes 51 formed in the silicon substrate 101 as the drawings of the half-finished pixel sensor substrate 12.

Subsequently, as illustrated in Fig. 66A, the half-finished logic substrate 11 and the half-finished pixel sensor substrate 12 are pasted by plasma bonding or an adhesive so that the side of the multi-layer wiring layer 82 of the logic substrate 11 and the side of the multi-layer wiring layer 102 of the pixel sensor substrate 12 face each other.

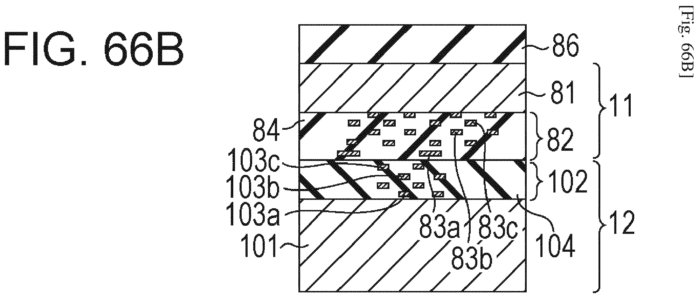

As illustrated in Fig. 66B, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

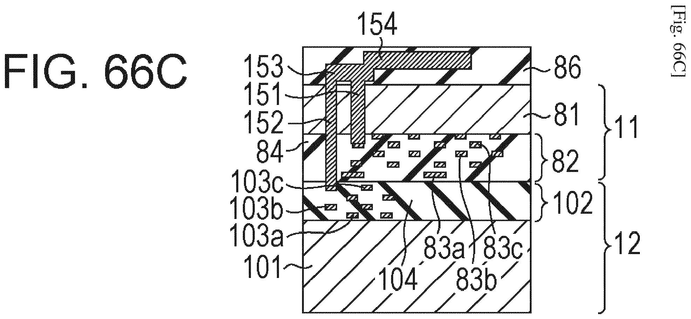

Next, as illustrated in Fig. 66C, the silicon through electrode 151 connected to the wiring layer 83c of the logic substrate 11, the chip through electrode 152 connected to the wiring layer 103c of the pixel sensor substrate 12, and the connection wiring 153 connecting the silicon through electrode 151 to the chip through electrode 152 are formed at predetermined positions of the silicon substrate 81 on the side of the logic substrate 11. The silicon through electrode 151, the chip through electrode 152, and the connection wiring 153 can be formed through the same process as the process described with reference to Figs. 22 to 24.

The rewiring 154 on which the solder ball 14 is mounted is also formed. The rewiring 154 is formed by, for example, a damascene method.

In Figs. 6, 66A to 66D, and 67A to 67C, the insulation film 86 is formed as one layer. In practice, the cap film 421, the insulation film 422, or the like is laminated as in the face-to-back structure. As described above, the rewiring 154 can have the structure in which the thickness remaining does not react with the copper or the structure which stops the reaction with the barrier metal 461. Further, for example, the structure in which the solder land 431 is added, as illustrated in Figs. 40 and 42, or the UBM structure illustrated in Figs. 52A to 53 can also be used.

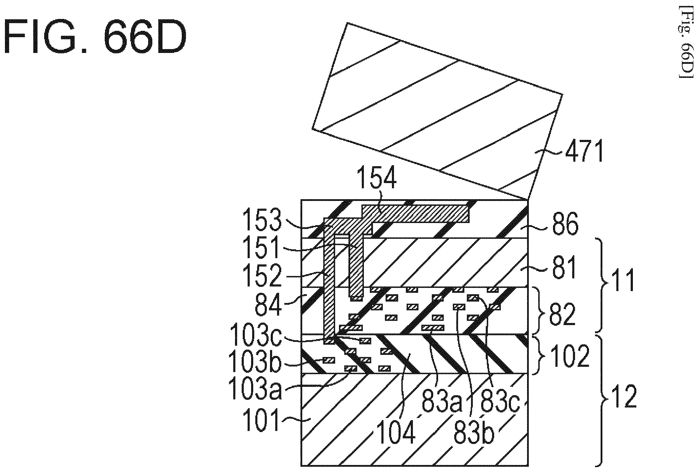

Next, as illustrated in Fig. 66D, a provisional bonded substrate (silicon substrate) 471 is pasted as a support substrate to the side of the insulation film 86 of the logic substrate 11.

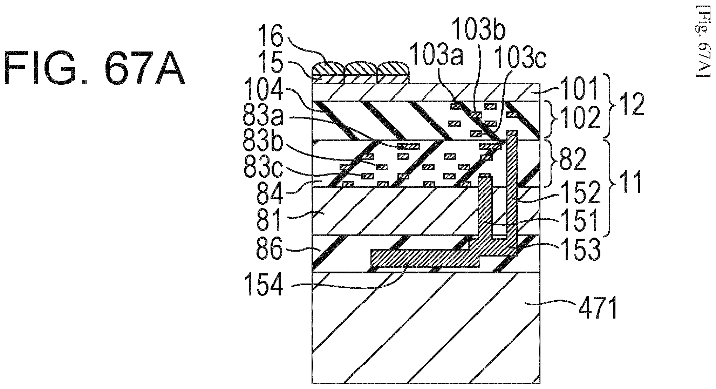

As illustrated in Fig. 67A, all of the substrates to which the provisional bonded substrate 471 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

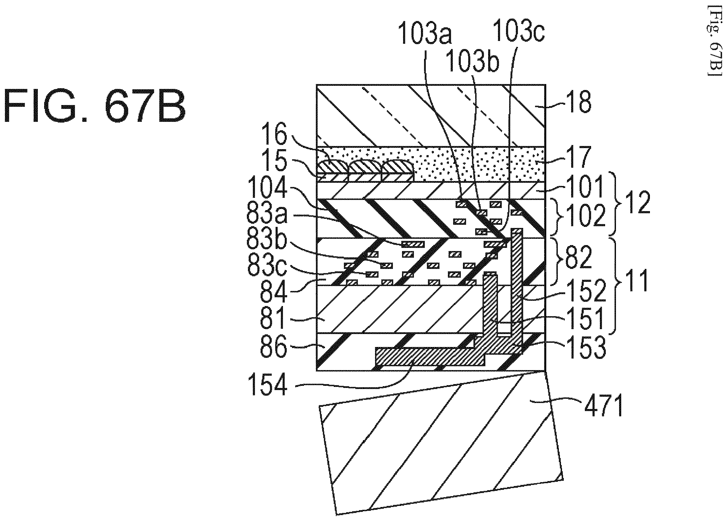

Next, as illustrated in Fig. 67B, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 471 is de-bonded.

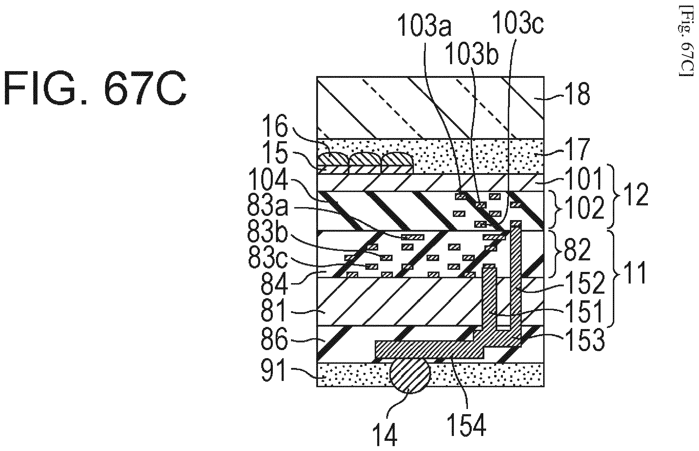

As illustrated in Fig. 67C, the solder mask 91 is formed on the entire surface, the solder mask 91 is removed only in the region on which the solder ball 14 is mounted, and then the solder ball 14 is formed by the solder-ball mounting method or the like.

According to the foregoing manufacturing method, the solid-state imaging device 1 in Fig. 1 having the structure according to the first modification example illustrated in Fig. 6 is completed.

### <Second Manufacturing Method of First Modification Example>

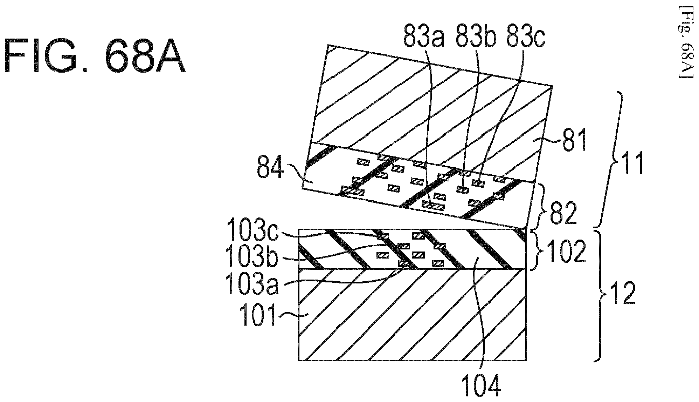

Next, a second method of manufacturing the solid-state imaging device 1 having the structure according to the first modification example illustrated in Fig. 6 will be described with reference to Figs. 68A to 70C.

First, as illustrated in Fig. 68A, the half-finished logic substrate 11 and pixel sensor substrate 12 which are separately manufactured are pasted so that the wiring layers thereof face each other.

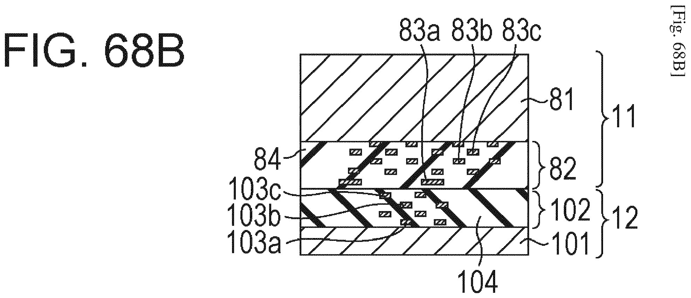

As illustrated in Fig. 68B, the silicon substrate 101 of the pixel sensor substrate 12 is thinned to be about 1 micrometer to about 10 micrometers using the silicon substrate 81 of the logic substrate 11 as a support substrate.

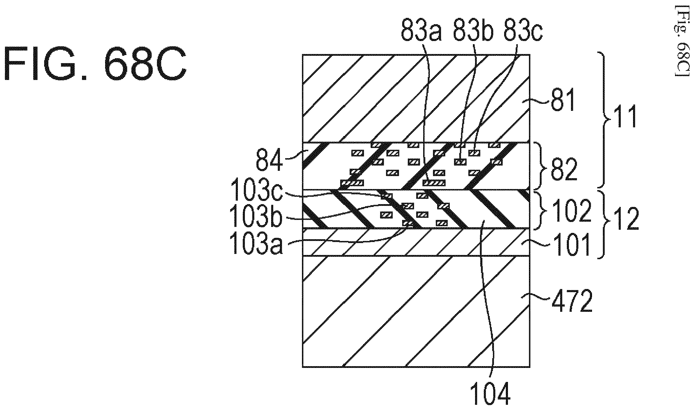

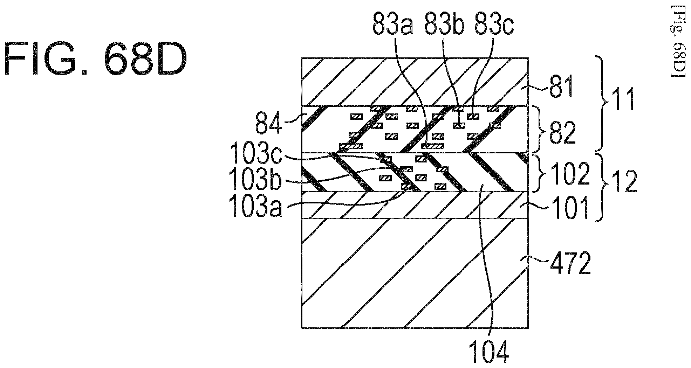

Next, as illustrated in Fig. 68C, a provisional bonded substrate (silicon substrate) 472 is pasted to the thinned silicon substrate 101 of the pixel sensor substrate 12. At this time, as illustrated in Fig. 68D, the silicon substrate 81 of the logic substrate 11 is thinned to be 20 micrometers to about 100 micrometers using the provisional bonded substrate 472 as a support substrate.

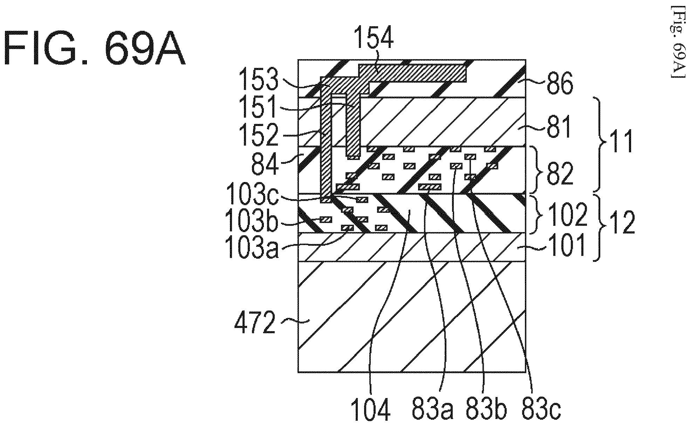

Next, as illustrated in Fig. 69A, the silicon through electrode 151 connected to the wiring layer 83c of the logic substrate 11, the chip through electrode 152 connected to the wiring layer 103c of the pixel sensor substrate 12, and the connection wiring 153 connecting the silicon through electrode 151 to the chip through electrode 152 are formed at predetermined positions of the silicon substrate 81 on the side of the logic substrate 11. The silicon through electrode 151, the chip through electrode 152, and the connection wiring 153 can be formed in the same process as the process described with reference to Figs. 22 to 24.

The rewiring 154 on which the solder ball 14 is mounted is also formed. The rewiring 154 is formed by, for example, a damascene method.

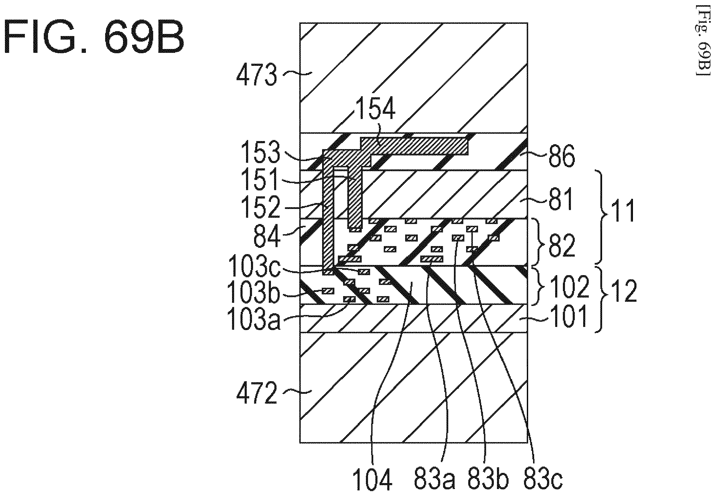

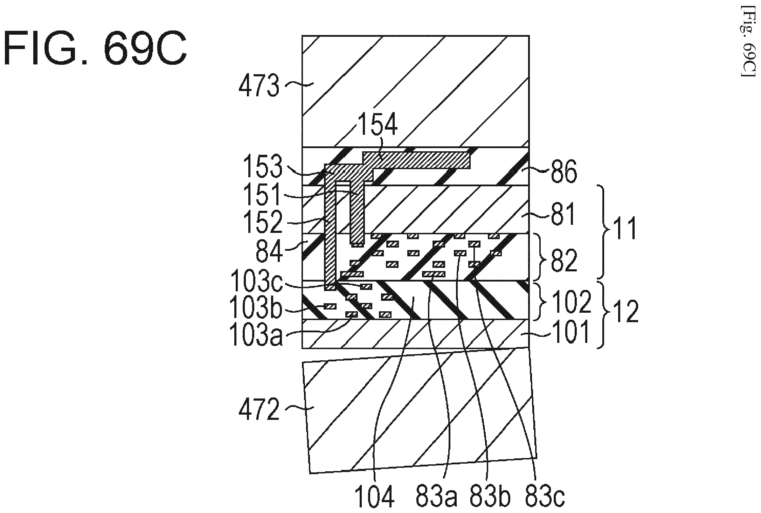

Next, after a provisional bonded substrate 473 is pasted to the side of the insulation film 86 of the logic substrate 11, as illustrated in Fig. 69B, the provisional bonded substrate 472 on the side of the pixel sensor substrate 12 is de-bonded, as illustrated in Fig. 69C.

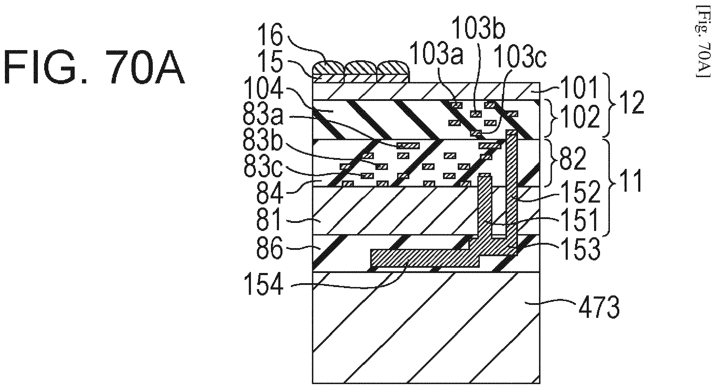

Next, as illustrated in Fig. 70A, all of the substrates to which the provisional bonded substrate 473 is bonded are turned upside down, and the color filters 15 and the on-chip lenses 16 are formed on the silicon substrate 101 of the pixel sensor substrate 12. Further, a high dielectric film such as the high dielectric film 401 in Fig. 15 may be formed on the upper surface of the thinned silicon substrate 101 in order to suppress a dark current.

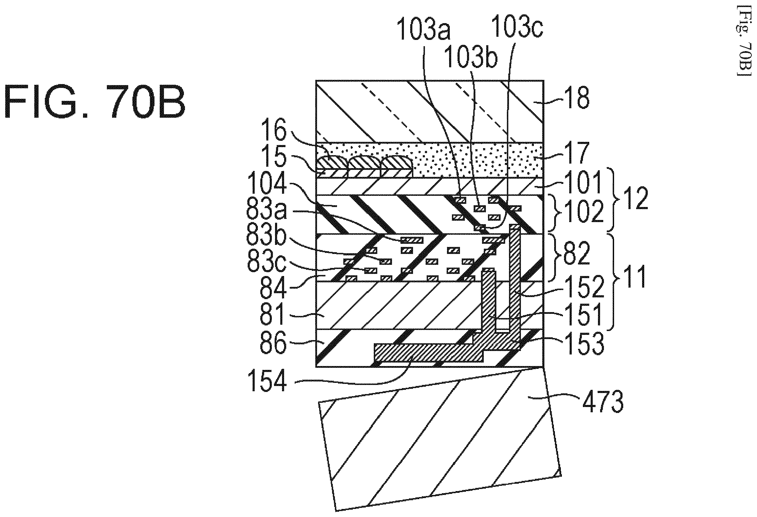

Next, as illustrated in Fig. 70B, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 473 is de-bonded.

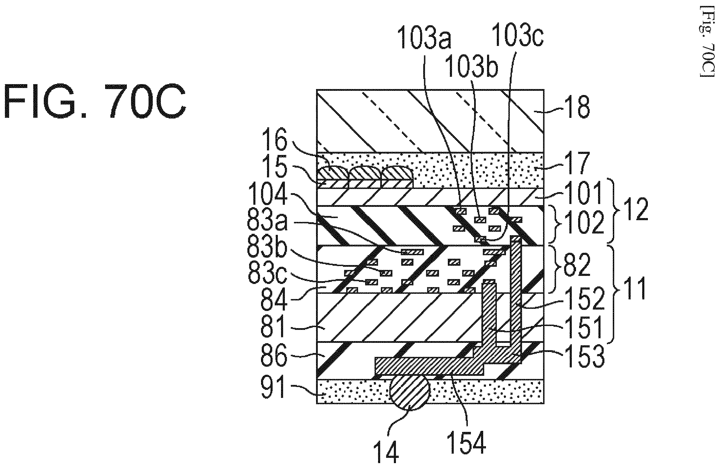

Finally, as illustrated in Fig. 70C, the solder mask 91 is formed on the entire surface, the solder mask 91 is removed only in the region on which the solder ball 14 is mounted, and then the solder ball 14 is formed by the solder-ball mounting method or the like.

According to the foregoing manufacturing method, the solid-state imaging device 1 in Fig. 1 having the structure according to the first modification example illustrated in Fig. 6 is completed.

In the face-to-face structure illustrated in Fig. 6, the connection wiring 153 connecting the silicon through electrode 151 to the chip through electrode 152 is configured to be formed on the upper surface of the silicon substrate 81.

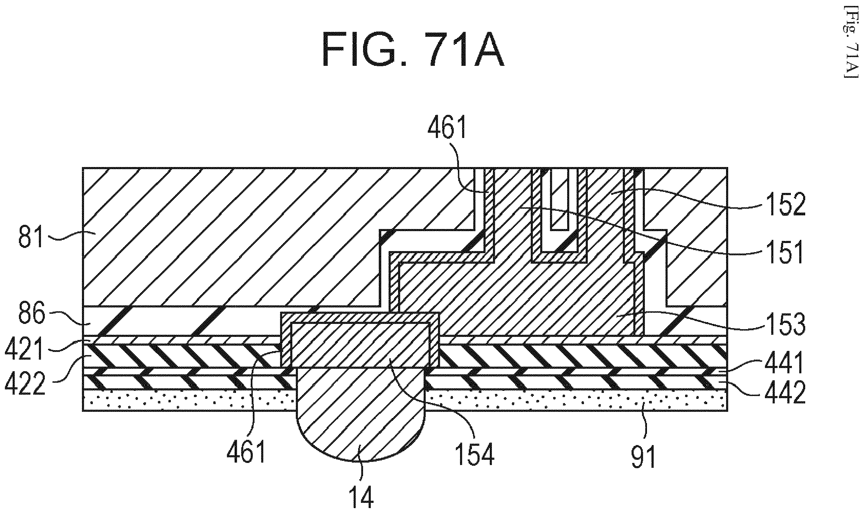

However, as illustrated in Fig. 71A, at least a part of the connection wiring 153 formed by the damascene method may be formed in a portion formed by engraving the silicon substrate 81.

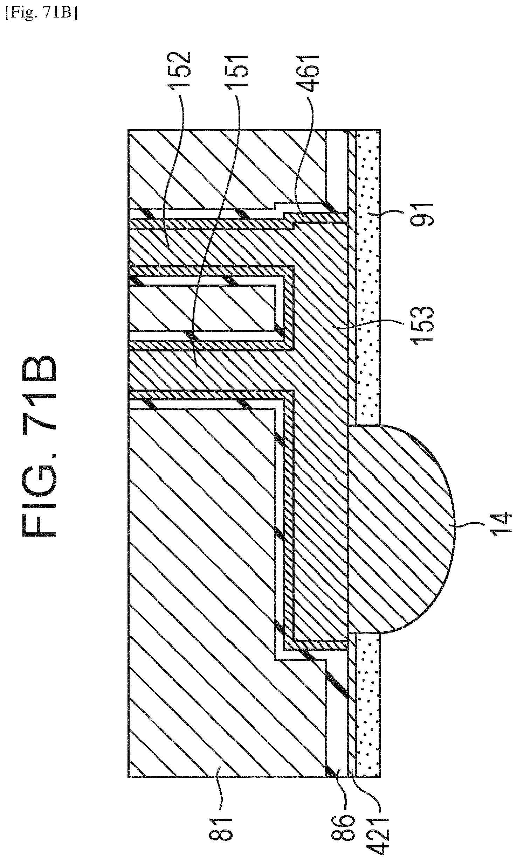

Fig. 71B illustrates an example of a structure in which the rewiring 154 connected to the solder ball 14 is omitted and the connection wiring 153 formed by the damascene method is formed in the portion formed by engraving the silicon substrate 81.

Thus, by forming the connection wiring 153 in the portion formed by engraving the silicon substrate 81, the insulation film (oxide film) 86 may be thin. Therefore, since the number of processes of forming the insulation film can be reduced, productivity is improved.

### <Third Manufacturing Method of First Modification Example>

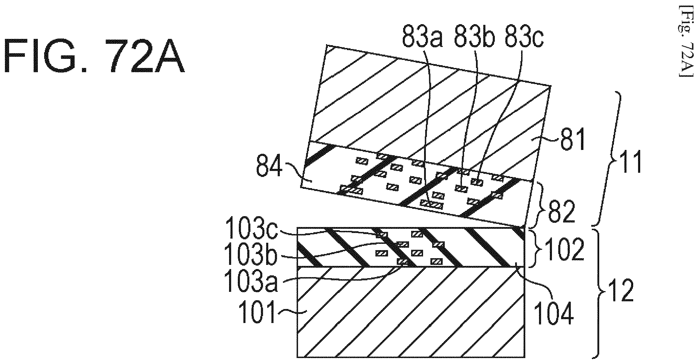

Next, a third method of manufacturing the solid-state imaging device 1 having the structure according to the first modification example illustrated in Fig. 6 will be described with reference to Figs. 72A to 73D.

First, as illustrated in Fig. 72A, the half-finished logic substrate 11 and pixel sensor substrate 12 which are separately manufactured are pasted so that the wiring layers thereof face each other.

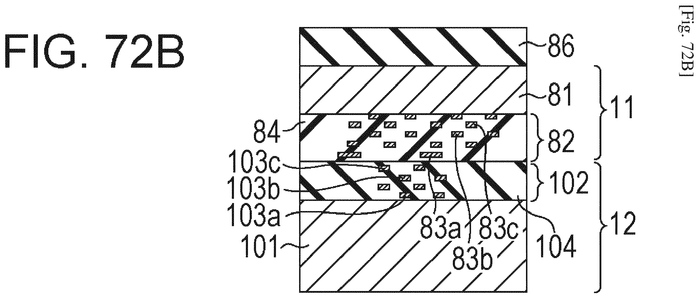

As illustrated in Fig. 72B, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

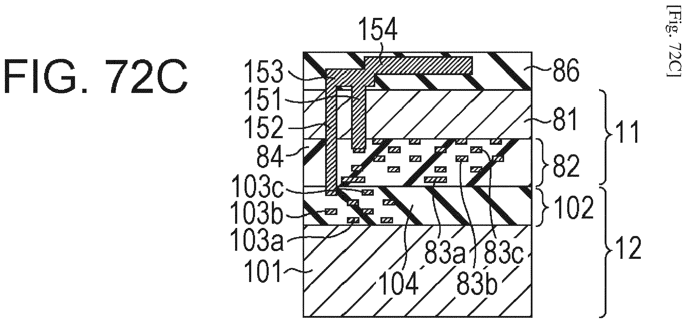

Next, as illustrated in Fig. 72C, the silicon through electrode 151, the chip through electrode 152, the connection wiring 153, and the rewiring 154 are formed at predetermined positions of the silicon substrate 81 on the side of the logic substrate 11. The forming method is the same as the above-described method.

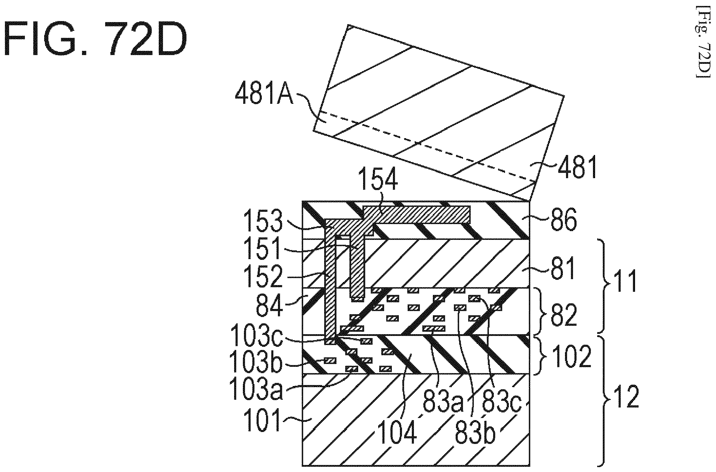

Next, the surface of the insulation film 86 of the logic substrate 11 is flattened by a CMP method. Thereafter, as illustrated in Fig. 72D, a provisional bonded substrate 481 including a peeling layer 481A such as a porous layer is pasted by plasma bonding. Since flatness of the entire thickness can be set vary by about 0.5 micrometers by provisionally pasting the provisional bonded substrate 481 by plasma bonding, it is easy to control the film thickness at the time of the thinning of the silicon substrate 101 of the pixel sensor substrate 12 in the subsequent process.

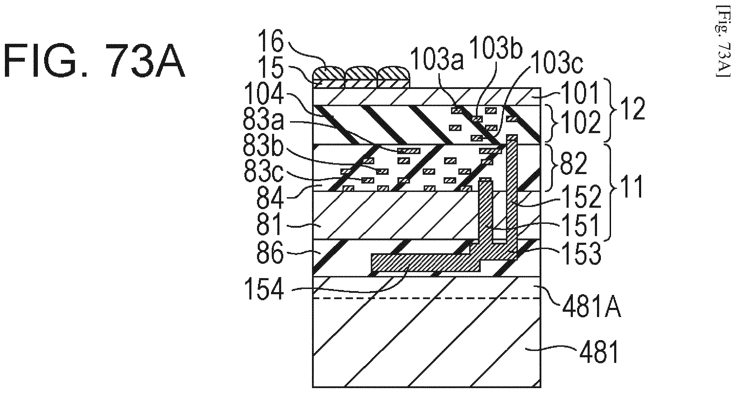

Next, as illustrated in Fig. 73A, all of the substrates to which the provisional bonded substrate 481 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

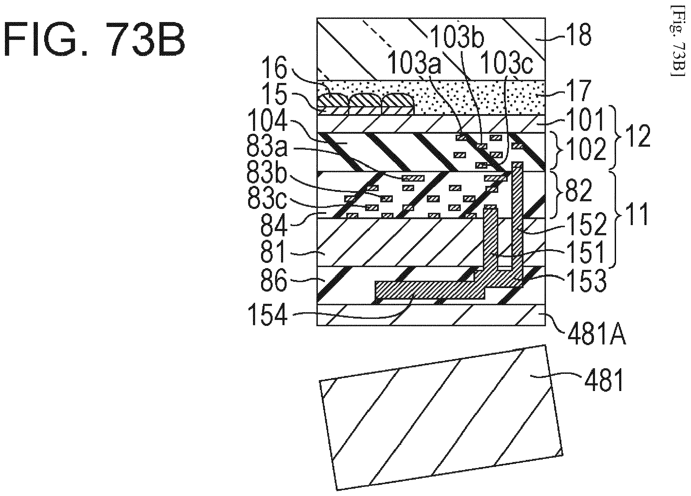

Next, as illustrated in Fig. 73B, after the glass seal resin 17 is applied to the entire surface on which the on-chip lenses 16 of the pixel sensor substrate 12 are formed, the glass protective substrate 18 is connected with the cavityless structure.

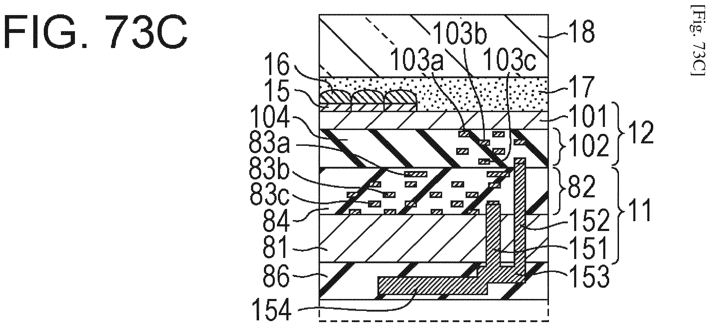

After the glass protective substrate 18 is connected, the provisional bonded substrate 481 is de-bonded with the peeling layer 481A remaining. Then, as illustrated in Fig. 73C, the peeling layer 481A is removed by grinding, polishing, or the like.

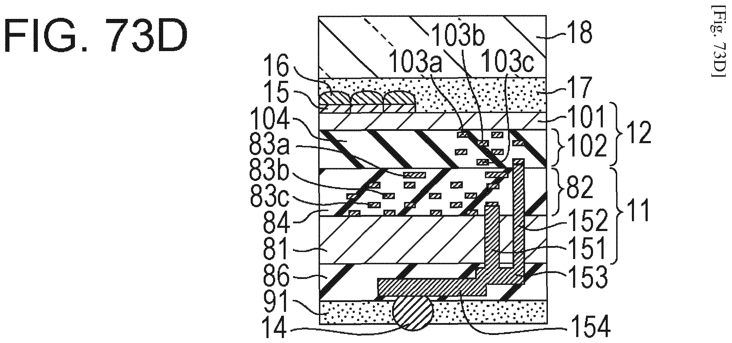

Finally, as illustrated in Fig. 73D, the solder mask 91 is formed on the entire surface, the solder mask 91 is removed only in the region on which the solder ball 14 is mounted, and then the solder ball 14 is formed by the solder-ball mounting method or the like.

According to the foregoing manufacturing method, the solid-state imaging device 1 in Fig. 1 having the structure according to the first modification example illustrated in Fig. 6 is completed.

### <Fourth Manufacturing Method of First Modification Example>

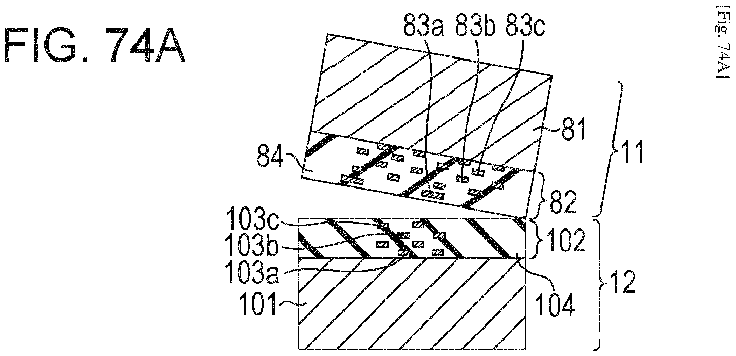

Next, a fourth method of manufacturing the solid-state imaging device 1 having the structure according to the first modification example illustrated in Fig. 6 will be described with reference to Figs. 74A to 75D.

First, as illustrated in Fig. 74A, the half-finished logic substrate 11 and pixel sensor substrate 12 which are separately manufactured are pasted so that the wiring layers thereof face each other.

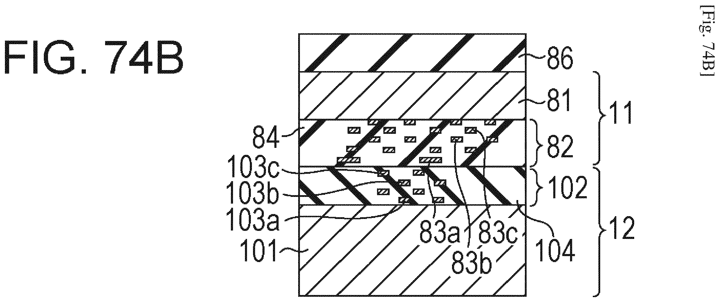

As illustrated in Fig. 74B, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

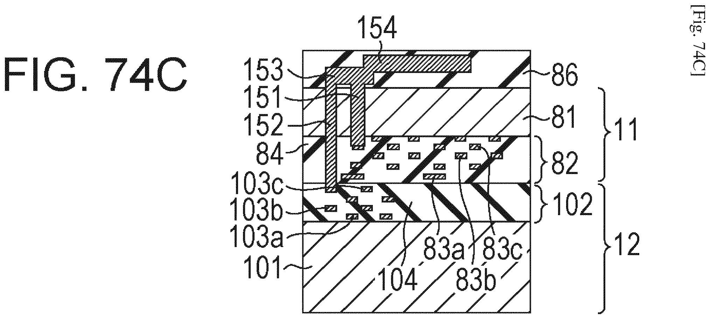

Next, as illustrated in Fig. 74C, the silicon through electrode 151, the chip through electrode 152, the connection wiring 153, and the rewiring 154 are formed at predetermined positions of the silicon substrate 81 on the side of the logic substrate 11. The forming method is the same as the above-described method.

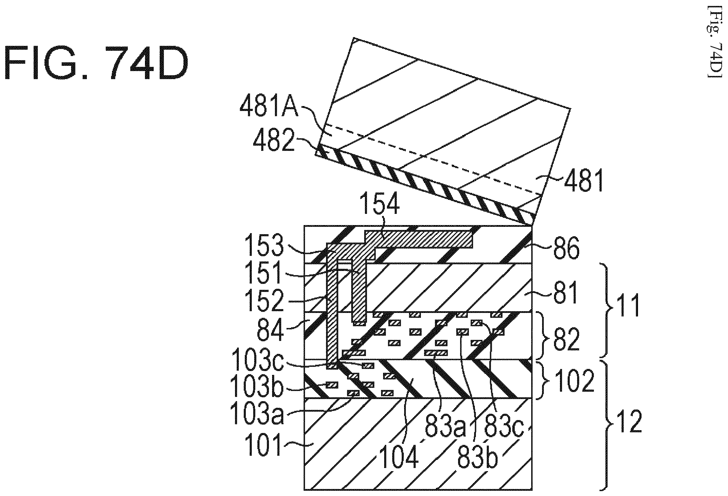

Next, the surface of the insulation film 86 of the logic substrate 11 is flattened by a CMP method. Thereafter, as illustrated in Fig. 74D, the provisional bonded substrate 481 is pasted as a support substrate by plasma bonding. In the provisional bonded substrate 481, a reliable insulation film 482 formed of SiN or the like is formed in advance on a bonded surface having a peeling layer 481A such as porous layer, and the insulation film 482 of the provisional bonded substrate 481 and the insulation film 86 of the logic substrate 11 are pasted to each other. Since flatness of the entire thickness can be set to vary by about 0.5 micrometers by provisionally pasting the provisional bonded substrate 481 by plasma bonding, it is easy to control the film thickness at the time of the thinning of the silicon substrate 101 of the pixel sensor substrate 12 in the subsequent process.

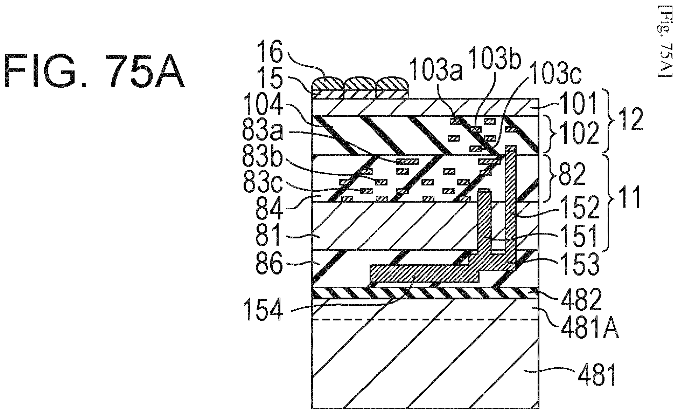

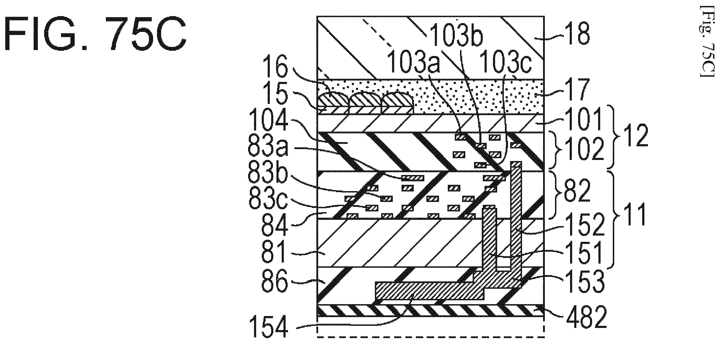

Next, as illustrated in Fig. 75A, all of the substrates to which the provisional bonded substrate 481 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

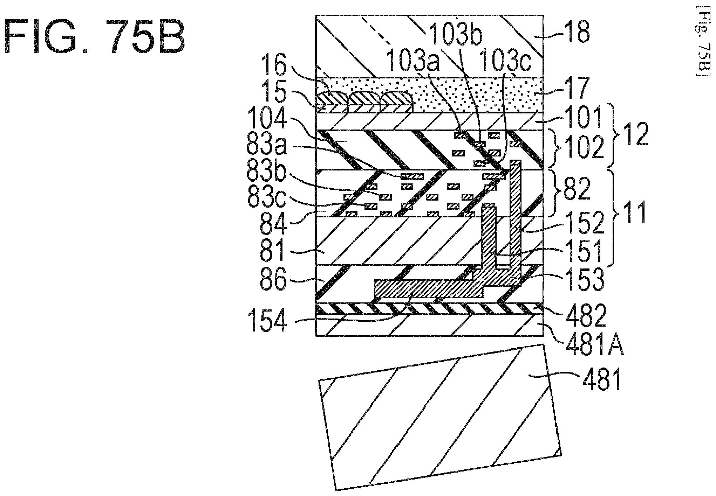

Next, as illustrated in Fig. 75B, after the glass seal resin 17 is applied to the entire surface on which the on-chip lenses 16 of the pixel sensor substrate 12 are formed, the glass protective substrate 18 is connected with the cavityless structure.

After the glass protective substrate 18 is connected, the provisional bonded substrate 481 is de-bonded with the peeling layer 481A remaining. Then, the peeling layer 481A is removed by grinding, polishing, or the like so that the reliable insulation film 482 is exposed.

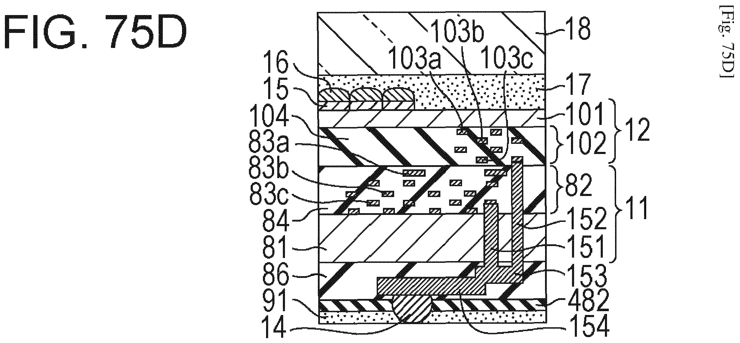

Finally, as illustrated in Fig. 75D, the solder mask 91 is formed on the entire surface, the solder mask 91 is removed only in the region on which the solder ball 14 is mounted, and then the solder ball 14 is formed by the solder-ball mounting method or the like.

According to the foregoing manufacturing method, the solid-state imaging device 1 in Fig. 1 having the structure according to the first modification example illustrated in Fig. 6 is completed.

According to the third and fourth manufacturing methods of the above-described first modification example, the provisional bonded substrate 481 can be reused, the manufacturing cost can be lowered.

### <Fifth Manufacturing Method of First Modification Example>

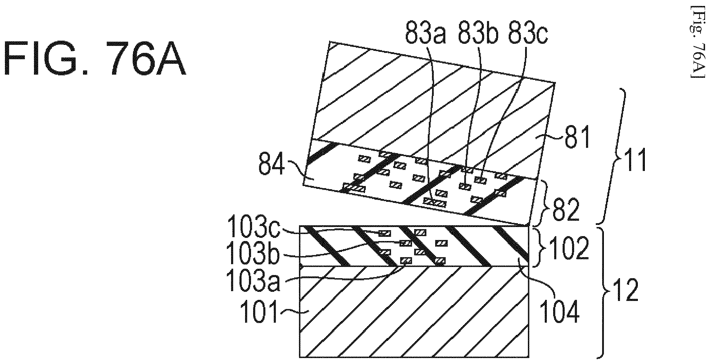

Next, a fifth method of manufacturing the solid-state imaging device 1 having the structure according to the first modification example illustrated in Fig. 6 will be described with reference to Figs. 76A to 77C.

First, as illustrated in Fig. 76A, the half-finished logic substrate 11 and pixel sensor substrate 12 which are separately manufactured are pasted so that the wiring layers thereof face each other.

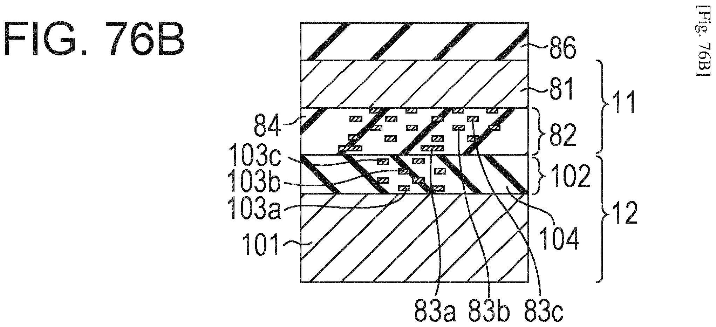

As illustrated in Fig. 76B, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

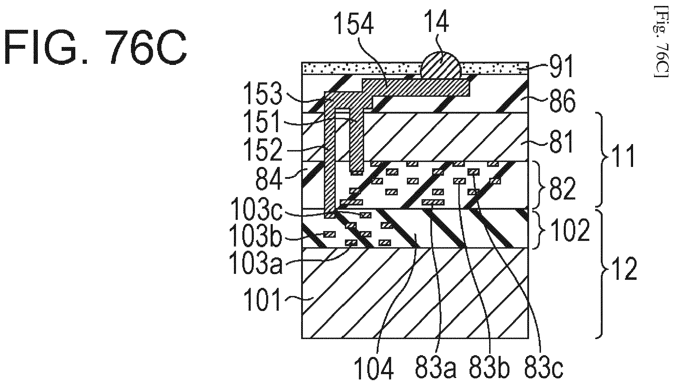

Next, as illustrated in Fig. 76C, the silicon through electrode 151, the chip through electrode 152, the connection wiring 153, and the rewiring 154 are formed at predetermined positions of the silicon substrate 81 on the side of the logic substrate 11. The forming method is the same as the above-described method.

Further, the solder mask 91 is formed on the entire surface, the solder mask 91 is removed only in the region on which the solder ball 14 is mounted, and then the solder ball 14 is formed by the solder-ball mounting method or the like.

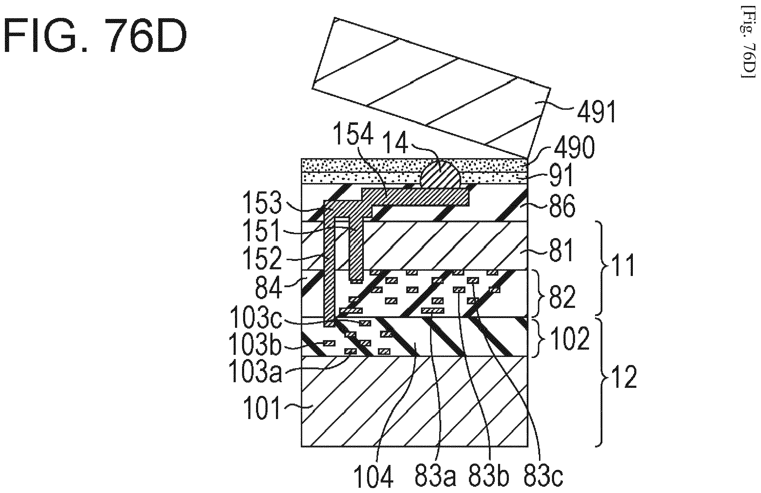

Next, as illustrated in Fig. 76D, a provisional bonded substrate 491 is pasted using an adhesive 490 with a thickness by which the solder ball 14 is concealed.

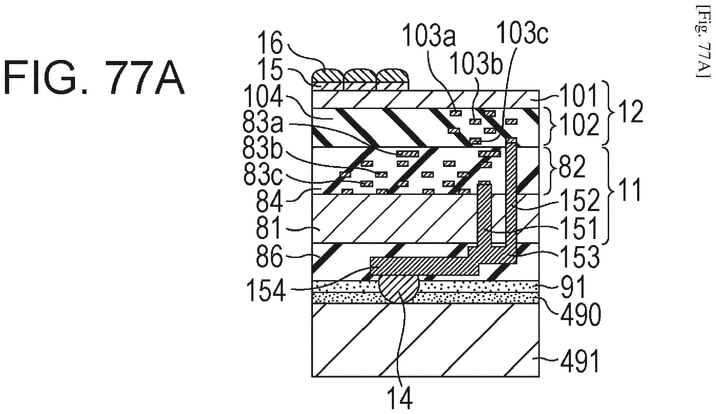

Next, as illustrated in Fig. 77A, all of the substrates to which the provisional bonded substrate 491 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

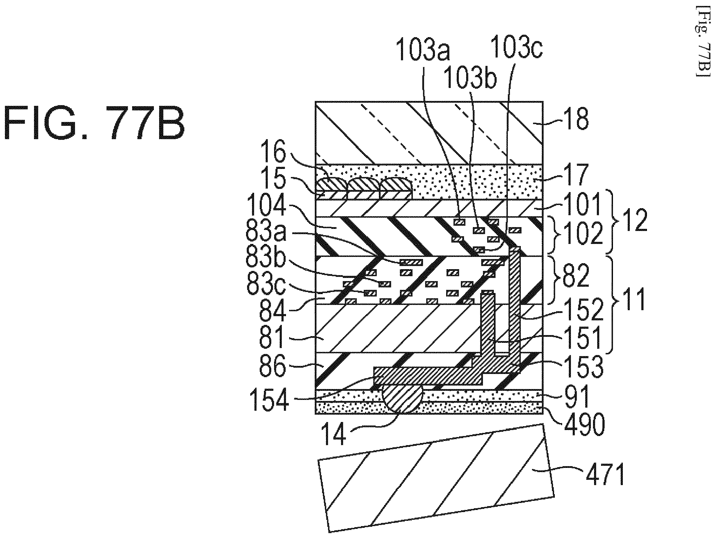

Next, as illustrated in Fig. 77B, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 491 is de-bonded.

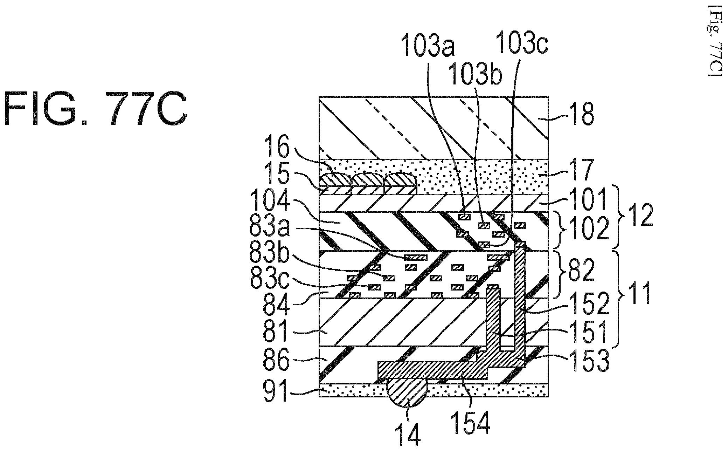

As illustrated in Fig. 77C, the adhesive 490 adhering the provisional bonded substrate 491 is removed.

According to the foregoing manufacturing method, the solid-state imaging device 1 in Fig. 1 having the structure according to the first modification example illustrated in Fig. 6 is completed.

### <Sixth Manufacturing Method of First Modification Example>

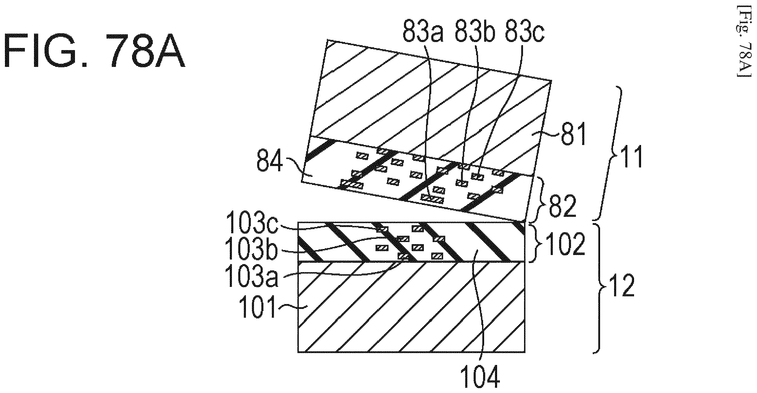

Next, a sixth method of manufacturing the solid-state imaging device 1 having the structure according to the first modification example illustrated in Fig. 6 will be described with reference to Figs. 78A to 80C.

First, as illustrated in Fig. 78A, the half-finished logic substrate 11 and pixel sensor substrate 12 which are separately manufactured are pasted so that the wiring layers thereof face each other.

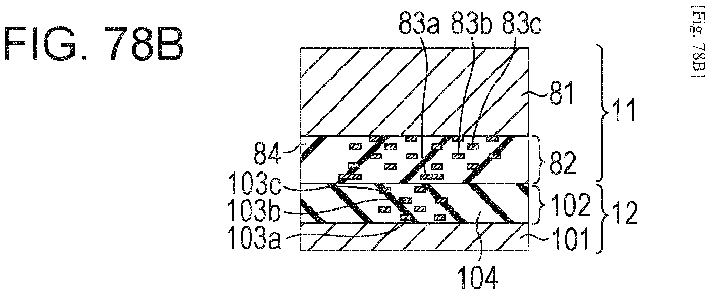

As illustrated in Fig. 78B, the silicon substrate 101 of the pixel sensor substrate 12 is thinned to be about 1 micrometer to about 10 micrometers using the silicon substrate 81 of the logic substrate 11 as a support substrate.

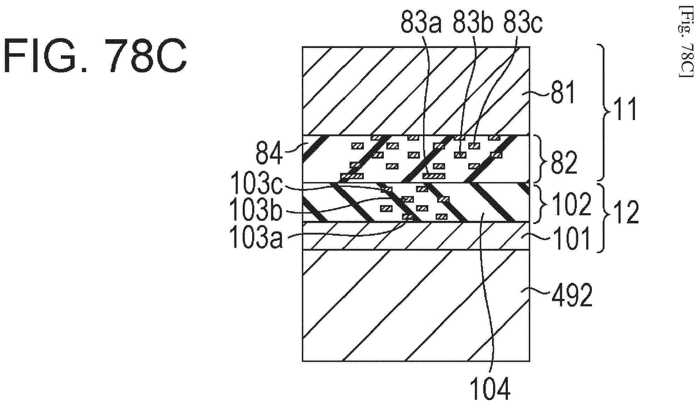

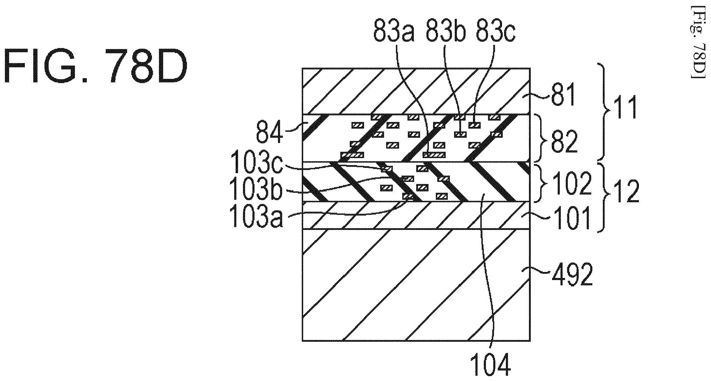

Next, as illustrated in Fig. 78C, a provisional bonded substrate (silicon substrate) 492 is pasted to the thinned silicon substrate 101 of the pixel sensor substrate 12. At this time, as illustrated in Fig. 78D, the silicon substrate 81 of the logic substrate 11 is thinned to be 20 micrometers to about 100 micrometers using the provisional bonded substrate 492 as a support substrate.

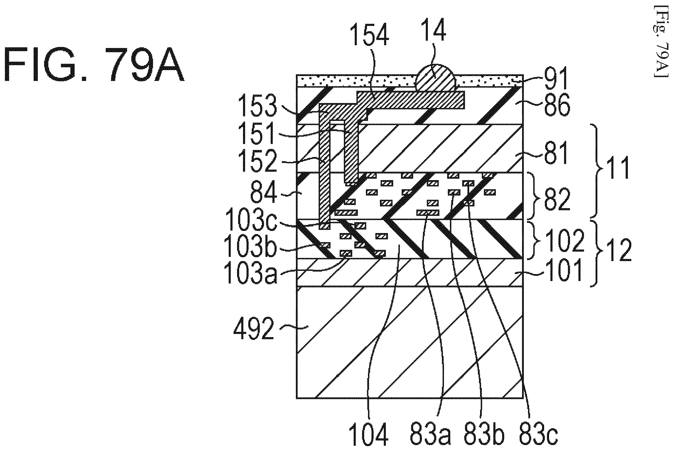

Next, as illustrated in Fig. 79A, the silicon through electrode 151, the chip through electrode 152, the connection wiring 153, and the rewiring 154 are formed at predetermined positions of the silicon substrate 81 on the side of the logic substrate 11. The forming method is the same as the above-described method.

Further, the solder mask 91 is formed on the entire surface, the solder mask 91 is removed only in the region on which the solder ball 14 is mounted, and then the solder ball 14 is formed by the solder-ball mounting method or the like.

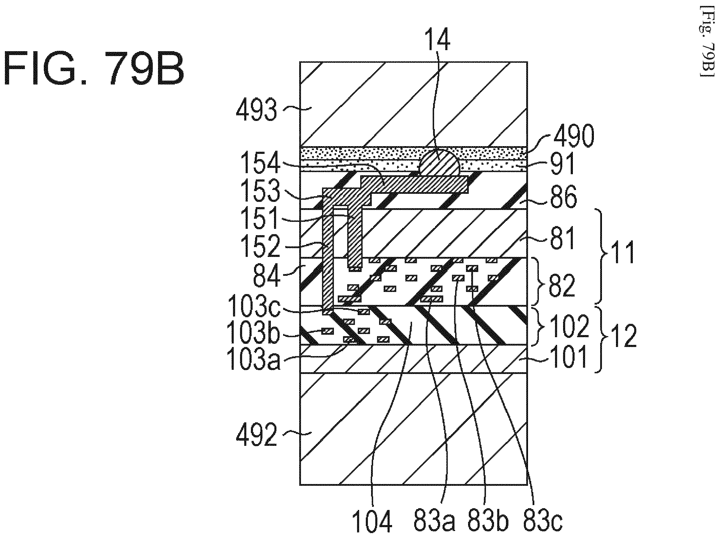

Next, as illustrated in Fig. 79B, a provisional bonded substrate 493 is pasted using an adhesive 490 with a thickness by which the solder ball 14 is concealed.

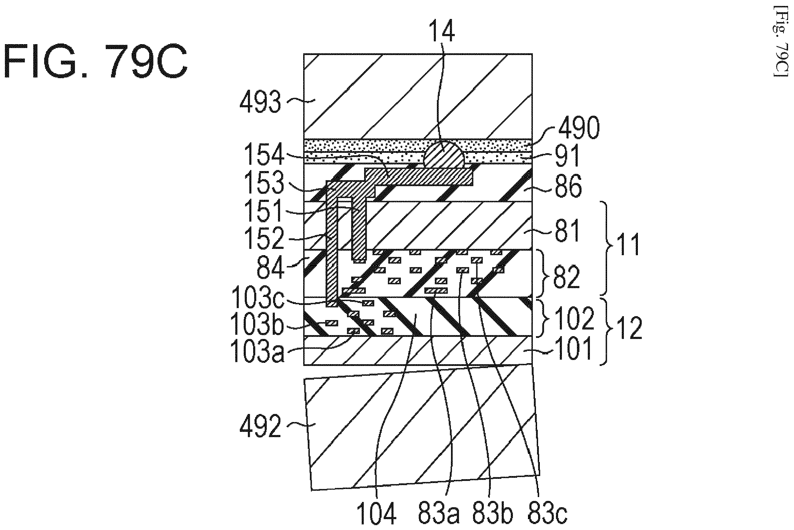

Next, as illustrated in Fig. 79C, the provisional bonded substrate 492 on the side of the pixel sensor substrate 12 is de-bonded.

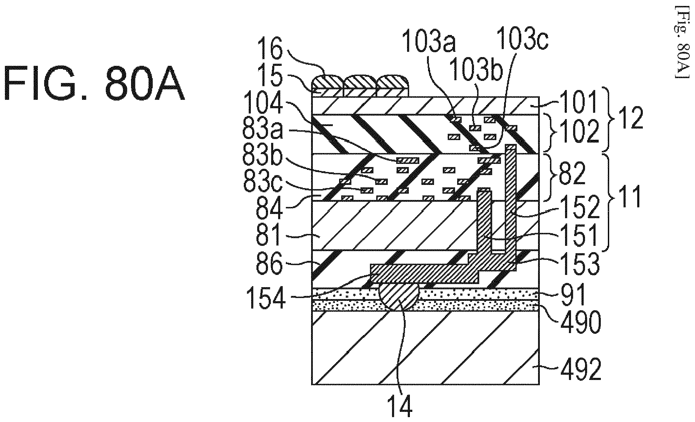

Next, as illustrated in Fig. 80A, all of the substrates to which the provisional bonded substrate 492 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

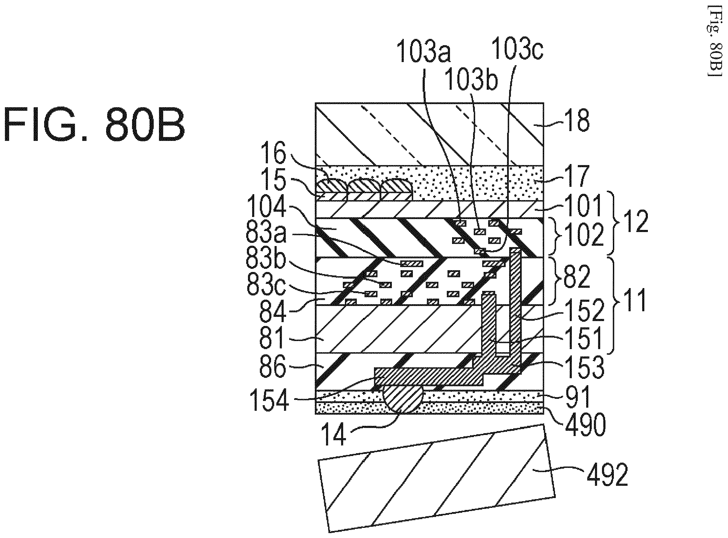

Next, as illustrated in Fig. 80B, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 492 is de-bonded.

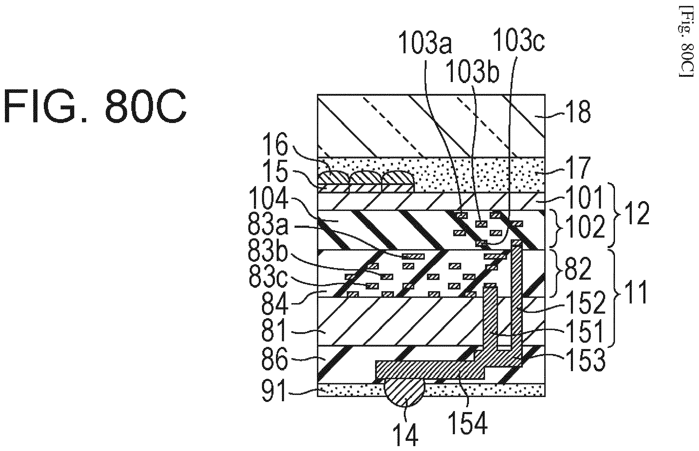

As illustrated in Fig. 80C, the adhesive 490 adhering the provisional bonded substrate 492 is removed.

According to the foregoing manufacturing method, the solid-state imaging device 1 in Fig. 1 having the structure according to the first modification example illustrated in Fig. 6 is completed.

### <First Manufacturing Method of Second Modification Example>

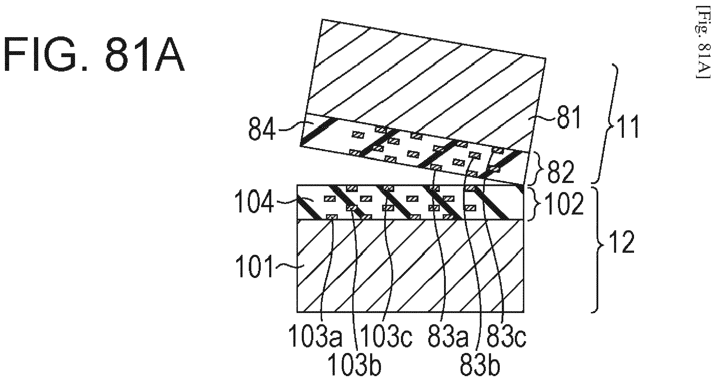

Next, a first method of manufacturing the solid-state imaging device 1 having the structure according to the second modification example illustrated in Fig. 7 will be described with reference to Figs. 81A to 82D. The structure according to the second modification example illustrated in Fig. 7 is a face-to-face structure using metal bond (Cu-Cu bond).

First, as illustrated in Fig. 81A, the wiring layer 83a of the multi-layer wiring layer 82 of the half-finished logic substrate 11 and the wiring layer 103c of the multi-layer wiring layer 102 of the half-finished pixel sensor substrate 12 which are separately manufactured are pasted by the metal bond (Cu-Cu).

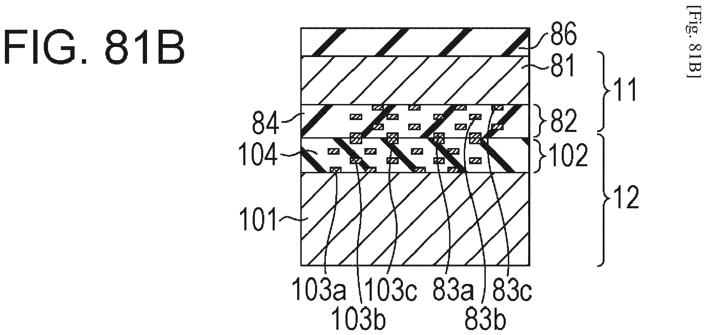

As illustrated in Fig. 81B, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

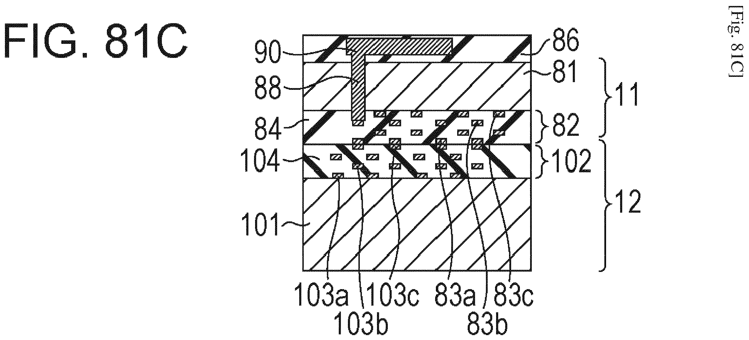

Next, as illustrated in Fig. 81C, the silicon through electrode 88 and the rewiring 90 are formed at predetermined positions of the silicon substrate 81 on the side of the logic substrate 11. The forming method is the same as the above-described method of forming the silicon through electrode 151 and the rewiring 154.

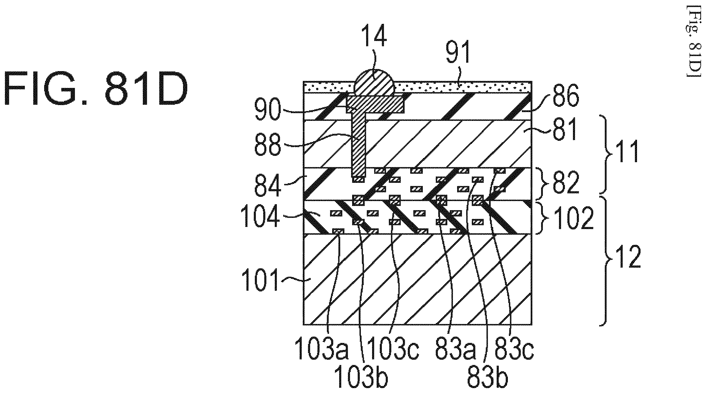

As illustrated in Fig. 81D, up to the solder mask 91 and the solder ball 14 may be formed after this process, as in the process illustrated in Fig. 76C.

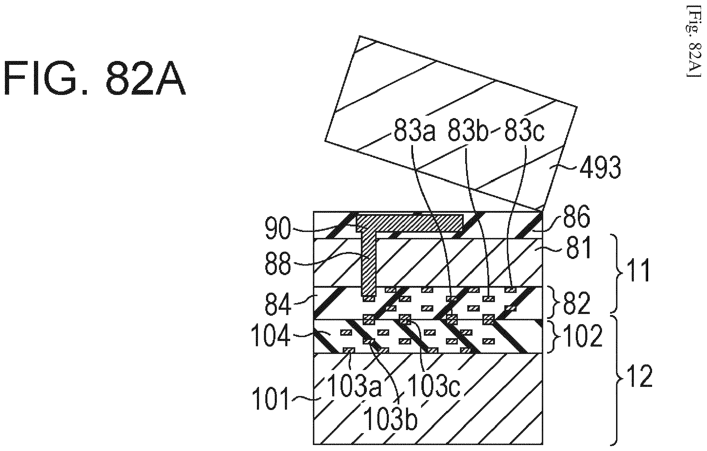

Next, as illustrated in Fig. 82A, a provisional bonded substrate (silicon substrate) 493 is pasted as a support substrate to the side of the insulation film 86 of the logic substrate 11.

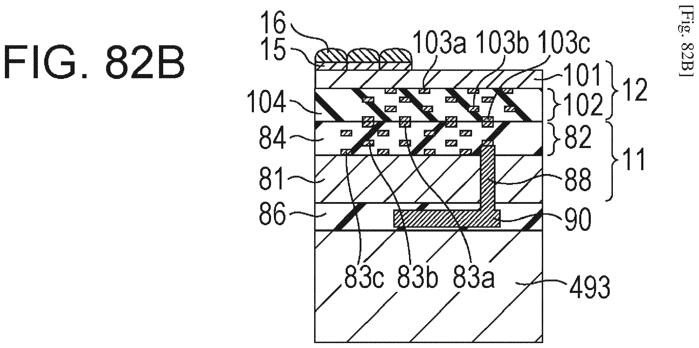

Next, as illustrated in Fig. 82B, all of the substrates to which the provisional bonded substrate 493 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

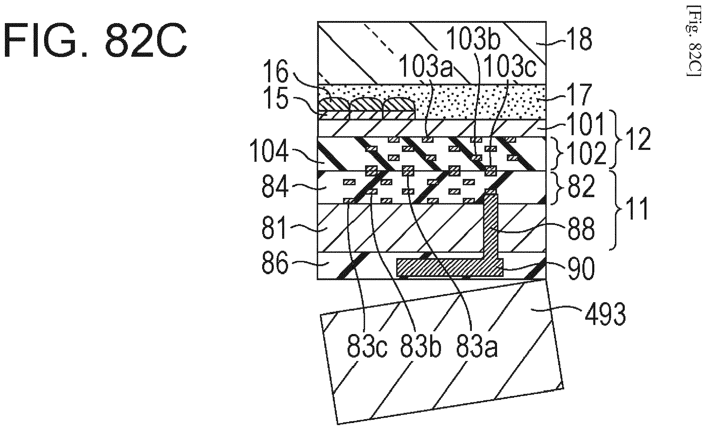

Next, as illustrated in Fig. 82C, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 493 is de-bonded.

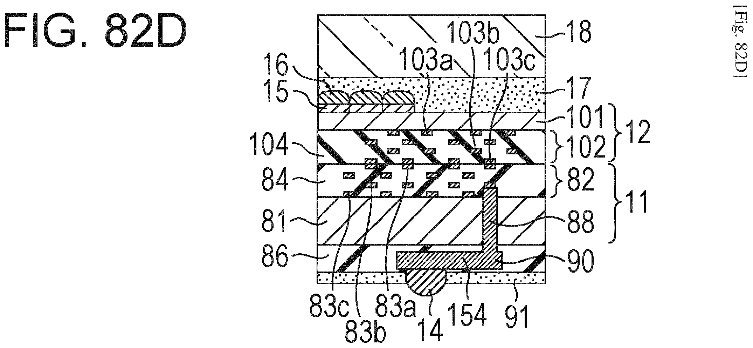

As illustrated in Fig. 82D, the solder mask 91 is formed on the entire surface, the solder mask 91 is removed only in the region on which the solder ball 14 is mounted, and then the solder ball 14 is formed by the solder-ball mounting method or the like.

As illustrated in Fig. 81D, when up to the solder mask 91 and the solder ball 14 are formed on the insulation film 86 and then the provisional bonded substrate 493 is adhered, the provisional bonded substrate 493 may be de-bonded and then the adhesive may be merely removed.

According to the foregoing manufacturing method, the solid-state imaging device 1 in Fig. 1 having the structure according to the second modification example illustrated in Fig. 7 is completed.

### <Second Manufacturing Method of Second Modification Example>

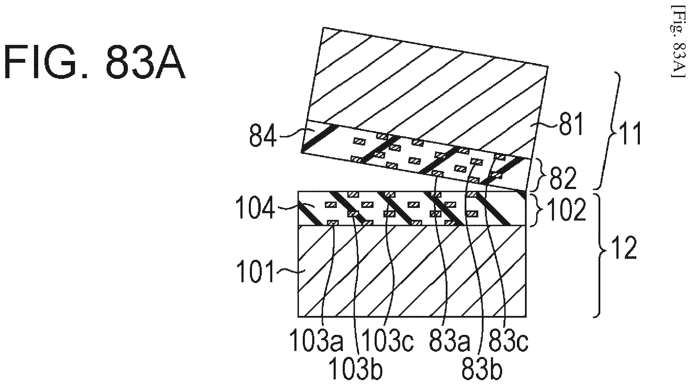

Next, a second method of manufacturing the solid-state imaging device 1 having the structure according to the second modification example illustrated in Fig. 7 will be described with reference to Figs. 83A to 85C.

First, as illustrated in Fig. 83A, the wiring layer 83a of the multi-layer wiring layer 82 of the half-finished logic substrate 11 and the wiring layer 103c of the multi-layer wiring layer 102 of the half-finished pixel sensor substrate 12 which are separately manufactured are pasted together by the metal bond (Cu-Cu).

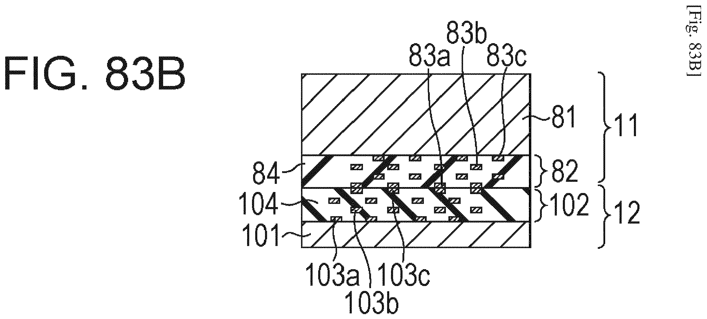

As illustrated in Fig. 83B, the silicon substrate 101 of the pixel sensor substrate 12 is thinned to be about 1 micrometer to about 10 micrometers using the silicon substrate 81 of the logic substrate 11 as a support substrate.

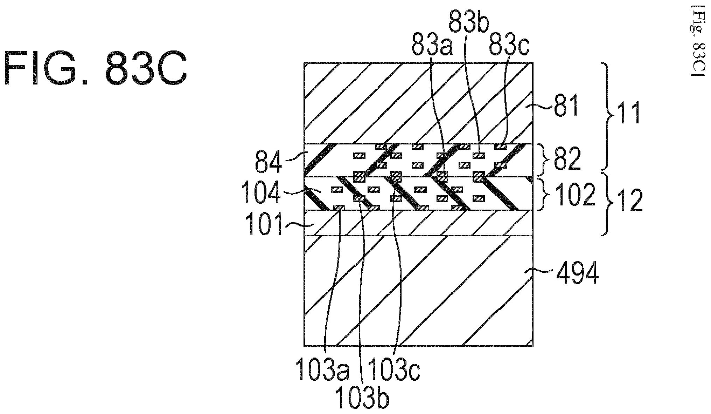

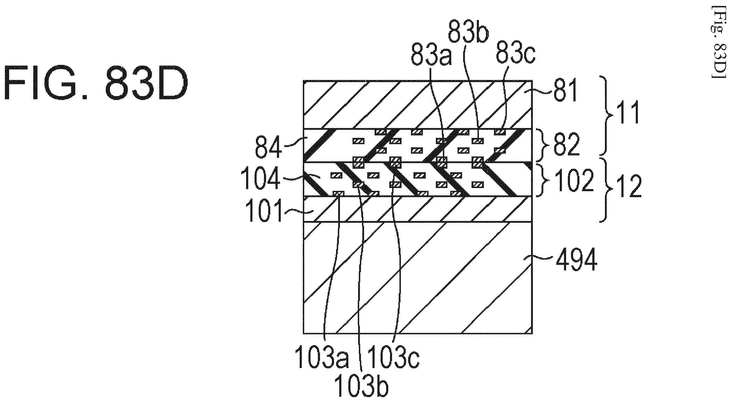

Next, as illustrated in Fig. 83C, a provisional bonded substrate (silicon substrate) 494 is pasted to the thinned silicon substrate 101 of the pixel sensor substrate 12. At this time, as illustrated in Fig. 83D, the silicon substrate 81 of the logic substrate 11 is thinned to be 20 micrometers to about 100 micrometers using the provisional bonded substrate 494 as a support substrate.

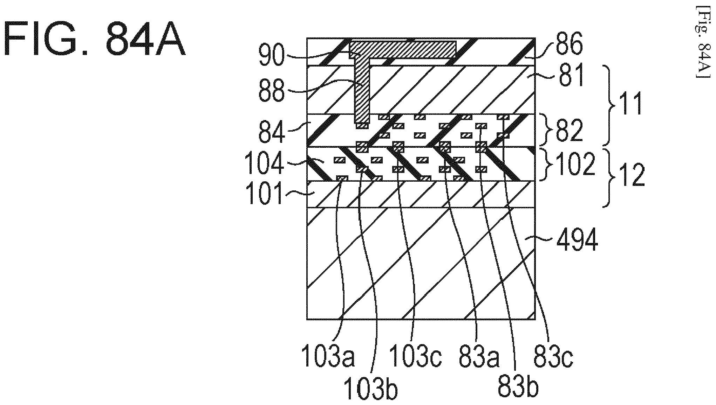

Next, as illustrated in Fig. 84A, the insulation film 86 is formed on the surface of the silicon substrate 81 by a plasma CVD method or the like, and then the silicon through electrode 88 and the rewiring 90 are formed at predetermined positions of the silicon substrate 81 on the side of the logic substrate 11. The forming method is the same as the above-described method of forming the silicon through electrode 151 and the rewiring 154.

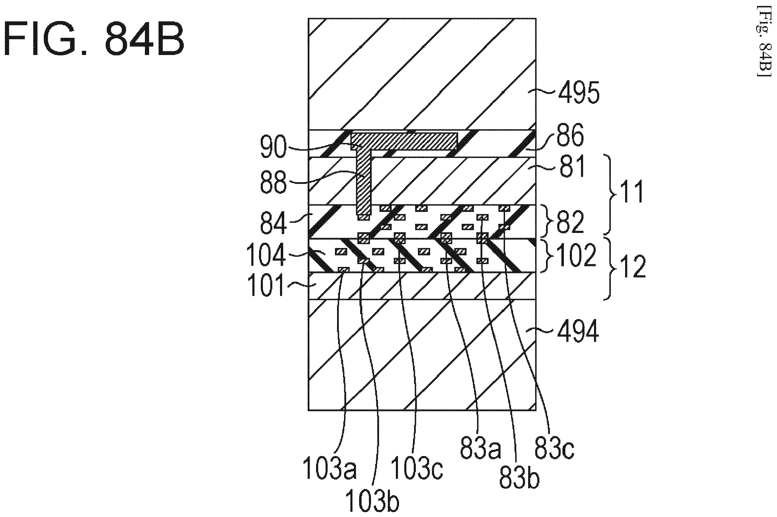

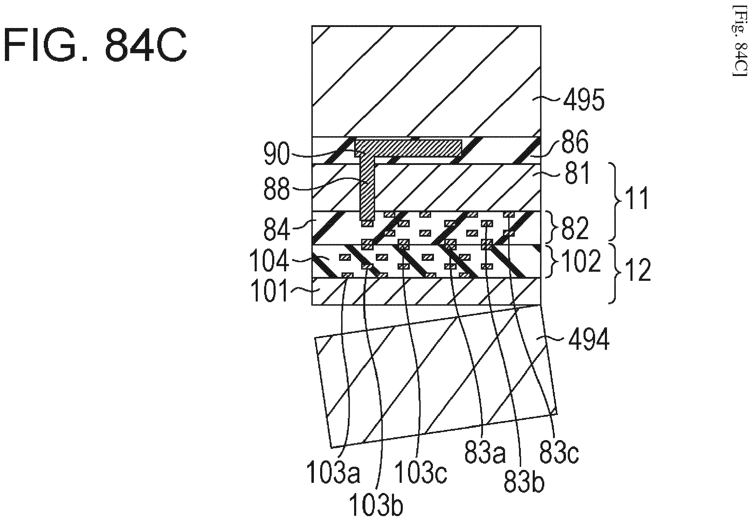

Next, as illustrated in Fig. 84B, a provisional bonded substrate (silicon substrate) 495 is pasted as a support substrate to the side of the insulation film 86 of the logic substrate 11. As illustrated in Fig. 84C, the provisional bonded substrate 494 on the side of the pixel sensor substrate 12 is de-bonded.

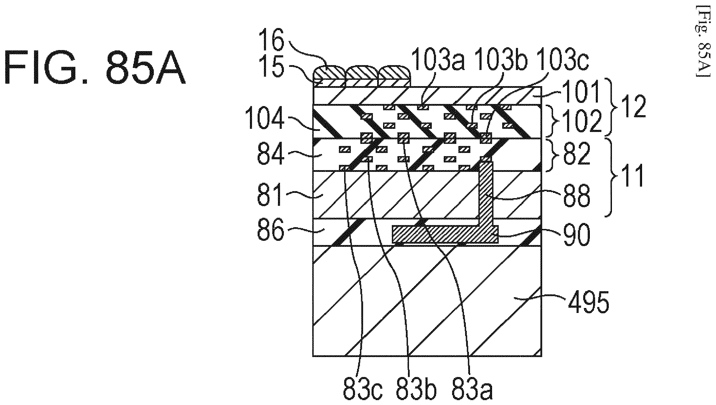

Next, as illustrated in Fig. 85A, all of the substrates to which the provisional bonded substrate 495 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

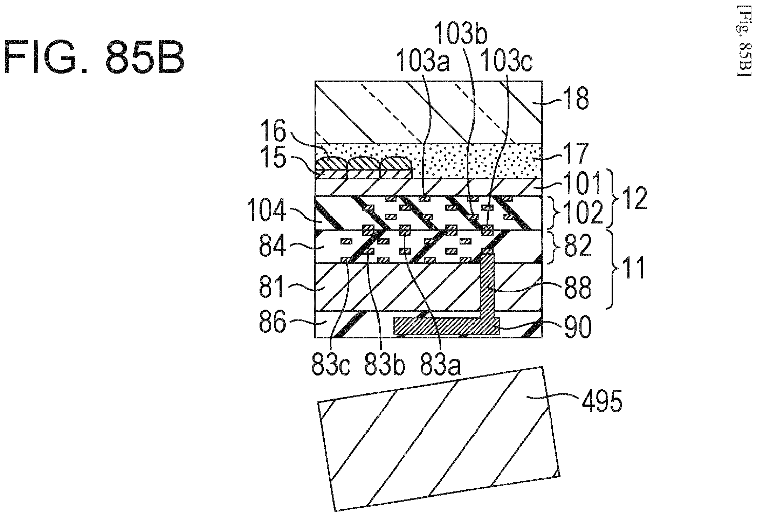

Next, as illustrated in Fig. 85B, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 495 is de-bonded.

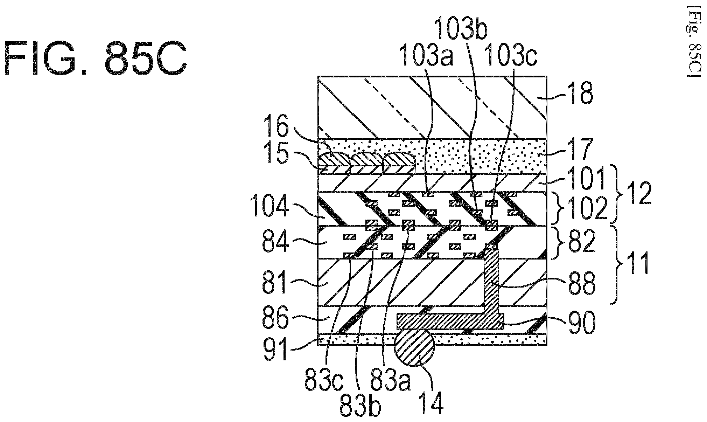

As illustrated in Fig. 85C, the solder mask 91 is formed on the entire surface, the solder mask 91 is removed only in the region on which the solder ball 14 is mounted, and then the solder ball 14 is formed by the solder-ball mounting method or the like.

According to the foregoing manufacturing method, the solid-state imaging device 1 in Fig. 1 having the structure according to the second modification example illustrated in Fig. 7 is completed.

Further, the solder mask 91 and the solder ball 14 are first formed on the insulation film 86 in Fig. 84A, and then the provisional bonded substrate 495 is adhered. In this case, in Fig. 85B, after the provisional bonded substrate 495 is de-bonded, the adhesive adhering the provisional bonded substrate 495 is merely removed.

### <Manufacturing Method of Third Modification Example>

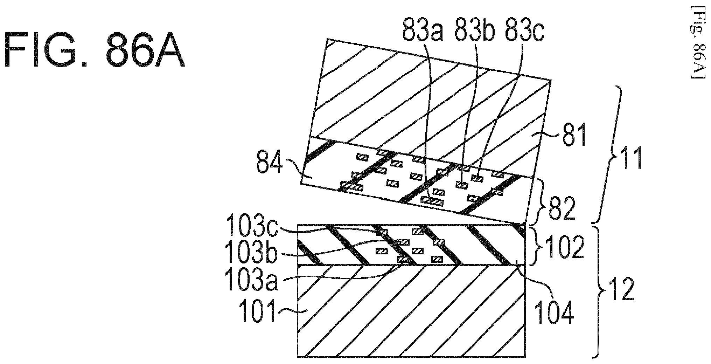

Next, a method of manufacturing the solid-state imaging device 1 having the structure according to the third modification example illustrated in Fig. 8 will be described with reference to Figs. 86A to 87D. The structure according to the third modification example illustrated in Fig. 8 is a face-to-face structure in which the connection wiring 153 and the rewiring 154 are connected to the connection conductor (via) 171.

First, as illustrated in Fig. 86A, the half-finished logic substrate 11 and pixel sensor substrate 12 which are separately manufactured are pasted so that the wiring layers thereof face each other.

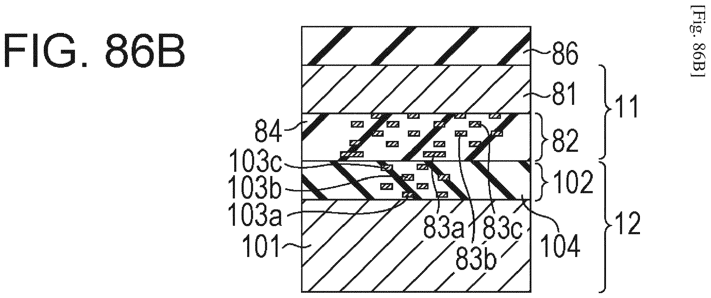

As illustrated in Fig. 86B, after the silicon substrate 81 of the logic substrate 11 is thinned to the extent of having a thickness which does not affect device characteristics, e.g., to the extent of about 20 micrometers to about 100 micrometers, the insulation film 86 for insulation from the silicon substrate 81 is formed on the surface of the silicon substrate 81 by a plasma CVD method or the like.

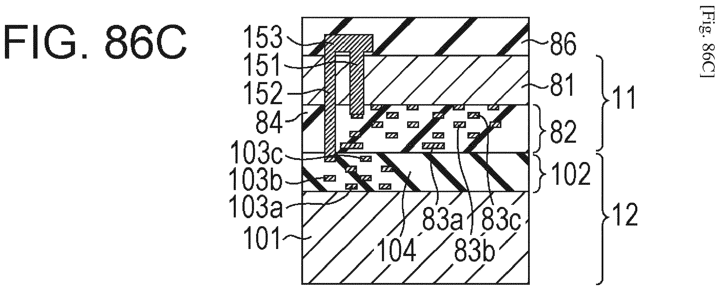

Next, as illustrated in Fig. 86C, the silicon through electrode 151, the chip through electrode 152, and the connection wiring 153 are formed at predetermined positions of the silicon substrate 81 on the side of the logic substrate 11. The forming method is the same as the above-described method.

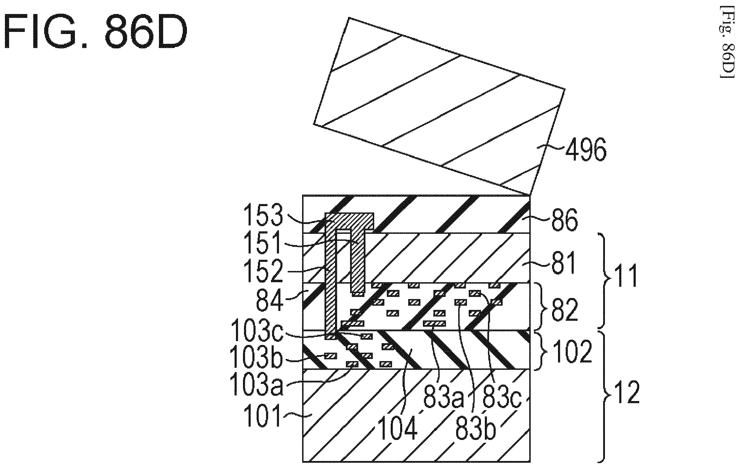

Next, as illustrated in Fig. 86D, a provisional bonded substrate (silicon substrate) 496 is pasted as a support substrate to the side of the insulation film 86 of the logic substrate 11.

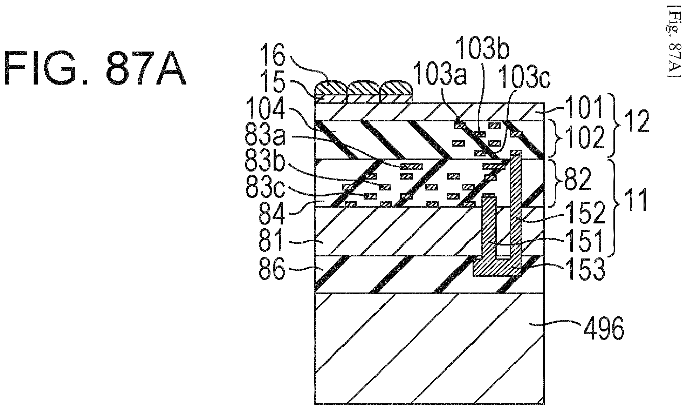

Next, as illustrated in Fig. 87A, all of the substrates to which the provisional bonded substrate 496 is bonded are turned upside down. After the silicon substrate 101 of the pixel sensor substrate 12 is thinned to be about 1 micrometer to about 10 micrometers, the color filters 15 and the on-chip lenses 16 are formed. Further, a high dielectric film such as the high dielectric film 401 in Fig. 15 may be formed on the upper surface of the thinned silicon substrate 101 in order to suppress a dark current.

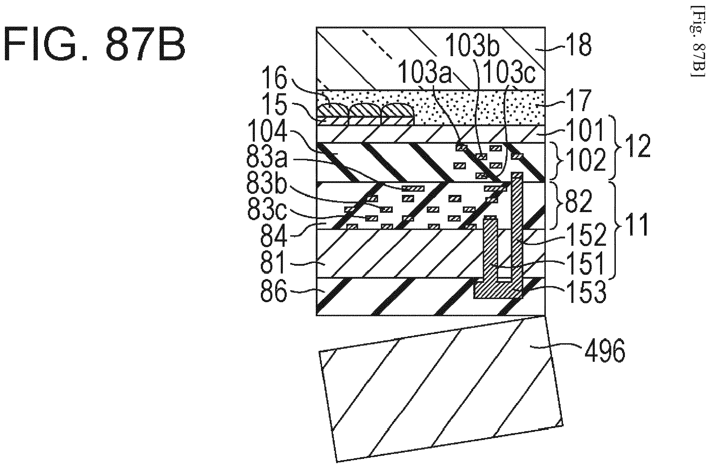

Next, as illustrated in Fig. 87B, after the glass seal resin 17 is applied to the entire surface on which the on-chip lenses 16 of the pixel sensor substrate 12 are formed, the glass protective substrate 18 is connected with the cavityless structure. After the glass protective substrate 18 is connected, the provisional bonded substrate 496 is de-bonded.

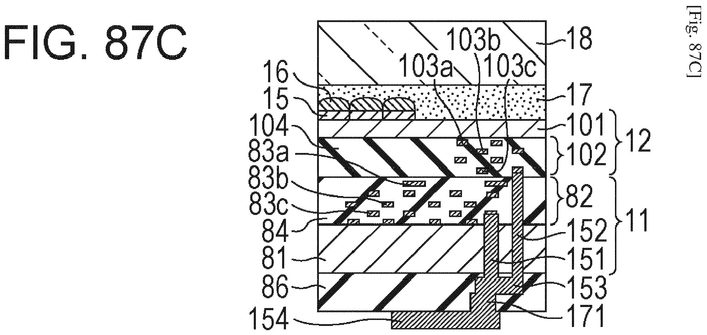

As illustrated in Fig. 87C, a part of the insulation film 86 on the connection wiring 153 is opened by etching, and then the connection conductor (via) 171 and the rewiring 154 are formed by a semi-additive method.

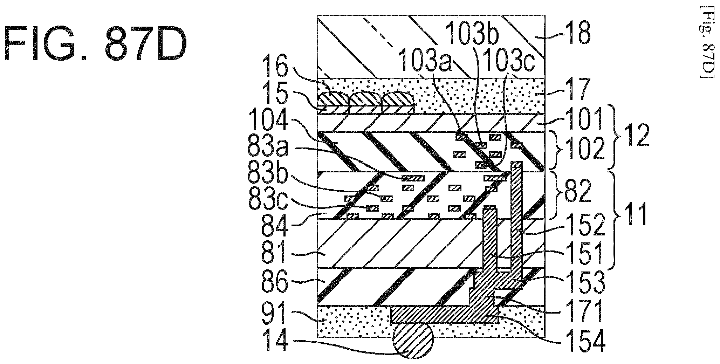

As illustrated in Fig. 87D, after the solder mask 91 is formed to cover the insulation film 86 and the rewiring 154, the solder mask 91 is opened only in the region on which the solder ball 14 is mounted.

Finally, the solder ball 14 is formed in the region in which the solder mask 91 is opened by the solder-ball mounting method or the like.

According to the foregoing manufacturing method, the solid-state imaging device 1 in Fig. 1 having the structure according to the third modification example illustrated in Fig. 8 is completed.

As described above in the first modification example, in the structure according to the above-described first to third modification examples, the connection wiring 153 electrically connecting the logic substrate 11 to the pixel sensor substrate 12 is formed not on the upper side of the silicon substrate 101 of the pixel sensor substrate 12 but on the lower side of the silicon substrate 81 of the logic substrate 11. Thus, since the space (thickness) between the glass protective substrate 18 and the laminated substrate 13 with the cavityless structure can be minimized, the low back of the solid-state imaging device 1 can be achieved, and thus the pixel characteristics can be improved.

### <Manufacturing Method of Fourth Modification Example>

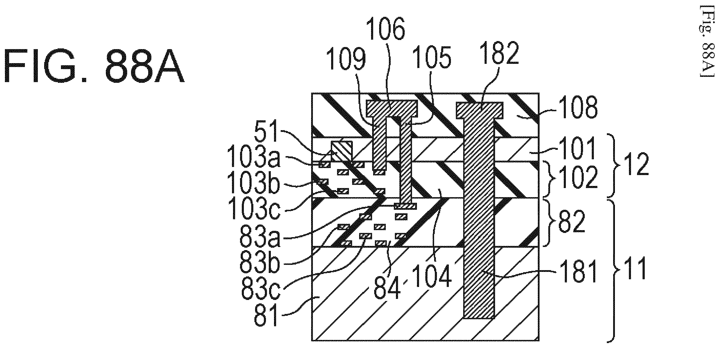

Next, a method of manufacturing the solid-state imaging device 1 having the structure according to the fourth modification example illustrated in Fig. 9 will be described with reference to Figs. 88A to 89D.

The structure according to the fourth modification example illustrated in Fig. 9 is a face-to-face structure in which the solder ball 14, the plurality of wiring layers 83 of the logic substrate 11, and the plurality of wiring layers 103 of the pixel sensor substrate 12 are connected by one chip through electrode 181 penetrating through the logic substrate 11 and the pixel sensor substrate 12.

First, as illustrated in Fig. 88A, the half-finished logic substrate 11 and pixel sensor substrate 12 which are separately manufactured are pasted so that the wiring layers thereof face each other. Then, the silicon through electrode 109, the chip through electrode 105, the connection wiring 106 connecting to the silicon through electrode 109 to the chip through electrode 105, the chip through electrode 181, and the connection wiring 182 are formed. The upper surface of the silicon substrate 101 is covered with the insulation film 108 excluding the silicon through electrode 109, the chip through electrode 105, the connection wiring 106, the chip through electrode 181, and the connection wiring 182. The insulation film 108 may be configured to include a plurality of layers, i.e., a cap film and an insulation film, as in the above-described other embodiments.

In the above-described first to third modification examples, the silicon through electrode 109, the chip through electrode 105, and the connection wiring 106 connecting the chip through electrode 105 to the silicon through electrode 109 are formed on the side of the logic substrate 11. However, in the fourth modification example, as illustrated in Fig. 88A, the silicon through electrode 109, the chip through electrode 105, and the connection wiring 106 are formed on the side of the pixel sensor substrate 12. However, a forming method is the same as the forming method according to the above-described first to fourth modification examples. The chip through electrode 181 and the connection wiring 182 can also be formed simultaneously with the silicon through electrode 109, the chip through electrode 105, and the connection wiring 106.

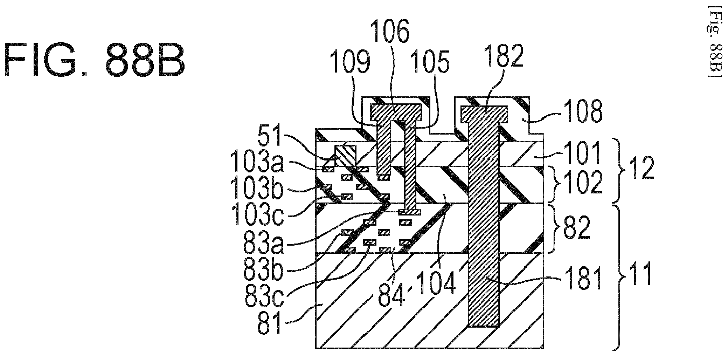

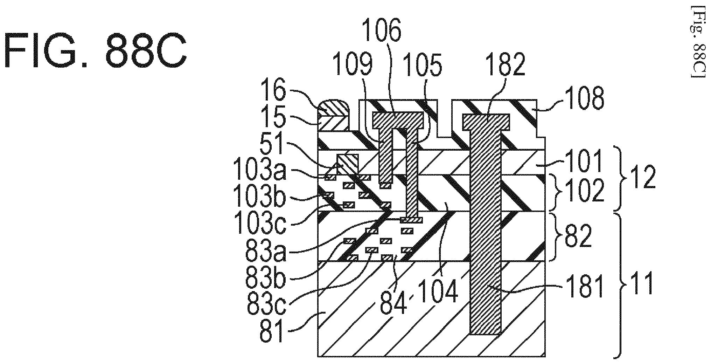

Next, as illustrated in Fig. 88B, necessary regions including the pixel region 21 are engraved in the portion in which the insulation film 108 is formed. Alternatively, or in addition, necessary regions including the pixel region 21 are formed in a groove portion in which the insulation film 108 is formed. As illustrated in Fig. 88C, the color filter 15 and the on-chip lens 16 are formed in the engraved portions of the pixel region 21. Alternatively, or in addition, the color filter 15 and the on-chip lens 16 are formed in the grooved portions of the pixel region 21.

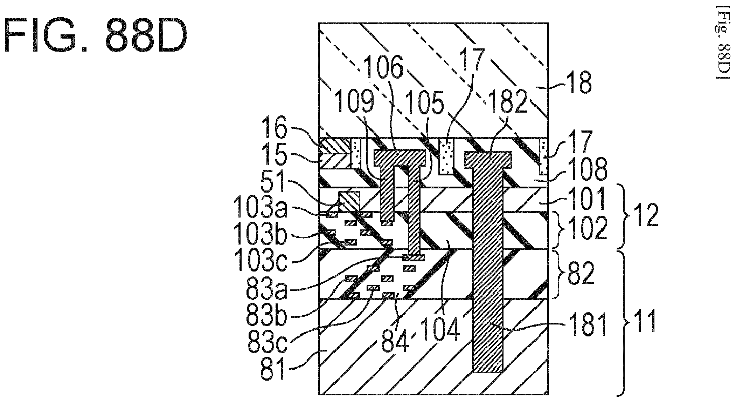

As illustrated in Fig. 88D, after the glass seal resin 17 is applied to the entire surface on which the on-chip lenses 16 of the pixel sensor substrate 12 are formed, the glass protective substrate 18 is connected with the cavityless structure.

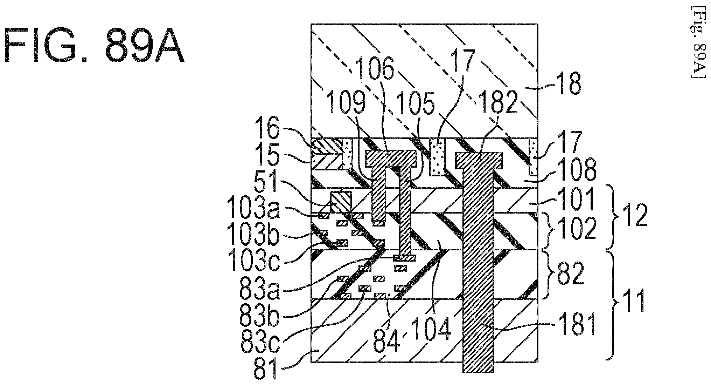

Next, as illustrated in Fig. 89A, the silicon substrate 81 of the logic substrate 11 is subjected to back grinding (polishing) to be thinned using the glass protective substrate 18 as the support substrate. In the back grinding, the chip through electrode 181 is slightly projected from the silicon substrate 81 by a difference in a polishing rate. After the thinning, the surface of the grounded silicon substrate 81 is flattened by a CMP method.

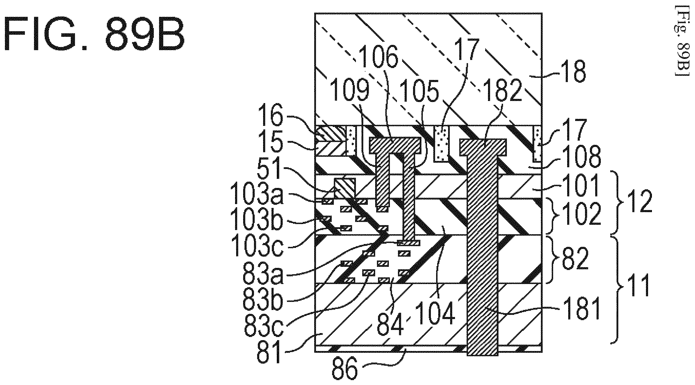

Thereafter, after a TEOS film serving as the insulation film 86 is formed by a plasma CVD method, the formed TEOS film is flattened by a CMP method and a wet etching process is performed using hydrofluoric acid (HF). Then, as illustrated in Fig. 89B, the surface of the silicon substrate 81 is covered with the insulation film 86 excluding the upper surface of the chip through electrode 181.

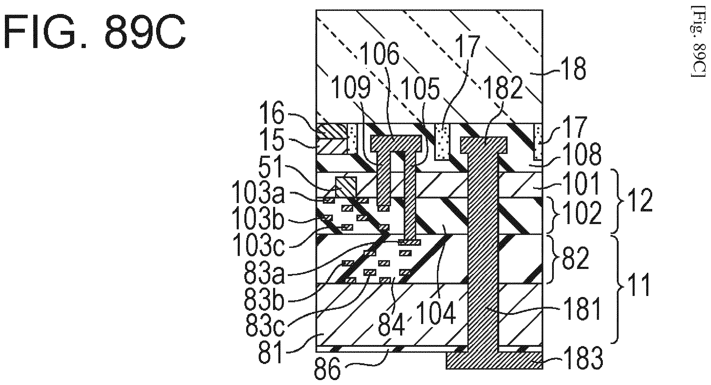

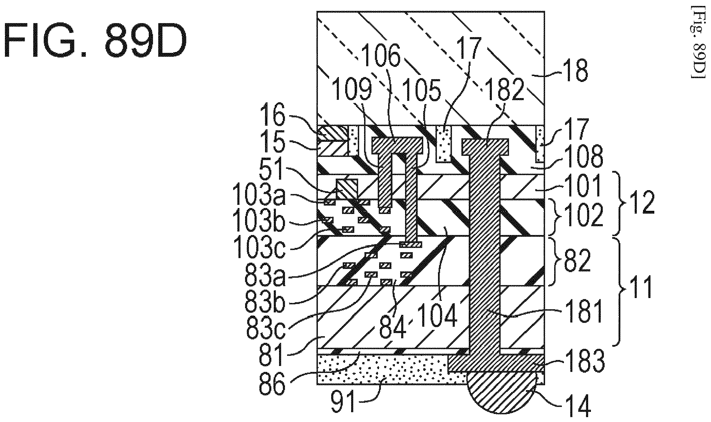

After a rewiring 183 is formed by a semi-additive method, as illustrated in Fig. 89C, the solder mask 91 and the solder ball 14 are formed, as illustrated in Fig. 89D.

According to the foregoing manufacturing method, the solid-state imaging device 1 in Fig. 1 having the structure according to the fourth modification example illustrated in Fig. 9 is completed.

### <Manufacturing Method of Fifth Modification Example>

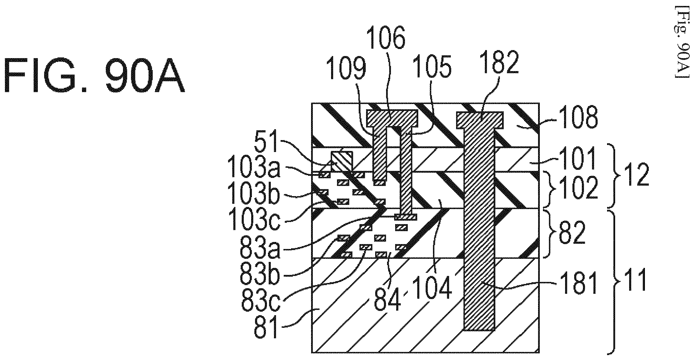

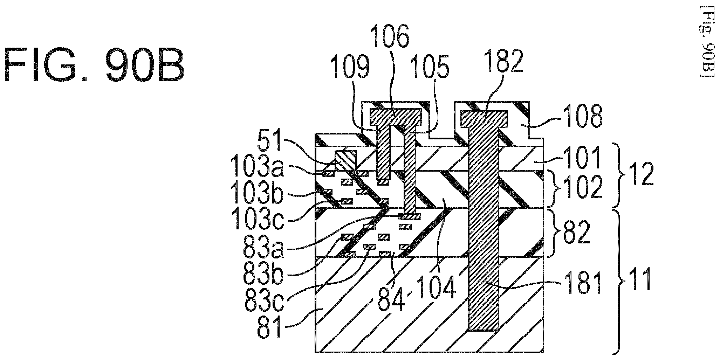

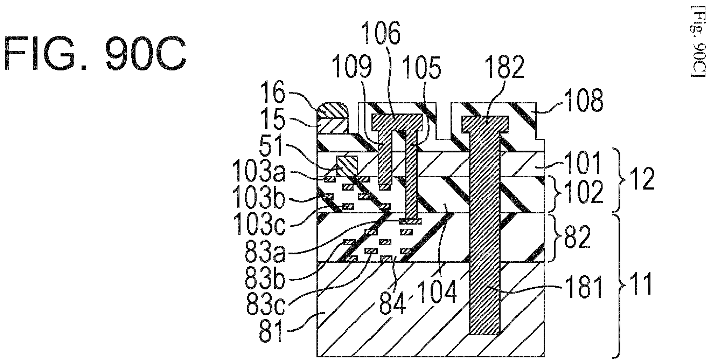

Next, a method of manufacturing the solid-state imaging device 1 having the structure according to the fifth modification example illustrated in Fig. 9 will be described with reference to Figs. 90A to 92C.

Processes illustrated in Figs. 90A to 90C are the same as those of the manufacturing method of the fourth modification example illustrated in Figs. 88A to 88C.

That is, after the half-finished logic substrate 11 and pixel sensor substrate 12 which are separately manufactured are pasted so that the wiring layers thereof face each other, connection conductors such as the chip through electrode 105, the silicon through electrode 109, and the chip through electrode 181 are formed. Then, the color filters 15 and the on-chip lenses 16 are formed on the side of the rear surface of the pixel sensor substrate 12.

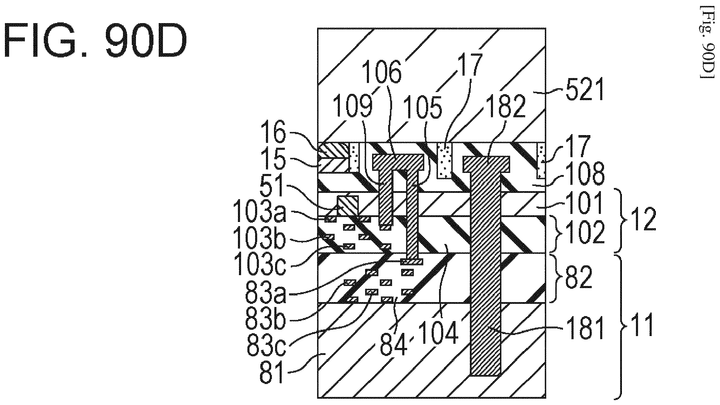

Subsequently, as illustrated in Fig. 90D, after the glass seal resin 17 is applied to the entire surface on which the on-chip lenses 16 of the pixel sensor substrate 12 are formed, a provisional bonded substrate 521 using a silicon substrate is pasted to the cavityless structure.

In the manufacturing method of the fourth modification example illustrated in Fig. 88D, the glass protective substrate 18 is pasted in this process. However, in the manufacturing method of the fifth modification example, the provisional bonded substrate 521 is pasted. By doing so, it is possible to obtain the advantage of using the equipment of the previous process.

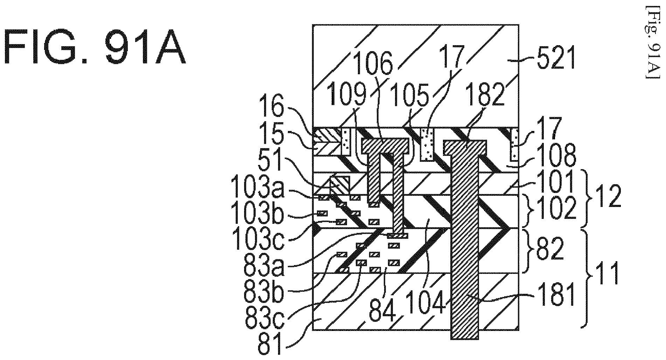

As illustrated in Fig. 91A, the silicon substrate 81 of the logic substrate 11 is thinned using the provisional bonded substrate 521 as a support substrate, as in Fig. 89A.

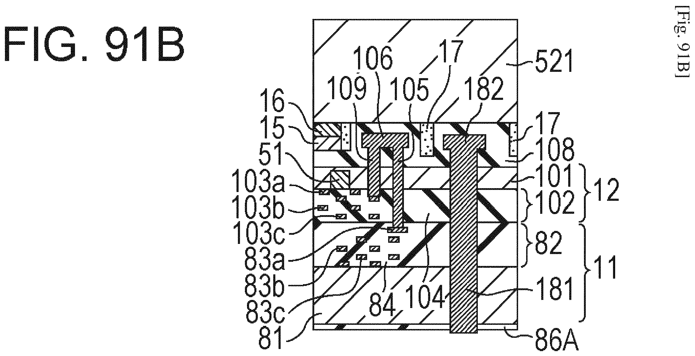

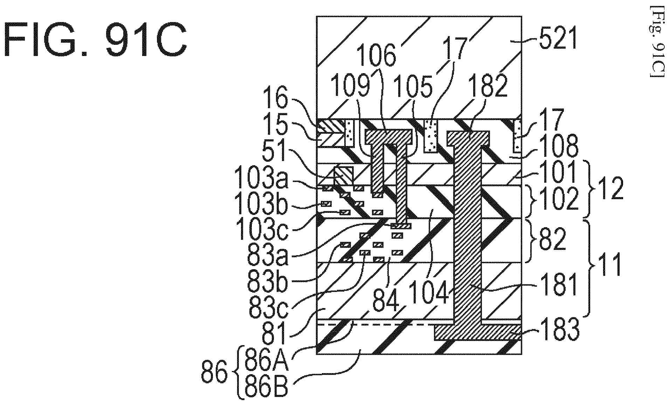

As illustrated in Fig. 91B, an insulation film 86A such as a TEOS film is formed in the same process as that of the method described with reference to Fig. 89B. Thereafter, as illustrated in Fig. 91C, the rewiring 183 and an insulation film 86B are formed on the upper surface of the insulation film 86A.

Accordingly, the insulation film 86 in the fifth modification example configured to include two layers, i.e., the insulation film 86A before the rewiring 183 is formed and the insulation film 86B after the rewiring 183 is formed. The rewiring 183 can be formed by a semi-additive method and the insulation film 86B can be formed by a plasma CVD method.

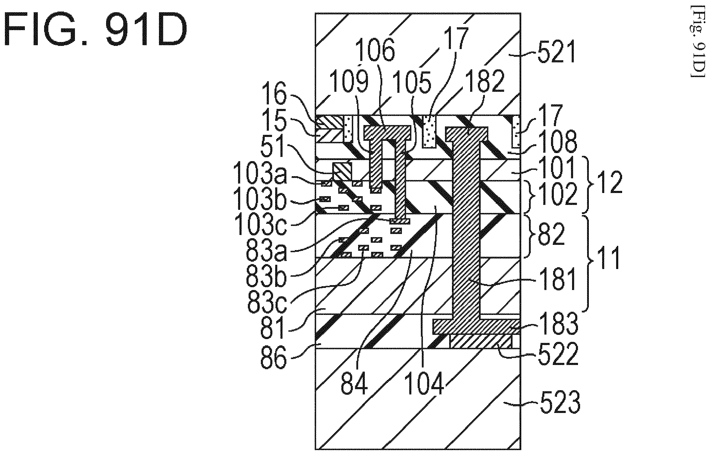

Next, as illustrated in Fig. 91D, a region on the rewiring 183 in which the solder ball 14 is formed is opened and, for example, an embedded material 522, such as a resist or an SOG (Spin On Glass), having etch selectivity to the insulation film 86 is embedded in the opened portion. Then, a provisional bonded substrate 523 is pasted to the upper surface of the insulation film 86 of the logic substrate 11 in which the embedded material 522 is embedded.

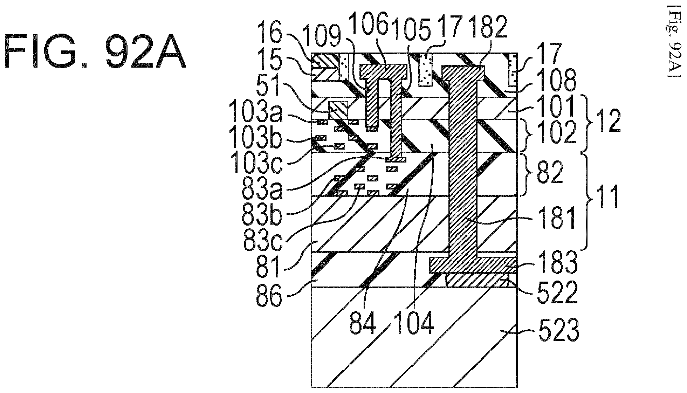

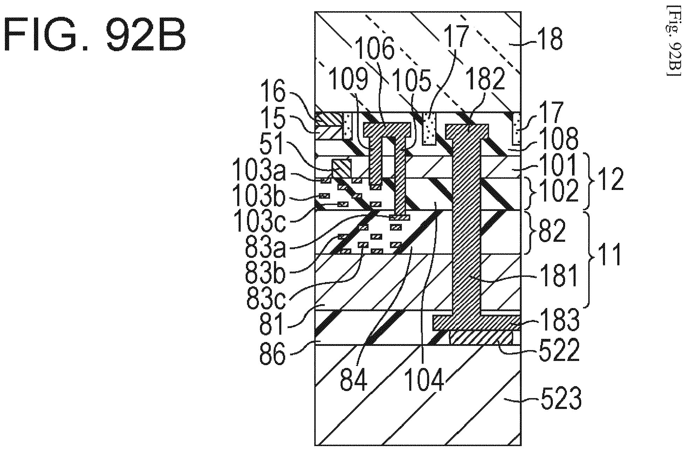

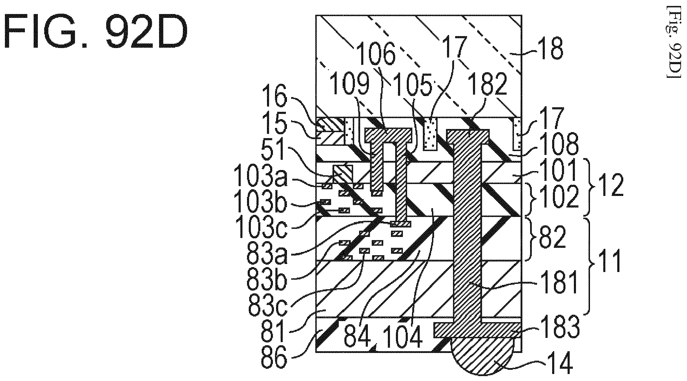

As illustrated in Fig. 92A, the provisional bonded substrate 521 pasted to the side of the on-chip lens 16 is de-bonded. Subsequently, as illustrated in Fig. 92B, the glass protective substrate 18 is pasted thereon.

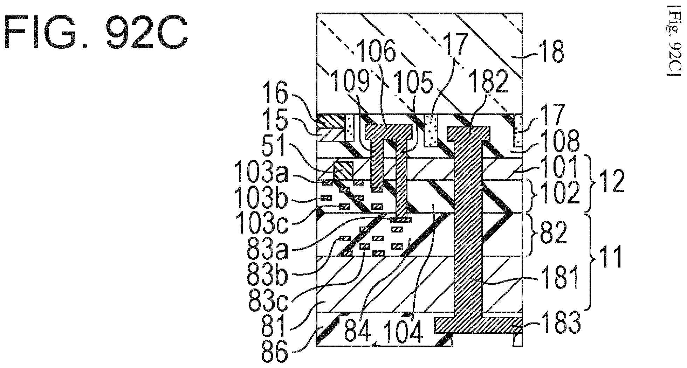

Next, as illustrated in Fig. 92C, the provisional bonded substrate 523 on the side of the insulation film 86 of the logic substrate 11 is de-bonded and the embedded material 522 is removed. Then, the solder ball 14 is formed in the portion from which the embedded material 522 is removed by the solder-ball mounting method or the like.

According to the foregoing manufacturing method, the solid-state imaging device 1 in Fig. 1 having the structure according to the fifth modification example illustrated in Fig. 10 is completed.

### <Manufacturing Method of Sixth Modification Example>

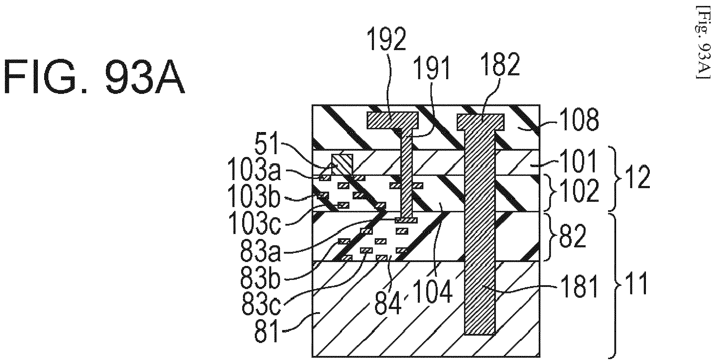

Next, a method of manufacturing the solid-state imaging device 1 having the structure according to the sixth modification example illustrated in Fig. 11 will be described with reference to Figs. 93A to 94C.

First, as illustrated in Fig. 93A, after the half-finished logic substrate 11 and pixel sensor substrate 12 which are separately manufactured are pasted so that the wiring layers thereof face each other, a chip through electrode 191, a connection wiring 192, the chip through electrode 181, and the connection wiring 182 are formed. Then, the upper surface of the silicon substrate 101 excluding the chip through electrode 191, the connection wiring 192, the chip through electrode 181, and the connection wiring 182 is covered with the insulation film 108. A method of forming the chip through electrode 191, the connection wiring 192, and the like is the same as the forming method of the above-described first to fifth modification examples. The insulation film 108 can be configured to include a plurality of layers, i.e., a cap film and an insulation film, as in the above-described other embodiments.

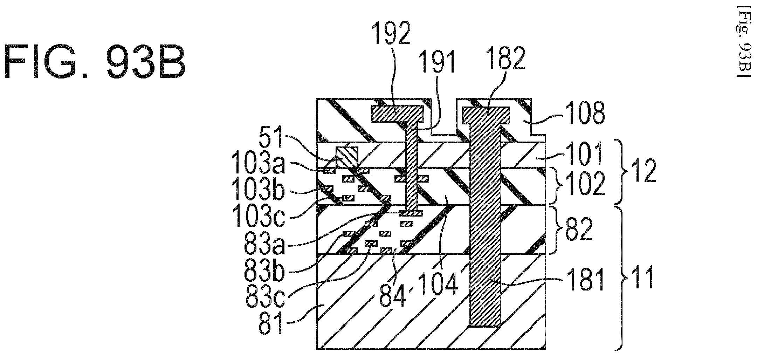

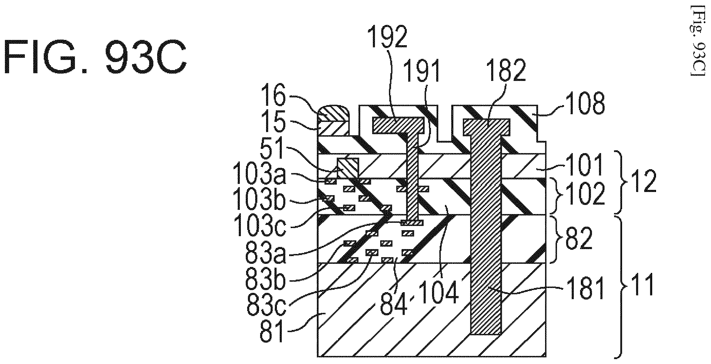

Next, as illustrated in Fig. 93B, necessary regions including the pixel region 21 are engraved in the portion in which the insulation film 108 is formed. Alternatively, or in addition, necessary regions including the pixel region 21 are formed in a groove portion in which the insulation film 108 is formed. As illustrated in Fig. 93C, the color filter 15 and the on-chip lens 16 are formed in the engraved portions of the pixel region 21. Alternatively, or in addition, the color filter 15 and the on-chip lens 16 are formed in the groove portions of the pixel region 21.

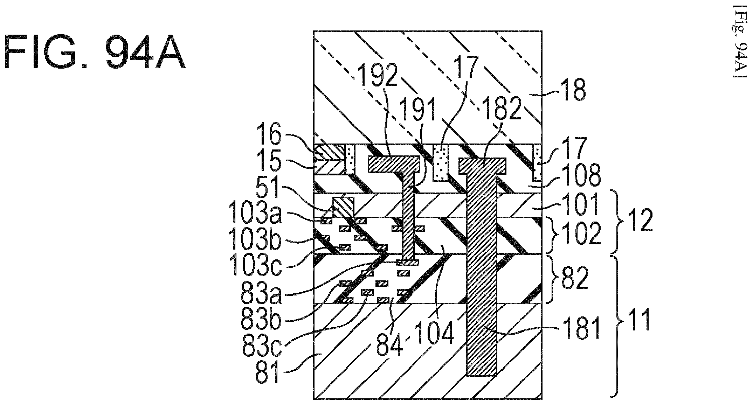

As illustrated in Fig. 94A, after the glass seal resin 17 is applied to the entire surface on which the on-chip lenses 16 of the pixel sensor substrate 12 are formed, the glass protective substrate 18 is connected with the cavityless structure.

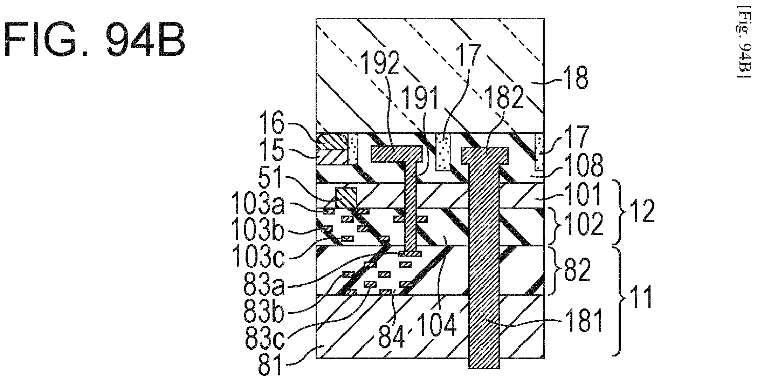

Next, as illustrated in Fig. 94B, the silicon substrate 81 of the logic substrate 11 is subjected to back grinding (polishing) to be thinned using the glass protective substrate 18 as the support substrate, and thus the silicon substrate 81 is thinned so that the chip through electrode 181 is slightly projected from the silicon substrate 81.

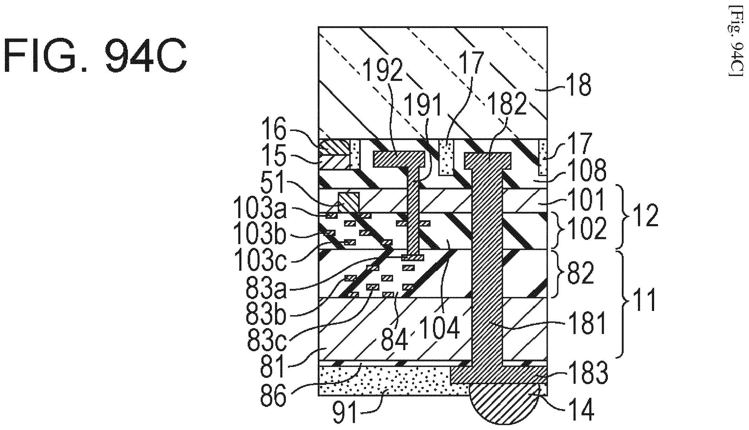

As illustrated in Fig. 94C, after the rewiring 183 is formed by a semi-additive method, the solder mask 91 and the solder ball 14 are formed.

According to the foregoing manufacturing method, the solid-state imaging device 1 in Fig. 1 having the structure according to the sixth modification example illustrated in Fig. 11 is completed.

The structure according to the sixth modification example can also be manufactured by a method of using two substrates, i.e., the provisional bonded substrates 521 and 523 described with reference to Figs. 90A to 92D.

### <Manufacturing Method of Seventh Modification Example>

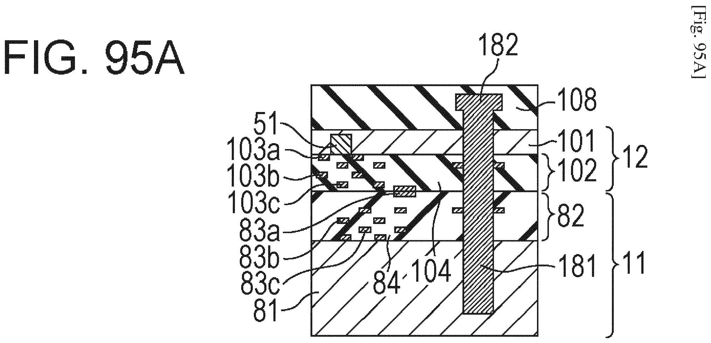

Next, a method of manufacturing the solid-state imaging device 1 having the structure according to the seventh modification example illustrated in Fig. 12 will be described with reference to Figs. 95A to 96C.

First, as illustrated in Fig. 95A, after the half-finished logic substrate 11 and pixel sensor substrate 12 which are separately manufactured are pasted so that the wiring layers thereof face each other, the chip through electrode 181 and the connection wiring 182 are formed. Then, the upper surface of the silicon substrate 101 excluding the chip through electrode 181 and the connection wiring 182 is covered with the insulation film 108.

A structure of the solid-state imaging device 1 illustrated in Fig. 12 according to the seventh modification example is a structure in which the logic substrate 11 and the pixel sensor substrate 12 are connected by metal bond. Accordingly, in Fig. 95A, the wiring layer 83a of the multi-layer wiring layer 82 of the half-finished logic substrate 11 and the wiring layer 103c of the multi-layer wiring layer 102 of the half-finished pixel sensor substrate 12 which are separately manufactured are pasted together by Cu-Cu metal bond.

A method of forming the chip through electrode 181 and the connection wiring 182 is the same as the forming method of the above-described first to sixth modification examples. The insulation film 108 can be configured to include a plurality of layers, i.e., a cap film and an insulation film, as in the above-described other embodiments.

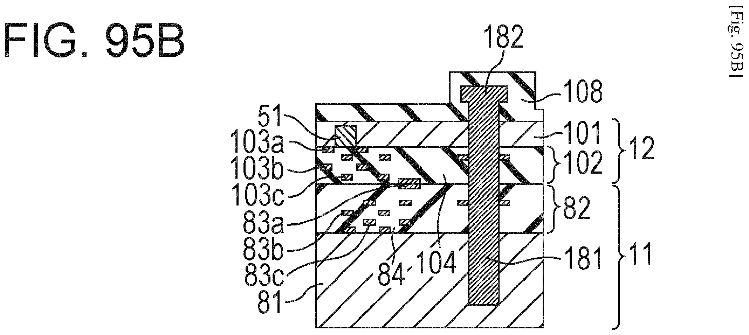

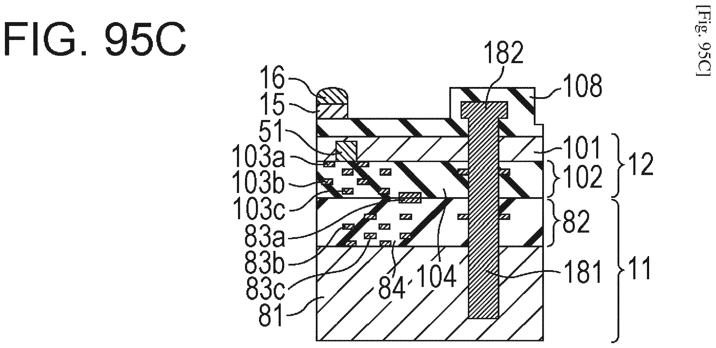

Next, as illustrated in Fig. 95B, necessary regions including the pixel region 21 are engraved in the portion in which the insulation film 108 is formed. Alternatively, or in addition, necessary regions including the pixel region 21 are formed in a grooved portion in which the insulation film 108 is formed. As illustrated in Fig. 95C, the color filter 15 and the on-chip lens 16 are formed in the engraved portions of the pixel region 21. Alternatively, or in addition, the color filter 15 and the on-chip lens 16 are formed in the grooved portions of the pixel region 21.

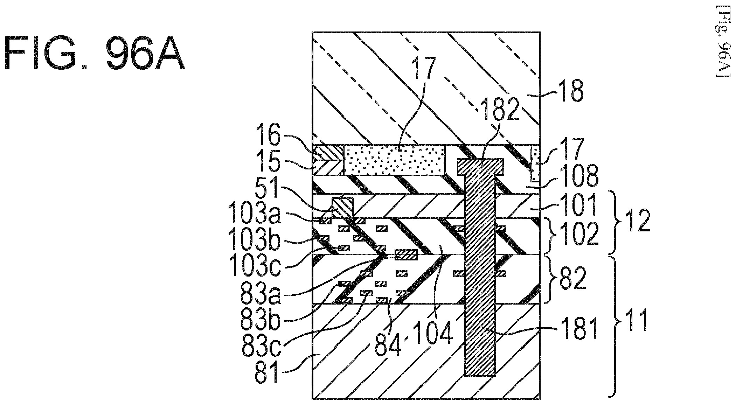

As illustrated in Fig. 96A, after the glass seal resin 17 is applied to the entire surface on which the on-chip lenses 16 of the pixel sensor substrate 12 are formed, the glass protective substrate 18 is connected with the cavityless structure.

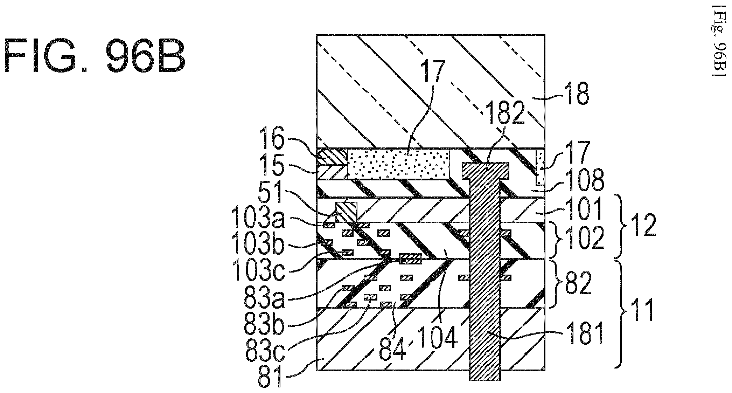

Next, as illustrated in Fig. 96B, the silicon substrate 81 of the logic substrate 11 is subjected to back grinding (polishing) to be thinned using the glass protective substrate 18 as the support substrate, and thus the silicon substrate 81 is thinned so that the chip through electrode 181 is slightly projected from the silicon substrate 81.

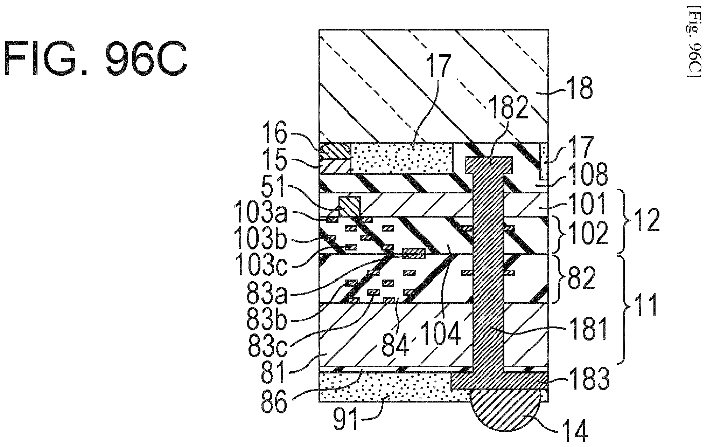

As illustrated in Fig. 96C, after the rewiring 183 is formed by a semi-additive method, the solder mask 91 and the solder ball 14 are formed.

According to the foregoing manufacturing method, the solid-state imaging device 1 in Fig. 1 having the structure according to the seventh modification example illustrated in Fig. 12 is completed.

The structure according to the seventh modification example can also be manufactured by a method of using two substrates, i.e., the provisional bonded substrates 521 and 523 described with reference to Figs. 90A to 92D.

### <Manufacturing Method of Eighth Modification Example>

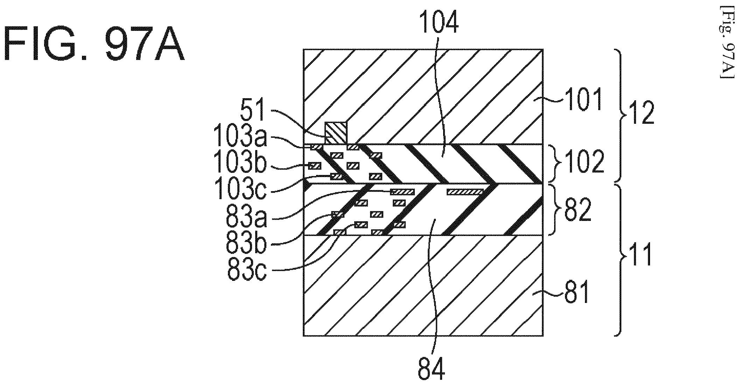

Next, a method of manufacturing the solid-state imaging device 1 having the structure according to the eighth modification example illustrated in Fig. 13 will be described with reference to Figs. 97A to 100C.

First, as illustrated in Fig. 97A, the half-finished logic substrate 11 and pixel sensor substrate 12 which are separately manufactured are pasted so that the wiring layers thereof face each other.

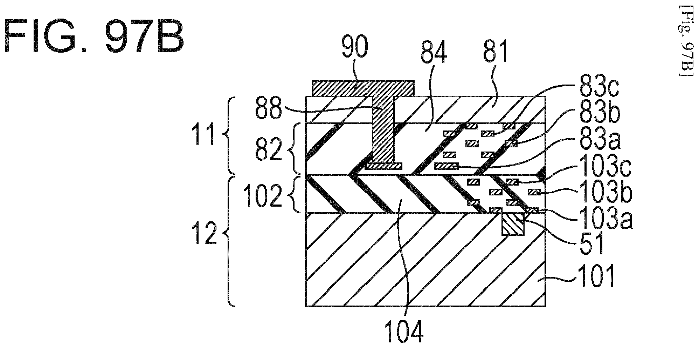

As illustrated in Fig. 97B, both of the pasted logic substrate 11 and pixel sensor substrate 12 are turned upside down. After the silicon substrate 81 of the logic substrate 11 is thinned, the silicon through electrode 88 and the rewiring 90 are formed. The method of forming the silicon through electrode 88 and the rewiring 90 is the same as the forming method of the above-described first to seventh modification example.

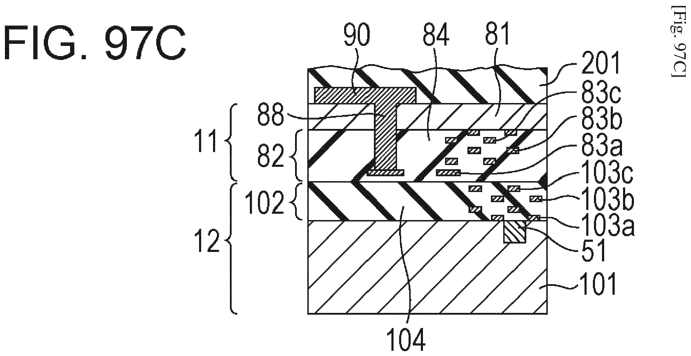

Next, as illustrated in Fig. 97C, the insulation film 201 is formed on the upper surface of the silicon substrate 81 of the logic substrate 11 in which the rewiring 90 is formed at a temperature equal to or greater than 250 degrees and equal to or less than 400 degrees which does not affect the wiring layer 83 or the like. For example, as described with reference to Fig. 13, for example, a plasma TEOS film, a plasma SiN film, a plasma SiO₂ film, a CVD-SiN film, or a CVD-SiO₂ film can be formed as the insulation film 201.

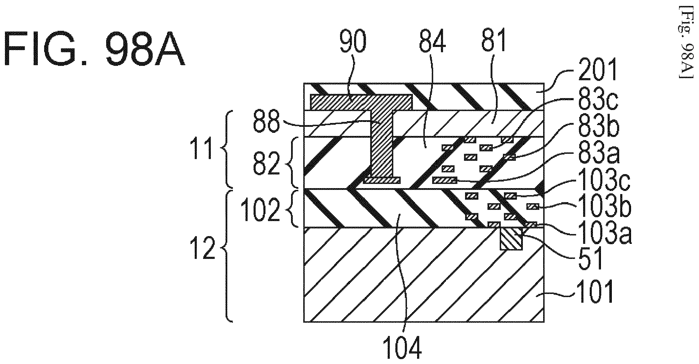

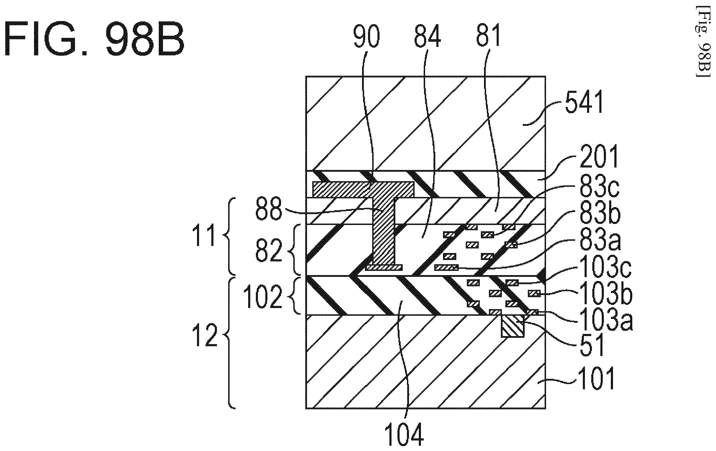

After the formed insulation film 201 is flattened by a CMP method, as illustrated in Fig. 98A, a provisional bonded substrate 541 is pasted to the upper surface of the flattened insulation film 201, as illustrated in Fig. 98B.

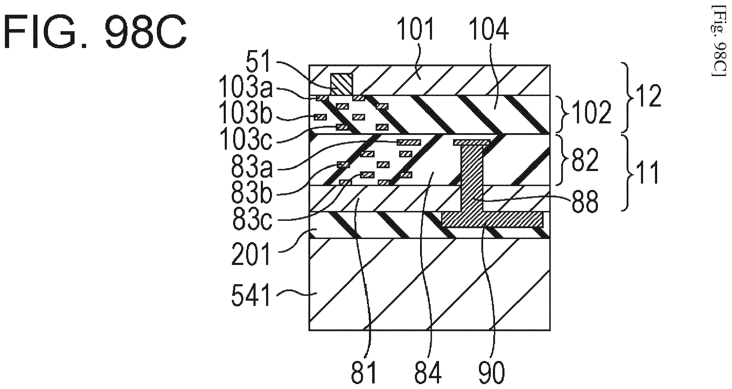

As illustrated in Fig. 98C, both of the logic substrate 11 and the pixel sensor substrate 12 are turned upside down again, the silicon substrate 101 of the pixel sensor substrate 12 is thinned using the provisional bonded substrate 541 as a support substrate.

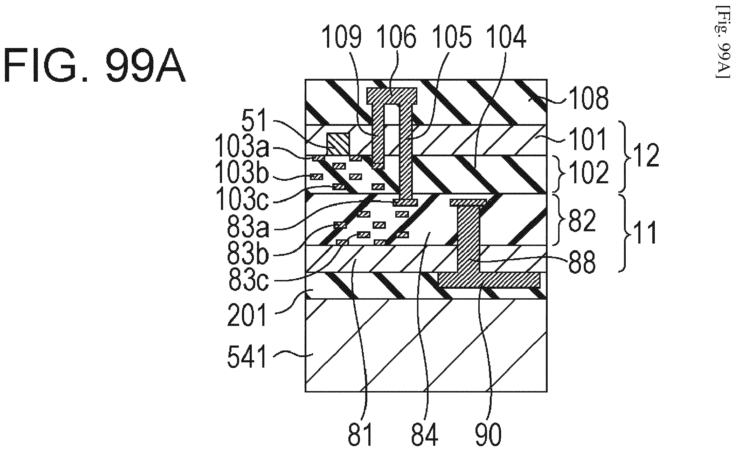

As illustrated in Fig. 99A, the chip through electrode 105, the silicon through electrode 109, and the connection wiring 106 connecting the chip through electrode 105 to the silicon through electrode 109 are formed. The upper surface of the silicon substrate 101 excluding the chip through electrode 105, the silicon through electrode 109, and the connection wiring 106 are covered with the insulation film 108. The insulation film 108 may be configured to include a plurality of layers, i.e., a cap film and an insulation film, as in the above-described other embodiments. As in the insulation films 86A and 86B in Fig. 91C, the insulation film 108 may be formed in two or more processes.

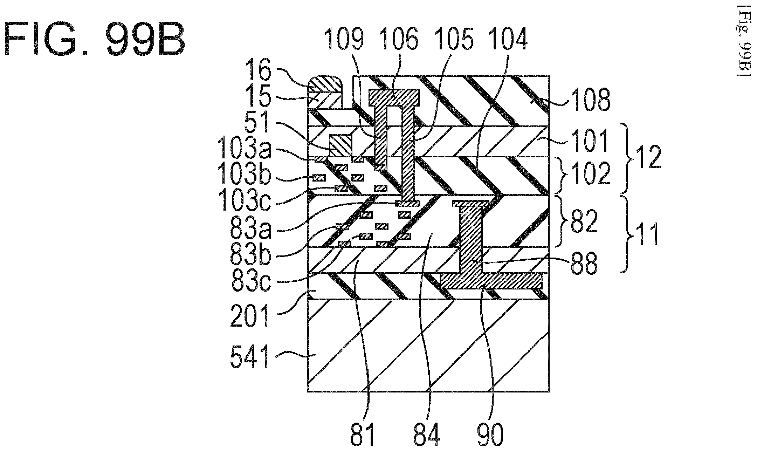

Next, as illustrated in Fig. 99B, necessary regions including the pixel region 21 are engraved in the portion in which the insulation film 108 is formed, and the color filter 15 and the on-chip lens 16 are formed in the engraved portions of the pixel region 21. Alternatively, or in addition, necessary regions including the pixel region 21 are formed in a grooved portion in which the insulation film 108 is formed, and the color filter 15 and the on-chip lens 16 are formed in the grooved portions of the pixel region 21.

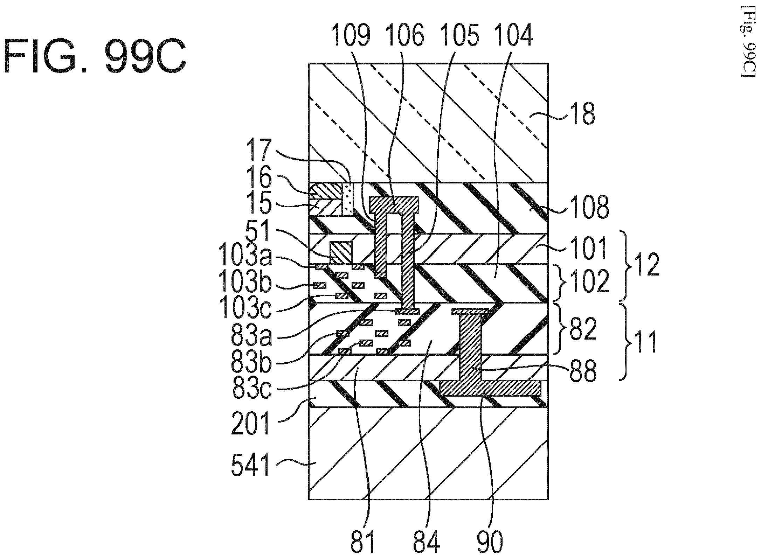

As illustrated in Fig. 99C, after the glass seal resin 17 is applied to the entire surface on which the on-chip lenses 16 of the pixel sensor substrate 12 are formed, the glass protective substrate 18 is connected with the cavityless structure.

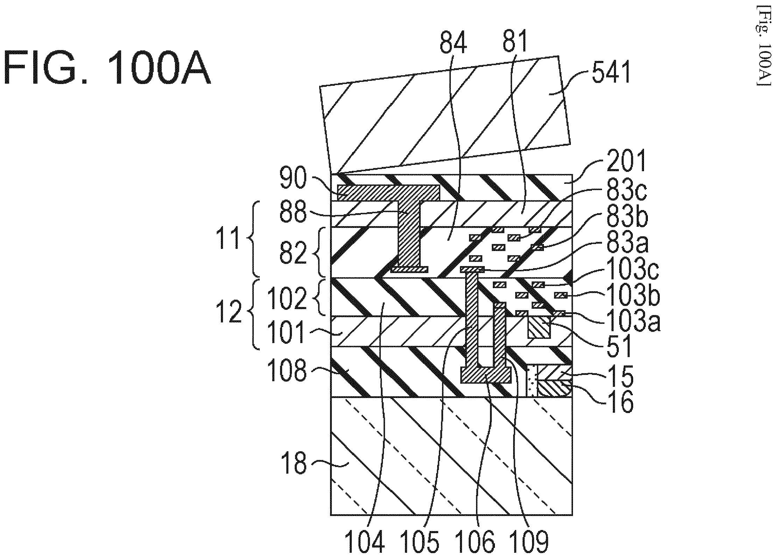

Thereafter, as illustrated in Fig. 100A, both of the pasted logic substrate 11 and pixel sensor substrate 12 are turned upside down and the provisional bonded substrate 541 is de-bonded.

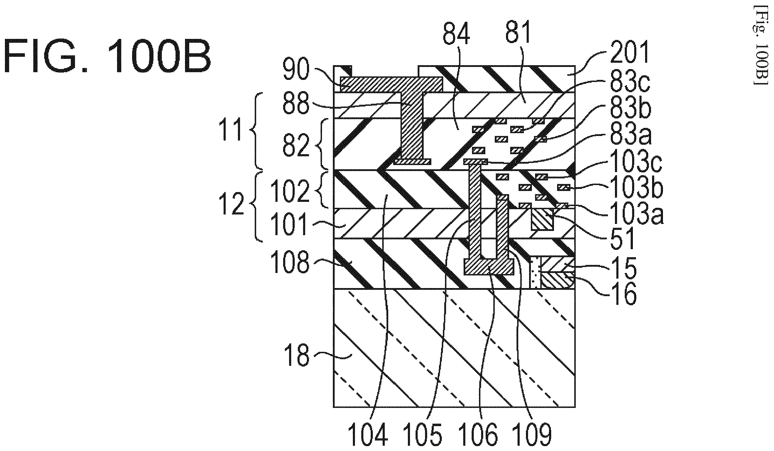

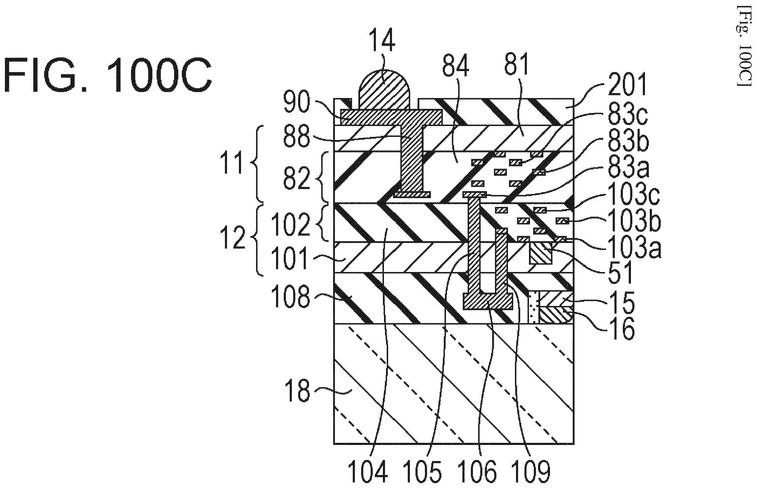

The insulation film 201 of the region on which the solder ball 14 is mounted is etched, as illustrated in Fig. 100B, so that the insulation film 201 is removed, as illustrated in Fig. 100C. Then, the solder ball 14 is formed on the exposed rewiring 90 by the solder-ball mounting method or the like.

According to the foregoing manufacturing method, the solid-state imaging device 1 in Fig. 1 having the structure according to the eighth modification example illustrated in Fig. 13 is completed.

### <Summary of Manufacturing Methods of First to Eighth Modification Examples>

The methods of manufacturing the solid-state imaging devices 1 having the structures according to the first to eighth modification examples will be described in brief.

In the structures according to the first to eighth modification examples, the silicon substrate 81 in which the multi-layer wiring layer 82 is formed on the side of the logic substrate 11 and the silicon substrate 101 in which the multi-layer wiring layer 102 is formed on the side of the pixel sensor substrate 12 are pasted so that the wiring layers face each other.

Next, the through hole connecting the wiring layer 83 of the logic substrate 11 to the wiring layer 103 of the pixel sensor substrate 12 is formed, and the through hole and the rewiring connecting the solder ball 14 which is a backside electrode to the wiring layer 83 of the logic substrate 11 are formed.

The through holes and the rewiring correspond to the silicon through electrode 151, the chip through electrode 152, and the rewiring 154 in the first and third modification examples, correspond to the silicon through electrode 88 and the rewiring 90 in the second modification example, and correspond to the chip through electrode 105, the silicon through electrode 109, the chip through electrode 181, and the rewiring 183 in the fourth, fifth, and eighth modification examples. The through holes and the rewiring correspond to the chip through electrode 181, the chip through electrode 191, and the rewiring 183 in the sixth and seventh modification examples.

The process of forming the through holes or the rewiring also includes forming the insulation film 86.

After the through hole and the rewiring are formed, the color filters 15 and the on-chip lenses 16 are formed. Finally, the glass protective substrate 18 is connected with the cavityless structure by the glass seal resin 17, so that the solid-state imaging device 1 is completed.

Accordingly, before the color filters 15 and the on-chip lenses 16 are formed, the through hole connecting the wiring layer 83 of the logic substrate 11 to the wiring layer 103 of the pixel sensor substrate 12 is formed and the through holes and the rewiring connecting the solder ball 14 which is a backside electrode to the wiring layer 83 of the logic substrate 11 are formed. Therefore, the insulation film 86 can be formed at a high temperature equal to or greater than 250 degrees. Thus, it is possible to form the insulation film 86 ensuring high reliability. In other words, it is possible to improve the mechanical characteristics or insulation resistance of the insulation film 86 to the same level as a signal processing wiring.

### <Manufacturing Method of Ninth Modification Example>

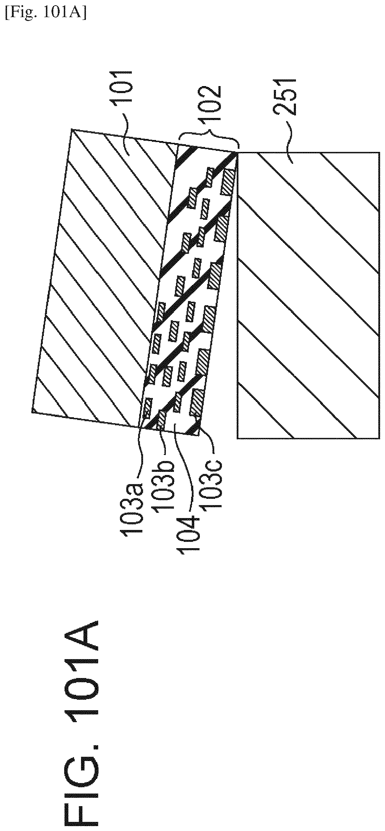

Next, a method of manufacturing the solid-state imaging device 1 having the structure according to the ninth modification example illustrated in Fig. 14 will be described with reference to Figs. 101A to 103C.

First, as illustrated in Fig. 101A, for example, after the multi-layer wiring layer 102 forming a part of the control circuit 22 or the like is formed in a region which becomes each chip portion of the silicon substrate (silicon wafer) 101 with a thickness of about 600 micrometers, a provisional bonded substrate 251 is pasted to the upper surface of the multi-layer wiring layer 102.

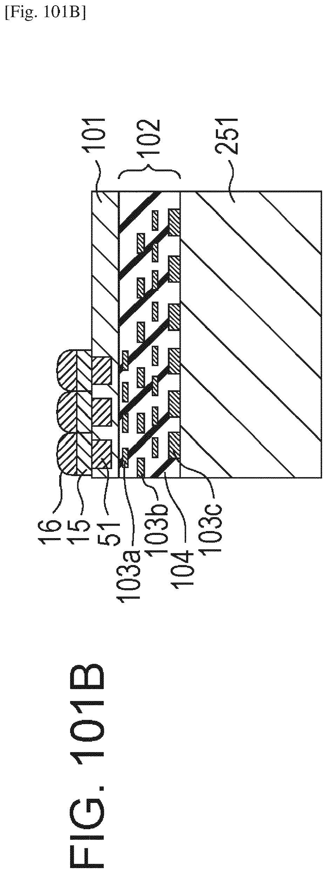

Next, as illustrated in Fig. 101B, after the silicon substrate 101 is thinned, the photodiode 51 of each pixel 32 is formed in a predetermined region in the silicon substrate 101. The color filter 15 and the on-chip lens 16 are formed on the upper side of the photodiode 51.

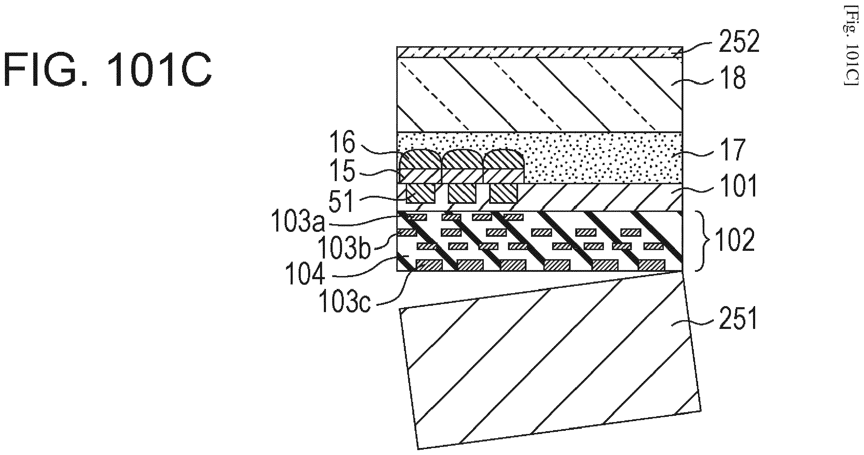

Next, as illustrated in Fig. 101C, the glass protective substrate 18 is connected with the cavityless structure using the glass seal resin 17 on the upper surface of the silicon substrate 101 in which the on-chip lenses 16 are formed. Then, after a glass surface protective film 252 is formed on the upper surface of the glass protective substrate 18, the provisional bonded substrate 251 is peeled off. For example, a SiN film or a SiO₂ film can be adopted as the glass surface protective film 252.

The half-finished pixel sensor substrate 12 is completed through the foregoing processes.

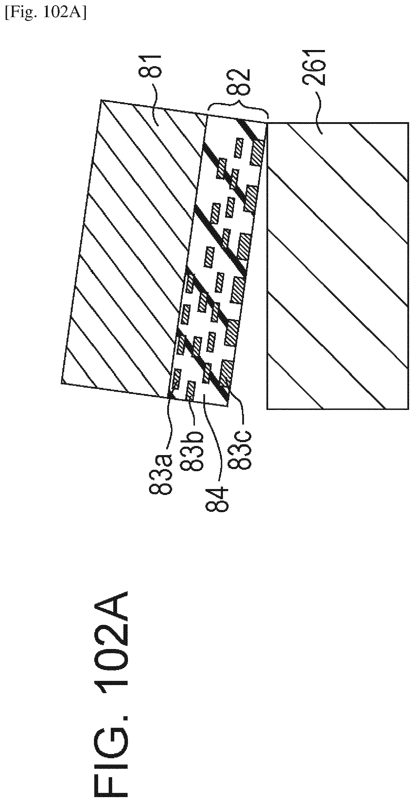

On the other hand, on the side of the logic substrate 11, as illustrated in Fig. 102A, for example, after the multi-layer wiring layer 82 forming the logic circuit 23 is formed in the region which becomes each chip portion of the silicon substrate (silicon wafer) 81 with a thickness of about 600 micrometers, a provisional bonded substrate 261 is pasted to the upper surface of the multi-layer wiring layer 82.

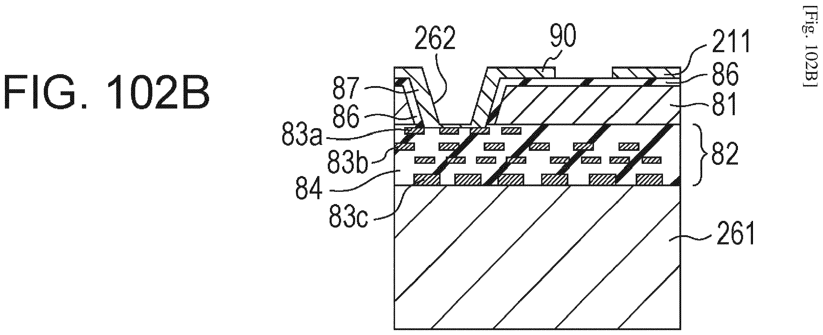

Next, as illustrated in Fig. 102B, after the silicon substrate 81 is thinned, an opening 262 is formed at a position at which the silicon through electrode 88 (not illustrated) is disposed and an insulation film (isolation film) 86 is formed on the inner wall surface of the opening 262 and the upper surface of the silicon substrate 81. The insulation film 86 is formed at a high temperature equal to or greater than 250 degrees in order to ensure high reliability.

As in the method of manufacturing the above-described basic structure, the connection conductor 87 and the rewiring 90 are formed after the barrier metal film and the Cu seed layer (not illustrated) are formed.

In the ninth modification example, a dummy wiring 211 is also formed at a predetermined position on the insulation film 86 formed on the silicon substrate 81 in order to reduce the influence of unevenness when Cu-Cu bonding is performed.

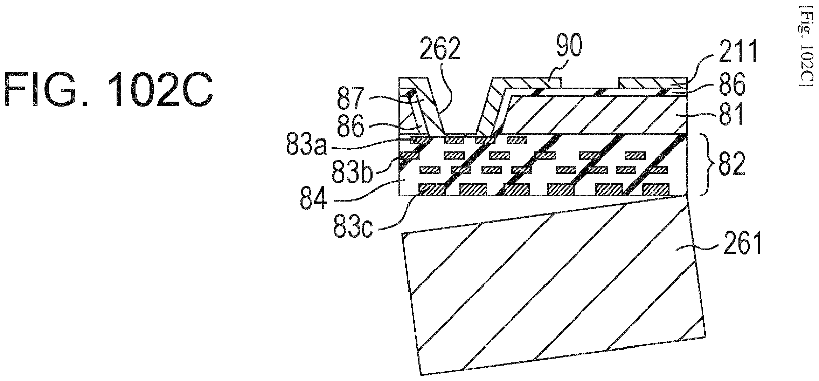

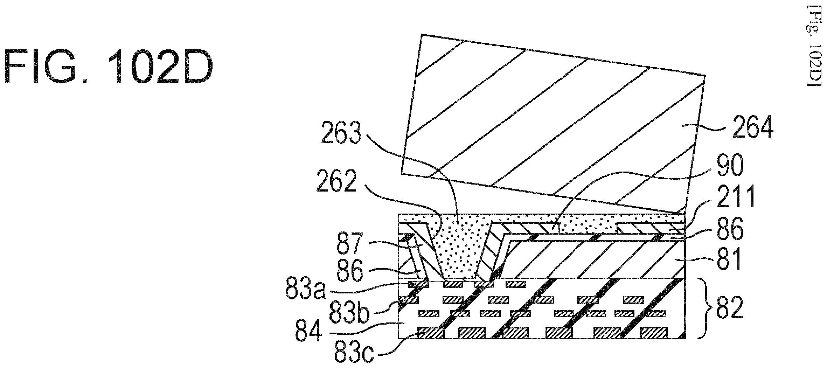

As illustrated in Fig. 102C, the provisional bonded substrate 261 is peeled off. Thereafter, as illustrated in Fig. 102D, at this time, an adhesive 263 is applied to the side of the rewiring 90 of the silicon substrate 81 and a provisional bonded substrate 264 is pasted thereon.

The half-finished logic substrate 11 is completed through the foregoing processes.

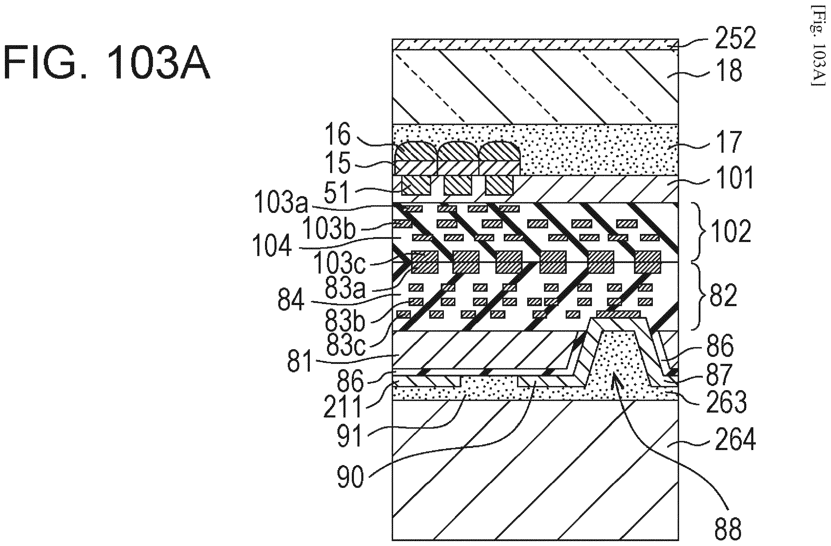

As illustrated in Fig. 103A, the half-finished logic substrate 11 and the half-finished pixel sensor substrate 12 are pasted together by metal bond (Cu-Cu bonding) of the wiring layer 83a of the uppermost layer of the logic substrate 11 and the wiring layer 103c of the lowermost layer of the pixel sensor substrate 12.

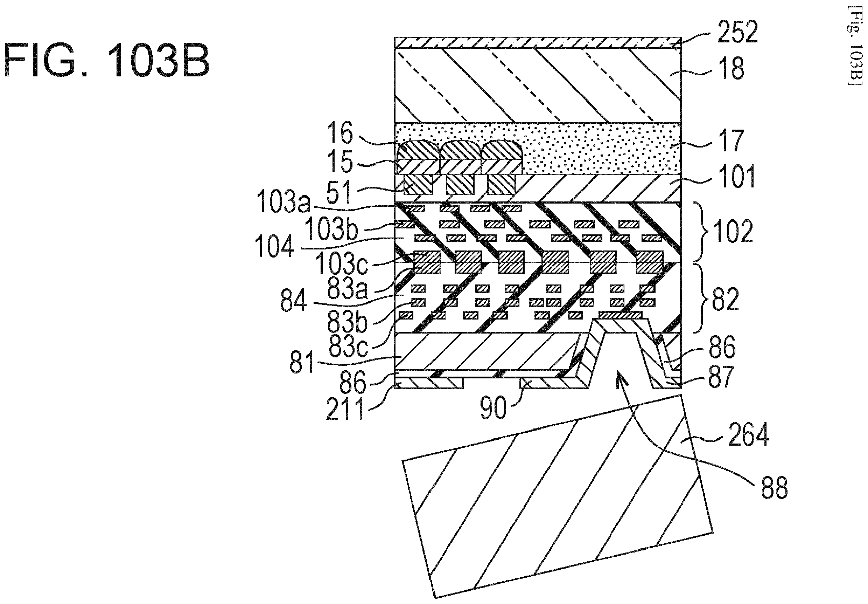

Thereafter, as illustrated in Fig. 103B, the provisional bonded substrate 264 temporarily pasted to the logic substrate 11 is peeled off and the adhesive 263 is also removed.

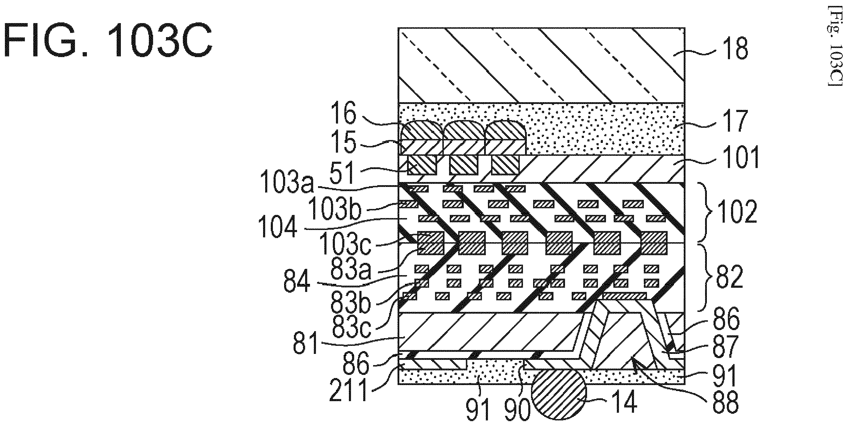

Finally, as illustrated in Fig. 103C, after the solder mask 91 and the solder ball 14 are formed through the processes described with reference to Figs. 64 and 65, the glass surface protective film 252 is removed.

According to the foregoing manufacturing method, the solid-state imaging device 1 in Fig. 1 having the structure according to the ninth modification example illustrated in Fig. 14 is completed.

According to the manufacturing method of the ninth modification example described above, the silicon through electrode 88 is formed in the process of the single logic substrate 11 before the logic substrate 11 and the pixel sensor substrate 12 are pasted together. Therefore, when the silicon through electrode 88 is formed, the color filters 15 and the on-chip lenses 16 with low heat resistance are not present. Therefore, the insulation film 86 can be formed at a high temperature equal to or greater than 250 degrees. Thus, it is possible to form the insulation film 86 ensuring high reliability.

According to the manufacturing method of the ninth modification example, the color filters 15 and the on-chip lenses 16 are formed when distortion of the single pixel sensor substrate 12 is small, before the logic substrate 11 and the pixel sensor substrate 12 are pasted together. Therefore, since misalignment between the color filters 15 and the on-chip lenses 16, and the photodiodes 51 can be small, a defect percentage caused due to the misalignment can be reduced. Since the misalignment is small, a pixel size can be miniaturized.

According to the manufacturing method of the ninth modification example, the dummy wiring 211 which is not relevant to transmission and reception of an electric signal is formed in the same layer as the layer in which the rewiring 90 is formed. Thus, it is possible to reduce the influence of the unevenness caused due to the presence or absence of the rewiring 90 when the Cu-Cu bonding is performed.

### <7. Tenth Modification Example>

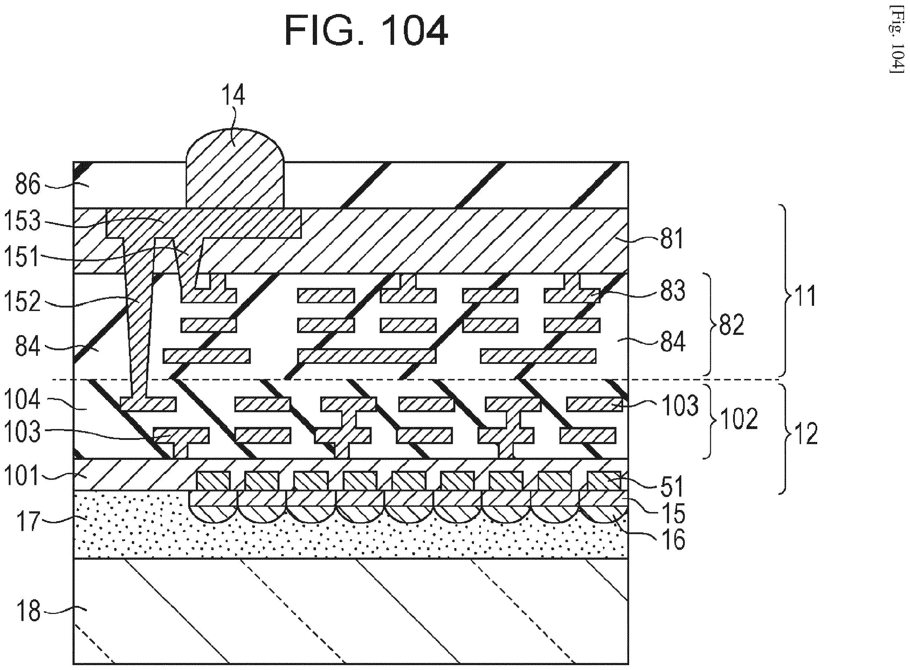

Fig. 104 is a diagram illustrating a detailed structure of the laminated substrate 13 of the solid-state imaging device 1 according to a tenth modification example.

In the tenth modification example illustrated in Fig. 104, a part of the structure of the first modification example illustrated in Fig. 6 is modified.

In Fig. 104, the same reference numerals are given to portions corresponding to the portions of the first modification example illustrated in Fig. 6 and the description thereof will be omitted.

In the first modification example of Fig. 6, two through electrodes, i.e., the silicon through electrode 151 and the chip through electrode 152, penetrate through the silicon substrate 81. The connection wiring 153 connecting the silicon through electrode 151 to the chip through electrode 152 is formed in an upper portion of the silicon substrate 81.

In contrast, in the tenth modification example, as illustrated in Fig. 104, the connection wiring 153 is formed to be embedded in the silicon substrate 81. The rewiring 154 is omitted (or the connection wiring 153 and the rewiring 154 are integrated), the solder ball 14 is formed on the connection wiring 153, and the upper surface of the silicon substrate 81 excluding the solder ball 14 is covered with the insulation film 86. The remaining structure is the same as that of the first modification example illustrated in Fig. 6.

In the tenth modification example of Fig. 104, the structure according to the first modification example illustrated in Fig. 6 is modified so that the connection wiring 153 is embedded in the silicon substrate 81. The same modification can also be applied to the structures according to the second to ninth modification examples illustrated in Figs. 7 to 14. For example, the connection wiring 106 or 182 may be configured to be embedded in the silicon substrate 101 or the rewiring 90 may be configured to be embedded in the silicon substrate 81.

### <8. Manufacturing Method of Tenth Modification Example>

### <First Manufacturing Method of Tenth Modification Example>

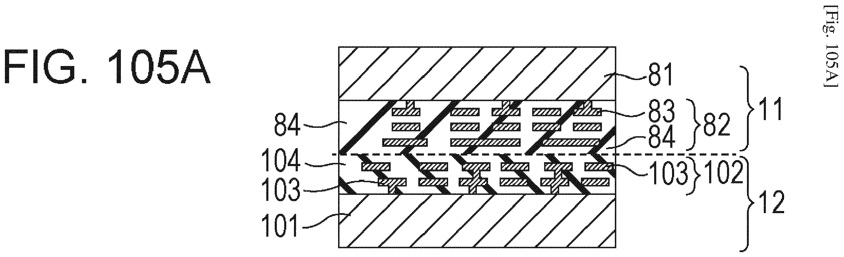

Next, a first method of manufacturing the solid-state imaging device 1 having the structure according to the tenth modification example illustrated in Fig. 104 will be described with reference to Figs. 105A to 107E.

First, as illustrated in Fig. 105A, the half-finished logic substrate 11 and pixel sensor substrate 12 which are separately manufactured are pasted so that the wiring layers thereof face each other.

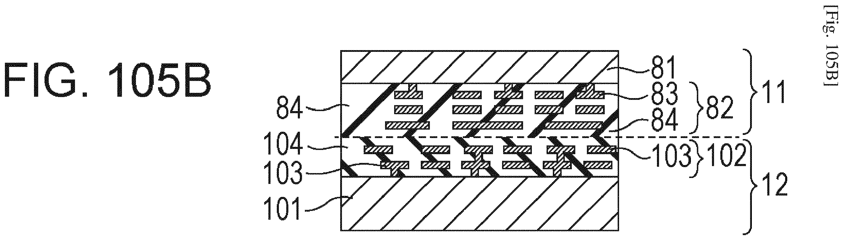

Next, as illustrated in Fig. 105B, the silicon substrate 81 of the logic substrate 11 is thinned to the extent of having a thickness which does not affect device characteristics, e.g., to the extent of about 20 micrometers to about 100 micrometers.

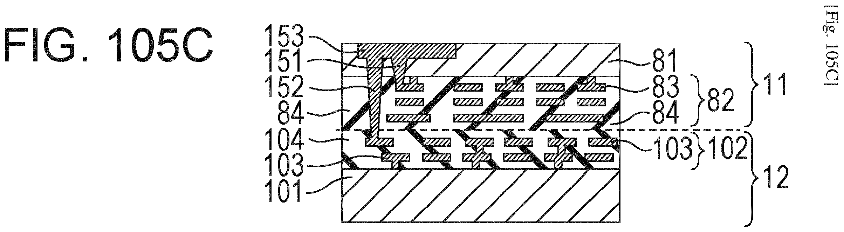

Next, as illustrated in Fig. 105C, the silicon through electrode 151 connected to the wiring layer 83c of the logic substrate 11, the chip through electrode 152 connected to the wiring layer 103c of the pixel sensor substrate 12, and the connection wiring 153 connecting the silicon through electrode 151 to the chip through electrode 152 are formed at predetermined positions of the silicon substrate 81 on the side of the logic substrate 11. The silicon through electrode 151, the chip through electrode 152, and the connection wiring 153 can be formed in the same processes as the processes described with reference to Figs. 22 to 24.

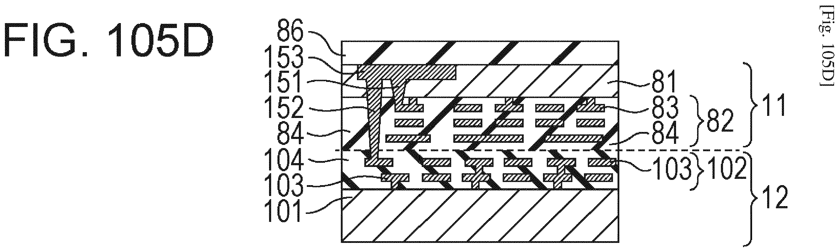

Next, as illustrated in Fig. 105D, the insulation film 86 is formed on the entire upper surfaces of the silicon substrate 81 and the connection wiring 153 of the logic substrate 11. The insulation film 86 includes, for example, a single CiCN layer, laminated layers of SiN and SiO, or laminated layers of SiCN and SiO and functions as a passivation film that prevents the material (for example, Cu) of the connection wiring 153 from diffusing. The insulation film 86 can be formed at a high temperature equal to or greater than 250 degrees and equal to or less than 400 degrees. Thus, the insulation film with good humidity resistance and good film quality can be formed, and thus erosion and wiring reliability can be improved.

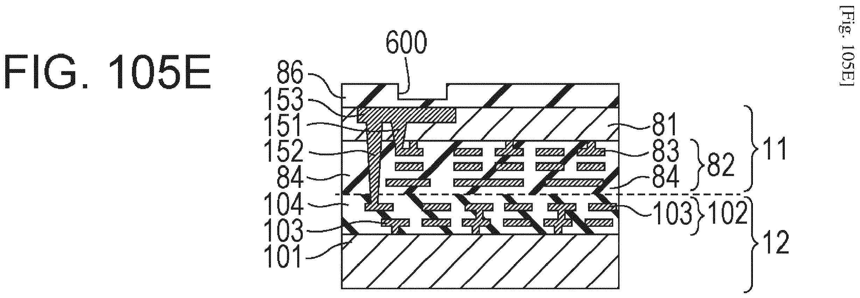

Next, as illustrated in Fig. 105E, the region in which the solder ball 14 is formed is opened in the insulation film 86 formed on the entire upper surfaces of the silicon substrate 81 and the connection wiring 153 of the logic substrate 11, and thus a solder land portion 600 is formed. Here, as illustrated in Fig. 105E, in the solder land portion 600, the insulation film 86 remains thin.

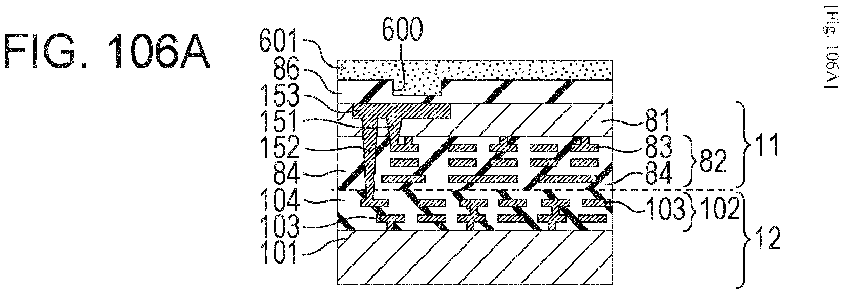

Next, as illustrated in Fig. 106A, an embedded material film 601 is formed in the opened solder land portion 600. The embedded material film 601 is also formed on the upper surface of the insulation film 86 in addition to the solder land portion 600 and the formed embedded material film 601 is flattened by a CMP method. The embedded material film 601 may have a material with etch selectivity to the insulation film 86. For example, an organic insulation film, a SiO film, or a SiOC film with a low dielectric constant can be adopted.

The embedded material film 601 can be formed by rotating and applying a resist. In this case, the flattening process by the CMP method is not necessary.

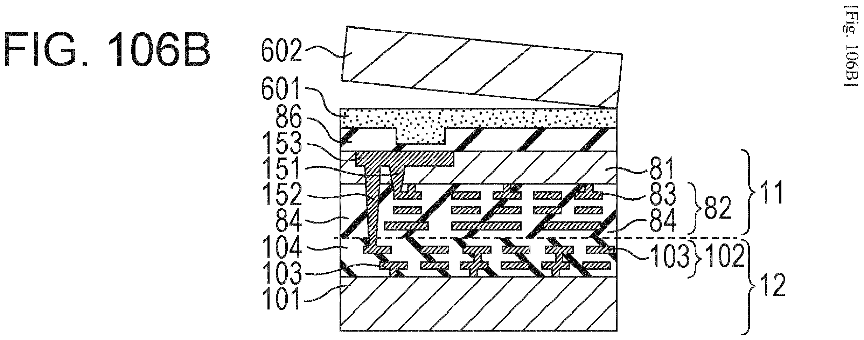

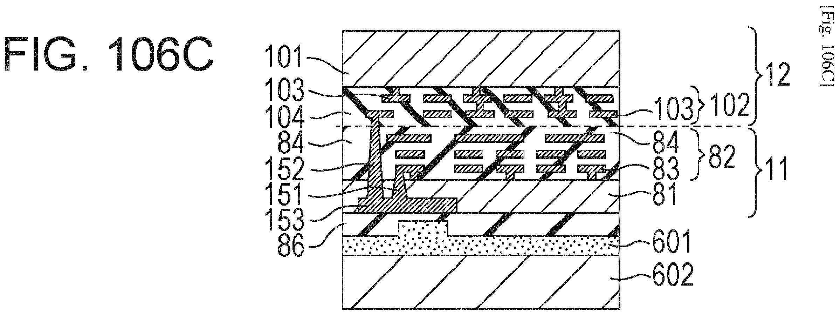

Next, after a provisional bonded substrate 602 is pasted to the side of the embedded material film 601 of the logic substrate 11, as illustrated in Fig. 106B, all of the substrates are turned upside down as illustrated in Fig. 106C.

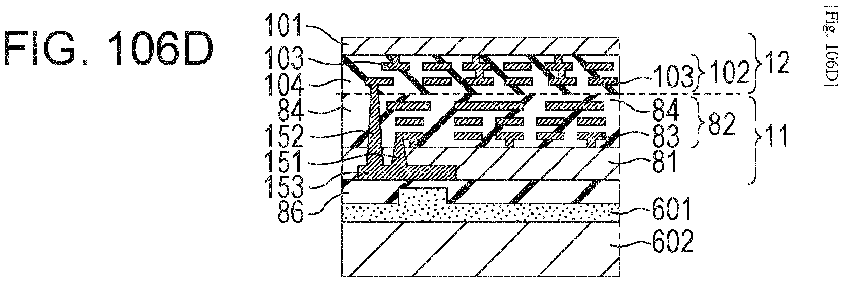

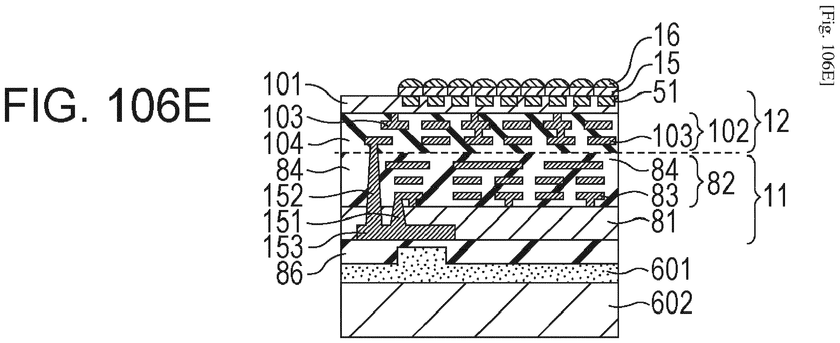

After the silicon substrate 101 of the pixel sensor substrate 12 is thinned to be about 1 micrometer to about 10 micrometers, as illustrated in Fig. 106D, the color filters 15 and the on-chip lenses 16 are formed thereon, as illustrated in Fig. 106E. Further, a high dielectric film such as the high dielectric film 401 in Fig. 15 may be formed on the upper surface of the thinned silicon substrate 101 in order to suppress a dark current.

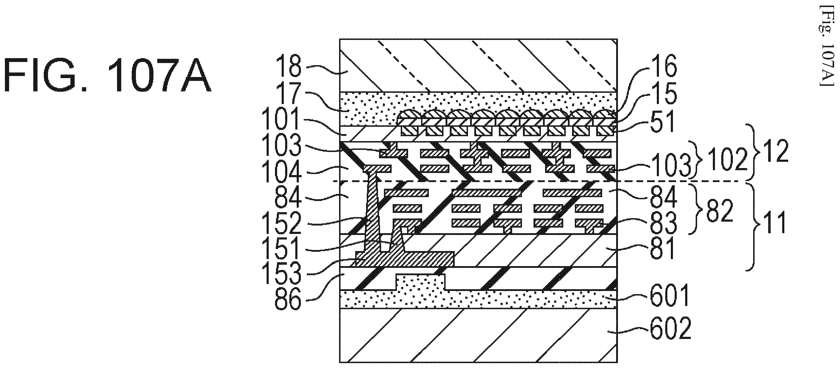

Next, as illustrated in Fig. 107A, after the glass seal resin 17 is applied to the entire surface on which the on-chip lenses 16 of the pixel sensor substrate 12 are formed, the glass protective substrate 18 is pasted with the cavityless structure.

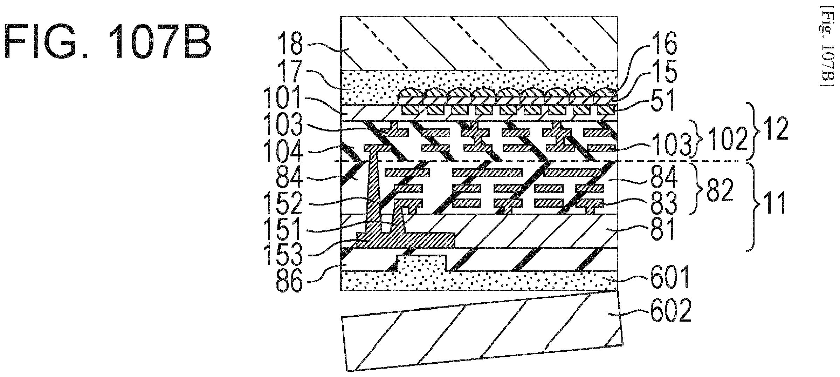

After the glass protective substrate 18 is pasted, the provisional bonded substrate 602 is de-bonded, as illustrated in Fig. 107B.

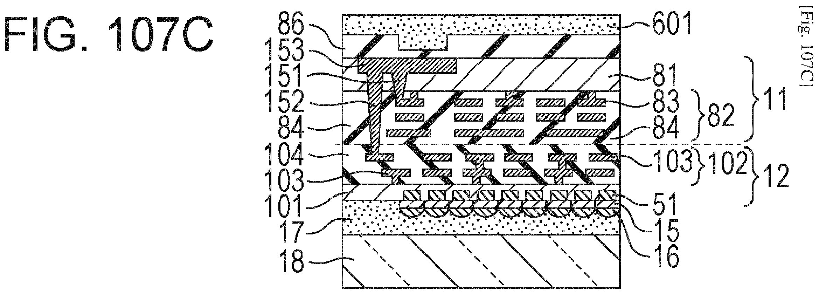

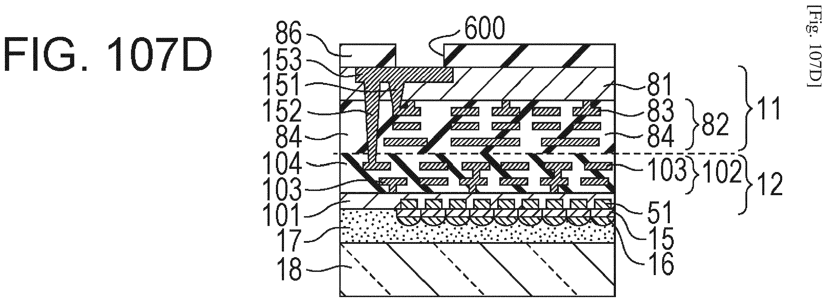

Next, after all of the substrates are turned upside down again, as illustrated in Fig. 107C, the embedded material film 601 is removed by, for example, wet etching using hydrofluoric acid (HF), as illustrated in Fig. 107D. By performing etch-back on the entire surface on which the insulation film 86 is formed, the insulation film 86 remaining which is thin in the solder land portion 600 is removed, so that the connection wiring 153 is exposed.

When the embedded material film 601 is formed by rotating and applying the resist in the process described with reference to Fig. 106A, the embedded material film 601 can be removed (subjected to ashing) by O₂ plasma.

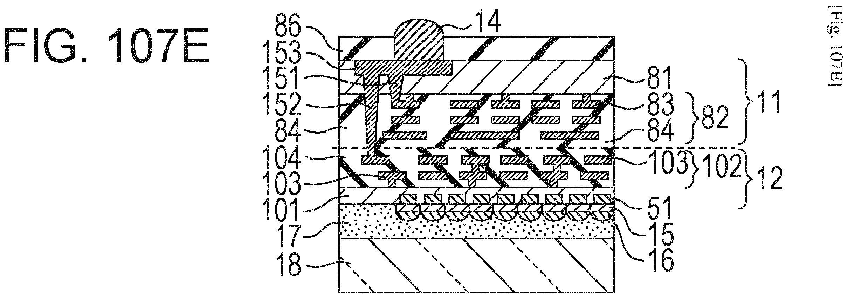

Finally, as illustrated in Fig. 107E, the solder ball 14 is formed in the portion in which the connection wiring 153 is exposed by the solder-ball mounting method or the like.

According to the foregoing manufacturing method, the solid-state imaging device 1 in Fig. 1 having the structure according to the tenth modification example illustrated in Fig. 104 is completed.

### <Second Manufacturing Method of Tenth Modification Example>

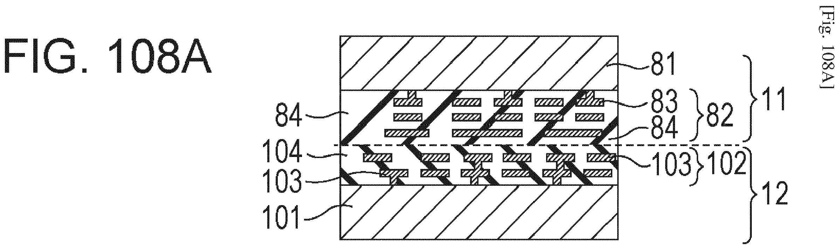

Next, a second method of manufacturing the solid-state imaging device 1 having the structure according to the tenth modification example illustrated in Fig. 104 will be described with reference to Figs. 108A to 110E.

First, as illustrated in Fig. 108A, the half-finished logic substrate 11 and pixel sensor substrate 12 which are separately manufactured are pasted so that the wiring layers thereof face each other.

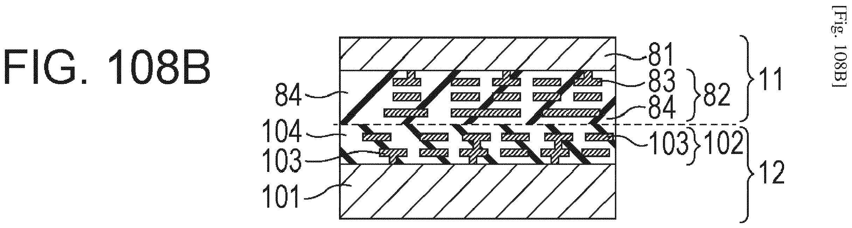

Next, as illustrated in Fig. 108B, the silicon substrate 81 of the logic substrate 11 is thinned to the extent of having a thickness which does not affect device characteristics, e.g., to the extent of about 20 micrometers to about 100 micrometers.

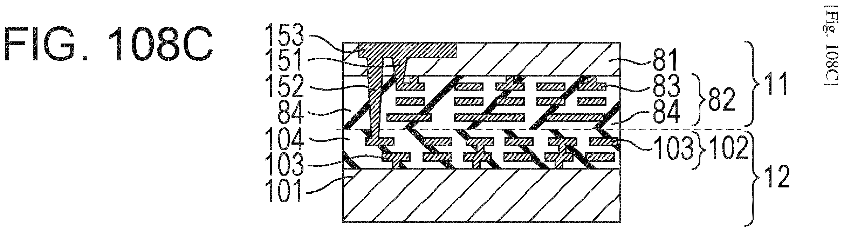

Next, as illustrated in Fig. 108C, the silicon through electrode 151 connected to the wiring layer 83c of the logic substrate 11, the chip through electrode 152 connected to the wiring layer 103c of the pixel sensor substrate 12, and the connection wiring 153 connecting the silicon through electrode 151 to the chip through electrode 152 are formed at predetermined positions of the silicon substrate 81 on the side of the logic substrate 11. The silicon through electrode 151, the chip through electrode 152, and the connection wiring 153 can be formed in the same processes as the processes described with reference to Figs. 22 to 24.

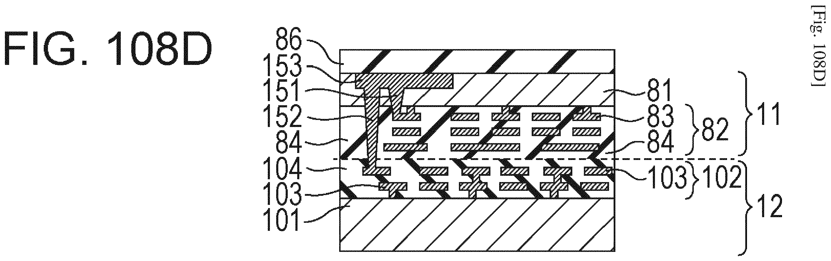

Next, as illustrated in Fig. 108D, the insulation film 86 is formed on the entire upper surfaces of the silicon substrate 81 and the connection wiring 153 of the logic substrate 11. The insulation film 86 includes, for example, a single CiCN layer, laminated layers of SiN and SiO, or laminated layers of SiCN and SiO and functions as a passivation film that prevents the material (for example, Cu) of the connection wiring 153 from diffusing. The insulation film 86 can be formed at a high temperature equal to or greater than 250 degrees and equal to or less than 400 degrees. Thus, the insulation film with good humidity resistance and good film quality can be formed, and thus erosion and wiring reliability can be improved.

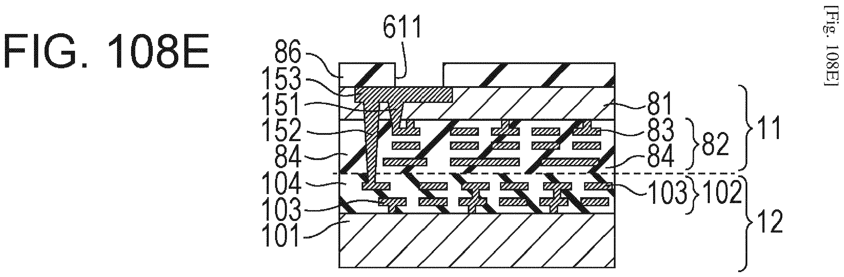

Next, as illustrated in Fig. 108E, the region in which the solder ball 14 is formed is opened in the insulation film 86 formed on the entire upper surfaces of the silicon substrate 81 and the connection wiring 153 of the logic substrate 11, and thus a solder land portion 611 is formed. Here, in the second manufacturing method, as illustrated in Fig. 108E, the insulation film 86 is removed in the solder land portion 611 until the connection wiring 153 is exposed.

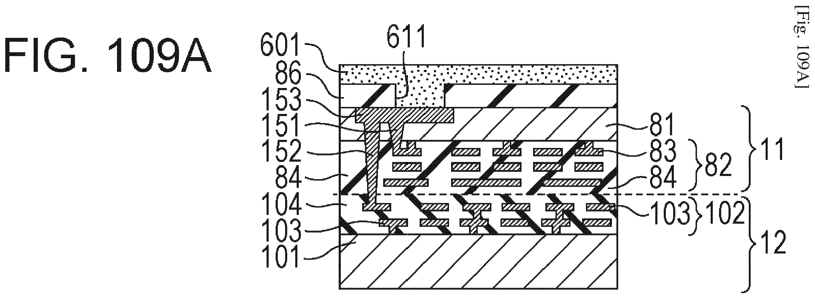

Next, as illustrated in Fig. 109A, an embedded material film 601 is formed in the opened solder land portion 611. The embedded material film 601 is also formed on the upper surface of the insulation film 86 in addition to the solder land portion 611 and the formed embedded material film 601 is flattened by a CMP method. The embedded material film 601 may have a material with etch selectivity to the insulation film 86. For example, an organic insulation film, a SiO film, or a SiOC film with a low dielectric constant can be adopted.

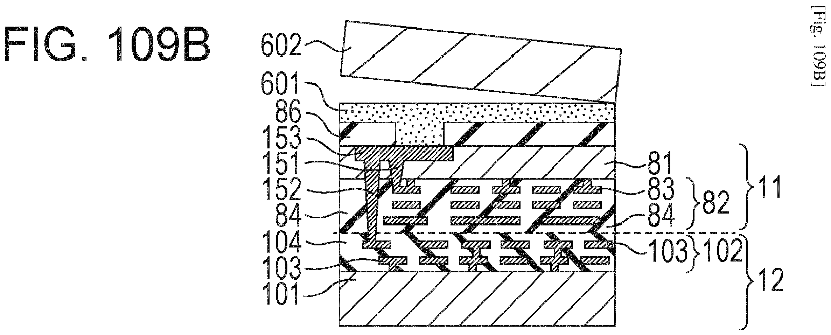

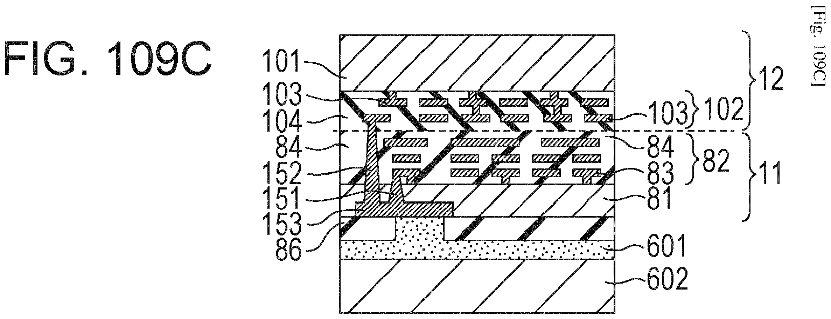

Next, after a provisional bonded substrate 602 is pasted to the side of the embedded material film 601 of the logic substrate 11, as illustrated in Fig. 109B, all of the substrates are turned upside down as illustrated in Fig. 109C.

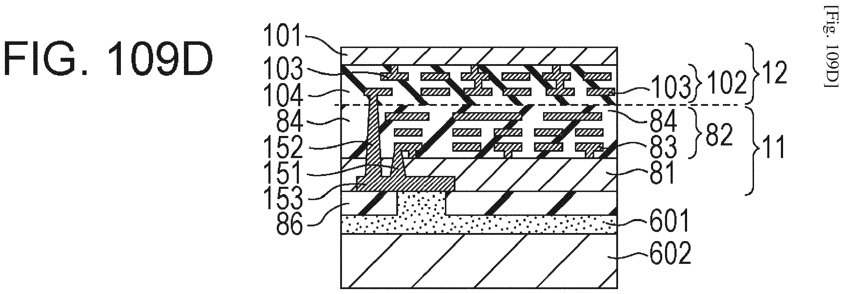

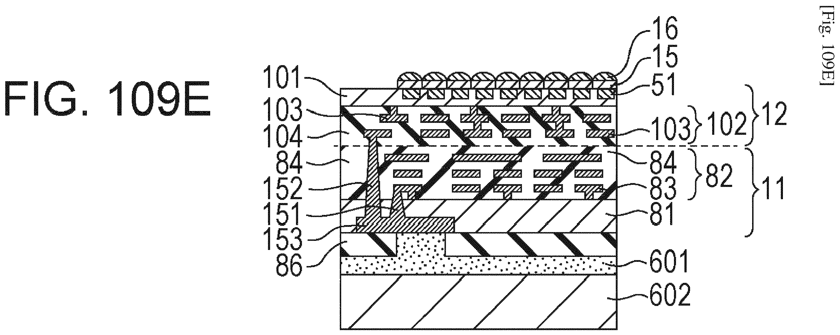

After the silicon substrate 101 of the pixel sensor substrate 12 is thinned to be about 1 micrometer to about 10 micrometers, as illustrated in Fig. 109D, the color filters 15 and the on-chip lenses 16 are formed thereon, as illustrated in Fig. 109E. Further, a high dielectric film such as the high dielectric film 401 in Fig. 15 may be formed on the upper surface of the thinned silicon substrate 101 in order to suppress a dark current.

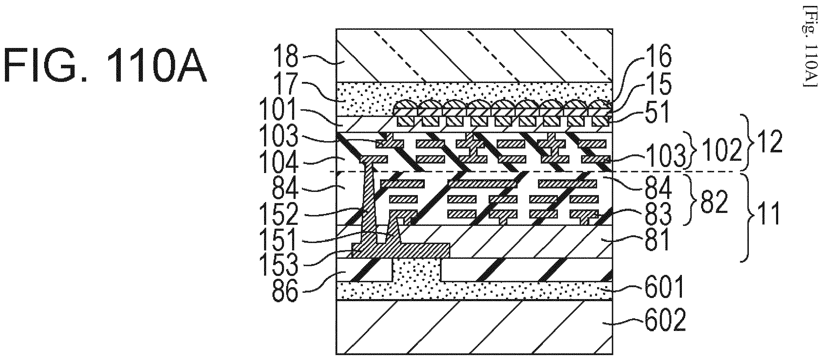

Next, as illustrated in Fig. 110A, after the glass seal resin 17 is applied to the entire surface on which the on-chip lenses 16 of the pixel sensor substrate 12 are formed, the glass protective substrate 18 is pasted with the cavityless structure.

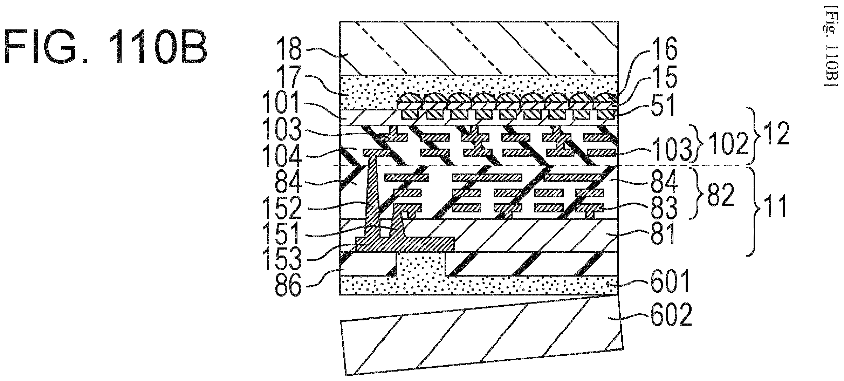

After the glass protective substrate 18 is pasted, the provisional bonded substrate 602 is de-bonded, as illustrated in Fig. 110B.

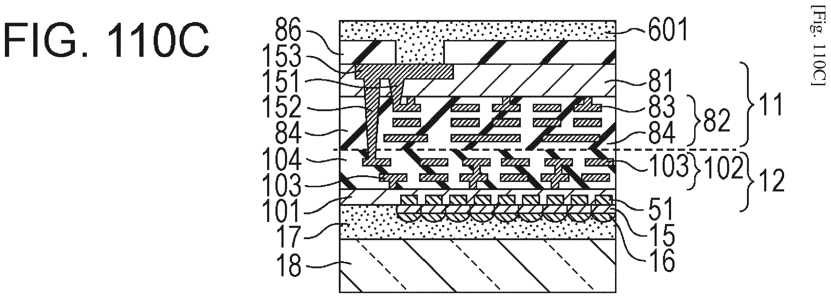

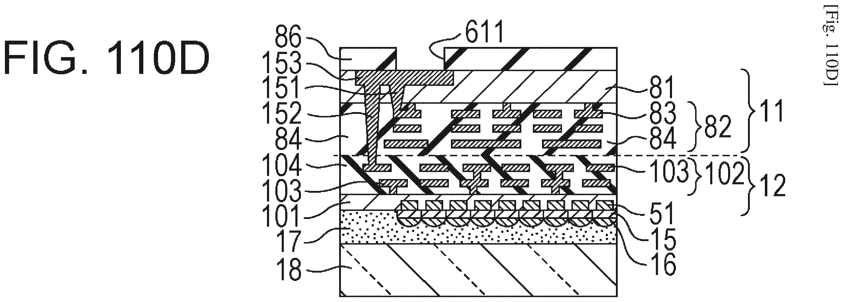

Next, after all of the substrates are turned upside down again, as illustrated in Fig. 110C, the embedded material film 601 is removed by, for example, wet etching using hydrofluoric acid (HF), as illustrated in Fig. 110D. Thus, the connection wiring 153 is exposed in the solder land portion 611.

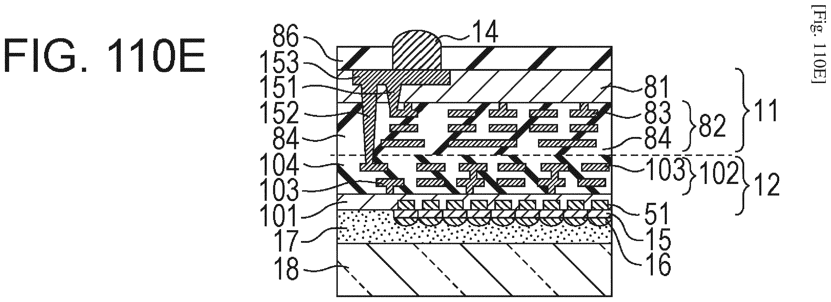

Finally, as illustrated in Fig. 110E, the solder ball 14 is formed in the portion in which the connection wiring 153 is exposed by the solder-ball mounting method or the like.

According to the foregoing manufacturing method, the solid-state imaging device 1 in Fig. 1 having the structure according to the tenth modification example illustrated in Fig. 104 is completed.

Even in the first and second manufacturing methods of the tenth modification example described with reference to Figs. 105A to 110E, before the color filters 15 and the on-chip lenses 16 are formed, the two through electrodes, i.e., the silicon through electrode 151 and the chip through electrode 152, and the connection wiring 153 connecting the two through electrodes to each other are formed. Therefore, the insulation film 86 can be formed at a high temperature equal to or greater than 250 degrees. Thus, it is possible to form the insulation film 86 ensuring high reliability. In other words, it is possible to improve the mechanical characteristics or insulation resistance of the insulation film 86 to the same level as a signal processing wiring.

Even in the solid-state imaging device 1 having the face-to-face structure of the above-described first to tenth modification examples, the structure in which the solder land 431 is formed on the rewiring 90, as described with reference to Figs. 40 to 42, can be adopted. At this time, as illustrated in Fig. 50, the barrier metal 461 stopping the reaction with the copper in the metal wiring from occurring can be formed below the rewiring 90.

### <Method of Manufacturing General Backside Irradiation Type Structure>

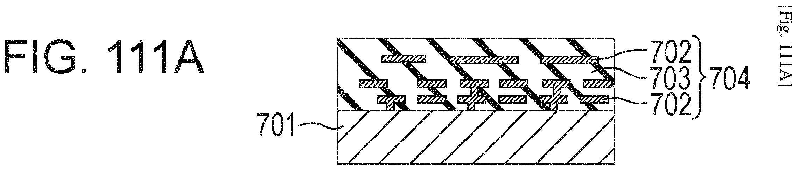

Next, a method of manufacturing a solid-state imaging device having a general backside irradiation type structure will be described with reference to Figs. 111A to 113E.

First, as illustrated in Fig. 111A, a photodiode (not illustrated) is formed in each pixel in a silicon substrate 701, which is a first semiconductor substrate, and a pixel circuit of a pixel transistor such as a first transfer transistor or an amplification transistor, a control circuit, and a logic circuit are formed in the silicon substrate 701 and a multi-layer wiring layer 704. The multi-layer wiring layer 704 includes a plurality of wiring layers 702 and inter-layer insulation films 703 formed between the respective wiring layers 702.

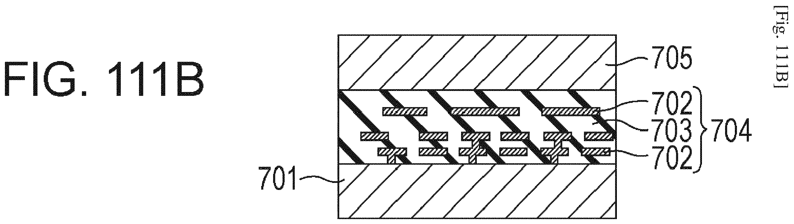

Next, as illustrated in Fig. 111B, a silicon substrate 705 which is a second semiconductor substrate is pasted to an upper portion of the multi-layer wiring layer 704 of the silicon substrate 701. Unlike the configuration of the laminated substrate 13 described above, no wiring layer is formed in the silicon substrate 705 which is the second semiconductor substrate, as in the above-described other manufacturing methods.

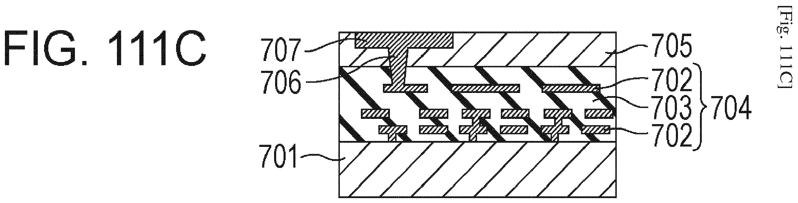

Next, as illustrated in Fig. 111C, a rewiring 707 and a silicon through electrode 706 connected to the uppermost wiring layer 702 are formed at predetermined positions of the silicon substrate 705. The silicon through electrode 706 and the rewiring 707 can be formed in the same process as the process described with reference to Figs. 22 to 24.

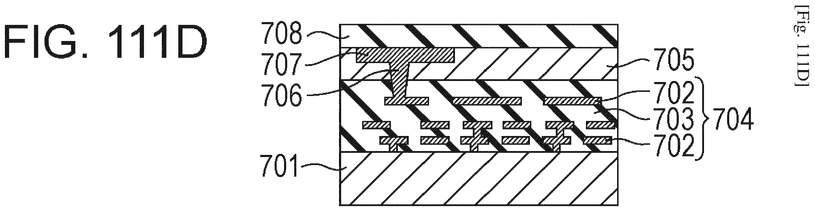

Next, as illustrated in Fig. 111D, an insulation film 708 is formed on the entire upper surfaces of the silicon substrate 705 and the rewiring 707. The insulation film 708 includes, for example, a single CiCN layer, laminated layers of SiN and SiO, or laminated layers of SiCN and SiO and functions as a passivation film that prevents the material (for example, Cu) of the rewiring 707 from diffusing. The insulation film 708 can be formed at a high temperature equal to or greater than 250 degrees and equal to or less than 400 degrees. Thus, the insulation film with good humidity resistance and good film quality can be formed, and thus erosion and wiring reliability can be improved.

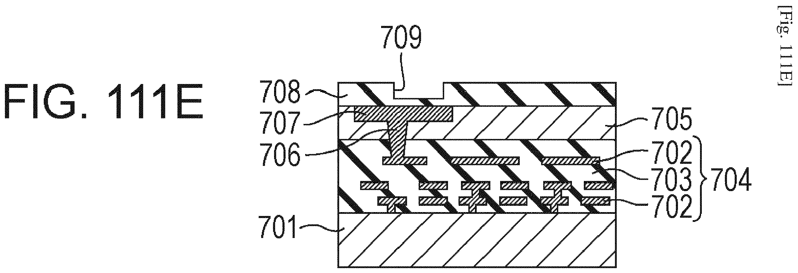

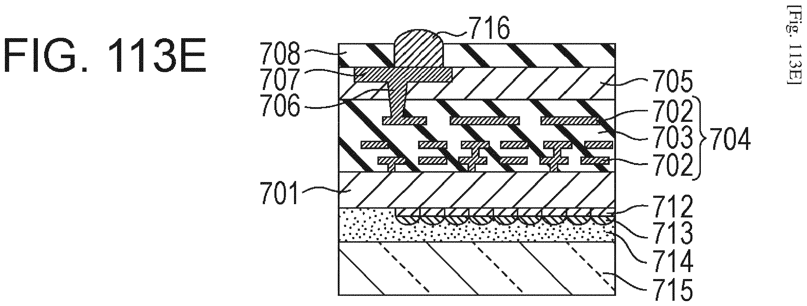

Next, as illustrated in Fig. 111E, a region in which a solder ball 716 (see Fig. 113E) is formed is opened in the insulation film 708 formed on the entire upper surfaces of the silicon substrate 705 and the rewiring 707, and thus a solder land portion 709 is formed. Here, as illustrated in Fig. 111E, in the solder land portion 709, the insulation film 708 remains thin.

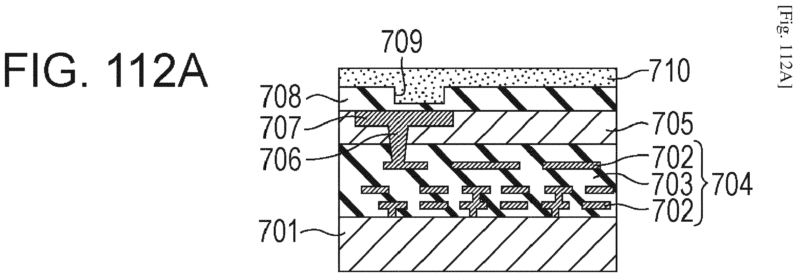

Next, as illustrated in Fig. 112A, an embedded material film 710 is embedded in the opened solder land portion 709. The embedded material film 710 is also formed on the upper surface of the insulation film 708 in addition to the solder land portion 709 and the formed embedded material film 710 is flattened by a CMP method. The embedded material film 710 may have a material with etch selectivity to the insulation film 708. For example, an organic insulation film, a SiO film, or a SiOC film with a low dielectric constant can be adopted.

The embedded material film 710 can be formed by rotating and applying a resist. In this case, the flattening process by the CMP method is not necessary.

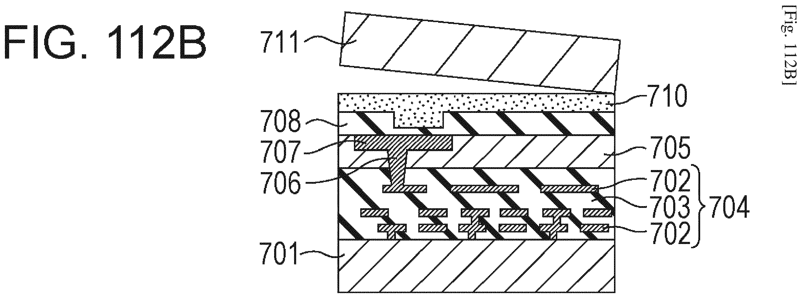

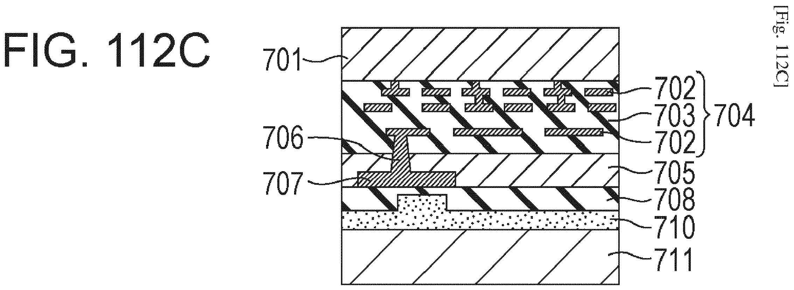

Next, after a provisional bonded substrate 711 is pasted to the side of the embedded material film 710 of the silicon substrate 705, as illustrated in Fig. 112B, all of the substrates are turned upside down as illustrated in Fig. 112C.

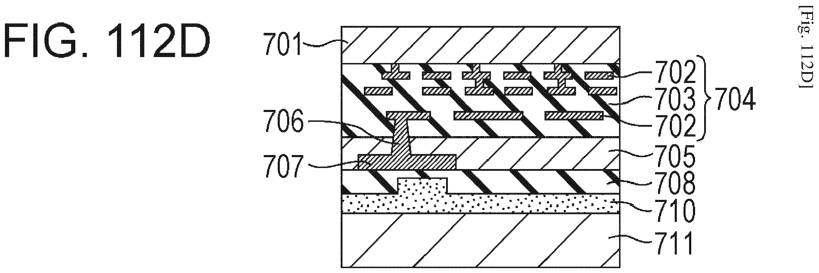

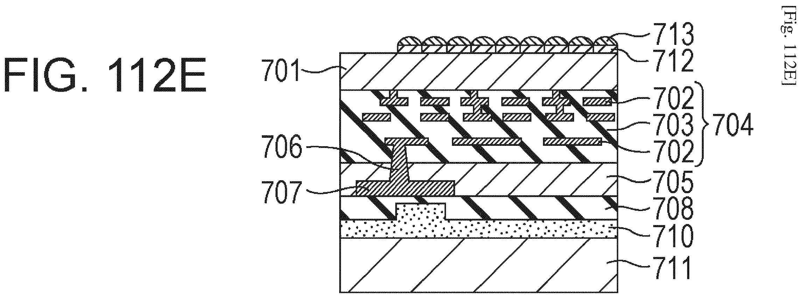

After the silicon substrate 701 is thinned to be about 1 micrometer to about 10 micrometers, as illustrated in Fig. 112D, color filters 712 and on-chip lenses 713 are formed thereon, as illustrated in Fig. 112E. Further, a high dielectric film such as the high dielectric film 401 in Fig. 15 may be formed on the upper surface of the thinned silicon substrate 711 in order to suppress a dark current.

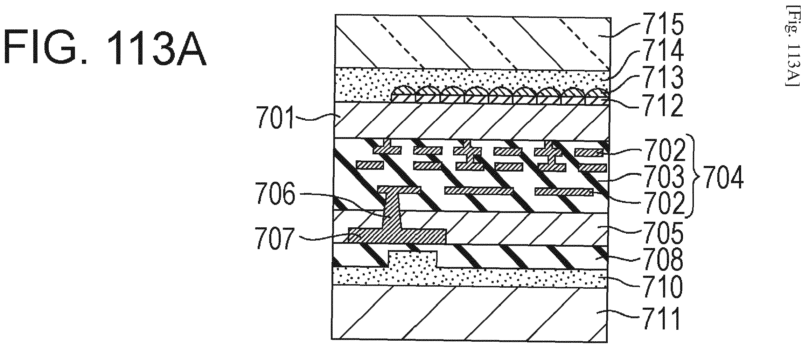

Next, as illustrated in Fig. 113A, after a glass seal resin 714 is applied to the entire surface on which the on-chip lenses 713 of the silicon substrate 711 are formed, a glass protective substrate 715 is pasted with the cavityless structure.

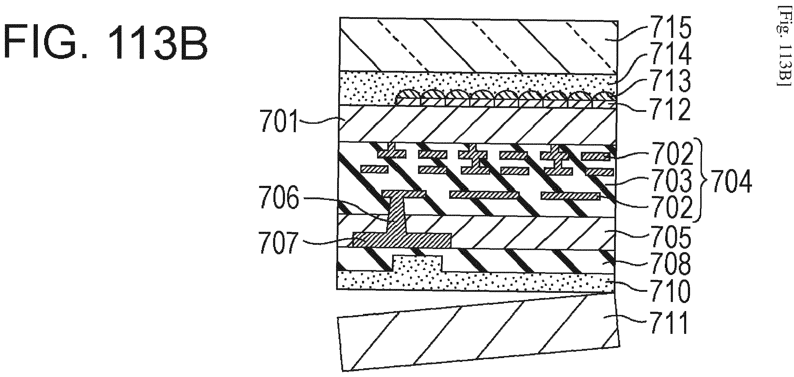

After the glass protective substrate 715 is pasted, the provisional bonded substrate 711 is de-bonded, as illustrated in Fig. 113B.

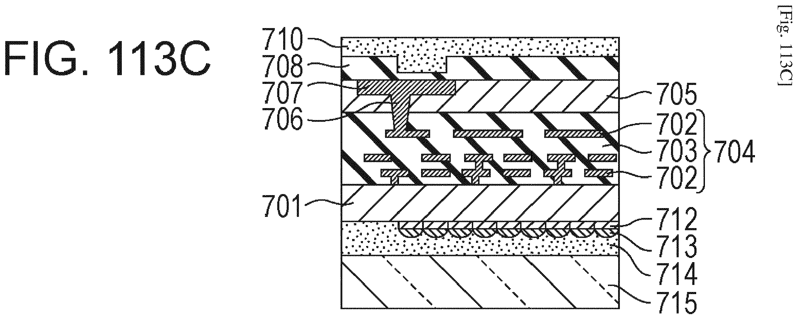

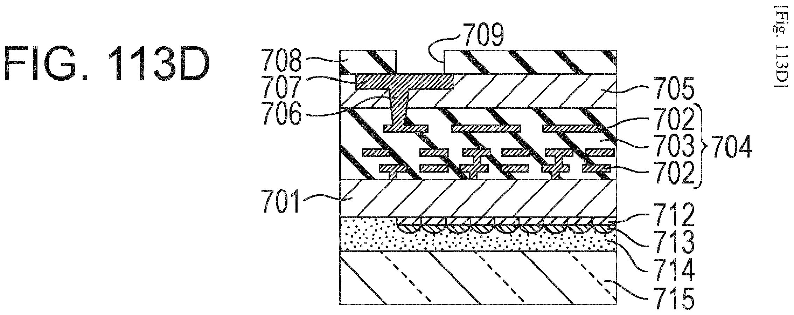

Next, after all of the substrates are turned upside down again, as illustrated in Fig. 113C, the embedded material film 710 is removed by, for example, wet etching using hydrofluoric acid (HF), as illustrated in Fig. 113D. By performing etch-back on the entire surface on which the insulation film 708 is formed, the insulation film 708 remaining which is thin in the solder land portion 709 is removed, so that the rewiring 707 is exposed.

When the embedded material film 710 is formed by rotating and applying the resist in the process described with reference to Fig. 112A, the embedded material film 710 can be removed (subjected to ashing) by O₂ plasma.

Finally, as illustrated in Fig. 112E, the solder ball 716 is formed in the portion in which the rewiring 707 is exposed by the solder-ball mounting method or the like.

As described above, not when pasting the semiconductor substrates in which the wiring layers are formed in advance are pasted but when the silicon substrates in which no wiring layer is formed are pasted, the silicon through electrode 706 and the rewiring 707 can be formed before the color filters 712 and the on-chip lenses 713 are formed, as in the above-described other manufacturing methods. Therefore, since the insulation film 708 can be formed at a high temperature equal to or greater than 250 degrees, it is possible to form the insulation film 708 ensuring high reliability. In other words, it is possible to improve the mechanical characteristics or insulation resistance of the insulation film 708 to the same level as a signal processing wiring.

### <9. Configuration Example of Three-layer Laminated Substrate>

In each embodiment described above, the laminated substrate 13 of the solid-state imaging device 1 is configured to include two layers, i.e., the logic substrate 11 and the pixel sensor substrate 12.

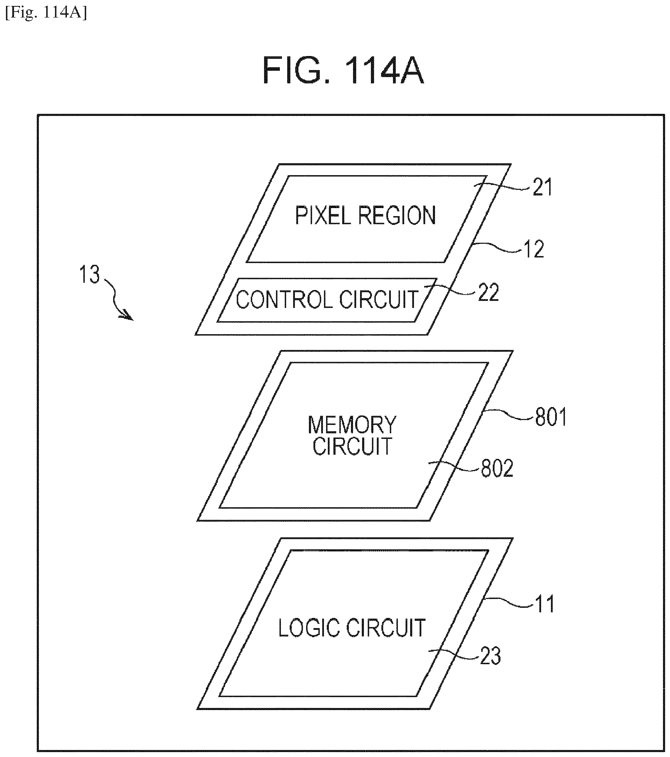

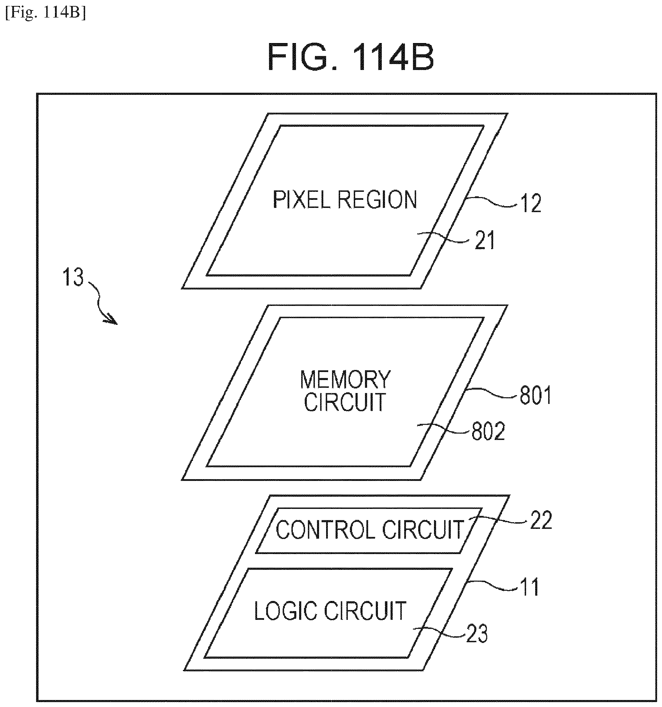

However, as illustrated in Figs. 114A and 114B, a laminated substrate 13 can also have a configuration of three layers in which a memory substrate 801 which is a third semiconductor substrate is provided between the logic substrate 11 and the pixel sensor substrate 12.

In the memory substrate 801, a memory circuit 802 storing a signal generated in the pixel region 21, data of a result of signal processing in the logic circuit 23, and the like is formed.

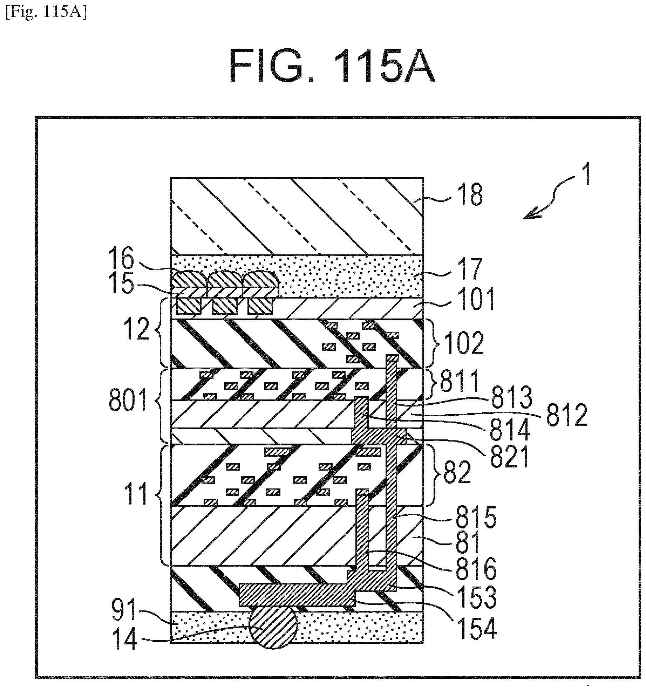

Figs. 115A to 118 are diagrams illustrating specific configuration examples when the laminated substrate 13 of the solid-state imaging device 1 is configured to include three layers.

Since the detailed configuration of each substrate in Figs. 115A to 118 is the same the configuration described in the above-described logic substrate 11 and pixel sensor substrate 12, the description thereof will be omitted.

First, the configurations of the solid-state imaging devices 1 having a three-layer structure illustrated in Figs. 115A to 115C will be described.

In all of the solid-state imaging devices 1 illustrated in Figs. 115A to 115C, the logic substrate 11 and the pixel sensor substrate 12 are laminated with the face-to-face structure. The memory substrate 801 inserted between the logic substrate 11 and the pixel sensor substrate 12 is laminated with the face-to-face structure with the pixel sensor substrate 12.

The solid-state imaging device 1 illustrated in Fig. 115A is manufactured in the following order.

First, the half-finished pixel sensor substrate 12 and the memory substrate 801 which are separately manufactured are pasted so that the wiring layers thereof face each other. Next, after a silicon substrate 812 of the memory substrate 801 is thinned, a chip through electrode 813 penetrating through the silicon substrate 812 and a multi-layer wiring layer 811 of the memory substrate 801, a silicon through electrode 814 penetrating through the silicon substrate 812, and a rewiring 821 connecting the chip through electrode 813 to the silicon through electrode 814 are formed. Thus, the multi-layer wiring layer 102 of the pixel sensor substrate 12 and the multi-layer wiring layer 811 of the memory substrate 801 are connected using the chip through electrode 813, the silicon through electrode 814, and the rewiring 821.

Next, the memory substrate 801 and the half-finished logic substrate 11 are pasted together, and a chip through electrode 815 penetrating through the silicon substrate 81 and the multi-layer wiring layer 82 of the logic substrate 11, a silicon through electrode 816 penetrating through the silicon substrate 81, and a connection wiring 153 are formed. Thus, the multi-layer wiring layer 82 of the logic substrate 11 and the multi-layer wiring layer 811 of the memory substrate 801 are connected using the chip through electrode 815, the silicon through electrode 816, and the connection wiring 153.

After the rewiring 154 and the insulation film 86 are formed on the upper side of the connection wiring 153 of the logic substrate 11, the logic substrate 11 and a provisional bonded substrate (not illustrated) are pasted together.

The silicon substrate 101 of the pixel sensor substrate 12 is thinned using the provisional bonded substrate (not illustrated) as a support substrate and the color filters 15 and the on-chip lenses 16 are formed on the upper surface of the thinned silicon substrate 101. Then, after the color filters 15 and the on-chip lenses 16 are formed, the glass seal resin 17 and the glass protective substrate 18 are pasted together.

Finally, the provisional bonded substrate bonded to the logic substrate 11 is de-bonded and the solder mask 91 and the solder ball 14 are formed, so that the solid-state imaging device 1 in Fig. 115A is completed.

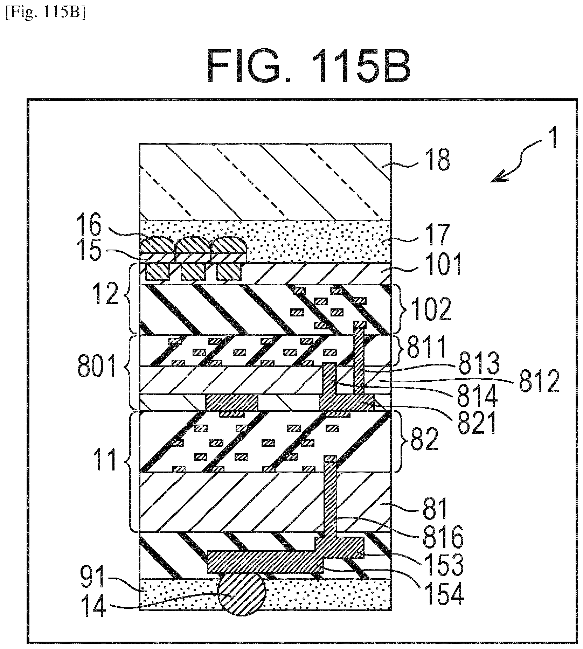

Next, the solid-state imaging device 1 illustrated in Fig. 115B is manufactured in the following order.

First, the half-finished pixel sensor substrate 12 and the memory substrate 801 which are separately manufactured are pasted so that the wiring layers thereof face each other. Next, after a silicon substrate 812 of the memory substrate 801 is thinned, the chip through electrode 813 penetrating through the silicon substrate 812 and the multi-layer wiring layer 811 of the memory substrate 801, the silicon through electrode 814 penetrating through the silicon substrate 812, and a rewiring 821 connecting the chip through electrode 813 to the silicon through electrode 814 are formed. Thus, the multi-layer wiring layer 102 of the pixel sensor substrate 12 and the multi-layer wiring layer 811 of the memory substrate 801 are connected using the chip through electrode 813, the silicon through electrode 814, and the rewiring 821.

Next, the memory substrate 801 and the half-finished logic substrate 11 are pasted together by metal bond (Cu-Cu) of the rewiring 821 of the memory substrate 801 and the wiring layer 83 of the multi-layer wiring layer 82 of the logic substrate 11.

After the silicon substrate 81 of the logic substrate 11 is thinned, a silicon through electrode 816 penetrating through the silicon substrate 81, the connection wiring 153, the rewiring 154, and the insulation film 86 are formed. Thereafter, a provisional bonded substrate (not illustrated) is pasted to the side of the insulation film 86 of the logic substrate 11.

The silicon substrate 101 of the pixel sensor substrate 12 is thinned using the provisional bonded substrate (not illustrated) as a support substrate and the color filters 15 and the on-chip lenses 16 are formed on the upper surface of the thinned silicon substrate 101. Then, after the color filters 15 and the on-chip lenses 16 are formed, the glass seal resin 17 and the glass protective substrate 18 are pasted together.

Finally, the provisional bonded substrate bonded to the logic substrate 11 is de-bonded and the solder mask 91 and the solder ball 14 are formed, so that the solid-state imaging device 1 in Fig. 115B is completed.

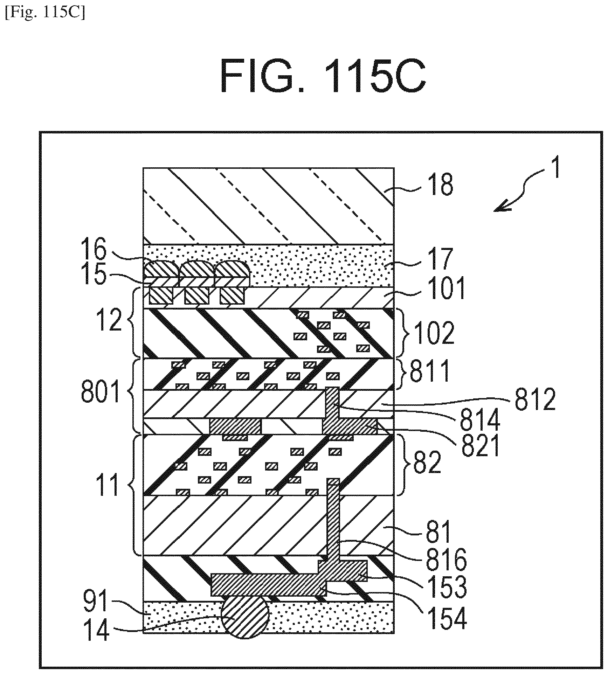

Next, the solid-state imaging device 1 illustrated in Fig. 115C is manufactured in the following order.

First, the half-finished pixel sensor substrate 12 and the memory substrate 801 which are separately manufactured are pasted so that the wiring layers thereof face each other. The pixel sensor substrate 12 and the memory substrate 801 are pasted together by metal bond (Cu-Cu) of the multi-layer wiring layer 102 of the pixel sensor substrate 12 and the multi-layer wiring layer 811 of the memory substrate 801.

Next, after the silicon substrate 812 of the memory substrate 801 is thinned, the silicon through electrode 814 penetrating through the silicon substrate 812 of the memory substrate 801 and a rewiring 821 connected to the silicon through electrode 814 are formed.

Next, the half-finished logic substrate 11 and the memory substrate 801 are pasted together by metal bond (Cu-Cu) of the rewiring 821 of the memory substrate 801 and the wiring layer 83 of the multi-layer wiring layer 82 of the logic substrate 11.

After the silicon substrate 81 of the logic substrate 11 is thinned, the silicon through electrode 816 penetrating through the silicon substrate 81, the connection wiring 153, the rewiring 154, and the insulation film 86 are formed. Thereafter, a provisional bonded substrate (not illustrated) is pasted to the side of the insulation film 86 of the logic substrate 11.

Next, the silicon substrate 101 of the pixel sensor substrate 12 is thinned using the provisional bonded substrate (not illustrated) as a support substrate and the color filters 15 and the on-chip lenses 16 are formed on the upper surface of the thinned silicon substrate 101. Then, after the color filters 15 and the on-chip lenses 16 are formed, the glass seal resin 17 and the glass protective substrate 18 are pasted together.

Finally, the provisional bonded substrate bonded to the logic substrate 11 is de-bonded and the solder mask 91 and the solder ball 14 are formed, so that the solid-state imaging device 1 in Fig. 115C is completed.

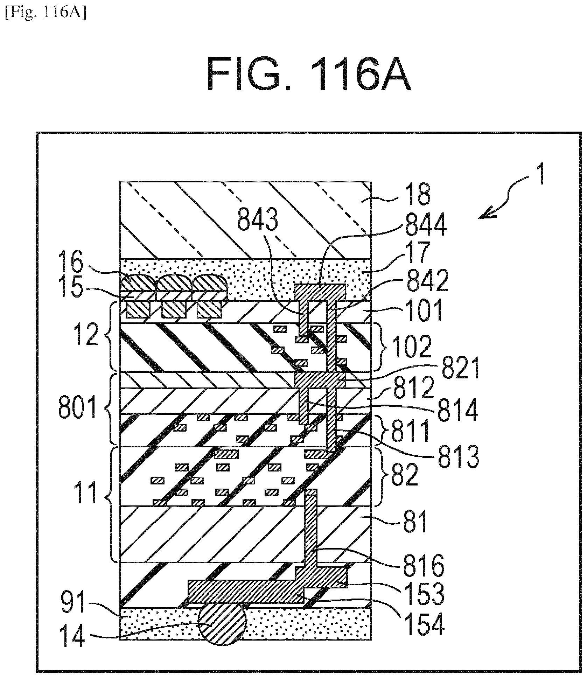

Next, the solid-state imaging devices 1 having the three-layer structures illustrated in Figs. 116A to 116C will be described in the following order.

In all of the solid-state imaging devices 1 illustrated in Figs. 116A to 116C, the memory substrate 801 and the logic substrate 11 are laminated with the face-to-face structure. The pixel sensor substrate 12 is also laminated to the logic substrate 11 with the face-to-face structure.

The solid-state imaging device 1 illustrated in Fig. 116A is manufactured in the following order.

First, the half-finished logic substrate 11 and the memory substrate 801 which are separately manufactured are pasted so that the wiring layers thereof face each other.

Next, after the silicon substrate 81 of the logic substrate 11 is thinned, the silicon through electrode 816, the connection wiring 153, the rewiring 154, and the insulation film 86 are formed, and the logic substrate 11 and a provisional bonded substrate (not illustrated) are pasted together.

Next, after the silicon substrate 812 of the memory substrate 801 is thinned using the provisional bonded substrate (not illustrated) as a support substrate, the chip through electrode 813, the silicon through electrode 814, and the rewiring 821 are formed.

Next, after the pixel sensor substrate 12 is bonded to the upper side of the memory substrate 801 and the silicon substrate 101 of the pixel sensor substrate 12 is thinned, a chip through electrode 842 penetrating through the silicon substrate 101 and the multi-layer wiring layer 102 of the pixel sensor substrate 12, a silicon through electrode 843 penetrating the silicon substrate 101, and a rewiring 844 connecting the chip through electrode 842 to the silicon through electrode 843 are formed. Thus, the multi-layer wiring layer 102 of the pixel sensor substrate 12 and the multi-layer wiring layer 811 of the memory substrate 801 are connected using the chip through electrode 842, the silicon through electrode 843, and the rewiring 844. Thereafter, the color filters 15 and the on-chip lenses 16 are formed and the glass protective substrate 18 is pasted by the glass seal resin 17.

Finally, the provisional bonded substrate bonded to the logic substrate 11 is de-bonded and the solder mask 91 and the solder ball 14 are formed, so that the solid-state imaging device 1 in Fig. 116A is completed.

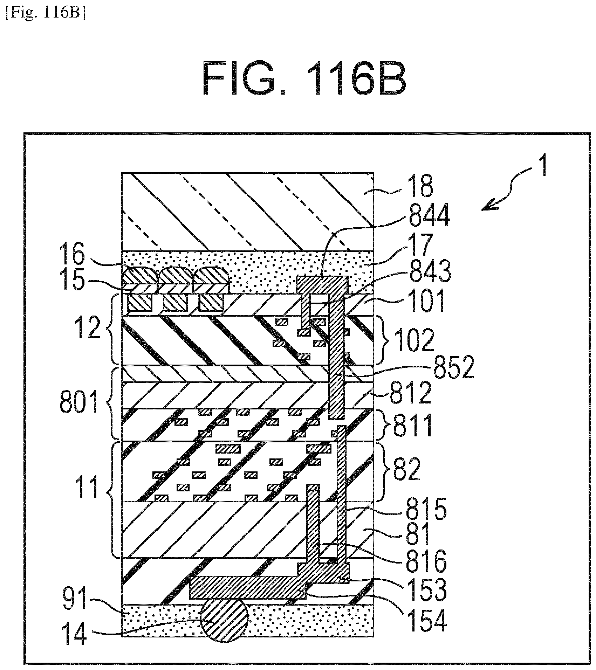

Next, the solid-state imaging device 1 illustrated in Fig. 116B is manufactured in the following order.

First, the half-finished logic substrate 11 and the memory substrate 801 which are separately manufactured are pasted so that the wiring layers thereof face each other.

Next, after the silicon substrate 81 of the logic substrate 11 manufactured up to the half-finished state is thinned, the chip through electrode 815, the silicon through electrode 816, the connection wiring 153, the rewiring 154, and the insulation film 86 are formed. Thus, the multi-layer wiring layer 82 of the logic substrate 11 and the multi-layer wiring layer 811 of the memory substrate 801 are connected using the chip through electrode 815, the silicon through electrode 816, and the connection wiring 153. Thereafter, the logic substrate 11 is pasted to a provisional bonded substrate (not illustrated).

Next, after the silicon substrate 812 of the memory substrate 801 is thinned, the pixel sensor substrate 12 is bonded to the upper side of the thinned silicon substrate 812.

Next, a chip through electrode 852 penetrating through the entire pixel sensor substrate 12 and the silicon substrate 812 of the memory substrate 801, a silicon through electrode 843 penetrating through the silicon substrate 101 of the pixel sensor substrate 12, and a rewiring 844 connecting the chip through electrode 842 to the silicon through electrode 843 are formed. Thus, the multi-layer wiring layer 102 of the pixel sensor substrate 12 and the multi-layer wiring layer 811 of the memory substrate 801 are connected using the chip through electrode 852, the silicon through electrode 843, and the rewiring 844. Thereafter, after the color filters 15 and the on-chip lenses 16 are formed, the glass seal resin 17 and the glass protective substrate 18 are pasted together.

Finally, the provisional bonded substrate bonded to the logic substrate 11 is de-bonded and the solder mask 91 and the solder ball 14 are formed, so that the solid-state imaging device 1 in Fig. 116B is completed.

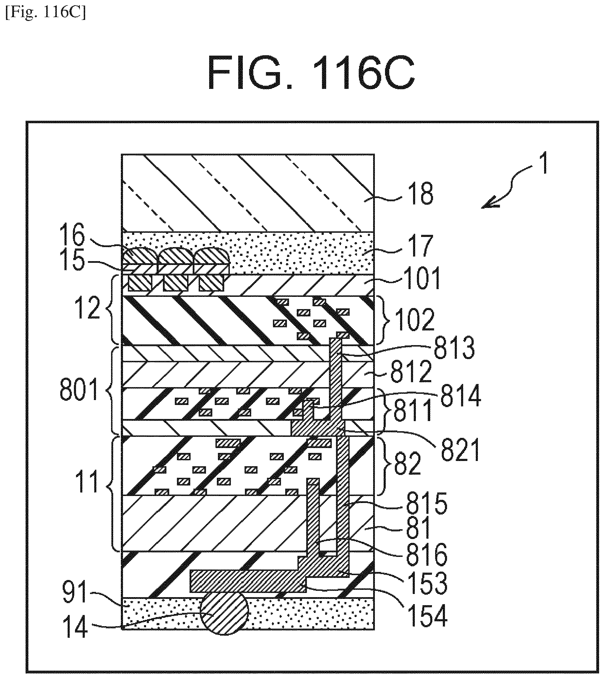

Next, the solid-state imaging device 1 illustrated in Fig. 116C is manufactured in the following order.

First, a first provisional bonded substrate (not illustrated) is pasted to the side of the multi-layer wiring layer 811 of the half-finished memory substrate 801 and the silicon substrate 812 of the memory substrate 801 is thinned using the first provisional bonded substrate as a support substrate.

Next, the pixel sensor substrate 12 manufactured up to the half-finished state is pasted to the memory substrate 801, the first provisional bonded substrate pasted to the other side of the memory substrate 801 is de-bonded, and the chip through electrode 813, the silicon through electrode 814, and the rewiring 821 are formed. Thus, the multi-layer wiring layer 102 of the pixel sensor substrate 12 and the multi-layer wiring layer 811 of the memory substrate 801 are connected using the chip through electrode 813, the silicon through electrode 814, and the rewiring 821.

Next, the logic substrate 11 manufactured up to the half-finished state is pasted to the side of the rewiring 821 of the memory substrate 801, and the chip through electrode 815, the silicon through electrode 816, the connection wiring 153, the rewiring 154, and the insulation film 86 are formed. Thus, the multi-layer wiring layer 82 of the logic substrate 11 and the multi-layer wiring layer 811 of the memory substrate 801 are connected using the chip through electrode 815, the silicon through electrode 816, and the connection wiring 153. Thereafter, the logic substrate 11 is pasted to a second provisional bonded substrate (not illustrated).

After the silicon substrate 101 of the pixel sensor substrate 12 is thinned, the color filters 15 and the on-chip lenses 16 are formed and the glass protective substrate 18 is pasted by the glass seal resin 17.

Finally, the second provisional bonded substrate bonded to the logic substrate 11 is de-bonded and the solder mask 91 and the solder ball 14 are formed, so that the solid-state imaging device 1 in Fig. 116C is completed.

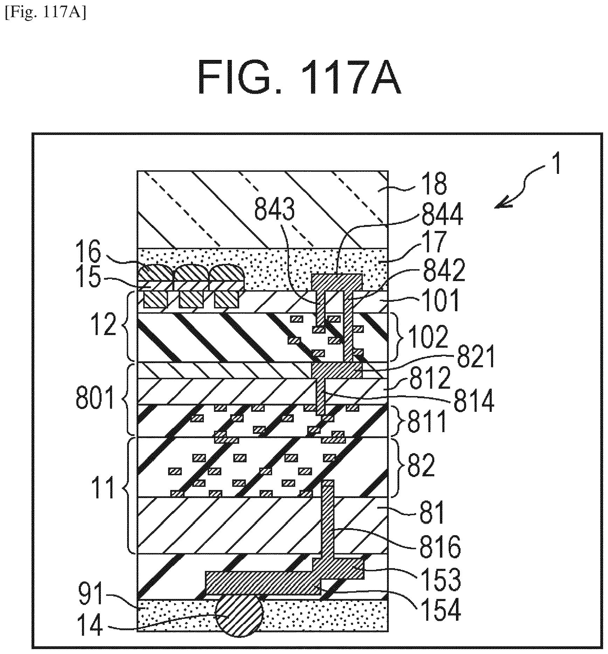

Next, the solid-state imaging devices 1 having the three-layer structures illustrated in Figs. 117A to 117C will be described in the following order.

In the solid-state imaging devices 1 illustrated in Figs. 117A to 117C, the memory substrate 801 and the logic substrate 11 are also laminated with the face-to-face structure and the pixel sensor substrate 12 is also laminated to the logic substrate 11 with the face-to-face structure.

The solid-state imaging device 1 illustrated in Fig. 117A is manufactured in the following order.

First, the half-finished logic substrate 11 and the memory substrate 801 which are separately manufactured are pasted by metal bond (Cu-Cu) of the multi-layer wiring layer 82 of the logic substrate 11 and the multi-layer wiring layer 811 of the memory substrate 801 so that the wiring layers thereof face each other.

Next, after the silicon substrate 81 of the logic substrate 11 is thinned, the silicon through electrode 816, the connection wiring 153, the rewiring 154, and the insulation film 86 are formed. Thereafter, the logic substrate 11 is pasted to a provisional bonded substrate (not illustrated).

Next, after the silicon substrate 812 of the memory substrate 801 is thinned using the provisional bonded substrate (not illustrated) as a support substrate, the silicon through electrode 814 and the rewiring 821 are formed.

Next, after the pixel sensor substrate 12 is bonded to the upper side of the memory substrate 801 and the silicon substrate 101 of the pixel sensor substrate 12 is thinned, the chip through electrode 842 penetrating through the silicon substrate 101 and the multi-layer wiring layer 102 of the pixel sensor substrate 12, the silicon through electrode 843 penetrating the silicon substrate 101, and a rewiring 844 connecting the chip through electrode 842 to the silicon through electrode 843 are formed. Thus, the multi-layer wiring layer 102 of the pixel sensor substrate 12 and the multi-layer wiring layer 811 of the memory substrate 801 are connected using the chip through electrode 842, the silicon through electrode 843, and the rewiring 844. Thereafter, the color filters 15 and the on-chip lenses 16 are formed and the glass protective substrate 18 is pasted using the glass seal resin 17.

Finally, the provisional bonded substrate bonded to the logic substrate 11 is de-bonded and the solder mask 91 and the solder ball 14 are formed, so that the solid-state imaging device 1 in Fig. 117A is completed.

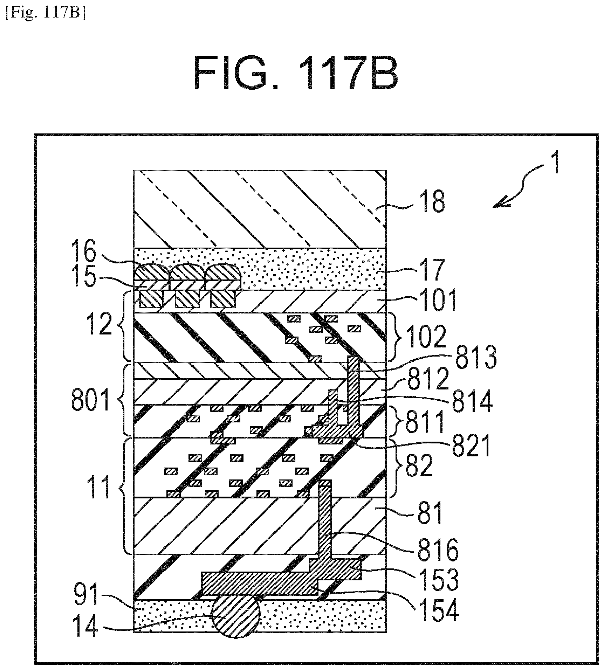

Next, the solid-state imaging device 1 illustrated in Fig. 117B is manufactured in the following order.

First, a first provisional bonded substrate (not illustrated) is pasted to the side of the multi-layer wiring layer 811 of the half-finished memory substrate 801 and the silicon substrate 812 of the memory substrate 801 is thinned using the first provisional bonded substrate as a support substrate.

Next, the pixel sensor substrate 12 manufactured up to the half-finished state is pasted to the memory substrate 801, the first provisional bonded substrate pasted to the other side of the memory substrate 801 is de-bonded, and the chip through electrode 813, the silicon through electrode 814, and the rewiring 821 are formed. Thus, the multi-layer wiring layer 102 of the pixel sensor substrate 12 and the multi-layer wiring layer 811 of the memory substrate 801 are connected using the chip through electrode 813, the silicon through electrode 814, and the rewiring 821.

Next, the half-finished logic substrate 11 and the memory substrate 801 are pasted by metal bond (Cu-Cu) of the multi-layer wiring layer 82 of the logic substrate 11 and the multi-layer wiring layer 811 of the memory substrate 801 so that the wiring layers thereof face each other.

Next, after the silicon substrate 81 of the logic substrate 11 is thinned, the silicon through electrode 816, the connection wiring 153, the rewiring 154, and the insulation film 86 are formed. Thereafter, the logic substrate 11 is pasted to a second provisional bonded substrate (not illustrated).

Then, the silicon substrate 101 of the pixel sensor substrate 12 is thinned using the second provisional bonded substrate as a support substrate. Thereafter, the color filters 15 and the on-chip lenses 16 are formed and the glass protective substrate 18 is pasted using the glass seal resin 17.

Finally, the second provisional bonded substrate bonded to the logic substrate 11 is de-bonded and the solder mask 91 and the solder ball 14 are formed, so that the solid-state imaging device 1 in Fig. 117B is completed.

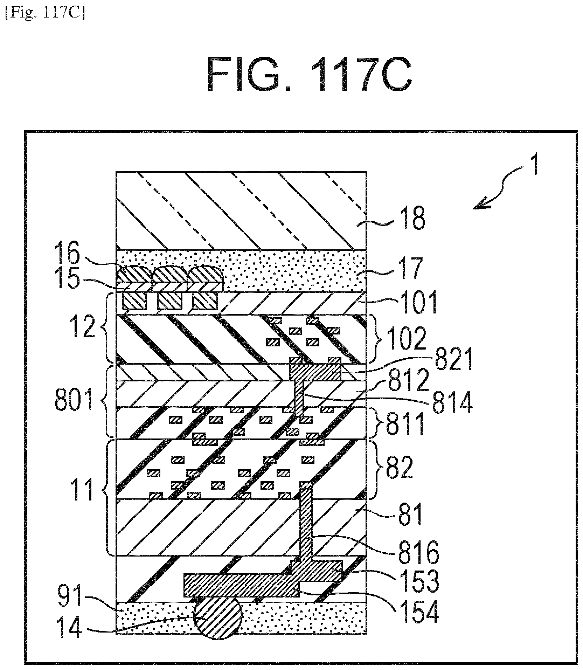

Next, the solid-state imaging device 1 illustrated in Fig. 117C is manufactured in the following order.

First, the half-finished logic substrate 11 and the memory substrate 801 which are separately manufactured are pasted by metal bond (Cu-Cu) of the multi-layer wiring layer 82 of the logic substrate 11 and the multi-layer wiring layer 811 of the memory substrate 801 so that the wiring layers thereof face each other.

Next, after the silicon substrate 81 of the logic substrate 11 is thinned, the silicon through electrode 816, the connection wiring 153, the rewiring 154, and the insulation film 86 are formed. Thereafter, the logic substrate 11 is pasted to a provisional bonded substrate (not illustrated).

Next, after the silicon substrate 812 of the memory substrate 801 is thinned, the silicon through electrode 814 and the rewiring 821 are formed.

Next, the pixel sensor substrate 12 is pasted to the upper side of the memory substrate 801. That is, the memory substrate 801 and the pixel sensor substrate 12 are bonded by metal bond (Cu-Cu) of the rewiring 821 of the memory substrate 801 and the multi-layer wiring layer 102 of the pixel sensor substrate 12.

Thereafter, the color filters 15 and the on-chip lenses 16 are formed on the upper surface of the silicon substrate 101 of the pixel sensor substrate 12 and the glass protective substrate 18 is pasted using the glass seal resin 17.

Finally, the provisional bonded substrate bonded to the logic substrate 11 is de-bonded and the solder mask 91 and the solder ball 14 are formed, so that the solid-state imaging device 1 in Fig. 117C is completed.

As described above with reference to Figs. 115A to 117C, the solid-state imaging device 1 having the three-layer structure can be configured by inserting the memory substrate 801 between the logic substrate 11 and the pixel sensor substrate 12 having the arrangement relation of the face-to-face structure. In this case, the direction of the memory substrate 801 can be oriented toward any of the face-to-face structure and the face-to-back structure with respect to the logic substrate 11, as described above.

Each structure illustrated in Figs. 115A to 117C is configured as the structure in which a signal of the pixel sensor substrate 12 most separated from the solder ball 14 is transmitted to the logic substrate 11 via the memory substrate 801.

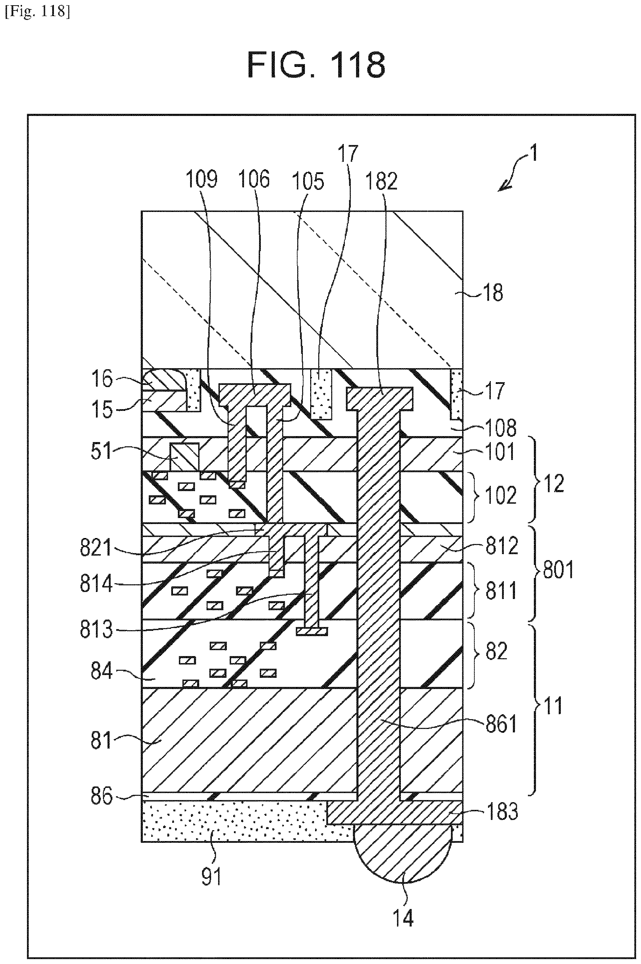

However, for example, as illustrated in Fig. 118, a chip through electrode 861 can also be formed to penetrate through three semiconductor substrates, i.e., the logic substrate 11, the memory substrate 801, and the pixel sensor substrate 12. A signal of the pixel sensor substrate 12 can be transmitted to the side of the logic substrate 11 via the chip through electrode 861. Likewise, a signal of the memory substrate 801 can also be transmitted to the side of the logic substrate 11 via the chip through electrode 861.

The number of laminated semiconductor substrates included in the solid-state imaging device 1 is not limited to two or three semiconductor substrates as described above, and four, five, or more semiconductor substrates may be laminated.

### <10. Application Example to Electronic Apparatus>

A technology of the present disclosure is not limited to application to the solid-state imaging device. That is, the technology of the present disclosure can be applied to general electronic apparatuses in which a solid-state imaging device is used in an image capturing unit (photoelectric conversion unit), such as imaging apparatuses such as digital still cameras or video cameras, portable terminal apparatuses having an imaging function, or copy machines in which a solid-state imaging device is used in an image reading unit.

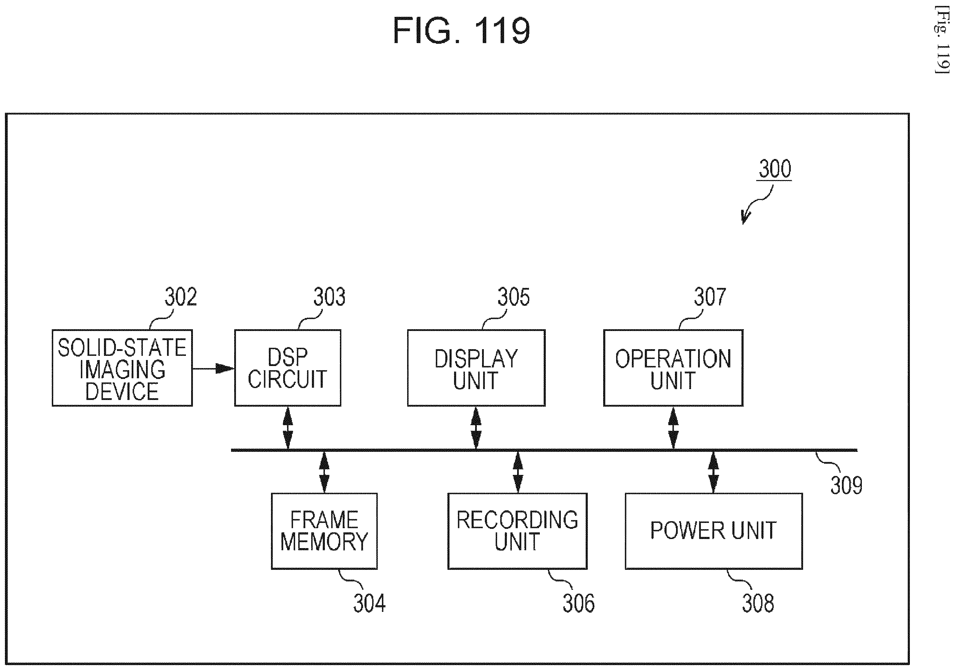

Fig. 119 is a block diagram illustrating a configuration example of an imaging apparatus which is an electronic apparatus according to an embodiment of the present disclosure.

An imaging apparatus 300 in Fig. 119 includes a solid-state imaging device 302 in which the configuration of the solid-state imaging device 1 in Fig. 1 is adopted and a digital signal processor (DSP) circuit 303 which is a camera signal processing circuit. The imaging apparatus 300 further includes a frame memory 304, a display unit 305, a recording unit 306, an operation unit 307, and a power unit 308. The DSP circuit 303, the frame memory 304, the display unit 305, the recording unit 306, the operation unit 307, and the power unit 308 are connected to each other via a bus line 309.

The solid-state imaging device 302 captures incident light (image light) from a subject, converts the amount of incident light formed as an image on an imaging surface into an electric signal in units of pixels, and outputs the electric signal as a pixel signal. The solid-state imaging device 1 in Fig. 1, i.e., the semiconductor package downsized by laminating the pixel sensor substrate 12 including the pixel region 21 and the logic substrate 11 including at least the logic circuit 23, can be used as the solid-state imaging device 302.

The display unit 305 is configured by a panel type display device such as a liquid crystal panel or an organic EL (Electro Luminescence) panel and displays a moving image or a still image captured by the solid-state imaging device 302. The recording unit 306 records a moving image or a still image captured by the solid-state imaging device 302 in a recording medium such as a hard disk or a semiconductor memory.

The operation unit 307 issues operation instructions in regard to various functions of the imaging apparatus 300 under operations of a user. The power unit 308 appropriately supplies supply targets with various amounts of power which are operational powers of the DSP circuit 303, the frame memory 304, the display unit 305, the recording unit 306, and the operation unit 307.

As described above, by using the solid-state imaging device 1 having any of the above-described structures as the solid-state imaging device 302, it is possible to realize the downsizing while enlarging the area of a photodiode PD and realizing high sensitivity. Accordingly, even in the imaging apparatus 300 such as a video camera, a digital still camera, or a camera module for a mobile apparatus such as a portable telephone, it is possible to achieve compatibility of the downsizing of the semiconductor package and high equality of a captured image.

In the above-described example, the configuration of a CMOS solid-state imaging device has been described as an example of a semiconductor device in which the laminated substrate 13 configured by laminating the lower substrate 11 and the upper substrate 12 is packaged. However, the technology of the present disclosure is not limited to the solid-stage imaging device, but can be applied to semiconductor devices packaged for other usage purposes.

For example, the technology of the present disclosure is not limited to solid-state imaging devices that detect a distribution of the amount of incident light of the visible light and image the distribution of the amount of incident light as an image, but can be generally applied to a solid-stage imaging device that images a distribution of the amount of incident infrared rays, X rays, or photons as an image or a solid-state imaging device (physical amount distribution detection devices) such as a fingerprint detection sensor that detects a distribution of another physical amount such as pressure or electrostatic capacity and images the distribution as an image in a broad sense.

Embodiments of the present disclosure are not limited to the above-described embodiments, and various modifications can be made within the scope of the present disclosure without departing from the gist of the present disclosure.

For example, a combination of all or some of the above-described plurality of embodiments may be adopted.

The advantageous effects described in the present specification are merely exemplary and are not restrictive, but other advantageous effects which have not been described in the present specification can be obtained.

Embodiments of the present disclosure can be configured as follows.
(1) A semiconductor device includes a first semiconductor substrate in which a pixel region where pixel portions performing photoelectric conversion are two-dimensionally arranged is formed and a second semiconductor substrate in which a logic circuit processing a pixel signal output from the pixel portion is formed, the first and second semiconductor substrates being laminated. A protective substrate protecting an on-chip lens is disposed on the on-chip lens in the pixel region of the first semiconductor substrate with a sealing resin interposed therebetween.
(2) In the semiconductor device described in (1) above, a laminated structure of the first and second semiconductor substrates may be configured by connecting the first and second semiconductor substrates after wiring layers are each formed.
(3) The semiconductor device described in (2) above may further include a first through electrode that penetrates through the first semiconductor substrate and is electrically connected to the wiring layer of the first semiconductor substrate; a second through electrode that penetrates through the first semiconductor substrate and the wiring layer of the first semiconductor substrate and is electrically connected to the wiring layer of the second semiconductor substrate; a connection wiring that electrically connects the first through electrode to the second through electrode; and a third through electrode that penetrates through the second semiconductor substrate and electrically connects an electrode portion outputting the pixel signal to an outside of the semiconductor device to the wiring layer of the second semiconductor substrate.
(4) In the semiconductor device described in (3) above, a solder mask may be formed on a surface on which the electrode portion of the second semiconductor substrate is formed and the solder mask is not formed on a region in which the electrode portion is formed.
(5) In the semiconductor device described in (3) above, an insulation film may be formed on a surface on which the electrode portion of the second semiconductor substrate is formed and the insulating film is not formed on a region in which the electrode portion is formed.
(6) The semiconductor device described in (2) above may further include: a first through electrode that penetrates through the second semiconductor substrate and is electrically connected to the wiring layer of the second semiconductor substrate; a second through electrode that penetrates through the second semiconductor substrate and the wiring layer of the second semiconductor substrate and is electrically connected to the wiring layer of the first semiconductor substrate; a connection wiring that electrically connects the first through electrode to the second through electrode; and a rewiring that electrically connects an electrode portion outputting the pixel signal to an outside of the semiconductor device to the connection wiring.
(7) The semiconductor device described in (2) above may further include: a through electrode that penetrates through the second semiconductor substrate and to electrically connects an electrode portion outputting the pixel signal to an outside of the semiconductor device to the wiring layer of the second semiconductor substrate; and a rewiring that electrically connects the through electrode to the electrode portion. The wiring layer of the first semiconductor substrate and the wiring layer of the second semiconductor substrate may be connected by a metal bond of one or more of the wiring layers.
(8) The semiconductor device described in (7) above may further include a dummy wiring that is not electrically connected to any wiring layer in the same layer as the rewiring.
(9) The semiconductor device described in (2) above may further include: a first through electrode that penetrates through the second semiconductor substrate and is electrically connected to the wiring layer of the second semiconductor substrate; a second through electrode that penetrates through the second semiconductor substrate and the wiring layer of the second semiconductor substrate and is electrically connected to the wiring layer of the first semiconductor substrate; a connection wiring that electrically connects the first through electrode to the second through electrode; a rewiring electrically connected to an electrode portion outputting the pixel signal to an outside of the semiconductor device; and a connection conductor that connects the rewiring to the connection wiring.
(10) The semiconductor device described in (2) above may further include: a first through electrode that penetrates through the first semiconductor substrate and is electrically connected to the wiring layer of the first semiconductor substrate; a second through electrode that penetrates through the first semiconductor substrate and the wiring layer of the first semiconductor substrate and is electrically connected to the wiring layer of the second semiconductor substrate; a connection wiring that electrically connects the first through electrode to the second through electrode; and a third through electrode that penetrates through the first and second semiconductor substrates and is electrically connected to an electrode portion outputting the pixel signal to an outside of the semiconductor device.
(11) In the semiconductor device described in (10) above, a solder mask may be formed on a surface on which the electrode portion of the second semiconductor substrate is formed and the solder mask is not formed on a region in which the electrode portion is formed.
(12) In the semiconductor device described in (10) above, an insulation film may be formed on a surface on which the electrode portion of the second semiconductor substrate is formed and the insulation film is not formed on a region in which the electrode portion is formed.
(13) The semiconductor device described in (2) above may further include: a first through electrode that penetrates through the first semiconductor substrate and is electrically connected to the wiring layer of each of the first and second semiconductor substrates; and a second through electrode that penetrates through the first and second semiconductor substrates and is electrically connected to an electrode portion outputting the pixel signal to an outside of the semiconductor device.
(14) The semiconductor device described in (2) above may further include a through electrode that penetrates through the first and second semiconductor substrates and is electrically connected to an electrode portion outputting the pixel signal to an outside of the semiconductor device. The wiring layer of the first semiconductor substrate and the wiring layer of the second semiconductor substrate may be connected by a metal bond of one or more of the wiring layers.
(15) In the semiconductor device described in (1) above, the first and second semiconductor substrates may be configured such that the wiring layers thereof face each other.
(16) In the semiconductor device described in (1) above, the first and second semiconductor substrates may be configured such that a side of the wiring layer of the first semiconductor substrate faces an opposite surface to a side of the wiring layer of the second semiconductor substrate.
(17) The semiconductor device described in (1) above may further include: an electrode portion that outputs the pixel signal to an outside of the semiconductor device; and a rewiring that delivers the pixel signal from the second semiconductor substrate to the electrode portion.
(18) In the semiconductor device described in (17) above, the electrode portion may be mounted on a land portion formed on the rewiring.
(19) In the semiconductor device described in (17) or (18) above, a barrier metal film that reduces a reaction with a material of the electrode portion may be formed outside of the rewiring.
(20) In the semiconductor device described in any one of (17) to (19) above, at least a part of the rewiring may be formed in a groove of the second semiconductor substrate.
(21) In the semiconductor device described in (1) above, a third semiconductor substrate in which a wiring layer is formed may be inserted between the first and second semiconductor substrates so that the semiconductor device includes three semiconductor substrates.
(22) In the semiconductor device described in (21) above, the third semiconductor substrate may be inserted between the first and second semiconductor substrates so that the wiring layer formed in the third semiconductor substrate faces the wiring layer of the first semiconductor substrate.
(23) In the semiconductor device described in (21) above, the third semiconductor substrate may be inserted between the first and second semiconductor substrates so that the wiring layer formed in the third semiconductor substrate faces the wiring layer of the second semiconductor substrate.
(24) In the semiconductor device described in (21) above, the third semiconductor substrate may include a memory circuit.
(25) In the semiconductor device described in (24) above, the memory circuit may store at least one of a signal generated in the pixel region and data indicative of a pixel signal processed by the logic circuit.
(26) A method of manufacturing a semiconductor device includes: connecting a first semiconductor substrate in which a first wiring layer is formed and a second semiconductor substrate in which a second wiring layer is formed so that the wiring layers thereof face each other; forming a through electrode electrically connected to the first and second wiring layers; forming a color filter and an on-chip lens; and connecting a protective substrate protecting the on-chip lens onto the on-chip lens by a sealing resin.
(27) A method of manufacturing a semiconductor device includes: on a first semiconductor substrate in which a first wiring layer is formed, forming a color filter and an on-chip lens on an opposite surface to a side in which the first wiring layer of the first semiconductor substrate is formed; forming a through electrode penetrating through a second semiconductor substrate in which a second wiring layer is formed; and connecting the first semiconductor substrate in which the color filter and the on-chip lens are formed to the second semiconductor substrate in which the through electrode is formed so that the wiring layers thereof face each other.
(28) An electronic apparatus includes a first semiconductor substrate in which a pixel region where pixel portions performing photoelectric conversion are two-dimensionally arranged is formed and a second semiconductor substrate in which a logic circuit processing a pixel signal output from the pixel portion is formed, the first and second semiconductor substrates being laminated. A protective substrate protecting an on-chip lens is disposed on the on-chip lens in the pixel region of the first semiconductor substrate with a sealing resin interposed therebetween.
   (A1) A method of manufacturing a semiconductor device includes: pasting a first semiconductor substrate in which a first wiring layer is formed and a second semiconductor substrate in which a second wiring layer is formed so that the wiring layers thereof face each other; forming a through electrode electrically connected to the first and second wiring layers, and then forming a color filter and an on-chip lens; and connecting a protective substrate protecting the on-chip lens onto the on-chip lens by a sealing resin.
   (A2) In the method of manufacturing the semiconductor device described in (A1) above, first and second through electrodes may be formed as the through electrode after the first and second semiconductor substrates are pasted. The first through electrode may penetrate through the second semiconductor substrate may be electrically connected to the wiring layer of the second semiconductor substrate. The second through electrode may penetrate through the second semiconductor substrate and the wiring layer of the second semiconductor substrate and may be electrically connected to the wiring layer of the first semiconductor substrate.
   (A3) The method of manufacturing the semiconductor device described in (A2) above may further include forming a connection wiring that electrically connects the first through electrode to the second through electrode; and forming a rewiring that electrically connects an electrode portion outputting a signal to the outside of the semiconductor device to the connection wiring.
   (A4) In the method of manufacturing the semiconductor device described in (A3) above, a provisional bonded substrate may be pasted onto the connection wiring and the rewiring after the connection wiring and the rewiring are formed. The electrode portion may be formed after the provisional bonded substrate is peeled off.
   (A5) In the method of manufacturing the semiconductor device described in (A4) above, after the connection wiring and the rewiring are formed, the first semiconductor substrate may be thinned.
   (A6) In the method of manufacturing the semiconductor device described in (A4) or (A5) above, the provisional bonded substrate may include a peeling layer and a surface of the peeling layer of the provisional bonded substrate may be pasted. When the provisional bonded substrate is peeled off, the peeling layer may remain after the peeling.
   (A7) In the method of manufacturing the semiconductor device described in (A4) or (A5) above, the provisional bonded substrate may include a peeling layer and an insulation film, and a surface of the insulation film of the provisional bonded substrate may be pasted. When the provisional bonded substrate is peeled off, the peeling layer and the insulation film may remain in the peeling.
   (A8) In the method of manufacturing the semiconductor device described in any one of (A4) to (A7) above, the first semiconductor substrate may be thinned before the connection wiring and the rewiring are formed.
   (A9) In the method of manufacturing the semiconductor device described in (A4) above, at least a part of the connection wiring or the rewiring may be formed in a portion engraved in the first semiconductor substrate.
   (A10) In the method of manufacturing the semiconductor device described in (A3) above, after the connection wiring and the rewiring are formed, the electrode portion may be formed on the connection wiring and the rewiring, and a provisional bonded substrate may be pasted onto the electrode portion.
   (A11) In the method of manufacturing the semiconductor device described in (A10) above, after the connection wiring and the rewiring are formed, the first semiconductor substrate may be thinned.
   (A12) In the method of manufacturing the semiconductor device described in (A10) above, before the connection wiring and the rewiring are formed, the first semiconductor substrate may be thinned.
   (A13) In the method of manufacturing the semiconductor device described in (A2) above, after a connection wiring electrically connecting the first through electrode to the second through electrode is simultaneously formed with the first and second through electrodes, a provisional bonded substrate may be bonded onto the connection wiring. After the provisional bonded substrate is peeled off, a rewiring electrically connecting an electrode portion outputting a signal to the outside of the semiconductor device to the connection wiring may be formed.
   (A14) In the method of manufacturing the semiconductor device described in (A13) above, after the provisional bonded substrate is peeled off, a connection conductor connecting the connection wiring to the rewiring may also be formed.
   (A15) In the method of manufacturing the semiconductor device described in (A2) above, a rewiring connected to an electrode portion outputting a signal to the outside of the semiconductor device may be formed along with the first and second through electrodes.
   (A16) In the method of manufacturing the semiconductor device described in (A15) above, after the rewiring is formed, an insulation film may be formed on the rewiring.
   (A17) In the method of manufacturing the semiconductor device described in (A16) above, a part of the insulation film in the region in which the electrode portion on the rewiring is formed may be removed.
   (A18) In the method of manufacturing the semiconductor device described in (A16) above, the insulation film in the region in which the electrode portion on the rewiring is formed may be removed until the rewiring is exposed.
   (A19) In the method of manufacturing the semiconductor device described in (A1) above, the first and second semiconductor substrates may be pasted by metal bond of the wiring layers and the through electrode penetrating the second semiconductor substrate may be formed.
   (A20) In the method of manufacturing the semiconductor device described in (A19) above, a rewiring connected to an electrode portion outputting a signal to the outside of the semiconductor device may be formed along with the through electrode, and then the first semiconductor substrate may be thinned.
   (A21) In the method of manufacturing the semiconductor device described in (A19) above, before a rewiring connected to an electrode portion outputting a signal to the outside of the semiconductor device is formed along with the through electrode, the first semiconductor substrate may be thinned.
   (A22) In the method of manufacturing the semiconductor device described in (A1) above, first and second through electrodes may be formed as the through electrode after the first and second semiconductor substrates are pasted. The first through electrode may penetrate through the first semiconductor substrate and may be electrically connected to the wiring layer of the first semiconductor substrate. The second through electrode may penetrate through the first semiconductor substrate and the wiring layer of the first semiconductor substrate and may be electrically connected to the wiring layer of the second semiconductor substrate.
   (A23) In the method of manufacturing the semiconductor device described in (A22) above, a third through electrode penetrating through the first and second semiconductor substrates and electrically connected to an electrode portion outputting a signal to the outside of the semiconductor device may be formed simultaneously with the first and second through electrodes.
   (A24) In the method of manufacturing the semiconductor device described in (A22) or (A23) above, after the on-chip lens is formed, a provisional bonded substrate may be pasted onto the on-chip lens. After the provisional bonded substrate is peeled off, the protective substrate may be connected by the sealing resin.
   (A25) In the method of manufacturing the semiconductor device described in (A2) above, before the first and second semiconductor substrates are pasted and then first and second through electrodes are formed as the through electrode, a third through electrode may be formed. The first through electrode may penetrate through the first semiconductor substrate and may be electrically connected to the wiring layer of the first semiconductor substrate. The second through electrode may penetrate through the first semiconductor substrate and the wiring layer of the first semiconductor substrate and may be electrically connected to the wiring layer of the second semiconductor substrate. The third through electrode may penetrate through the second semiconductor substrate and may be electrically connected to the wiring layer of the second semiconductor substrate.
   (A26) In the method of manufacturing the semiconductor device described in (A1) above, first and second through electrodes may be formed as the through electrode after the first and second semiconductor substrates are pasted. The first through electrode may penetrate through the first semiconductor substrate and may be electrically connected to the wiring layer of each of the first and second semiconductor substrates. The second through electrode may penetrate through the first and second semiconductor substrates and may be electrically connected to an electrode portion outputting a signal to the outside of the semiconductor device.
   (A27) In the method of manufacturing the semiconductor device described in (A1) above, the first and second semiconductor substrates may be pasted by metal bond of the wiring layers. The through electrode may be formed which penetrates through the first and second semiconductor substrates and is electrically connected to an electrode portion outputting a signal to the outside of the semiconductor device.
   (A28) In the method of manufacturing the semiconductor device described in (A1) above, a rewiring connected to an electrode portion outputting a signal to the outside of the semiconductor device may be formed by a damascene method.
   (A29) In the method of manufacturing the semiconductor device described in (A1) above, a rewiring connected to an electrode portion outputting a signal to the outside of the semiconductor device may be formed by a semi-additive method.
   (B1) A method of manufacturing a semiconductor device includes: pasting a first semiconductor substrate in which a first wiring layer is formed and a second semiconductor substrate in which a second wiring layer is formed so that the first wiring layer of the first semiconductor substrate faces an opposite surface to the side of the second wiring layer of the second semiconductor substrate; forming a through electrode electrically connected to the first and second wiring layers, and then forming a color filter and an on-chip lens; and connecting a protective substrate protecting the on-chip lens onto the on-chip lens by a sealing resin.
   (B2) In the method of manufacturing the semiconductor device described in (B1) above, first and second through electrodes may be formed as the through electrode after the first and second semiconductor substrates are pasted. The first through electrode may penetrate through the first semiconductor substrate and may be electrically connected to the wiring layer of the first semiconductor substrate. The second through electrode may penetrate through the second semiconductor substrate and the wiring layer of the second semiconductor substrate may be electrically connected to the wiring layer of the first semiconductor substrate.
   (B3) The method of manufacturing the semiconductor device described in (B1) or (B2) above may further include forming a rewiring connected to an electrode portion outputting a signal to the outside of the semiconductor device after the protective substrate is connected to the sealing resin.
   (B4) In the method of manufacturing the semiconductor device described in (B3) above, a light-shielding film may be formed on a bonded surface with the first semiconductor substrate after the second semiconductor substrate is thinned.
   (B5) The method of manufacturing the semiconductor device described in (B2) above may further include forming a rewiring connected to an electrode portion outputting a signal to the outside of the semiconductor device before the first and second semiconductor substrates are pasted.
   (B6) In the method of manufacturing the semiconductor device described in (B5) above, a land portion formed of a predetermined connection conductor and connected to the electrode portion outputting the signal to the outside of the semiconductor device is formed on the rewiring.
   (B7) In the method of manufacturing the semiconductor device described in (B6) above, the land portion and the rewiring may be connected through a via.
   (B8) The method of manufacturing the semiconductor device described in (B1) above may further include forming an electrode portion outputting a signal to the outside of the semiconductor device and a rewiring connected to the electrode portion before the first and second semiconductor substrates are pasted.
   (B9) In the method of manufacturing the semiconductor device described in (B1) above, a rewiring connected to an electrode portion outputting a signal to the outside of the semiconductor device may be formed by a damascene method.
   (B10) In the method of manufacturing the semiconductor device described in (B1) above, a rewiring connected to an electrode portion outputting a signal to the outside of the semiconductor device may be formed by a semi-additive method.
   (C1) A method of manufacturing a semiconductor device includes: forming a color filter and an on-chip lens, in a first semiconductor substrate in which a first wiring layer is formed, on an opposite surface to a side in which the first wiring layer of the first semiconductor substrate is formed; forming a through electrode penetrating through a second semiconductor substrate in the second semiconductor substrate in which a second wiring layer is formed; and pasting the first semiconductor substrate in which the color filter and the on-chip lens are formed to the second semiconductor substrate in which the through electrode is formed so that the wiring layers thereof face each other.
   (C2) In the method of manufacturing the semiconductor device described in (C1) above, the first and second semiconductor substrates may be pasted by metal bond of the first and second wiring layers.
   (C3) In the method of manufacturing the semiconductor device described in (C2) above, after the color filter and the on-chip lens are formed on an opposite surface to the side in which the first wiring layer of the first semiconductor substrate is formed, a protective substrate protecting the on-chip lens may be connected onto the on-chip lens by a sealing resin.
   (C4) The method of manufacturing the semiconductor device described in (C3) above may further include forming a protective film on the surface of the protective substrate.
   (C5) In the method of manufacturing the semiconductor device described in (C1) above, when the through electrode penetrating through the second semiconductor substrate is formed in the second semiconductor substrate, a rewiring electrically connected to an electrode portion outputting a signal to the outside of the semiconductor device may also be formed.
   (C6) In the method of manufacturing the semiconductor device described in (C5) above, a dummy wiring electrically connected to no wiring layer in the same layer as the rewiring may also be formed.

It should be understood by those skilled in the art that various modifications, combinations, sub-combinations and alterations may occur depending on design requirements and other factors insofar as they are within the scope of the appended claims or the equivalents thereof.

### Reference Signs List

1 Solid-state imaging device
11 Lower substrate (logic substrate)
12 Upper substrate (pixel sensor substrate)
13 Laminated substrate
15 Color filter
16 On-chip lens
17 Glass seal resin
18 Glass protective substrate
21 Pixel region
22 Control circuit
23 Logic circuit
32 Pixel
51 Photodiode
81 Silicon substrate
83 Wiring layer
86 Insulation film
88 Silicon through electrode
91 Solder mask
101 Silicon substrate
103 Wiring layer
105 Chip through electrode
106 Connection wiring
109 Silicon through electrode
151 Silicon through electrode
152 Chip through electrode
153 Connection wiring
154 Rewiring
171 Connection conductor
181 Chip through electrode
191 Chip through electrode
211 Dummy wiring
300 Imaging device
302 Solid-state imaging device
421 Cap film
431 Solder land
441 Insulation film
443 Via
801 Memory substrate

## Claims

1. A semiconductor device comprising:
a first semiconductor substrate (12) in which a pixel region where pixel portions performing photoelectric conversion are two-dimensionally arranged is formed and a second semiconductor substrate (11) in which a logic circuit processing a pixel signal output from the pixel portion is formed, the first (12) and second (11) semiconductor substrates being laminated,
wherein a protective substrate (18) protecting an on-chip lens (16) is disposed on the on-chip lens (16) in the pixel region of the first semiconductor substrate (12) with a sealing resin (17) interposed therebetween,
wherein a laminated structure of the first (12) and second (11) semiconductor substrates includes a wiring layer (102) of the first semiconductor substrate (12) and a wiring layer (82) of the second semiconductor substrate (11) being in contact with one another,
the semiconductor device further comprising:
a first through electrode (109) that penetrates through the first semiconductor substrate (12) and is electrically connected to the wiring layer (102) of the first semiconductor substrate (12);
a second through electrode (105) that penetrates through the first semiconductor substrate (12) and the wiring layer (102) of the first semiconductor substrate (12) and is electrically connected to the wiring layer (82) of the second semiconductor substrate (11);
a connection wiring (106) that electrically connects the first through electrode (109) to the second through electrode (105); and
a third through electrode (88) that penetrates through the second semiconductor substrate (11) and electrically connects an electrode portion outputting the pixel signal to an outside of the semiconductor device to the wiring layer (82) of the second semiconductor substrate (11).

2. The semiconductor device according to claim 1, wherein a solder mask (91) is formed on a surface on which the electrode portion of the second semiconductor substrate (11) is formed and the solder mask (91) is not formed on a region in which the electrode portion is formed.

3. The semiconductor device according to claim 1, wherein an insulation film (86) is formed on a surface on which the electrode portion of the second semiconductor substrate (11) is formed and the insulation film (86) is not formed on a region in which the electrode portion is formed.

4. A semiconductor device comprising:
a first semiconductor substrate (12) in which a pixel region where pixel portions performing photoelectric conversion are two-dimensionally arranged is formed and a second semiconductor substrate (11) in which a logic circuit processing a pixel signal output from the pixel portion is formed, the first (12) and second (11) semiconductor substrates being laminated,
wherein a protective substrate (18) protecting an on-chip lens (16) is disposed on the on-chip lens (16) in the pixel region of the first semiconductor substrate (12) with a sealing resin (17) interposed therebetween,
wherein a laminated structure of the first (12) and second (11) semiconductor substrates includes a wiring layer (102) of the first semiconductor substrate (12) and a wiring layer (82) of the second semiconductor substrate (11) being in contact with one another,
the semiconductor device further comprising:
a through electrode (88) that penetrates through the second semiconductor substrate (11) and electrically connects an electrode portion outputting the pixel signal to an outside of the semiconductor device to the wiring layer (82) of the second semiconductor substrate (11);
a rewiring that electrically connects the through electrode (88) to the electrode portion; and
a dummy wiring that is not electrically connected to any wiring layer (82, 102) in the same layer as the rewiring,
wherein the wiring layer (102) of the first semiconductor substrate (12) and the wiring layer (82) of the second semiconductor substrate (11) are connected by a metal bond of one or more of the wiring layers (82, 102).

5. The semiconductor device according to claim 1, wherein the first (12) and second (11) semiconductor substrates are configured such that the wiring layers (82, 102) thereof face each other.

6. The semiconductor device according to claim 1, further comprising:
an electrode portion that outputs the pixel signal to an outside of the semiconductor device; and
a rewiring that delivers the pixel signal from the second semiconductor substrate (11) to the electrode portion.

7. A method of manufacturing a semiconductor device, comprising:
connecting a first semiconductor substrate (12) in which a first wiring layer (102) is formed and a second semiconductor substrate (11) in which a second wiring layer (82) is formed so that the wiring layers (82, 102) thereof face each other;
forming a through electrode electrically connected to the first (102) and second (82) wiring layers;
forming a color filter (15) and an on-chip lens (16); and
connecting a protective substrate (18) protecting the on-chip lens (16) onto the on-chip lens (16) by a sealing resin (17).

8. A method of manufacturing a semiconductor device, comprising:
on a first semiconductor substrate (12) in which a first wiring layer (102) is formed, forming a color filter (15) and an on-chip lens (16) on an opposite surface to a side in which the first wiring layer (102) of the first semiconductor substrate (12) is formed;
forming a through electrode penetrating through a second semiconductor substrate (11) in which a second wiring layer (82) is formed; and
connecting the first semiconductor substrate (12) in which the color filter (15) and the on-chip lens (16) are formed to the second semiconductor substrate (11) in which the through electrode is formed so that the wiring layers (82, 102) thereof face each other.

9. An electronic apparatus comprising:
a semiconductor device according to claim 1 or claim 4.
